(19) Europäisches Patentamt
European Patent Office
Office européen des brevets

(11) **EP 3 794 650 B1**

(12) **EUROPEAN PATENT SPECIFICATION**

(45) Date of publication and mention of the grant of the patent:
**13.03.2024 Bulletin 2024/11**

(21) Application number: **19804572.6**

(22) Date of filing: **16.04.2019**

(51) International Patent Classification (IPC):
***H10K 85/10*** *(2023.01)*

(52) Cooperative Patent Classification (CPC):
**H10K 85/113; H10K 85/151;** Y02E 10/549; Y02P 70/50

(86) International application number:
**PCT/CN2019/082826**

(87) International publication number:
**WO 2019/218828 (21.11.2019 Gazette 2019/47)**

(54) **ORGANIC SEMICONDUCTORS**

ORGANISCHE HALBLEITER

SEMI-CONDUCTEURS ORGANIQUES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **16.05.2018 PCT/CN2018/087133**

(43) Date of publication of application:
**24.03.2021 Bulletin 2021/12**

(73) Proprietor: **Raynergy Tek Incorporation
Hsinchu (TW)**

(72) Inventors:
- **AN, Cunbin
Beijing 100190 (CN)**
- **MORSE, Graham
Southampton SO14 5GP (GB)**
- **PRON, Agnieszka
FELTHAM TW14 8HA (GB)**
- **BURGUES, Ignasi
08860 Castelldefels
Barcelona (ES)**
- **HOU, Jianhui
Beijing 100190 (CN)**

(74) Representative: **Lawrie IP Limited
310 St. Vincent Street
Glasgow G2 5RG (GB)**

(56) References cited:
**EP-A1- 2 246 862**
**WO-A1-2017/190345**
**CN-A- 102 986 050**
**US-A1- 2009 242 878**
**US-A1- 2015 349 260**

- **WANG ZHEN ET AL: "From Alloy-Like to Cascade Blended Structure: Designing High-Performance All-Small-Molecule Ternary Solar Cells", JOURNAL OF THE AMERICAN CHEMICAL SOCIETY, [Online] vol. 140, no. 4, 31 January 2018 (2018-01-31), pages 1549-1556, XP055889904, ISSN: 0002-7863, DOI: 10.1021/jacs.7b13054 Retrieved from the Internet: URL:https://pubs.acs.org/doi/pdf/10.1021/jacs.7b13054> [retrieved on 2022-02-09]**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 794 650 B1

**Description**

Technical Field

The invention relates to novel organic semiconducting (OSC) compounds containing one or more ester-substituted 4,8-dithiophenyl-benzodithiophene units or derivatives thereof, to methods for their preparation and educts or intermediates used therein, to compositions and formulations containing them, to the use of the compounds and compositions as organic semiconductors in, or for the preparation of, organic electronic (OE) devices, especially organic photovoltaic (OPV) devices, perovskite-based solar cell (PSC) devices, organic photodetectors (OPD), organic field effect transistors (OFET) and organic light emitting diodes (OLED), and to OE devices comprising these compounds or compositions.

Background

In recent years, there has been development of OSC materials in order to produce more versatile, lower cost electronic devices. Such materials find application in a wide range of devices or apparatus, including organic field effect transistors (OFETs), organic light emitting diodes (OLEDs), organic photodetectors (OPDs), organic photovoltaic (OPV) cells, perovskite-based solar cell (PSC) devices, sensors, memory elements and logic circuits to name just a few. The OSC materials are typically present in the electronic device in the form of a thin layer, for example of between 50 and 300 nm thickness.

OSC materials are receiving ever-growing attention mostly due to their lucrative commercial prospects in organic electronics manufactured by cost effective solution processing technology at low temperature. It is generally believed that OSCs have a number of advantage over their inorganic counterparts, such as the potential of fabricating lightweight flexible backplanes, the opportunity to make large area displays using lowcost, high speed solution based fabrication techniques, and their optical and electronic properties being fine-tuneable via rational chemical structure modifications.

One particular area of importance is organic photovoltaics (OPV). Conjugated OSC polymers and OSC small molecules have found use in OPVs, mainly in the photoactive layer, as they allow devices to be manufactured by solution-processing techniques such as spin casting, dip coating or inkjet printing. Solution processing can be carried out cheaper and on a larger scale compared to the evaporative techniques used to make inorganic thin film devices. Currently, polymer based photovoltaic devices are achieving efficiencies above 1 0%.

In photoactive layers containing a blend of an n-type OSC and a p-type OSC, typically a $\pi$-conjugated polymer, forming a bulk-heterojunction (BHJ), the $\pi$-conjugated polymer serves as the main absorber of the solar energy. Therefore a low band gap is a basic requirement for the polymer to absorb the maximum of the solar spectrum.

Thus, for use as donor OSC in OPV cells and OPDs, the conjugated polymer should have a low bandgap, which enables improved light harvesting by the photoactive layer and can lead to higher power conversion efficiency.

Polymerising $\pi$-$\pi$-donor-acceptor (D-A) monomers to synthesize D-A copolymers through transition metal catalysed polycondensation is a known strategy to achieve low bandgap semiconducting polymers for OPV and OPD applications. Conjugated D-A copolymers have also been found to demonstrate high charge carrier mobilities in OTFTs. It is generally accepted that the alternating D-A structure facilitates stronger intermolecular interactions, leading to smaller $\pi$-$\pi$-stacking distance and efficient intermolecular charge transfer due to static attractions between the donor and the acceptor monomer units.

Another particular area of importance are OFETs. The performance of OFET devices is principally based upon the charge carrier mobility of the semiconducting material and the current on/off ratio, so the ideal semiconductor should have a low conductivity in the off state, combined with high charge carrier mobility ($> 1 \times 10^{-1}$ $cm^2$ $V^{-1}$ $s^{-1}$). In addition, it is important that the semiconducting material is stable to oxidation *i.e.* it has a high ionisation potential, as oxidation leads to reduced device performance, like for example increased off current and threshold voltage shift. Further requirements for the semiconducting material are good processibility, especially for large-scale production of thin layers and desired patterns, and high stability, film uniformity and integrity of the organic semiconductor layer.

Organic photodetectors (OPDs) are a further particular area of importance, for which conjugated light-absorbing polymers offer the hope of allowing efficient devices to be produced by solution-processing technologies, such as spin casting, dip coating or inkjet printing, to name a few only.

The photosensitive layer in an OPV or OPD device is usually composed of at least two materials, a p-type semiconductor, which is typically a conjugated polymer, an oligomer or a defined molecular unit, and an n-type semiconductor, which is typically a fullerene or substituted fullerene, graphene, a metal oxide, or quantum dots.

However, the OSC materials disclosed in prior art for use in OE devices do still have several drawbacks, such as poor solubility in solvents suitable for mass production, relatively low device performance such as inadequate charge-carrier mobility for commercial application for example in transistors, modest thermal, photo and electrical stability, poor long term stability and non-reproducible film forming properties. In addition, other OSC materials do not often form a

favourable morphology and/or donor phase miscibility for use in organic photovoltaics or organic photodetectors.

Therefore there is still a need for OSC materials for use in OE devices like OPVs, OPDs and OFETs, which have advantageous properties, in particular good processibility, high solubility in organic solvents, good structural organization and film-forming properties. In addition, the OSC materials should be easy to synthesize, especially by methods suitable for mass production. For use in OPV cells, the OSC materials should especially have a low bandgap, which enables improved light harvesting by the photoactive layer and can lead to higher cell efficiencies, high stability and long lifetime. For use in OFETs the OSC materials should especially have high charge-carrier mobility, high on/off ratio in transistor devices, high oxidative stability and long lifetime.

It was an aim of the present invention to provide new OSC compounds, including p-type and n-type OSCs, which can overcome the drawbacks of the OSCs from prior art, and which provide one or more of the above-mentioned advantageous properties, especially easy synthesis by methods suitable for mass production, good processibility, high stability, long lifetime in OE devices, good solubility in organic solvents, high charge carrier mobility, and a low bandgap. Another aim of the invention was to extend the pool of OSC materials and p-type and n-type OSCs available to the expert. Other aims of the present invention are immediately evident to the expert from the following detailed description.

The inventors of the present invention have found that one or more of the above aims can be achieved by providing oligomers and polymers as disclosed and claimed hereinafter, which contain an ester-substituted 4,8-dithiophenyl-benzodithiophene unit as shown in formula I. It has been found that oligomers and polymers comprising such a unit can be used as OSCs which show advantageous properties as described above. CN105218558A discloses small molecules comprising an ester-substituted 4,8-dithiophenyl-benzodithiophene moiety, but does neither disclose nor suggest the compounds as disclosed and claimed hereinafter.

The document WANG ZHEN ET AL: "From Alloy-Like to Cascade Blended Structure: Designing High-Performance All-Small-Molecule Ternary Solar Cells",J. Am. Chem.Soc., vol. 140, no. 4, 31 January 2018 (2018-01-31), pages 1549-1556, discloses an ester substituted small molecule thiophene derivative for the use in organic solar cells.

<u>Summary</u>

The invention relates to a compound comprising two or more repeating units, at least one of which is, preferably at least two of which are, selected of formula I

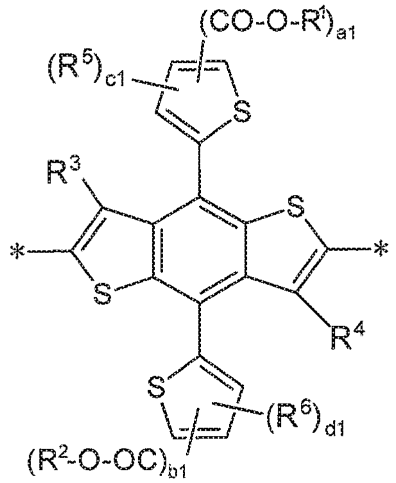

I

wherein the individual radicals, independently of each other and on each occurrence identically or differently, have the following meanings

$R^1$, $R^2$ straight-chain, branched or cyclic alkyl with 1 to 30, preferably 1 to 20, C atoms, in which one or more $CH_2$ groups are optionally replaced by -O-, -S-, -C(=O)-, -C(=S)-, -C(=O)-O-, -O-C(=O)-,-$NR^0$-, -$SiR^0R^{00}$-, -$CF_2$-, -$CR^0$=$CR^{00}$-, -$CY^1$=$CY^2$- or -C=C- in such a manner that O and/or S atoms are not linked directly to one another, and in which one or more H atoms are optionally replaced by F, C!, Br, I or CN, and in which one or more $CH_2$ or $CH_3$ groups are optionally replaced by a cationic or anionic group, or aryl, heteroaryl, arylalkyl or heteroarylalkyl, wherein each of the aforementioned cyclic groups has 5 to 20 ring atoms, is mono- or polycyclic, does optionally contain fused rings, and is unsubstituted or substituted by one or more identical or different groups L,

| | |
|---|---|
| $R^{3-6}$ | H, F, Cl, CN, or straight-chain, branched or cyclic alkyl with 1 to 30, preferably 1 to 20, C atoms, in which one or more $CH_2$ groups are optionally replaced by -O-, -S-, -C(=O)-, -C(=S)-, -C(=O)-O-, -O-C(=O)-, $-NR^0-$, $-SiR^0R^{00}-$, $-CF_2-$, $-CR^0=CR^{00}-$, $-CY^1=CY^2-$ or -C≡C-in such a manner that O and/or S atoms are not linked directly to one another, and in which one or more H atoms are optionally replaced by F, Cl, Br, I or CN, and in which one or more $CH_2$ or $CH_3$ groups are optionally replaced by a cationic or anionic group, or aryl, heteroaryl, arylalkyl, heteroarylalkyl, aryloxy or heteroaryloxy, wherein each of the aforementioned cyclic groups has 5 to 20 ring atoms, is mono- or polycyclic, does optionally contain fused rings, and is unsubstituted or substituted by one or more identical or different groups L, |
| L | F, Cl, -CN, -NC, -NCO, -NCS, -OCN, -SCN, $R^0$, $OR^0$, $SR^0$,$-C(=O)X^0$, $-C(=O)R^0$, $-C(=O)-OR^0$, $-O-C(=O)-R^0$, $-NH_2$, $-NHR^0$,$-NR^0R^{00}$, $-C(=O)NHR^0$, $-C(=O)NR^0R^{00}$, $-SO_3R^0$, $-SO_2R^0$, -OH, $-NO_2$, $-CF_3$, $-SF_5$, or optionally substituted silyl, or carbyl or hydrocarbyl with with 1 to 30, preferably 1 to 20 C atoms that is optionally substituted and optionally comprises one or more hetero atoms, preferably F, -CN, $R^0$, $-OR^0$, $-SR^0$, $-C(=O)-R^0$, $-C(=O)-OR^0$, $-O-C(=O)-R^0$, $-O-C(=O)-OR^0$, $-C(=O)-NHR^0$, $-C(=O)-NR^0R^{00}$, |
| $Y^1$,$Y^2$ | H, F, Cl or CN, |
| $X^0$ | halogen, preferably F or Cl, |
| $R^0$, $R^{00}$ | H or straight-chain or branched alkyl with 1 to 20, preferably 1 to 12, C atoms that is optionally fluorinated, |
| a1, b1 | 0, 1 or 2, wherein a1+b1>0, |
| c1, d1 | 0, 1 or 2, wherein a1+c1≤3 and b1+d1≤3. |

A compound comprising two or more repeating units, at least one of which is, preferably at least two of which are, selected of formula I or its subformulae, is hereinafter also referred to as "compound according to the (present) invention".

The invention further relates to a compound according to the present invention which is a conjugated polymer.

The invention further relates to a compound according to the present invention, which is a conjugated polymer comprising two or more repeating units selected from formula I or its subformulae.

The invention further relates to a compound according to the present invention which is a conjugated oligomer or polymer comprising one or more, preferably two or more, units of formula I or its subformulae, and one or more addditional units selected form the group consisting of C=C double bonds that are optionally substituted by F, Cl or CN, C≡C triple bonds, and arylene or heteroarylene units that are different from formula I and its subformulae, have from 5 to 20 ring atoms, are mono- or polycyclic, do optionally contain fused rings, and are unsubstituted or substituted by one or more identical or different groups L as defined in formula I.

The invention further relates to a conjugated oligomer or polymer as described above wherein one or more of these additional arylene or heteroarylene units have electron donor property. The invention further relates to a conjugated oligomer or polymer as described above wherein one or more of these additional arylene or heteroarylene units have electron acceptor property.

The invention further relates to a compound according to the present invention which is a monomer comprising a divalent unit of formula I or its subformulae, optionally further comprising one or more additional arylene or heteroarylene units, and further comprising one or more reactive groups which can be reacted to form a conjugated polymer as described above and below.

The invention further relates to the use of a compound according to the present invention as electron donor or p-type semiconductor, or as electron acceptor or n-type semiconductor.

The invention further relates to the use of a compound according to the present invention as electron donor or electron acceptor component in a semiconducting material, formulation, polymer blend, device or component of a device.

The invention further relates to a semiconducting material, formulation, polymer blend, device or component of a device comprising a compound according to the present invention as electron donor component, and preferably further comprising one or more compounds having electron acceptor properties.

The invention further relates to a semiconducting material, formulation, polymer blend, device or component of a device comprising a compound according to the present invention as electron acceptor component, and preferably further comprising one or more compounds having electron donor properties.

The invention further relates to a composition, which may also be a polymer blend, comprising one or more compounds according to the present invention, and further comprising one or more additional compounds selected from compounds having one or more of semiconducting, charge transport, hole or electron transport, hole or electron blocking,

electrically conducting, photoconducting or light emitting properties.

The invention further relates to a composition comprising one or more compounds according to the present invention, and further comprising one or more n-type organic semiconductors, preferably selected from fullerenes or substituted fullerenes.

The invention further relates to a composition comprising a compound according to the present invention, and further comprising one or more electron donors or p-type semiconductors, preferably selected from conjugated polymers.

The invention further relates to a composition comprising a first n-type semiconductor which is a compound according to the present invention, a second n-type semiconductor, which is preferably a fullerene or fullerene derivative, and a p-type semiconductor, which is a conjugated polymer.

The invention further relates to a bulk heterojunction (BHJ) formed from a composition comprising a compound according to the present invention as electron acceptor or n-type semiconductor, and one or more compounds which are electron donor or p-type semiconductors and are preferably selected from conjugated polymers.

The invention further relates to a formulation comprising one or more compounds or a composition according to the present invention, and further comprising one or more solvents, preferably selected from organic solvents.

The invention further relates to an organic semiconducting formulation comprising one or more compounds according to the present invention, and further comprising one or more organic binders or precursors thereof, preferably having a permittivity $\varepsilon$ at 1,000 Hz and 20°C of 3.3 or less, and optionally one or more solvents preferably selected from organic solvents.

The invention further relates to an optical, electrooptical, electronic, electroluminescent or photoluminescent device, or a component thereof, or an assembly comprising it, which is prepared using a formulation according to the present invention.

The invention further relates to the use of a compound or composition according to the present invention as semiconducting, charge transport, electrically conducting, photoconducting or light emitting material, or in an optical, electrooptical, electronic, electroluminescent or photoluminescent device, or in a component of such a device or in an assembly comprising such a device or component

The invention further relates to a semiconducting, charge transport, electrically conducting, photoconducting or light emitting material comprising a compound or composition according to the present invention.

The invention further relates to an optical, electrooptical, electronic, electroluminescent or photoluminescent device, or a component thereof, or an assembly comprising it, which comprises a compound or composition according to the present invention, or comprises a semiconducting, charge transport, electrically conducting, photoconducting or light emitting material according to the present invention.

The optical, electrooptical, electronic, electroluminescent and photoluminescent device includes, without limitation, organic field effect transistors (OFET), organic thin film transistors (OTFT), organic light emitting diodes (OLED), organic light emitting transistors (OLET), organic photovoltaic devices (OPV), organic photodetectors (OPD), organic solar cells, dye-sensitized solar cells (DSSC), perovskite-based solar cells (PSC), laser diodes, Schottky diodes, photoconductors and photodetectors.

Preferred devices are OFETs, OTFTs, OPVs, PSCs, OPDs and OLEDs, in particular OTFTs, PSCs, OPDs and bulk heterojunction (BHJ) OPVs or inverted BHJ OPVs.

Further preferred is the use of a compound or composition according to the present invention as dye in a DSSC or a PSC. Further preferred is a DSSC or PSC comprising a compound or composition according to the present invention.

The component of the above devices includes, without limitation, charge injection layers, charge transport layers, interlayers, planarising layers, antistatic films, polymer electrolyte membranes (PEM), conducting substrates and conducting patterns.

The assembly comprising such a device or component includes, without limitation, integrated circuits (IC), radio frequency identification (RFID) tags or security markings or security devices containg them, flat panel displays or backlights thereof, electrophotographic devices, electrophotographic recording devices, organic memory devices, sensor devices, biosensors and biochips.

In addition the compounds, compositions and formulations of the present invention can be used as electrode materials in batteries and in components or devices for detecting and discriminating DNA sequences.

The invention further relates to a bulk heterojunction which comprises, or is being formed from, a composition comprising one or more compounds according to the present invention and one or more n-type organic semiconductors that are preferably selected from fullerenes or substituted fullerenes. The invention further relates to a bulk heterojunction (BHJ) OPV device or inverted BHJ OPV device, comprising such a bulk heterojunction.

## Terms and Definitions

As used herein, the term "polymer" will be understood to mean a molecule of high relative molecular mass, the structure of which essentially comprises multiple repetitions of units derived, actually or conceptually, from molecules

of low relative molecular mass (Pure Appl. Chem., 1996, 68, 2291). The term "oligomer" will be understood to mean a molecule of intermediate relative molecular mass, the structure of which essentially comprises a small plurality of units derived, actually or conceptually, from molecules of lower relative molecular mass (Pure Appl. Chem., 1996, 68, 2291). In a preferred meaning as used herein present invention a polymer will be understood to mean a compound having > 1, i.e. at least 2 repeat units, preferably ≥ 5, very preferably ≥10, repeat units, and an oligomer will be understood to mean a compound with > 1 and < 10, preferably < 5, repeat units.

Further, as used herein, the term "polymer" will be understood to mean a molecule that encompasses a backbone (also referred to as "main chain") of one or more distinct types of repeat units (the smallest constitutional unit of the molecule) and is inclusive of the commonly known terms "oligomer", "copolymer", "homopolymer", "random polymer" and the like. Further, it will be understood that the term polymer is inclusive of, in addition to the polymer itself, residues from initiators, catalysts and other elements attendant to the synthesis of such a polymer, where such residues are understood as not being covalently incorporated thereto. Further, such residues and other elements, while normally removed during post polymerization purification processes, are typically mixed or co-mingled with the polymer such that they generally remain with the polymer when it is transferred between vessels or between solvents or dispersion media.

As used herein, in a formula showing a polymer or a repeat unit an asterisk (*) will be understood to mean a chemical linkage, usually a single bond, to an adjacent unit or to a terminal group in the polymer backbone. In a ring, like for example a benzene or thiophene ring, an asterisk (*) will be understood to mean a C atom that is fused to an adjacent ring.

As used herein, in a formula showing a ring, a polymer or a repeat unit a dashed line (-----) will be understood to mean a single bond.

As used herein, the terms "repeat unit", "repeating unit" and "monomeric unit" are used interchangeably and will be understood to mean the constitutional repeating unit (CRU), which is the smallest constitutional unit the repetition of which constitutes a regular macromolecule, a regular oligomer molecule, a regular block or a regular chain (Pure Appl. Chem., 1996, 68, 2291). As further used herein, the term "unit" will be understood to mean a structural unit which can be a repeating unit on its own, or can together with other units form a constitutional repeating unit.

As used herein, a "terminal group" will be understood to mean a group that terminates a polymer backbone. The expression "in terminal position in the backbone" will be understood to mean a divalent unit or repeat unit that is linked at one side to such a terminal group and at the other side to another repeat unit. Such terminal groups include endcap groups, or reactive groups that are attached to a monomer forming the polymer backbone which did not participate in the polymerization reaction, like for example a group having the meaning of $R^{31}$ or $R^{32}$ as defined below.

As used herein, the term "endcap group" will be understood to mean a group that is attached to, or replacing, a terminal group of the polymer backbone. The endcap group can be introduced into the polymer by an endcapping process. Endcapping can be carried out for example by reacting the terminal groups of the polymer backbone with a monofunctional compound ("endcapper") like for example an alkyl- or aryl halide, an alkyl- or arylstannane or an alkyl- or arylboronate. The endcapper can be added for example after the polymerization reaction. Alternatively the endcapper can be added in situ to the reaction mixture before or during the polymerization reaction. In situ addition of an endcapper can also be used to terminate the polymerization reaction and thus control the molecular weight of the forming polymer. Typical endcap groups are for example H, phenyl and lower alkyl.

As used herein, the term "small molecule" will be understood to mean a monomeric compound which typically does not contain a reactive group by which it can be reacted to form a polymer, and which is designated to be used in monomeric form. In contrast thereto, the term "monomer" unless stated otherwise will be understood to mean a monomeric compound that carries one or more reactive functional groups by which it can be reacted to form a polymer.

As used herein, the terms "donor" or "donating" and "acceptor" or "accepting" will be understood to mean an electron donor or electron acceptor, respectively. "Electron donor" will be understood to mean a chemical entity that donates electrons to another compound or another group of atoms of a compound. "Electron acceptor" will be understood to mean a chemical entity that accepts electrons transferred to it from another compound or another group of atoms of a compound. See also International Union of Pure and Applied Chemistry, Compendium of Chemical Technology, Gold Book, Version 2.3.2, 19. August 2012, pages 477 and 480.

As used herein, the term "n-type" or "n-type semiconductor" will be understood to mean an extrinsic semiconductor in which the conduction electron density is in excess of the mobile hole density, and the term "p-type" or "p-type semiconductor" will be understood to mean an extrinsic semiconductor in which mobile hole density is in excess of the conduction electron density (see also, J. Thewlis, Concise Dictionary of Physics, Pergamon Press, Oxford, 1973).

As used herein, the term "leaving group" will be understood to mean an atom or group (which may be charged or uncharged) that becomes detached from an atom in what is considered to be the residual or main part of the molecule taking part in a specified reaction (see also Pure Appl. Chem., 1994, 66, 1134).

As used herein, the term "conjugated" will be understood to mean a compound (for example a polymer) that contains mainly C atoms with $sp^2$-hybridization (or optionally also sp-hybridization), and wherein these C atoms may also be replaced by hetero atoms. In the simplest case this is for example a compound with alternating C-C single and

double (or triple) bonds, but is also inclusive of compounds with aromatic units like for example 1 ,4-phenylene. The term "mainly" in this connection will be understood to mean that a compound with naturally (spontaneously) occurring defects, or with defects included by design, which may lead to interruption of the conjugation, is still regarded as a conjugated compound.

As used herein, unless stated otherwise the molecular weight is given as the number average molecular weight $M_n$ or weight average molecular weight $M_W$, which is determined by gel permeation chromatography (GPC) against polystyrene standards in eluent solvents such as tetrahydrofuran, trichloromethane (TCM, chloroform), chlorobenzene or 1,2,4-trichlorobenzene. Unless stated otherwise, chlorobenzene is used as solvent. The degree of polymerization, also referred to as total number of repeat units, n, will be understood to mean the number average degree of polymerization given as $n = M_n/M_U$, wherein $M_n$ is the number average molecular weight and $M_U$ is the molecular weight of the single repeat unit, see J. M. G. Cowie, Polymers: Chemistry & Physics of Modern Materials, Blackie, Glasgow, 1991.

As used herein, the term "carbyl group" will be understood to mean any monovalent or multivalent organic moiety which comprises at least one carbon atom either without any non-carbon atoms (like for example -C≡C-), or optionally combined with at least one non-carbon atom such as B, N, O, S, P, Si, Se, As, Te or Ge (for example carbonyl etc.).

As used herein, the term "hydrocarbyl group" will be understood to mean a carbyl group that does additionally contain one or more H atoms and optionally contains one or more hetero atoms like for example B, N, O, S, P, Si, Se, As, Te or Ge.

As used herein, the term "hetero atom" will be understood to mean an atom in an organic compound that is not a H- or C-atom, and preferably will be understood to mean B, N, O, S, P, Si, Se, Sn, As, Te or Ge.

A carbyl or hydrocarbyl group comprising a chain of 3 or more C atoms may be straight-chain, branched and/or cyclic, and may include spiro-connected and/or fused rings.

Preferred carbyl and hydrocarbyl groups include alkyl, alkoxy, thioalkyl, alkylcarbonyl, alkoxycarbonyl, alkylcarbonyloxy and alkoxycarbonyloxy, each of which is optionally substituted and has up to 40, preferably up to 25, very preferably up to 18 C atoms, furthermore optionally substituted aryl or aryloxy having 6 to 40, preferably 6 to 25 C atoms, furthermore alkylaryloxy, arylcarbonyl, aryloxycarbonyl, arylcarbonyloxy and aryloxycarbonyloxy, each of which is optionally substituted and has 1 to 40, preferably 6 to 40 C atoms, wherein each of these groups optionally contains one or more hetero atoms, preferably selected from B, N, O, S, P, Si, Se, As, Te and Ge.

Further preferred carbyl and hydrocarbyl group include for example: a $C_1$-$C_{40}$ alkyl group, a $C_1$-$C_{40}$ fluoroalkyl group, a $C_1$-$C_{40}$ alkoxy or oxaalkyl group, a $C_2$-$C_{40}$ alkenyl group, a $C_2$-$C_{40}$ alkynyl group, a $C_3$-$C_{40}$ allyl group, a $C_4$-$C_{40}$ alkyldienyl group, a $C_4$-$C_{40}$ polyenyl group, a $C_2$-$C_{40}$ ketone group, a $C_2$-$C_{40}$ ester group, a $C_6$-$C_{18}$ aryl group, a $C_6$-$C_{40}$ alkylaryl group, a $C_6$-$C_{40}$ arylalkyl group, a $C_4$-$C_{40}$ cycloalkyl group, a $C_4$-$C_{40}$ cycloalkenyl group, and the like. Preferred among the foregoing groups are a $C_1$-$C_{20}$ alkyl group, a $C_1$-$C_{20}$ fluoroalkyl group, a $C_2$-$C_{20}$ alkenyl group, a $C_2$ -$C_{20}$ alkynyl group, a $C_3$-$C_{20}$ allyl group, a $C_4$-$C_{20}$ alkyldienyl group, a $C_2$-$C_{20}$ ketone group, a $C_2$-$C_{20}$ ester group, a $C_6$-$C_{12}$ aryl group, and a $C_4$-$C_{20}$ polyenyl group, respectively.

Also included are combinations of groups having carbon atoms and groups having hetero atoms, like e.g. an alkynyl group, preferably ethynyl, that is substituted with a silyl group, preferably a trialkylsilyl group.

The carbyl or hydrocarbyl group may be an acyclic group or a cyclic group. Where the carbyl or hydrocarbyl group is an acyclic group, it may be straight-chain or branched. Where the carbyl or hydrocarbyl group is a cyclic group, it may be a non-aromatic carbocyclic or heterocyclic group, or an aryl or heteroaryl group.

A non-aromatic carbocyclic group as referred to above and below is saturated or unsaturated and preferably has 4 to 30 ring C atoms. A non-aromatic heterocyclic group as referred to above and below preferably has 4 to 30 ring C atoms, wherein one or more of the C ring atoms are each optionally replaced by a hetero atom, preferably selected from N, O, P, S, Si and Se, or by a -S(O)- or $-S(O)_2-$ group. The non-aromatic carbo- and heterocyclic groups are mono- or polycyclic, may also contain fused rings, preferably contain 1, 2, 3 or 4 fused or unfused rings, and are optionally substituted with one or more groups L.

L is selected from F, Cl, -CN, $-NO_2$, -NC, -NCO, -NCS, -OCN, -SCN, $-R^0$, - $OR^0$, $-SR^0$, $-C(=O)X^0$, $-C(=O)R^0$, $-C(=O)-OR^0$, $-O-C(=O)-R^0$, $-NH_2$, $-NHR^0$, - $NR^0R^{00}$, $-C(=O)NHR^0$, $-C(=O)NR^0R^{00}$, $-SO_3R^0$, $-SO_2R^0$, -OH, $-CF_3$, $-SF_5$, or optionally substituted silyl, or carbyl or hydrocarbyl with 1 to 30, preferably 1 to 20 C atoms that is optionally substituted and optionally comprises one or more hetero atoms, wherein $X^0$ is halogen, preferably F or Cl, and $R^0$, $R^{00}$ each independently denote H or straight-chain or branched alkyl with 1 to 20, preferably 1 to 12 C atoms that is optionally fluorinated.

Preferably L is selected from F, -CN, $R^0$, $-OR^0$, $-SR^0$, $-C(=O)-R^0$, $-C(=O)-OR^0$, $-O-C(=O)-R^0$, $-O-C(=O)-OR^0$, $-C(=O)-NHR^0$ and $-C(=O)-NR^0R^{00}$.

Further preferably L is selected from F or alkyl, alkoxy, oxaalkyl, thioalkyl, fluoroalkyl, fluoroalkoxy, alkylcarbonyl, alkoxycarbonyl, with 1 to 16 C atoms, or alkenyl or alkynyl with 2 to 16 C atoms.

Preferred non-aromatic carbocyclic or heterocyclic groups are tetrahydrofuran, indane, pyran, pyrrolidine, piperidine, cyclopentane, cyclohexane, cycloheptane, cyclopentanone, cyclohexanone, dihydrofuran-2-one, tetrahydro-pyran-2-one and oxepan-2-one.

An aryl group as referred to above and below preferably has 4 to 30, very preferably 5 to 20, ring C atoms, is mono- or polycyclic and may also contain fused rings, preferably contains 1, 2, 3 or 4 fused or unfused rings, and is optionally substituted with one or more groups L as defined above.

A heteroaryl group as referred to above and below preferably has 4 to 30, very preferably 5 to 20, ring C atoms, wherein one or more of the ring C atoms are replaced by a hetero atom, preferably selected from N, O, S, Si and Se, is mono- or polycyclic and may also contain fused rings, preferably contains 1, 2, 3 or 4 fused or unfused rings, and is optionally substituted with one or more groups L as defined above.

An arylalkyl or heteroarylalkyl group as referred to above and below preferably denotes $-(CH_2)_a$-aryl or $-(CH_2)_a$-heteroaryl, wherein a is an integer from 1 to 6, preferably 1, and "aryl" and "heteroaryl" have the meanings given above and below. A preferred arylalkyl group is benzyl which is optionally substituted by L.

As used herein, "arylene" will be understood to mean a divalent aryl group, and "heteroarylene" will be understood to mean a divalent heteroaryl group, including all preferred meanings of aryl and heteroaryl as given above and below.

Preferred aryl and heteroaryl groups are phenyl in which, in addition, one or more CH groups may each be replaced by N, naphthalene, thiophene, selenophene, thienothiophene, dithienothiophene, fluorene and oxazole, all of which can be unsubstituted, mono- or polysubstituted with L as defined above. Very preferred aryl and heteroaryl groups are selected from phenyl, pyrrole, preferably N-pyrrole, furan, pyridine, preferably 2- or 3-pyridine, pyrimidine, pyridazine, pyrazine, triazole, tetrazole, pyrazole, imidazole, isothiazole, thiazole, thiadiazole, isoxazole, oxazole, oxadiazole, thiophene, preferably 2-thiophene, selenophene, preferably 2-selenophene, 2,5-dithiophene-2',5'-diyl, thieno[3,2-b]thiophene, thieno[2,3-b]thiophene, furo[3,2-b]furan, furo[2,3-b]furan, seleno[3,2-b]selenophene, seleno[2,3-b]selenophene, thieno[3,2-b]selenophene, thieno[3,2-b]furan, indole, isoindole, benzo[b]furan, benzo[b]thiophene, benzo[1,2-b;4,5-b']dithiophene, benzo[2,1-b;3,4-b']dithiophene, quinole, 2- methylquinole, isoquinole, quinoxaline, quinazoline, benzotriazole, benzimidazole, benzothiazole, benzisothiazole, benzisoxazole, benzoxadiazole, benzoxazole, benzothiadiazole, 4H-cyclopenta[2,1-b;3,4-b']dithiophene, 7H-3,4-dithia-7-sila-cyclopenta[a]pentalene, all of which can be unsubstituted, mono- or polysubstituted with L as defined above. Further examples of aryl and heteroaryl groups are those selected from the groups shown hereinafter.

An alkyl group or an alkoxy group, *i.e.*, where the terminal $CH_2$ group is replaced by -O-, can be straight-chain or branched. Particularly preferred straight-chains have 2, 3, 4, 5, 6, 7, 8, 12 or 16 carbon atoms and accordingly denote preferably ethyl, propyl, butyl, pentyl, hexyl, heptyl, octyl, dodecyl or hexadecyl, ethoxy, propoxy, butoxy, pentoxy, hexoxy, heptoxy, octoxy, dodecoxy or hexadecoxy, furthermore methyl, nonyl, decyl, undecyl, tridecyl, tetradecyl, pentadecyl, nonoxy, decoxy, undecoxy, tridecoxy or tetradecoxy, for example.

An alkenyl group, *i.e.*, wherein one or more $CH_2$ groups are each replaced by -CH=CH- can be straight-chain or branched. It is preferably straight-chain, has 2 to 10 C atoms and accordingly is preferably vinyl, prop-1-, or prop-2-enyl, but-1-, 2- or but-3-enyl, pent-1-, 2-, 3- or pent-4-enyl, hex-1-, 2-, 3-, 4- or hex-5-enyl, hept-1-, 2-, 3-, 4-, 5- or hept-6-enyl, oct-1-, 2-, 3-, 4-, 5-, 6- or oct-7-enyl, non-1-, 2-, 3-, 4-, 5-, 6-, 7- or non-8-enyl, dec-1-, 2-, 3-, 4-, 5-, 6-, 7-, 8- or dec-9-enyl.

Especially preferred alkenyl groups are $C_2$-$C_7$-1E-alkenyl, $C_4$-$C_7$-3E-alkenyl, $C_5$-$C_7$-4-alkenyl, $C_6$-$C_7$-5-alkenyl and $C_7$-6-alkenyl, in particular $C_2$-$C_7$-1E-alkenyl, $C_4$-$C_7$-3E-alkenyl and $C_5$-$C_7$-4-alkenyl. Examples for particularly preferred alkenyl groups are vinyl, 1E-propenyl, 1E-butenyl, 1E-pentenyl, 1E-hexenyl, 1E-heptenyl, 3-butenyl, 3E-pentenyl, 3E-hexenyl, 3E-heptenyl, 4-pentenyl, 4Z-hexenyl, 4E-hexenyl, 4Z-heptenyl, 5-hexenyl, 6-heptenyl and the like. Groups having up to 5 C atoms are generally preferred.

An oxaalkyl group, *i.e.*, where one $CH_2$ group is replaced by -O-, can be straight-chain. Particularly preferred straight-chains are 2-oxapropyl (=methoxymethyl), 2- (=ethoxymethyl) or 3-oxabutyl (=2-methoxyethyl), 2-, 3-, or 4-oxapentyl, 2-, 3-, 4-, or 5-oxahexyl, 2-, 3-, 4-, 5-, or 6-oxaheptyl, 2-, 3-, 4-, 5-, 6- or 7-oxaoctyl, 2-, 3-, 4-, 5-, 6-, 7- or 8-oxanonyl or 2-, 3-, 4-, 5-, 6-,7-, 8- or 9-oxadecyl, for example.

In an alkyl group wherein one $CH_2$ group is replaced by -O- and one $CH_2$ group is replaced by -C(O)-, these radicals are preferably neighboured. Accordingly these radicals together form a carbonyloxy group -C(O)-O- or an oxycarbonyl group -O-C(O)-. Preferably this group is straight-chain and has 2 to 6 C atoms. It is accordingly preferably acetyloxy, propionyloxy, butyryloxy, pentanoyloxy, hexanoyloxy, acetyloxymethyl, propionyloxymethyl, butyryloxymethyl, pentanoyloxymethyl, 2-acetyloxyethyl, 2-propionyloxyethyl, 2-butyryloxyethyl, 3-acetyloxypropyl, 3-propionyloxypropyl, 4-acetyloxybutyl, methoxycarbonyl, ethoxycarbonyl, propoxycarbonyl, butoxycarbonyl, pentoxycarbonyl, methoxycarbonylmethyl, ethoxycarbonylmethyl, propoxycarbonylmethyl, butoxycarbonylmethyl, 2-(methoxycarbonyl)ethyl, 2-(ethoxycarbonyl)ethyl, 2-(propoxycarbonyl)ethyl, 3-(methoxycarbonyl)propyl, 3-(ethoxycarbonyl)propyl or 4-(methoxycarbonyl)-butyl.

An alkyl group wherein two or more $CH_2$ groups are replaced by -O-and/or -C(O)O- can be straight-chain or branched. It is preferably straight-chain and has 3 to 12 C atoms. Accordingly, it is preferably bis-carboxymethyl, 2,2-bis-carboxy-ethyl, 3,3-bis-carboxy-propyl, 4,4-bis-carboxy-butyl, 5,5-bis-carboxy-pentyl, 6,6-bis-carboxy-hexyl, 7,7-bis-carboxy-heptyl, 8,8-bis-carboxy-octyl, 9,9-bis-carboxy-nonyl, 10,10-bis-carboxy-decyl, bis-(methoxycarbonyl)-methyl,

2,2-bis-(methoxycarbonyl)-ethyl, 3,3-bis-(methoxycarbonyl)-propyl, 4,4-bis-(methoxycarbonyl)-butyl, 5,5-bis-(methoxycarbonyl)-pentyl, 6,6-bis-(methoxycarbonyl)-hexyl, 7,7-bis-(methoxycarbonyl)-heptyl, 8,8-bis-(methoxycarbonyl)-octyl, bis-(ethoxycarbonyl)-methyl, 2,2-bis-(ethoxycarbonyl)-ethyl, 3,3-bis-(ethoxycarbonyl)-propyl, 4,4-bis-(ethoxycarbonyl)-butyl or 5,5-bis-(ethoxycarbonyl)-hexyl.

A thioalkyl group, *i.e.*, where one $CH_2$ group is replaced by -S-, is preferably straight-chain thiomethyl ($-SCH_3$), 1-thioethyl ($-SCH_2CH_3$), 1-thiopropyl (= $-SCH_2CH_2CH_3$), 1- (thiobutyl), 1-(thiopentyl), 1-(thiohexyl), 1-(thioheptyl), 1-(thiooctyl), 1-(thiononyl), 1-(thiodecyl), 1-(thioundecyl) or 1-(thiododecyl), wherein preferably the $CH_2$ group adjacent to the $sp^2$ hybridized vinyl carbon atom is replaced.

A fluoroalkyl group can be perfluoroalkyl $C_iF_{2i+1}$, wherein i is an integer from 1 to 15, in particular $CF_3$, $C_2F_5$, $C_3F_7$, $C_4F_9$, $C_5F_{11}$, $C_6F_{13}$, $C_7F_{15}$ or $C_8F_{17}$, very preferably $C_6F_{13}$, or partially fluorinated alkyl, preferably with 1 to 15 C atoms, in particular 1,1-difluoroalkyl, all of the aforementioned being straight-chain or branched.

Preferably "fluoroalkyl" means a partially fluorinated (i.e. not perfluorinated) alkyl group.

Alkyl, alkoxy, alkenyl, oxaalkyl, thioalkyl, carbonyl and carbonyloxy groups can be achiral or chiral groups. Particularly preferred chiral groups are 2-butyl (=1-methylpropyl), 2-methylbutyl, 2-methylpentyl, 3-methylpentyl, 2-ethylhexyl, 2-butyloctyl, 2-hexyldecyl, 2-octyldodecyl, 3,7-dimethyloctyl, 3,7,1 1-trimethyldodecyl, 2-propylpentyl, in particular 2-methylbutyl, 2-methylbutoxy, 2-methylpentoxy, 3-methyl-pentoxy, 2-ethyl-hexoxy, 2-butyloctoxyo, 2-hexyldecoxy, 2-octyldodecoxy, 3,7-dimethyloctoxy, 3,7,11-trimethyldodecoxy, 1-methylhexoxy, 2-octyloxy, 2-oxa-3-methylbutyl, 3-oxa-4-methyl-pentyl, 4-methylhexyl, 2-hexyl, 2-octyl, 2-nonyl, 2-decyl, 2-dodecyl, 6-methoxy-octoxy, 6-methyloctoxy, 6-methyloctanoyloxy, 5-methylheptyloxy-carbonyl, 2-methylbutyryloxy, 3-methylvaleroyloxy, 4-methylhexanoyloxy, 2-chloropropionyloxy, 2-chloro-3-methylbutyryloxy, 2-chloro-4-methyl-valeryl-oxy, 2-chloro-3-methylvaleryloxy, 2-methyl-3-oxapentyl, 2-methyl-3-oxa-hexyl, 1-methoxypropyl-2-oxy, 1-ethoxypropyl-2-oxy, 1-propoxypropyl-2-oxy, 1-butoxypropyl-2-oxy, 2-fluorooctyloxy, 2-fluorodecyloxy, 1,1,1-trifluoro-2-octyloxy, 1,1,1-trifluoro-2-octyl and 2-fluoromethyloctyloxy for example. Very preferred are 2-methylbutyl, 2-ethylhexyl, 2-butyloctyl, 2-hexyldecyl, 2-octyldodecyl, 3,7-dimethyloctyl, 3,7,11-trimethyldodecyl, 2-hexyl, 2-octyl, 2-octyloxy, 1,1,1-trifluoro-2-hexyl, 1,1,1-trifluoro-2-octyl and 1,1,1-trifluoro-2-octyloxy.

Preferred achiral branched groups are isopropyl, isobutyl (=methylpropyl), isopentyl (=3-methylbutyl), tert. butyl, isopropoxy, 2-methyl-propoxy and 3-methylbutoxy.

In a preferred embodiment, the substituents on an aryl or heteroaryl ring are independently of each other selected from primary, secondary or tertiary alkyl, alkoxy, oxaalkyl, thioalkyl, alkylcarbonyl or alkoxycarbonyl with 1 to 30 C atoms, wherein one or more H atoms are each optionally replaced by F, or aryl, aryloxy, heteroaryl or heteroaryloxy that is optionally alkylated, alkoxylated, alkylthiolated or esterified and has 4 to 30, preferably 5 to 20, ring atoms. Further preferred substituents are selected from the group consisting of the following formulae

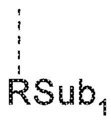
SUB1

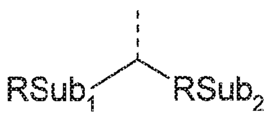
SUB2

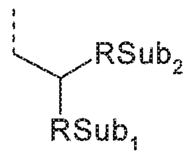
SUB3

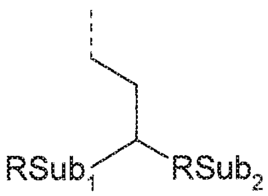
SUB4

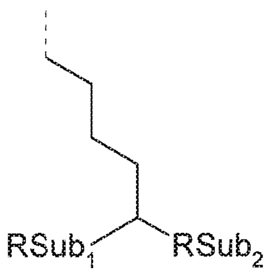
SUB5

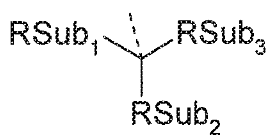
SUB6

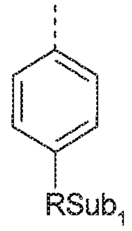

SUB7

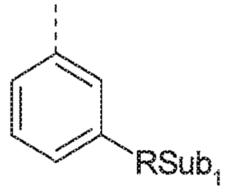

SUB8

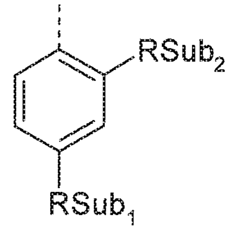

SUB9

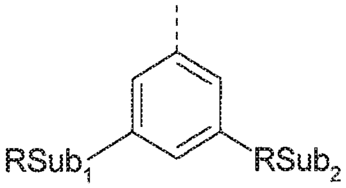

SUB10

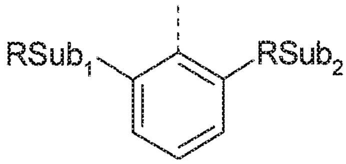

SUB11

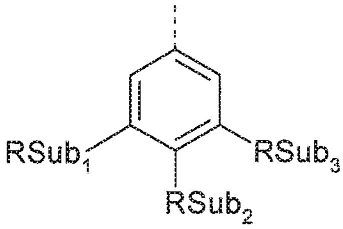

SUB12

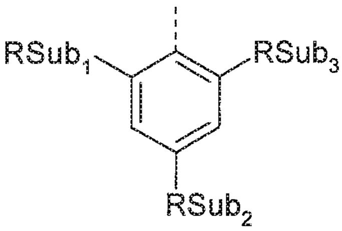

SUB13

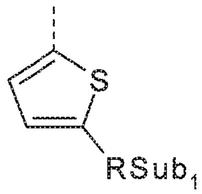

SUB14

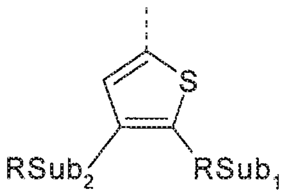

SUB15

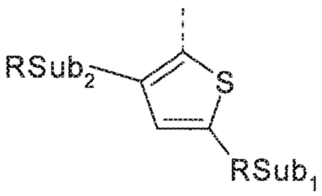

SUB16

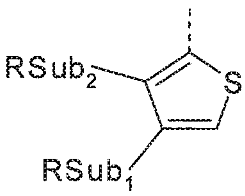

SUB17

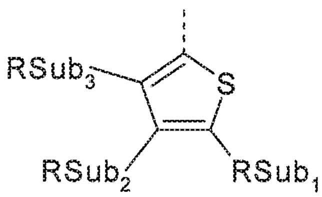

SUB18

wherein $RSub_{1-3}$ each denote L as defined above and below and where at least, preferably all, of $RSub_{1-3}$ is alkyl, alkoxy, oxaalkyl, thioalkyl, alkylcarbonyl or alkoxycarbonyl with up to 24 C atoms, preferably up to 20 C atoms, that is optionally fluorinated, and wherein the dashed line denotes the link to the ring to which these groups are attached. Very preferred among these substituents are those wherein all $RSub_{1-3}$ subgroups are identical.

As used herein, if an aryl(oxy) or heteroaryl(oxy) group is "alkylated or alkoxylated", this means that it is substituted with one or more alkyl or alkoxy groups having from 1 to 24 C-atoms and being straight-chain or branched and wherein one or more H atoms are each optionally substituted by an F atom.

Above and below, $Y^1$ and $Y^2$ are independently of each other H, F, Cl or CN.

As used herein, -CO-, -C(=O)- and -C(O)- will be understood to mean a carbonyl group, i.e. a group having the structure

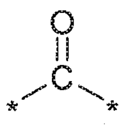

.

As used herein, $C=CR^1R^2$ will be understood to mean a group having the structure

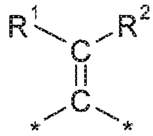

.

As used herein, "halogen" includes F, Cl, Br or I, preferably F, Cl or Br. A halogen atom that represents a substituent on a ring or chain is preferably F or Cl, very preferably F. A halogen atom that represents a reactive group in a monomer or an intermediate is preferably Br or I.

Above and below, the term "mirror image" means a moiety that can be obtained from another moiety by flipping it vertically or horizontally across an external symmetry plane or a symmetry plane extending through the moiety. For example the moiety

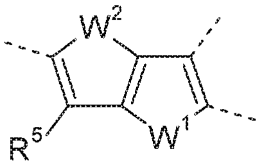

also includes the mirror images

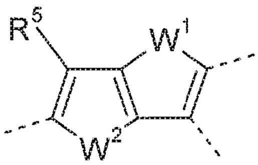

and

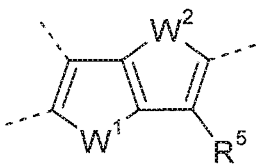

.

Detailed Description

The compounds of the present invention are easy to synthesize and exhibit advantageous properties. They show good processability for the device manufacture process, high solubility in organic solvents, and are especially suitable for large scale production using solution processing methods.

Co-polymers derived from monomers of the present invention and electron acceptor monomers show low bandgaps, high charge carrier mobilities, high external quantum efficiencies in BHJ solar cells, good morphology when used in p/n-type blends e.g. with fullerenes, high oxidative stability, a long lifetime in electronic devices, and are promising materials for organic electronic OE devices, especially for OPV devices with high power conversion efficiency.

The compounds of the present invention are especially suitable as both p-type and n-type semiconductors, depending on the nature of the comonomer or $\pi$-units cross-coupled to extend the conjugation, for the preparation of blends of p-type and n-type semiconductors which are suitable for use in BHJ photovoltaic devices.

Besides, the compounds of the present invention show the following advantageous properties:

i) a higher Voc which is beneficial for solar cell module production,

ii) an improved morphology of the BHJ which can be achieved by modification of the solubilizing groups and which

can lead to the an increased fill factor (FF).

Preferably, in the unit of formula I a1 is >0 and b1 is >0.

In another preferred embodiment of the present invention, in the unit of formula I b1 is 0 and a1 is 1 or 2.

In another preferred embodiment of the present invention, in the unit of formula I a1=b1=1 and c1 and d1 are independently of each other 0, 1 or 2, preferably 0 or 1, very preferably 0.

In another preferred embodiment of the present invention, in the unit of formula I a1 is 2, b1 is 1 or 2, c1 is 0 or 1, preferably 0, and d1 is 0, 1 or 2, preferably 0 or 1, very preferably 0.

Preferably the unit of formula I is selected of formula I1

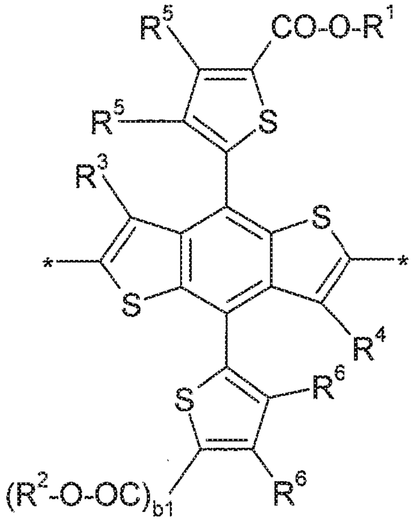

I1

wherein $R^{1-6}$ have, on each occurrence identically or differently, the meanings given above and below, and b1 is 0, 1 or 2, preferably 1 or 2.

In a preferred embodiment of the present invention, in the units of formula I $R^1$ and $R^2$ are selected from straight-chain or branched alkyl with 1 to 30, preferably 1 to 20 C atoms that is unsubstituted or substituted by one or more F atoms, most preferably from formulae SUB1-SUB6 above.

In another preferred embodiment of the present invention, in the units of formula I and 11 $R^1$ and $R^2$ are selected from mono- or polycyclic aryl or heteroaryl, each of which is optionally substituted with one or more groups L as defined in formula I and has 5 to 20 ring atoms, and wherein two or more rings may be fused to each other or connected with each other by a covalent bond, very preferably phenyl that is optionally substituted, preferably in 4-position, 2,4-positions, 2,4,6-positions or 3,5-positions, or thiophene that is optionally substituted, preferably in 5-position, 4,5-positions or 3,5-positions, with alkyl, alkoxy or thioalkyl having 1 to 16 C atoms, most preferably from formulae SUB7-SUB18 above.

In a preferred embodiment of the present invention, in the units of formula I and I1 $R^{3-6}$ are H.

In another preferred embodiment of the present invention, in the units of formula I and I1 at least one of $R^3$ and $R^4$ is different from H.

In another preferred embodiment of the present invention, in the units of formula I and I1 at least one of $R^5$ and $R^6$ is different from H.

In a preferred embodiment of the present invention, in the units of formula I and 11, $R^{3-6}$, when being different from H, are each independently selected from F, Cl, CN, or from straight-chain or branched alkyl, alkoxy, sulfanylalkyl, sulfonylalkyl, alkylcarbonyl, alkoxycarbonyl and alkylcarbonyloxy, each of which has 1 to 20 C atoms and is unsubstituted or substituted by one or more F atoms, most preferably from F, Cl or formulae SUB1-SUB6 above.

In another preferred embodiment of the present invention, in the units of formula I and 11 $R^{3-6}$, when being different from H, are each independently selected are selected from mono- or polycyclic aryl or heteroaryl, each of which is optionally substituted with one or more groups L as defined in formula I and has 5 to 20 ring atoms, and wherein two or more rings may be fused to each other or connected with each other by a covalent bond, very preferably phenyl that is optionally substituted, preferably in 4-position, 2,4-positions, 2,4,6-positions or 3,5-positions, or thiophene that is optionally substituted, preferably in 5-position, 4,5-positions or 3,5-positions, with alkyl, alkoxy or thioalkyl having 1 to 16 C atoms, more preferably from formulae SUB7-SUB18 above, most preferably from formulae SUB14-SUB18 above.

Preferred aryl and heteroaryl groups $R^{1-6}$, when being different from H, are each independently selected from the following formulae

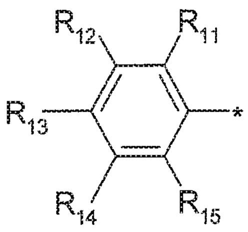
C1

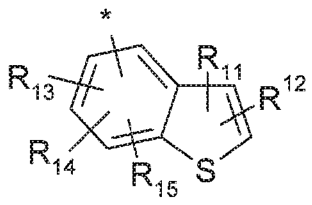
C2

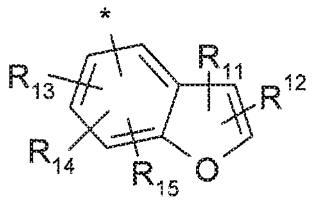
C3

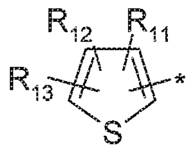
C4

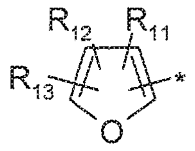
C5

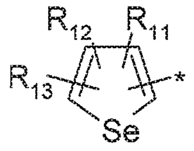
C6

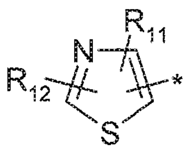
C7

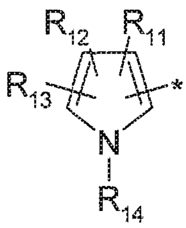
C8

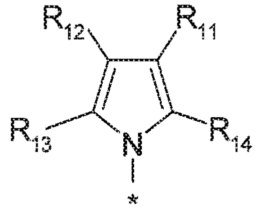
C9

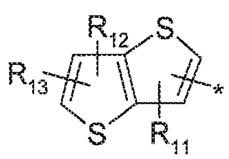
C10

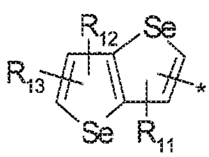
C11

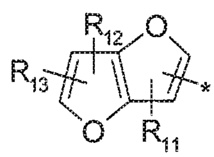
C12

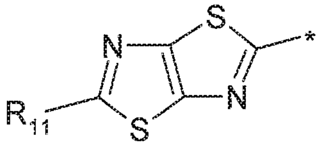
C13

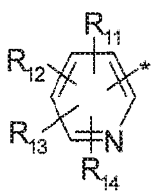
C14

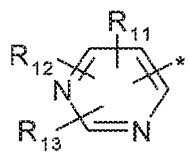
C15

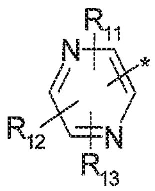
C16

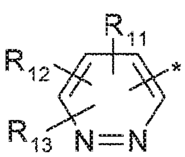
C17

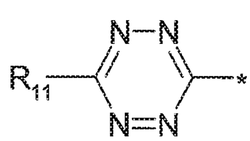
C18

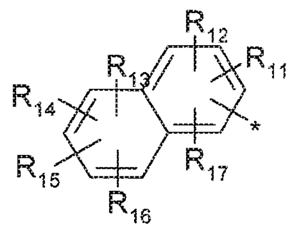

C19

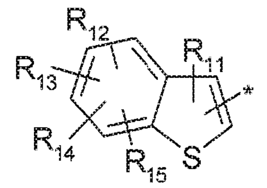

C20

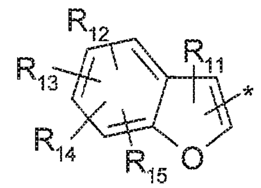

C21

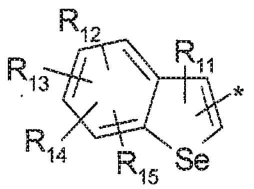

C22

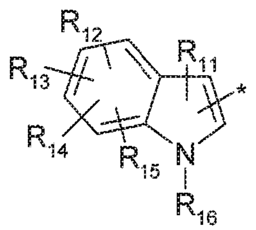

C23

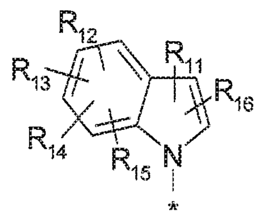

C24

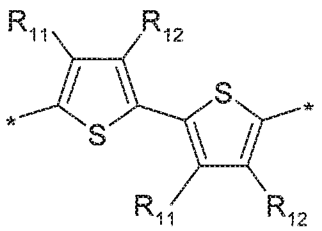

C25

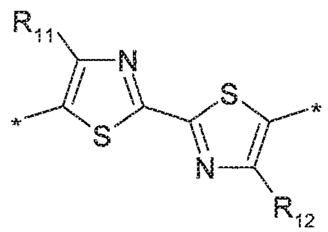

C26

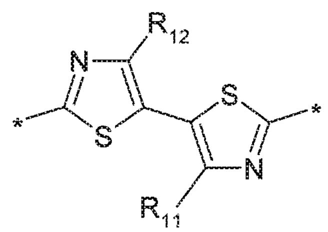

C27

wherein $R^{11-17}$, independently of each other, and on each occurrence identically or differently, have one of the meanings of $R^3$ in formula I.

Very preferred aryl and heteroaryl groups $R^{1-6}$, when being different from H, are each independently selected from the following formulae

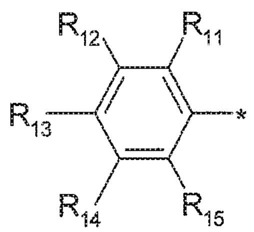

C1-1

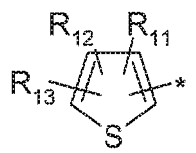

C4-1

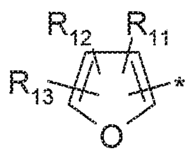

C5-1

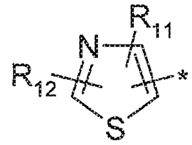

C7-1

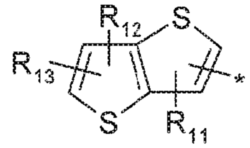

C10-1

wherein $R^{11-15}$ are as defined above. Most preferred aryl and heteroaryl groups $R^{1-6}$ are each independently selected

from formulae SUB7-SUB18 as defined above.

In another preferred embodiment one or more of $R^{1-6}$, when being different from H, denote a straight-chain, branched or cyclic alkyl group with 1 to 50, preferably 2 to 50, very preferably 2 to 30, more preferably 2 to 24, most preferably 2 to 16 C atoms, in which one or more $CH_2$ or $CH_3$ groups are replaced by a cationic or anionic group.

The cationic group is preferably selected from the group consisting of phosphonium, sulfonium, ammonium, uronium, thiouronium, guanidinium or heterocyclic cations such as imidazolium, pyridinium, pyrrolidinium, triazolium, morpholinium or piperidinium cation.

Preferred cationic groups are selected from the group consisting of tetraalkylammonium, tetraalkylphosphonium, N-alkylpyridinium, N,N-dialkylpyrrolidinium, 1,3-dialkylimidazolium, wherein "alkyl" preferably denotes a straight-chain or branched alkyl group with 1 to 12 C atoms and very preferably is selected from formulae SUB1-6 .

Further preferred cationic groups are selected from the group consisting of the following formulae

imidazolium

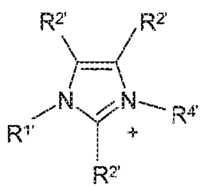

,

1H-pyrazolium

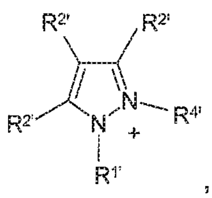

,

3H-pyrazolium

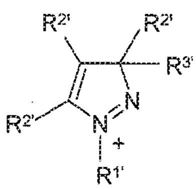

,

4H-pyrazolium

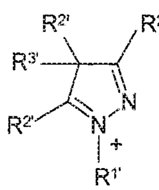

,

1-pyrazolinium

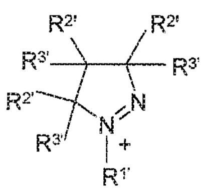

,

2-pyrazolinium

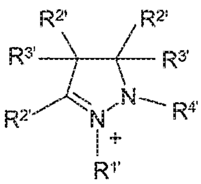

,

3-pyrazolinium

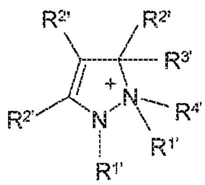

,

2,3-dihydroimidazolinium

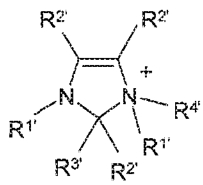

,

4,5-dihydroimidazolinium

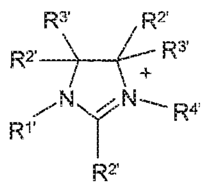

,

2,5-dihydroimidazolinium

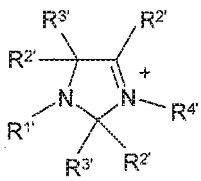

,

pyrrolidinium

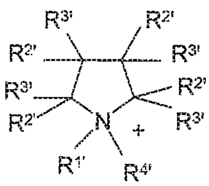

,

1,2,4-triazolium

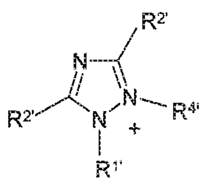

,

1,2,4-triazolium

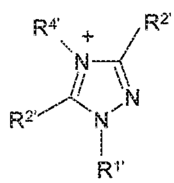

,

1,2,3-triazolium

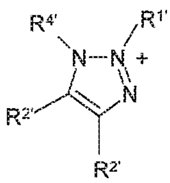

,

1,2,3-triazolium

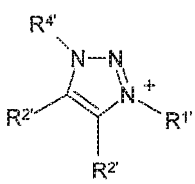

,

pyridinium

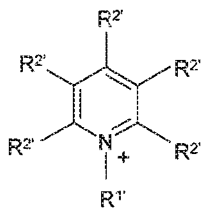

,

pyridazinium

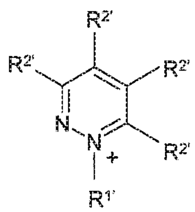

,

pyrimidinium

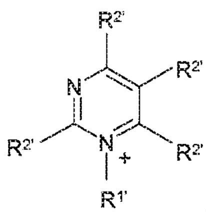

,

piperidinium

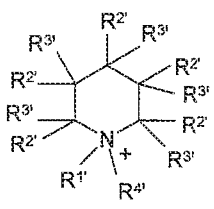

,

morpholinium

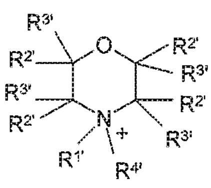

,

piperazinium

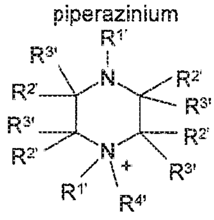

,

piperazinium

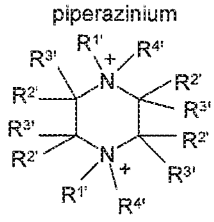

,

pyrazinium

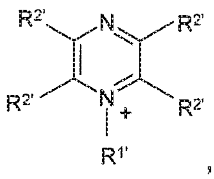

,

thiazolium

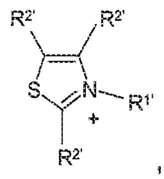

,

oxazolium

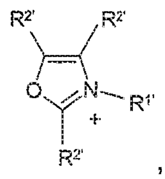

,

indolium

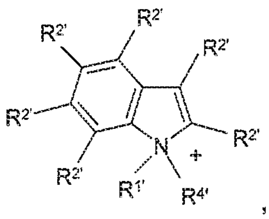

,

quinolinium

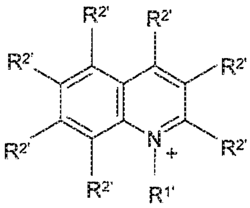

,

isoquinolinium

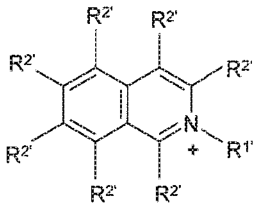

,

quinoxalinium

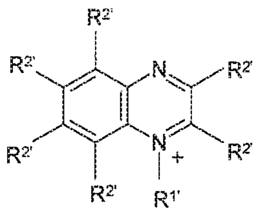

or

indolinium

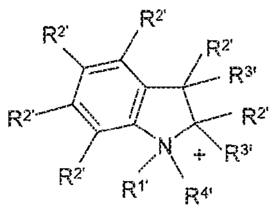

wherein R1', R2', R3' and R4' denote, independently of each other, H, a straight-chain or branched alkyl group with 1 to 12 C atoms or non-aromatic carbo- or heterocyclic group or an aryl or heteroaryl group, each of the aforementioned groups having 3 to 20, preferably 5 to 15, ring atoms, being mono- or polycyclic, and optionally being substituted by one or more identical or different substituents L as defined above, or denote a link to the respective group $R^{1-6}$.

In the above cationic groups of the above-mentioned formulae any one of the groups R1', R2' , R3' and R4' (if they replace a $CH_3$ group) can denote a link to the respective group $R^{1-6}$, or two neighbored groups R1', R2', R3' or R4' (if they replace a $CH_2$ group) can denote a link to the respective group $R^{1-6}$.

The anionic group is preferably selected from the group consisting of borate, imide, phosphate, sulfonate, sulfate, succinate, naphthenate or carboxylate, very preferably from phosphate, sulfonate or carboxylate.

In the formulae above and below, L is preferably selected from the following groups

- the group consisting of R, -OR and -SR wherein R is straight-chain or branched alkyl with 1 to 25, preferably 1 to 18 C atoms which is optionally fluorinated,

- the group consisting of F, Cl, CN, -C(=O)-R, -C(=O)-OR, -OC(=O)-R, - C(=O)-NHR and -C(=O)-NRR$^n$, wherein R and R$^n$ are independently of each other straight-chain or branched alkyl with 1 to 25, preferably 1 to 18 C atoms that is optionally fluorinated.

The compounds according to the present invention include oligomers and polymers, which are preferably conjugated.

A preferred embodiment of the present invention relates to a conjugated polymer comprising one or more, preferably two or more, repeating units selected of formula I or I1.

Another preferred embodiment of the present invention relates to a conjugated oligomer or polymer, preferably a conjugated polymer, comprising one or more, preferably two or more, units of formula I or I1, and additionally comprising one or more arylene or heteroarylene units that are different from formula I and I1, have from 5 to 20 ring atoms, are mono- or polycyclic, do optionally contain fused rings, are unsubstituted or substituted by one or more identical or different

groups L, wherein one or more of these additional arylene or heteroarylene units have electron donor or electron acceptor property property.

Another preferred embodiment of the present invention relates to a conjugated oligomer or polymer, preferably a conjugated polymer, comprising, preferably consisting of, one or more, preferably two or more, repeating units of formula II1 and/or II2, and optionally one or more repeating units of formula II3:

$$-(Ar^1)_a-U-(Ar2)_b-(Ar^3)_c-(Ar^4)_d- \qquad II1$$

$$-(Ar^1)_a-(Ar^2)_b-U-(Ar^3)_c-(Ar^4)_d- \qquad II2$$

$$-(Ar^1)_a-(Ar^2)_b-(Ar^3)_c-(Ar^4)_d- \qquad II3$$

wherein the individual radicals, independently of each other and on each occurrence identically or differently, have the following meanings

U a unit of formula I or 11 as defined above and below,

$Ar^{1-4}$ arylene or heteroarylene that has 5 to 20 ring atoms, is mono- or polycyclic, does optionally contain fused rings, is unsubstituted or substituted by one or more identical or different groups L as defined in formula I, and is different from U,

a, b, c, d 0 or 1, wherein in formula II3 $a+b+c+d \geq 1$.

Preferably the conjugated oligomer or polymer comprises one or more repeating units of formula II1 or II2 wherein $a+b+c+d \geq 1$.

Further preferably the conjugated oligomer or polymer comprises one or more repeating units of formula II1 wherein b=1 and a=c=d=0 and one or more repeating units of formula II3 wherein a=b=0 and c=d=1.

Further preferably the conjugated oligomer or polymer comprises two or more distinct repeating units of formula II1 wherein b=1 and a=c=d=0.

Further preferably at least one of $Ar^1$, $Ar^2$, $Ar^3$ and $Ar^4$ is an arylene or heteroarylene group as being defined in formula II1 and having electron donor property.

Further preferably the conjugated oligomer or polymer according to the present invention is selected of formula III:

$$*\!-\!\left[(A)_x-(B)_y-(C)_z-(D)_v-(E)_w\right]_n\!-\!* \qquad III$$

wherein the individual radicals, independently of each other and on each occurrence identically or differently, have the following meanings

A a unit of formula I or I1, II1 or II2 as defined above and below,

B, C, D, E a unit of formula I or I1, II1, II2 or II3 as defined above and below,

x > 0 and ≤ 1,

v, w, y, z ≥ 0 and < 1,

v+w+x+y+z 1, and

n an integer >1, preferably ≥5.

Preferred oligomers and polymers of formula III are selected from the following subformulae

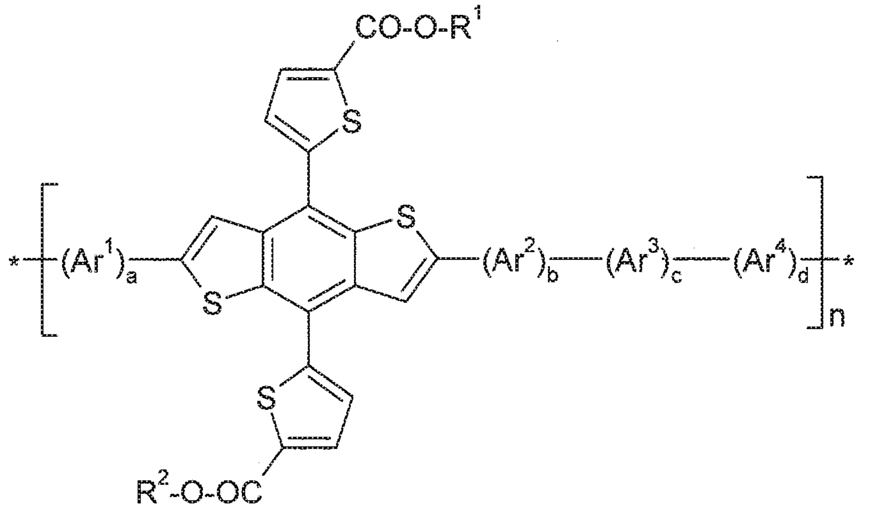

III1

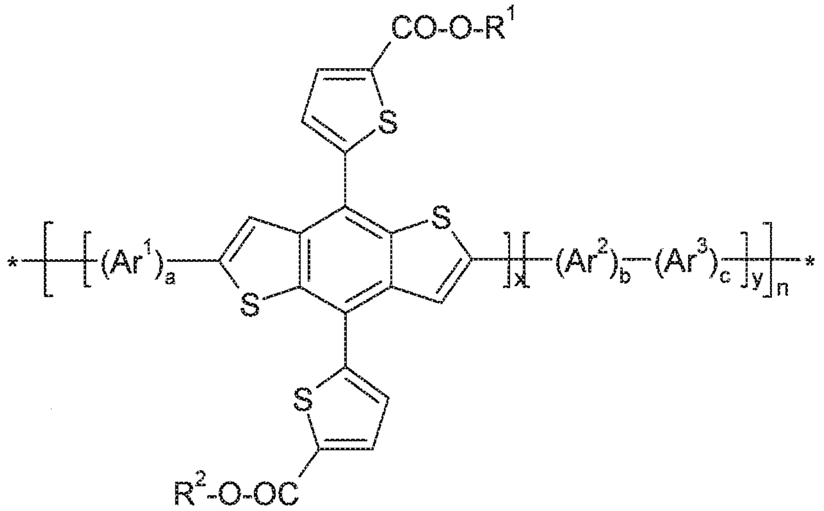

III2

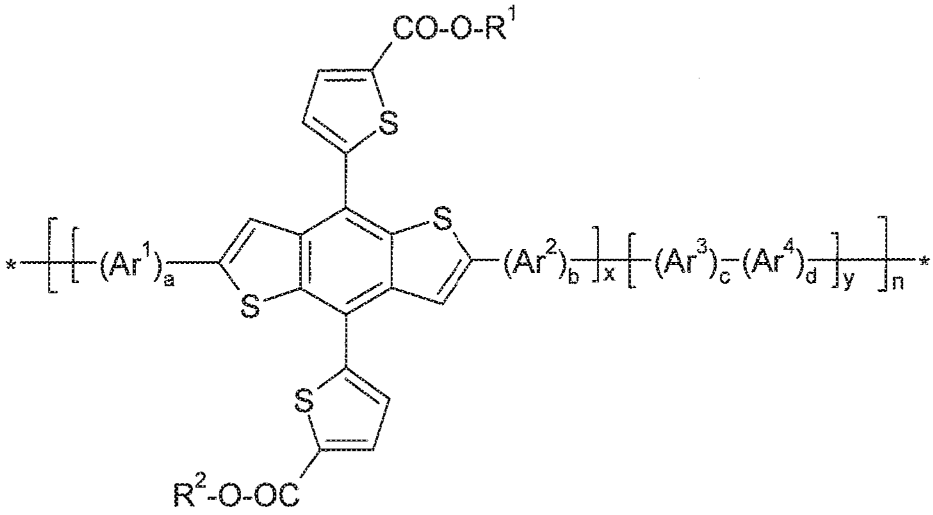

III3

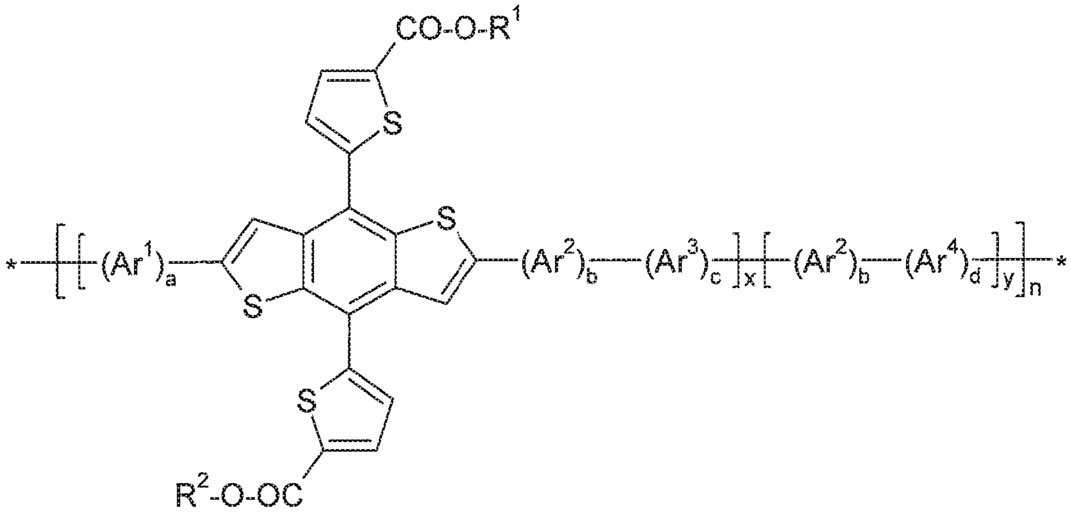

III4

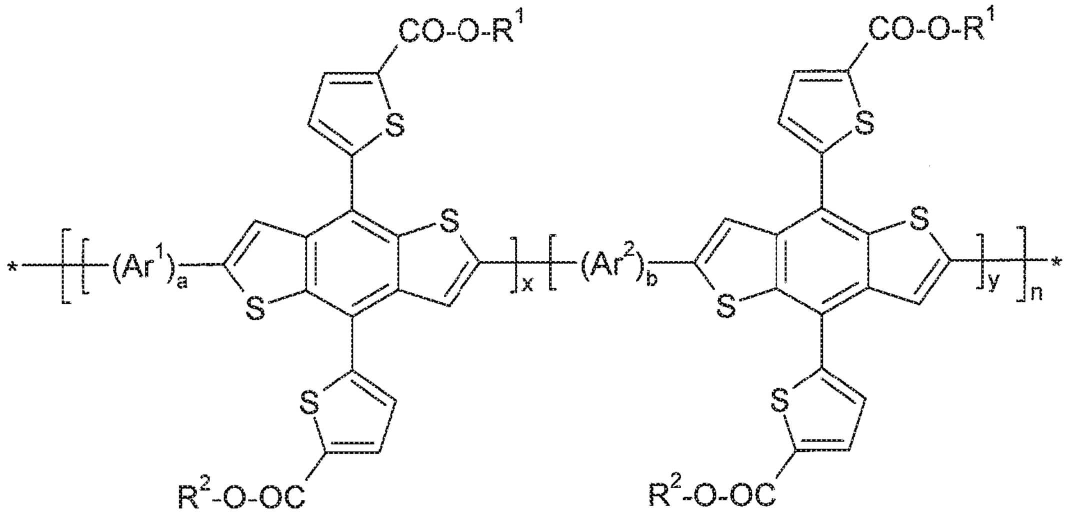

III5

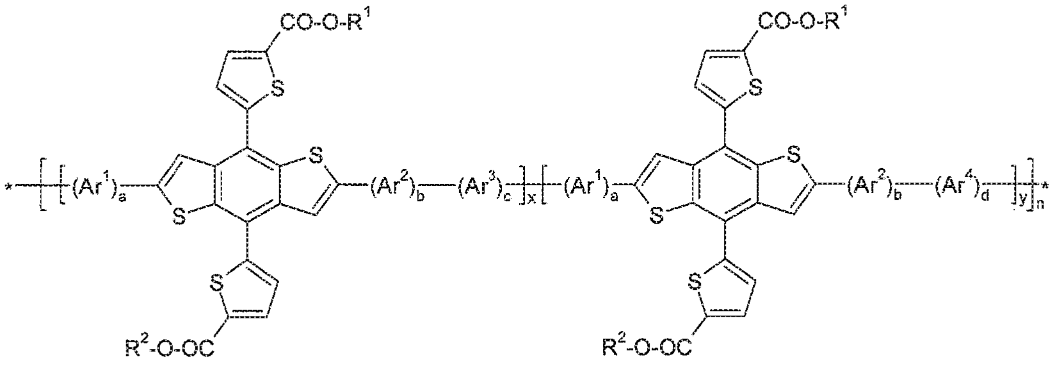

III6

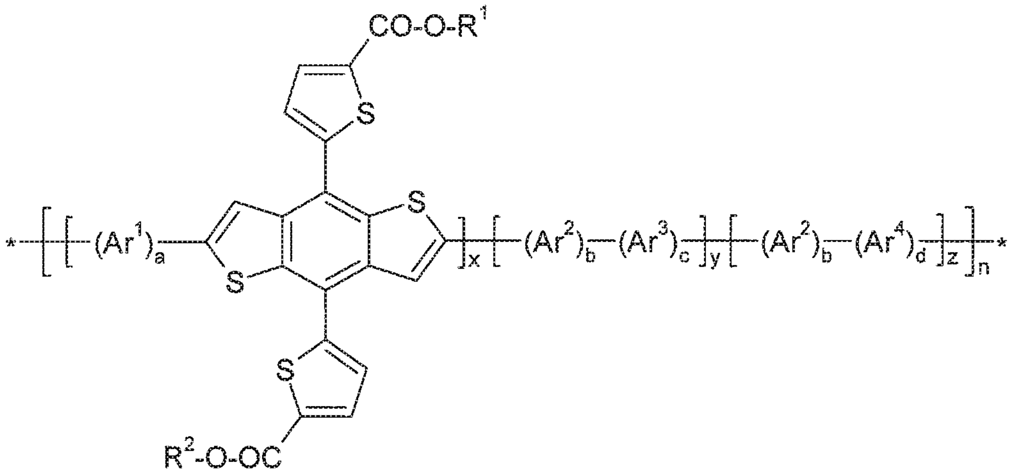

III7

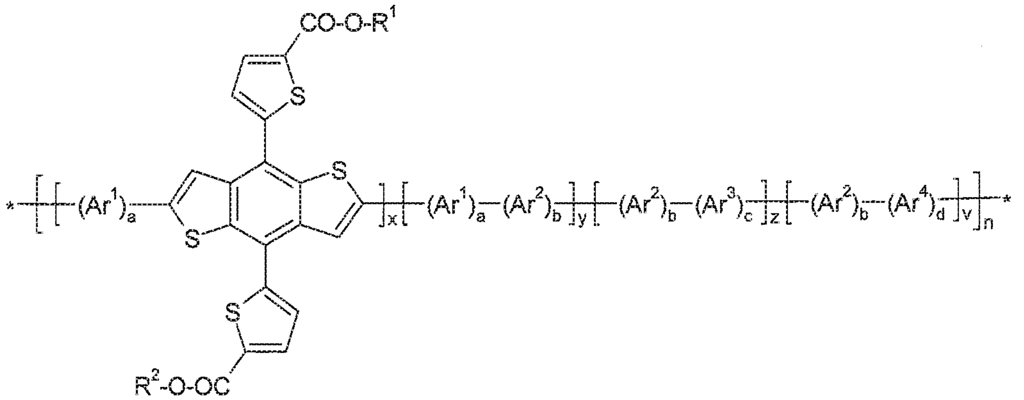

III8

wherein $R^1$, $R^2$, $Ar^1$, $Ar^2$, $Ar^3$, $Ar^4$, a, b, c, d, v, x, y, z and n have the meanings of formula I, II1 and III or one of the preferred meanings given above and below, and preferably one or more of $Ar^3$ and $Ar^4$ are selected from arylene or heteroarylene units as described above and below having electron acceptor properties.

Another preferred embodiment of the invention relates to a conjugated oligomer or polymer, preferably a conjugated polymer, comprising one or more electron donating units ("donor units"), at least one of which is selected of formula I or I1, preferably further comprising one or more electron accepting units ("acceptor units"), and optionally comprising one or more spacer units separating a donor unit from an acceptor unit, wherein each donor and acceptor unit is directly connected either to to another donor or acceptor unit or to a spacer unit, and wherein all of the donor, acceptor and spacer units that are different from formula I and i1 are each independently selected from arylene or heteroarylene that has from 5 to 20 ring atoms, is mono- or polycyclic, optionally contains fused rings, are is unsubstituted or substituted by one or more identical or different groups L as defined above.

Preferably the spacer units, if present, are located between the donor and acceptor units such that a donor unit and an acceptor unit are not directly connected to each other.

Preferred conjugated oligomers and polymers of this preferred embodiment comprise, very preferably consist of, one or more units selected from the group consisting of the following formulae

-(D-Sp)- U1

-(A-Sp)- U2

-(A-D)- U3

-(D)- U4

-(Sp-D-Sp)- U5

-(A)- U6

-(Sp-A-Sp)- U7

wherein D denotes a donor unit, A denotes an acceptor unit and Sp denotes a spacer unit, all of which are selected, independently of each other and on each occurrence identically or differently, from arylene or heteroarylene that has from 5 to 20 ring atoms, is mono- or polycyclic, optionally contains fused rings, are is unsubstituted or substituted by one or more identical or different groups L as defined above, and wherein the oligomer or polymer comprises at least one unit selected from formulae U1, U3, U4 and U5 wherein D is a unit selected of formula I or I1.

Very preferred oligomers and polymers of this preferred embodiment are those selected from formulae Pi-Pviii

$-[(D\text{-}Sp)_x\text{-}(A\text{-}Sp)_y]_n-$ Pi

$-[(A\text{-}D)_x\text{-}(A\text{-}Sp)_y]_n-$ Pii

$-[(D)_x\text{-}(Sp\text{-}A\text{-}Sp)_y]_n-$ Piii

$-[D\text{-}Sp\text{-}A\text{-}Sp]_n-$ Piv

$-[D\text{-}A]_n-$ Pv

$-[D\text{-}Sp\text{-}A\text{-}Sp]_n$ Pvi

$-[D^1\text{-}A\text{-}D^2\text{-}A]_n$ Pvii

$-[D\text{-}A^1\text{-}D\text{-}A^2]_n$ Pviii

wherein A, D and Sp are as defined in formula U1-U7, A and D can each, in case of multiple occurrence, also have different meanings, $D^1$ and $D^2$ have one of the meanings given for D and are different from each other, $A^1$ and $A^2$ have one of the meanings given for A and are different from each other, x and y denote the molar fractions of the corresponding units, x and y are each, independently of one another, a non-integer >0 and <1, with x+y=1, and n is an integer >1.

Especially preferred are repeating units, oligomers and polymers of formulae II1, II2, II3, III, III1-III8, U1-U7, Pi-Pviii and their subformulae wherein one or more of $Ar^1$, $Ar^2$, $Ar^3$ and $Ar^4$, or wherein D, respectively, denote arylene or heteroarylene that has electron donor properties and is selected from the group consisting of the following formulae

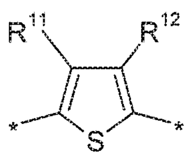
(D1)

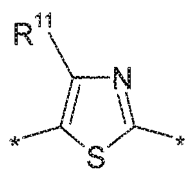
(D2)

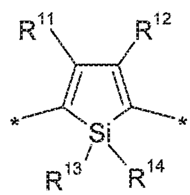
(D3)

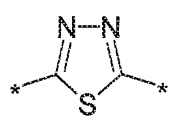
(D4)

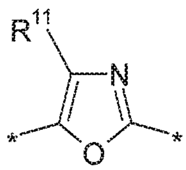
(D5)

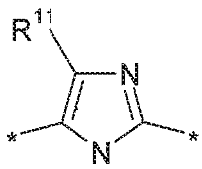
(D6)

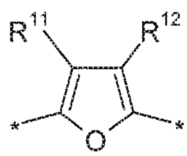
(D7)

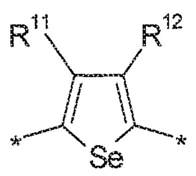

(D8)

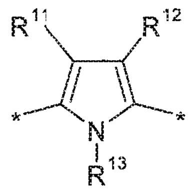

(D9)

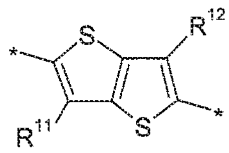

(D10)

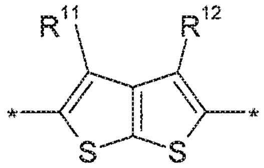

(D11)

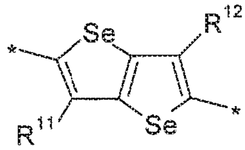

(D12)

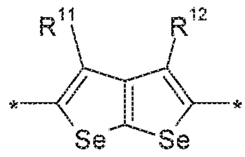

(D13)

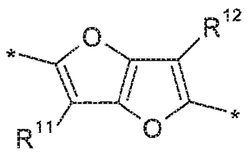

(D14)

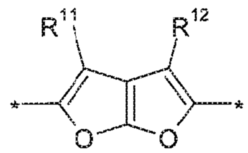

(D15)

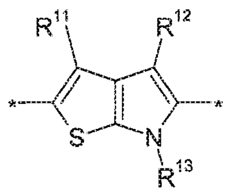

(D16)

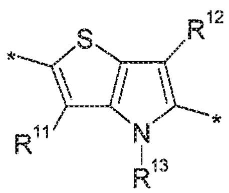

(D17)

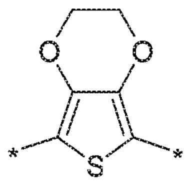

(D18)

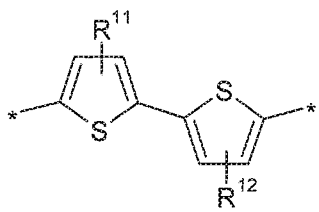

(D19)

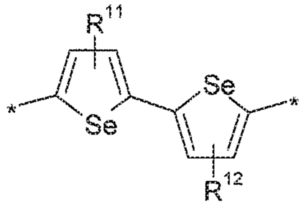

(D20)

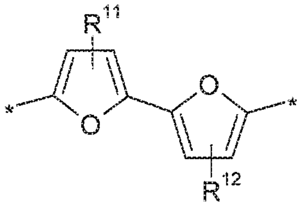

(D21)

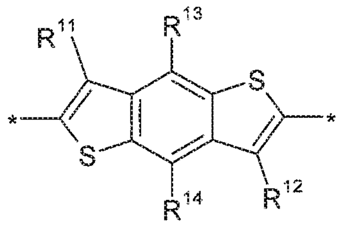

(D22)

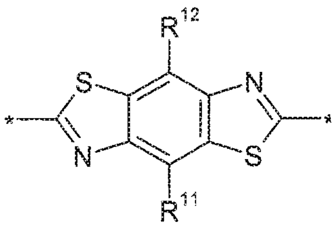

(D23)

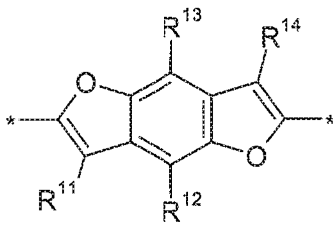

(D24)

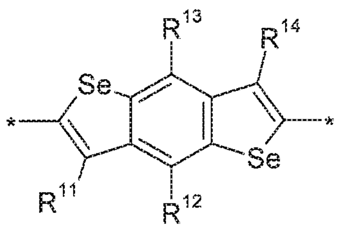

(D25)

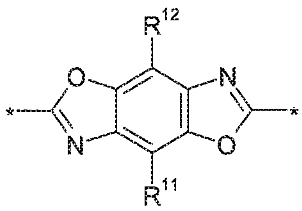

(D26)

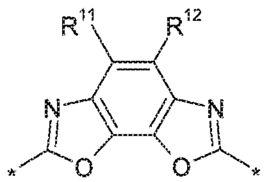

(D27)

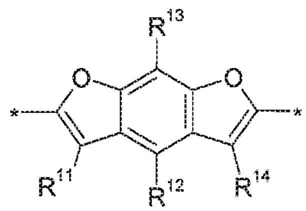

(D28)

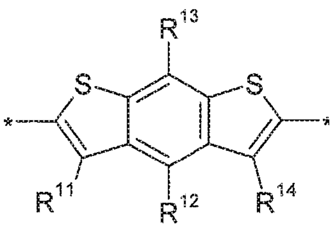

(D29)

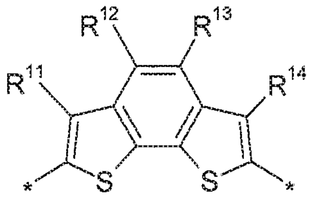

(D30)

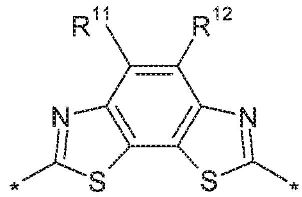

(D31)

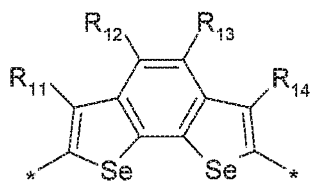

(D32)

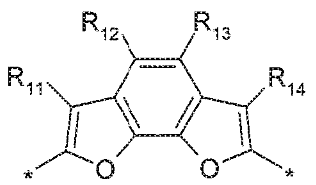

(D33)

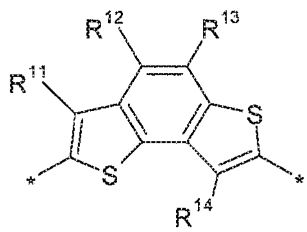

(D34)

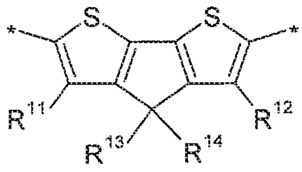

(D35)

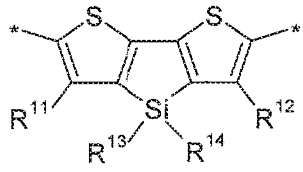

(D36)

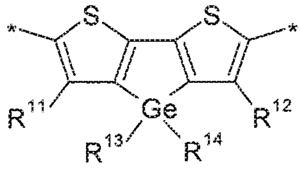

(D37)

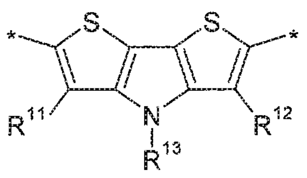

(D38)

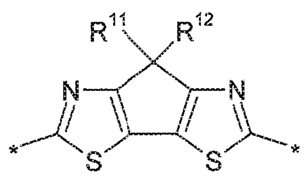

(D39)

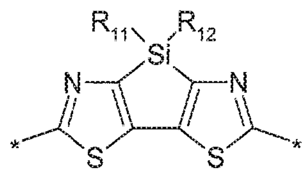

(D40)

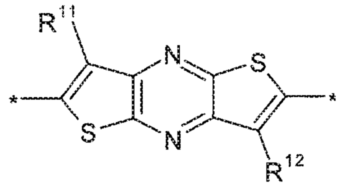

(D41)

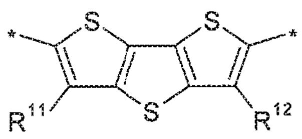

(D42)

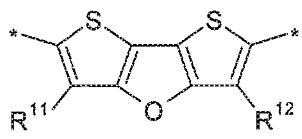

(D43)

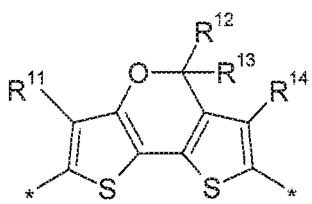

(D44)

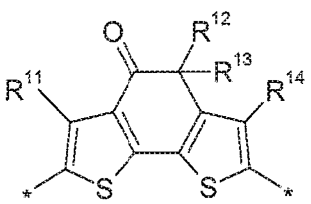

(D45)

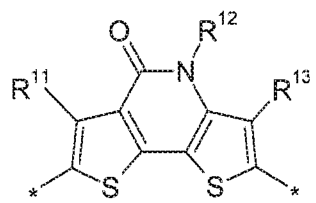

(D46)

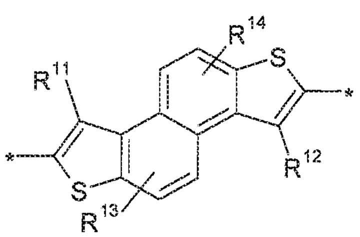

(D47)

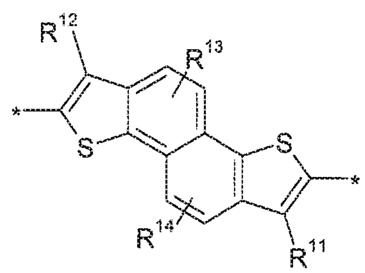

(D48)

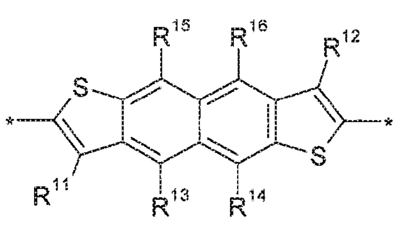

(D49)

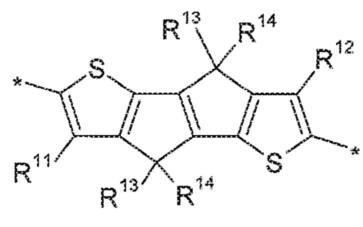

(D50)

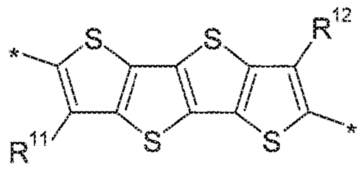

(D51)

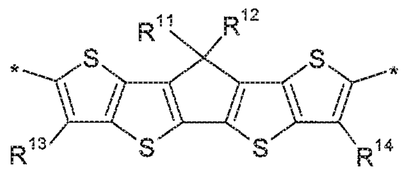

(D52)

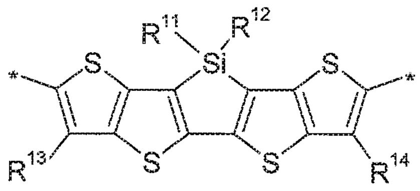

(D53)

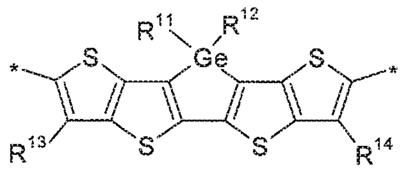

(D54)

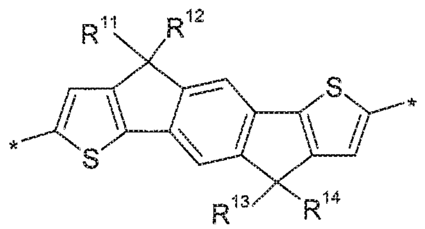

(D55)

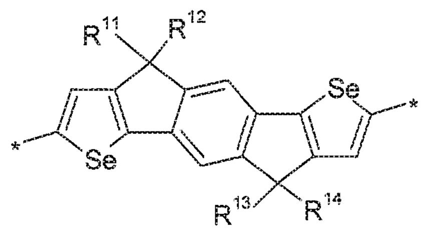

(D56)

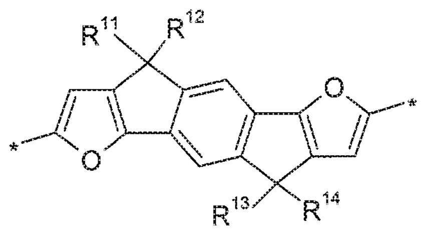

(D57)

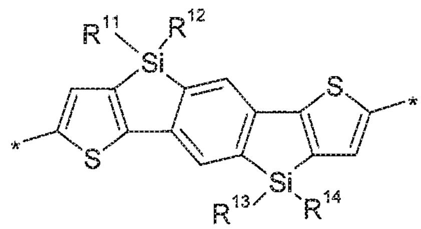

(D58)

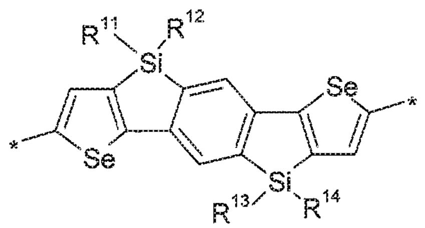

(D59)

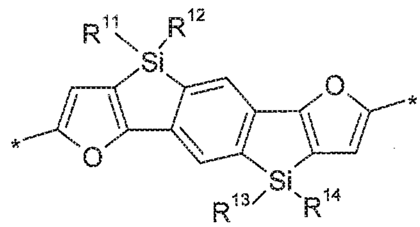

(D60)

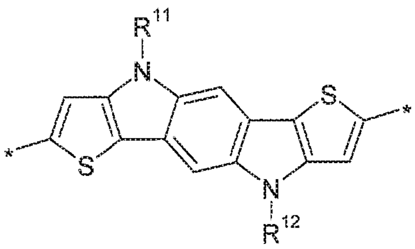

(D61)

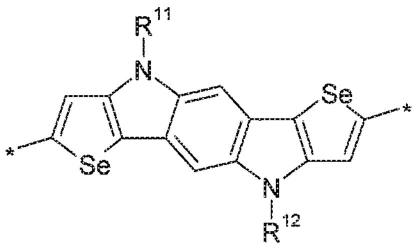

(D62)

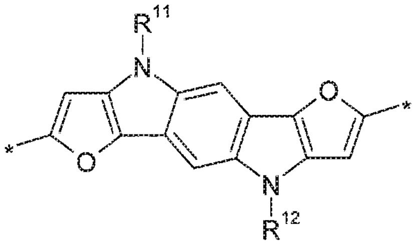

(D63)

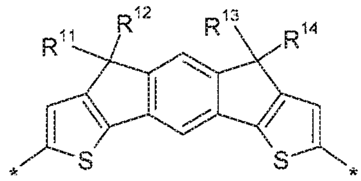

(D64)

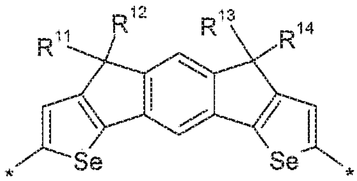

(D65)

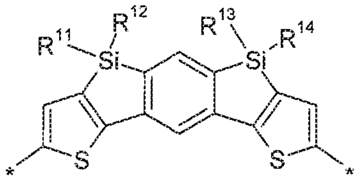

(D66)

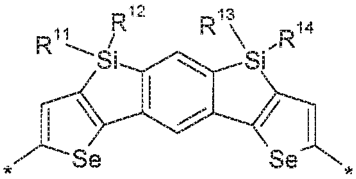

(D67)

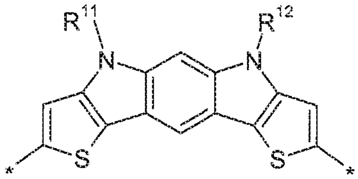

(D68)

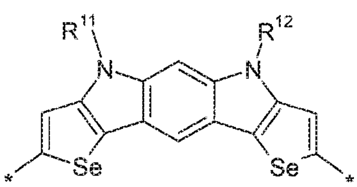

(D69)

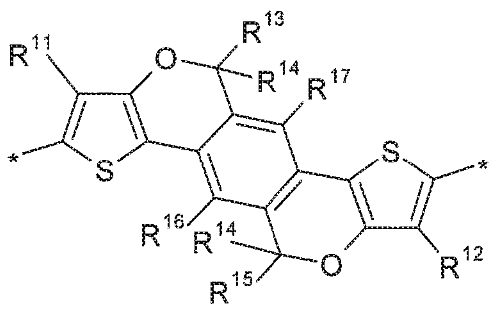

(D70)

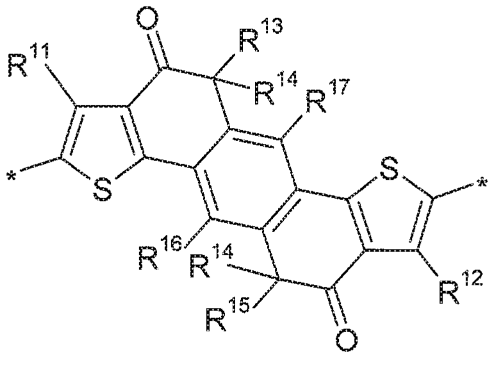

(D71)

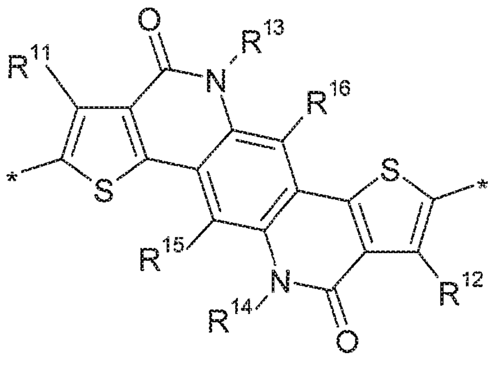

(D72)

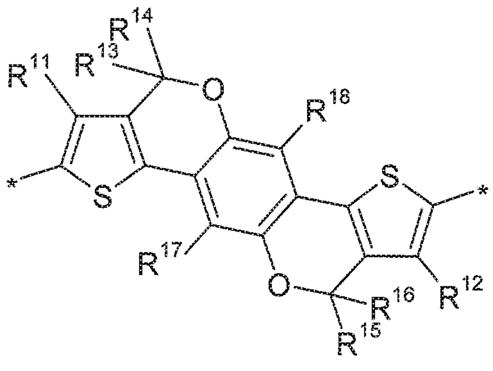

(D73)

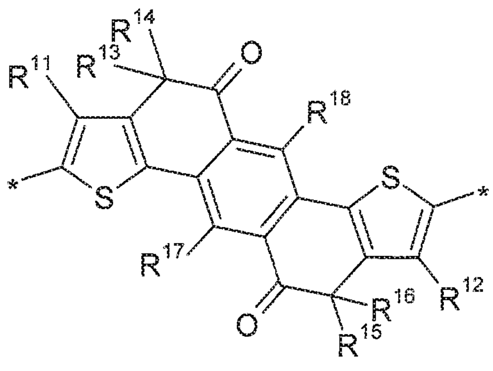

(D74)

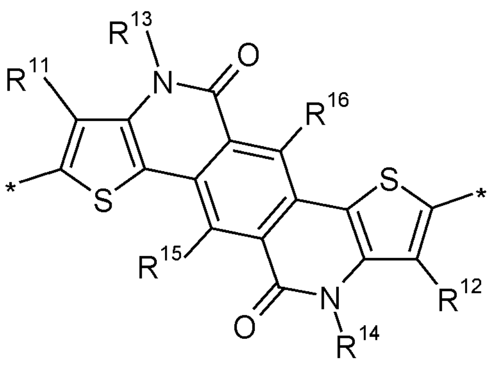

(D75)

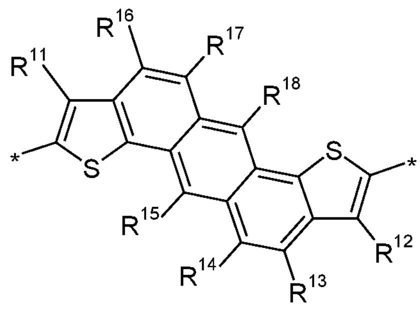

(D76)

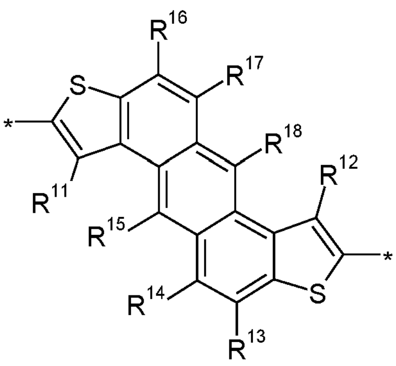

(D77)

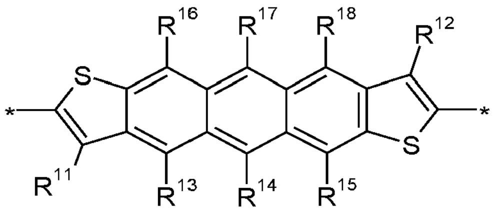

(D78)

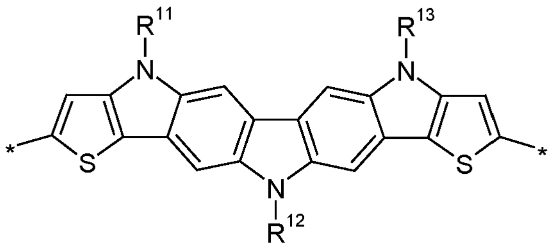

(D79)

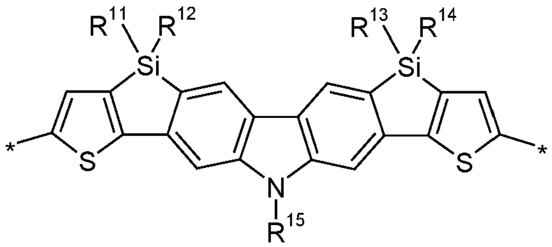

(D80)

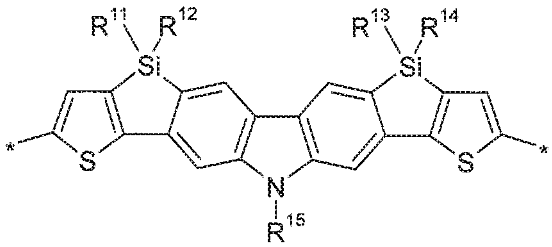

(D81)

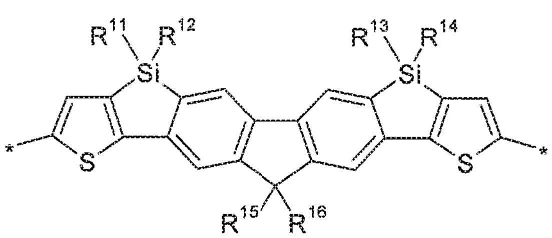

(D82)

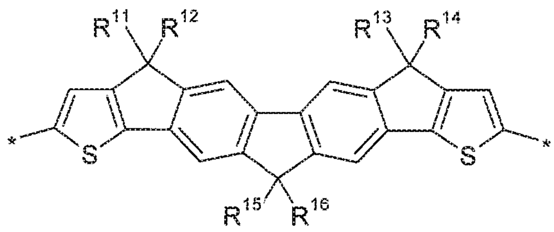

(D83)

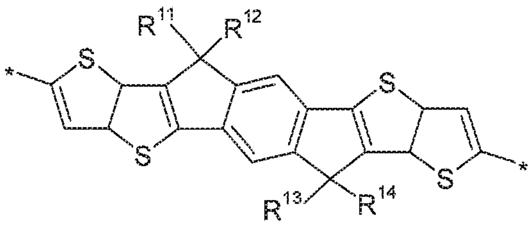

(D84)

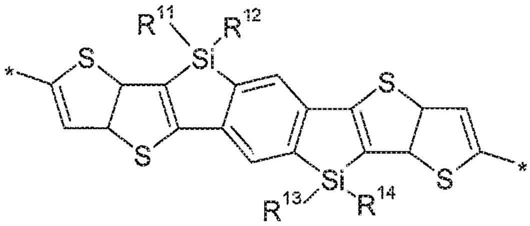

(D85)

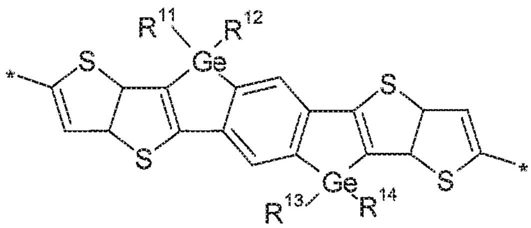

(D86)

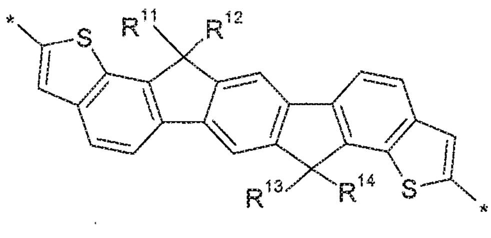

(D87)

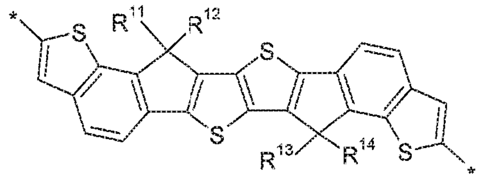

(D88)

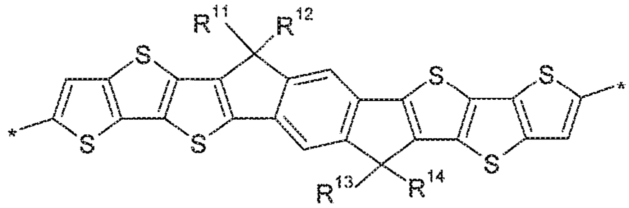

(D89)

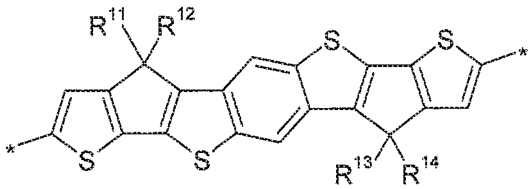

(D90)

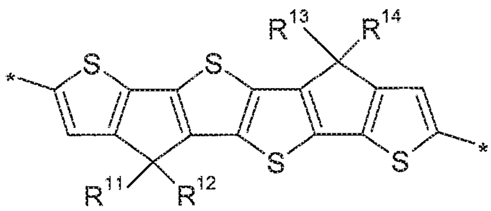

(D91)

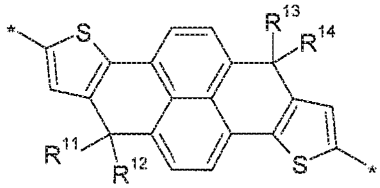

(D92)

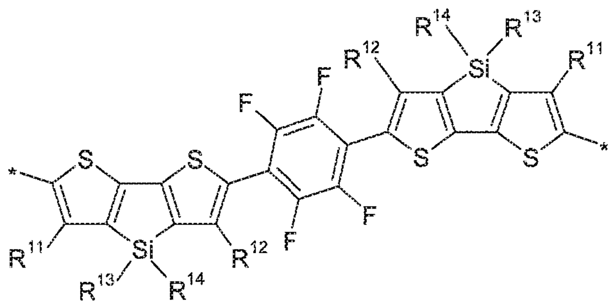

(D93)

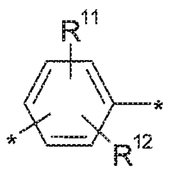

(D94)

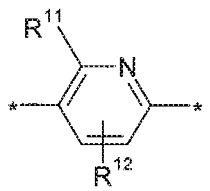

(D95)

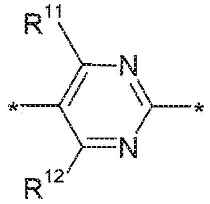

(D96)

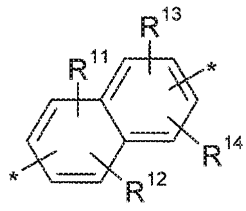

(D97)

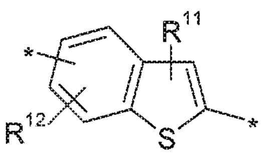

(D98)

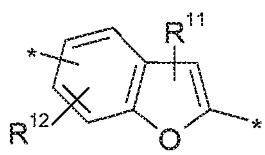

(D99)

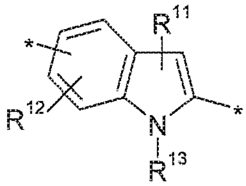

(D100)

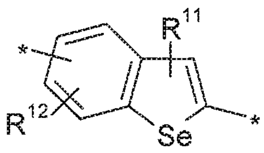

(D101)

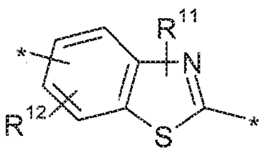

(D102)

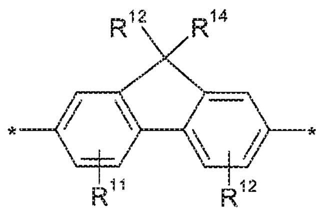

(D103)

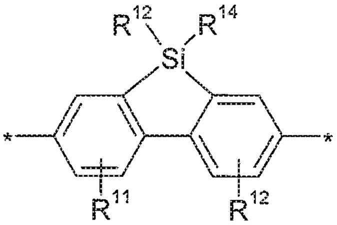

(D104)

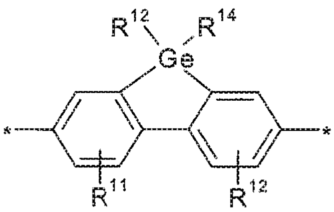

(D105)

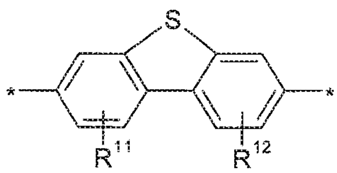

(D106)

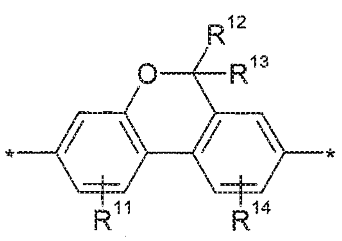

(D107)

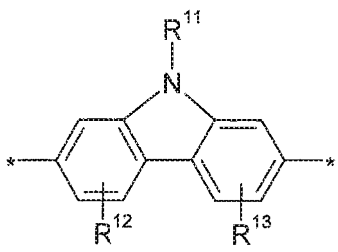

(D108)

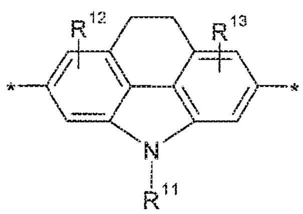

(D109)

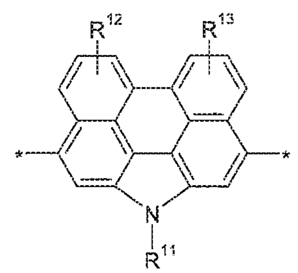

(D110)

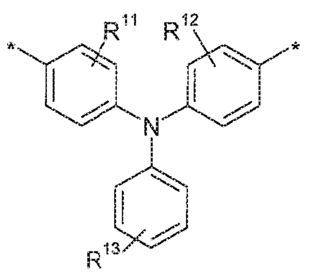

(D111)

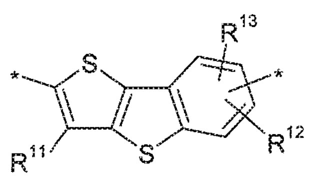

(D112)

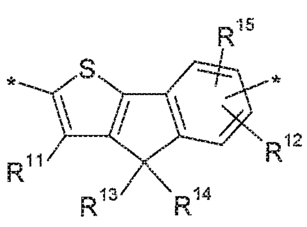

(D113)

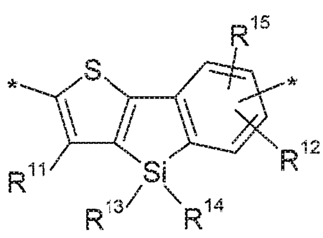

(D114)

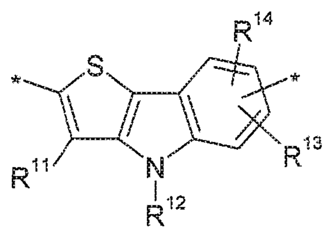

(D115)

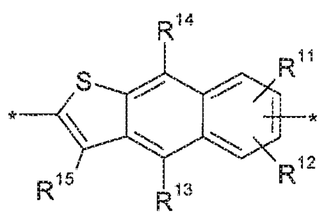

(D116)

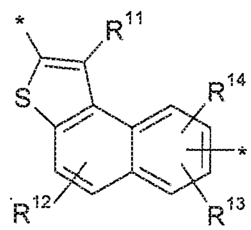

(D117)

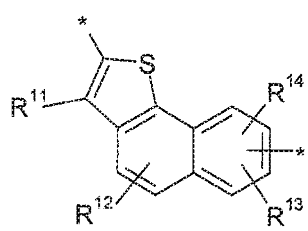

(D118)

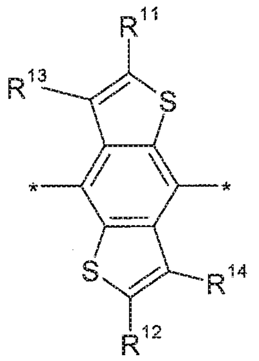
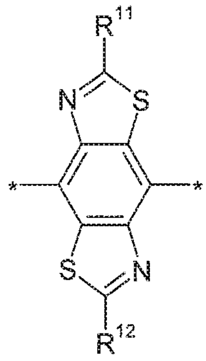
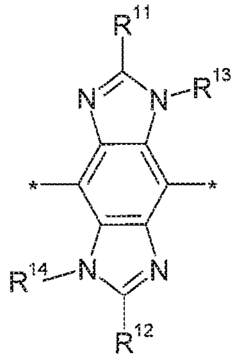
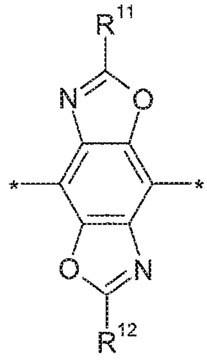

(D119) (D120) (D121) (D122)

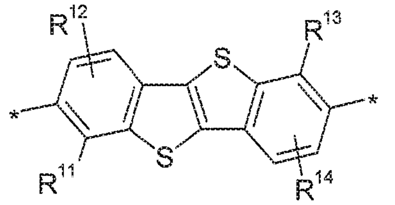

(D123)

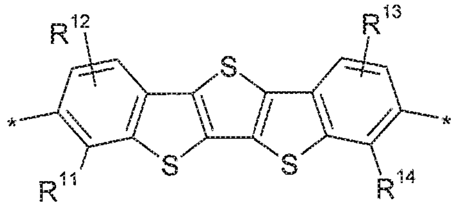

(D124)

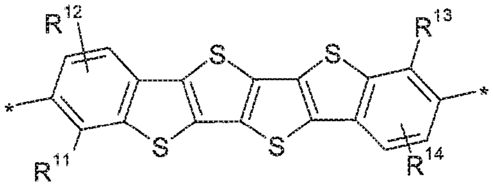

(D125)

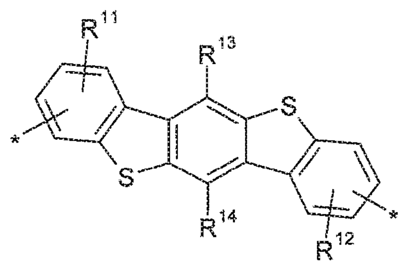

(D126)

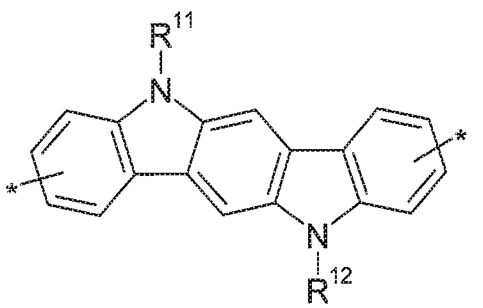

(D127)

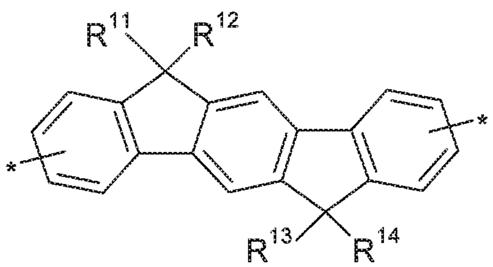

(D128)

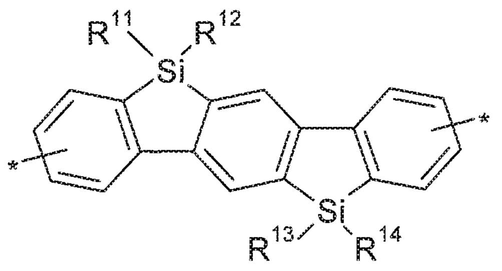

(D129)

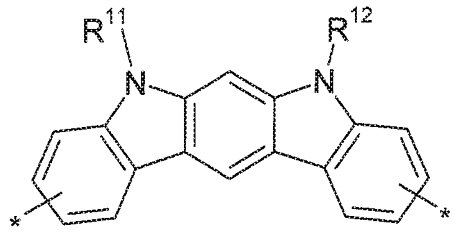

(D130)

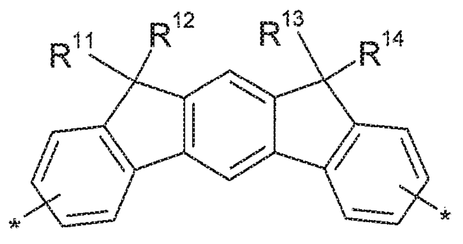

(D131)

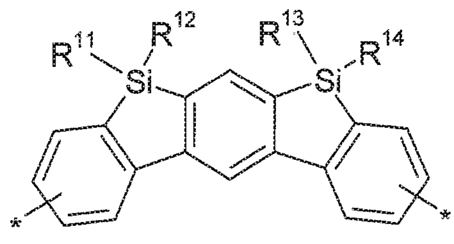

(D132)

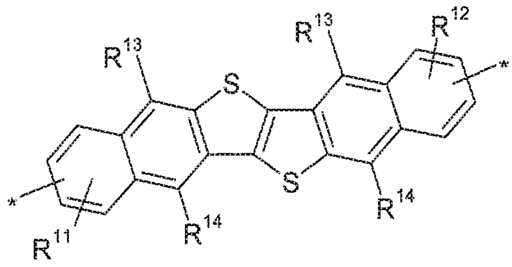

(D133)

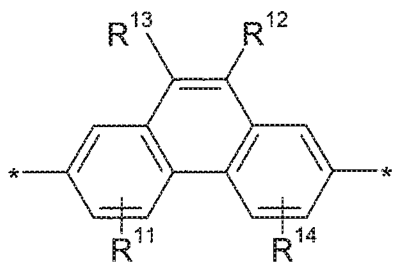

(D134)

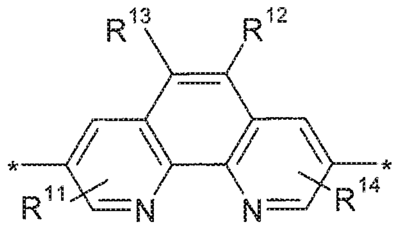

(D135)

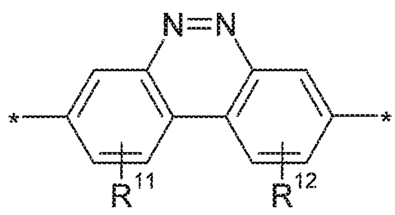

(D136)

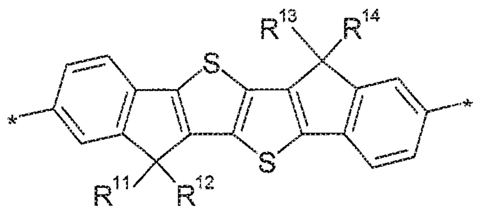

(D137)

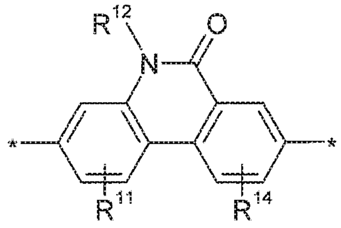

(D138)

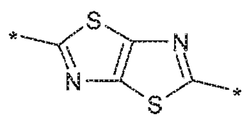

(D139)

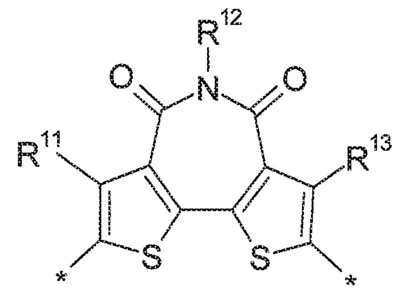

(D140)

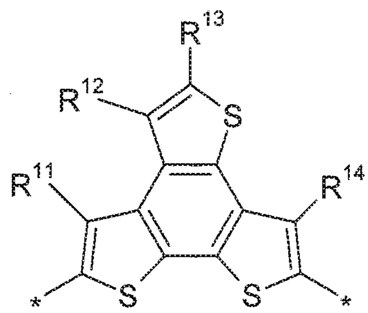

(D141)

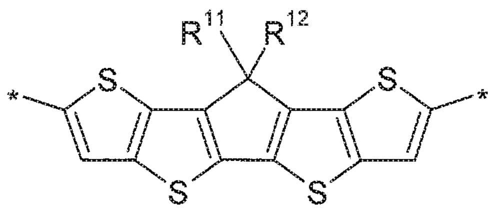

(D142)

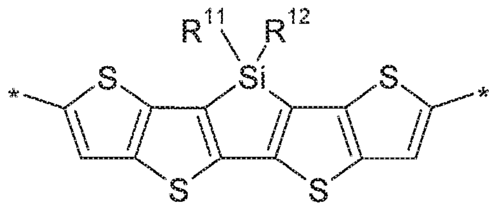

(D143)

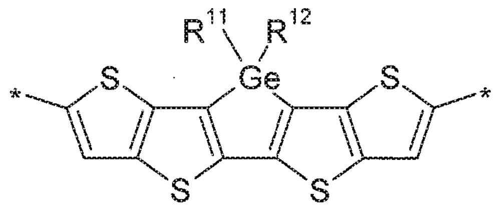

(D144)

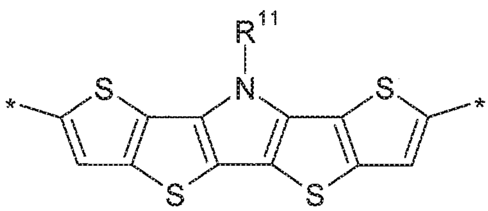

(D145)

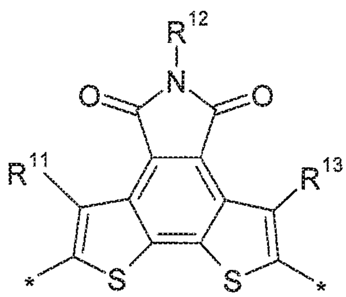

(D146)

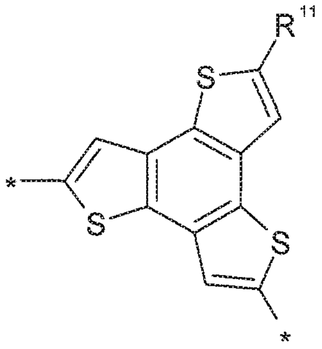

(D147)

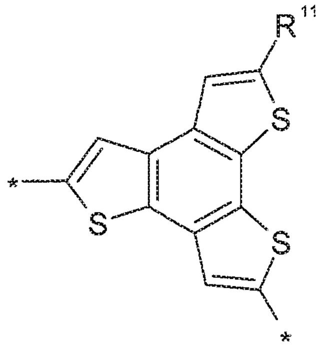

(D148)

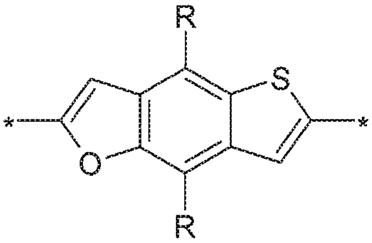

(D149)

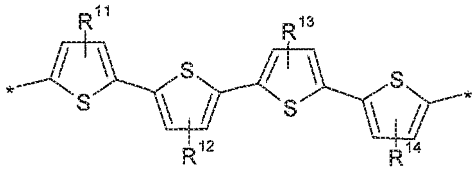

(D150)

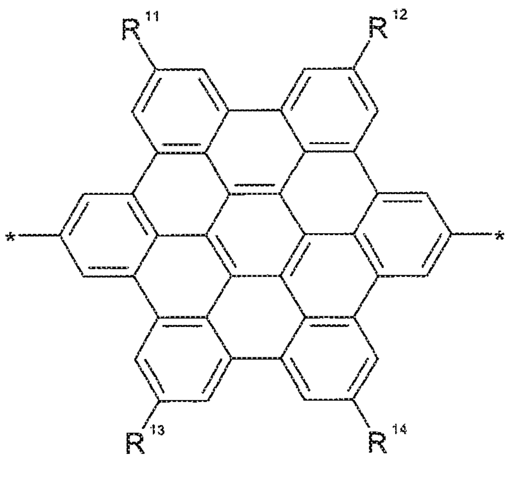

(D151)

wherein $R^{11}$, $R^{12}$, $R^{13}$, $R^{14}$, $R^{15}$, $R^{16}$, $R^{17}$ and $R^{18}$ independently of each other have one of the meanings of $R^3$ as given in formula I or one of its preferred meanings as given above and below.

Preferred donor units are selected from formulae D1, D7, D10, D11, D19, D22, D29, D30, D35, D36, D37, D44, D55, D84, D87, D88, D89, D93, D94, D106, D111, D139, D140, D141, D146 or D150 wherein preferably at least one of $R^{11}$, $R^{12}$, $R^{13}$ and $R^{14}$ is different from H.

Further preferred are repeating units, oligomers and polymers of formulae II1, II2, II3, III, III1-III8, U1-U7, Pi-Pviii and their subformulae wherein one or more of $Ar^1$, $Ar^2$, $Ar^3$ and $Ar^4$, or wherein A, respectively, denote arylene or heteroarylene that has electron acceptor properties and is selected from the group consisting of the following formulae

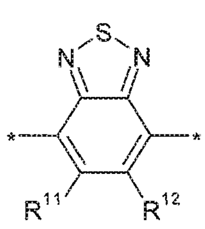
(A1)

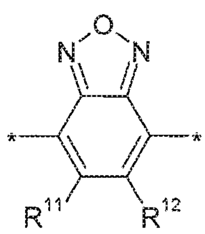
(A2)

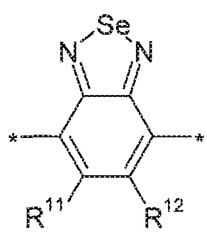
(A3)

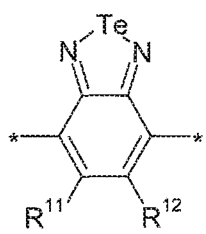
(A4)

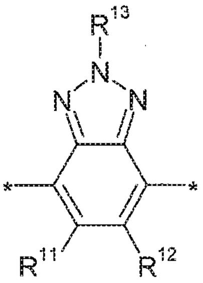
(A5)

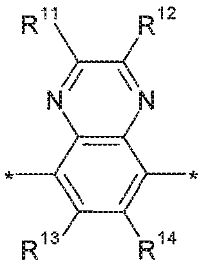
(A6)

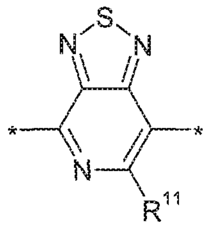
(A7)

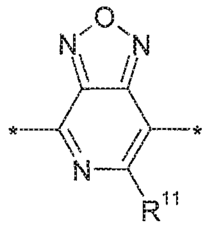
(A8)

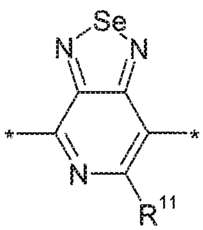
(A9)

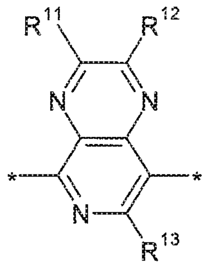
(A10)

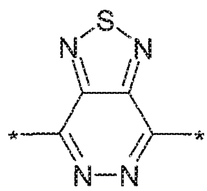
(A11)

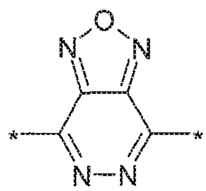
(A12)

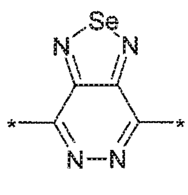
(A13)

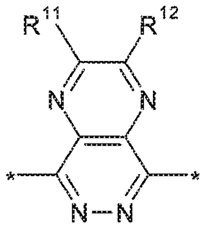
(A14)

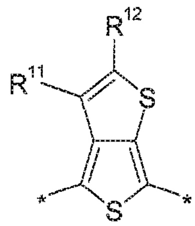
(A15)

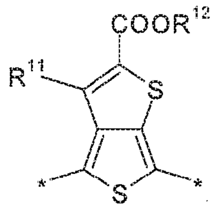
(A16)

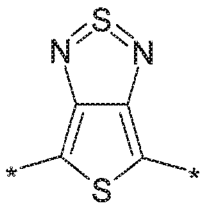

(A17)

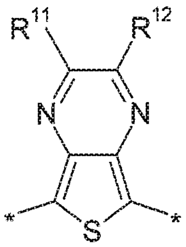

(A18)

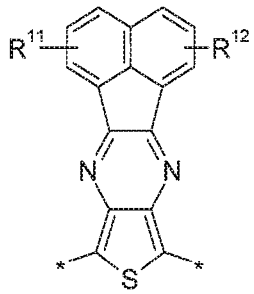

(A19)

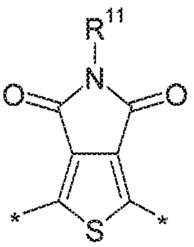

(A20)

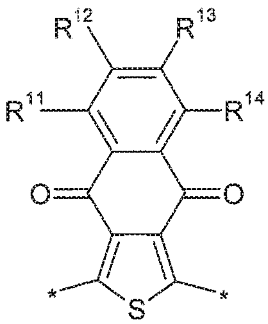

(A21)

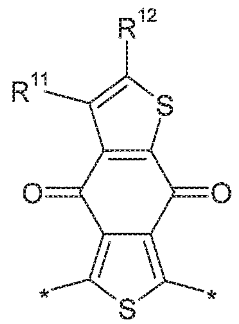

(A22)

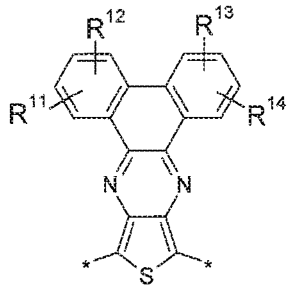

(A23)

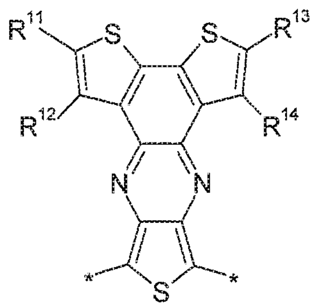

(A24)

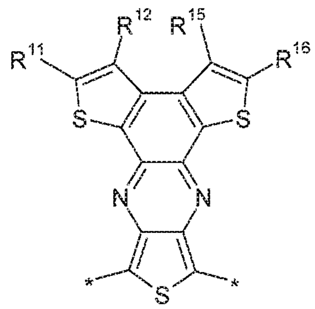

(A25)

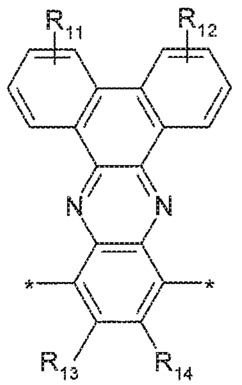

(A26)

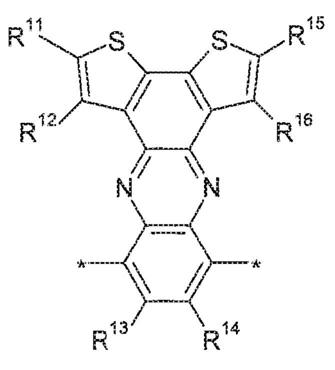

(A27)

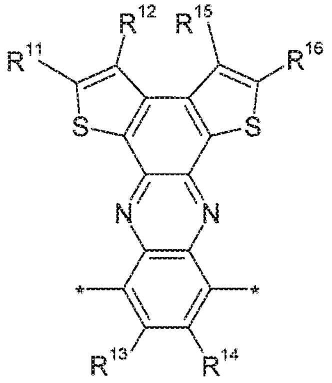

(A28)

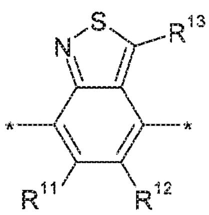
(A29)

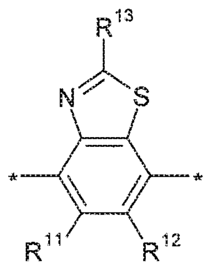
(A30)

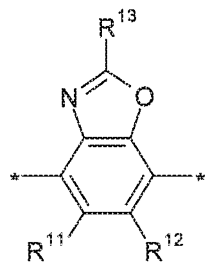
(A31)

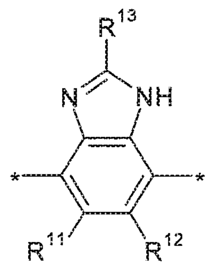
(A32)

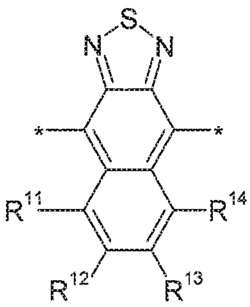
(A33)

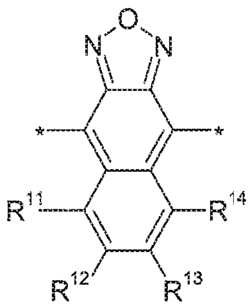
(A34)

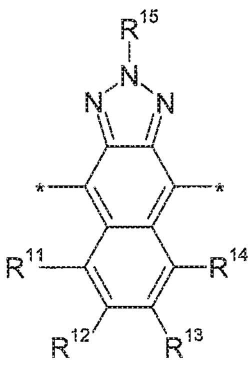
(A35)

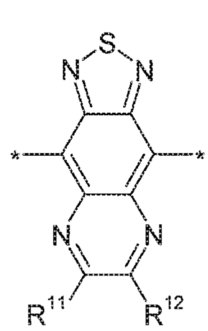
(A36)

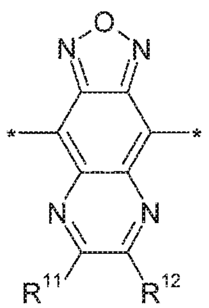
(A37)

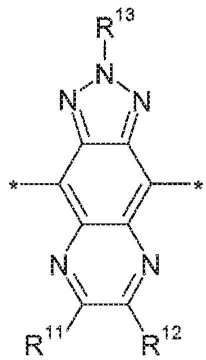
(A38)

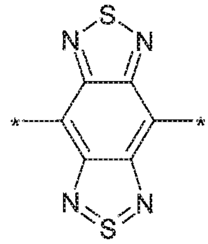
(A39)

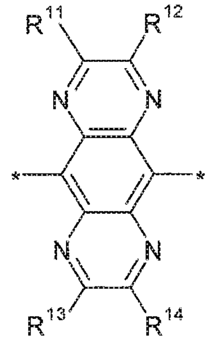
(A40)

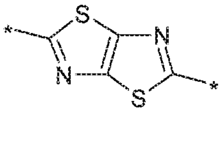
(A41)

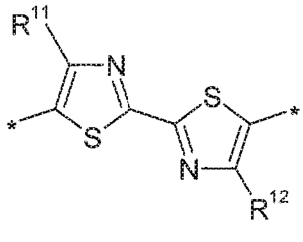
(A42)

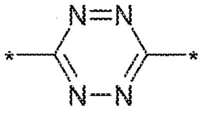
(A43)

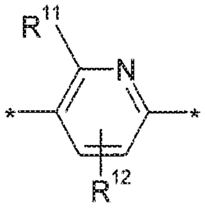 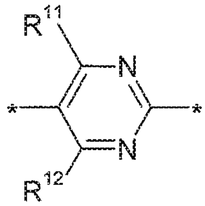 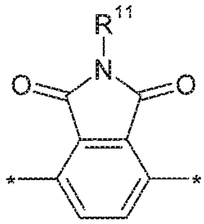 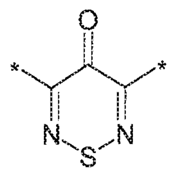

(A44) (A45) (A46) (A47)

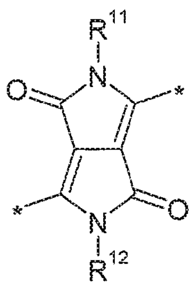 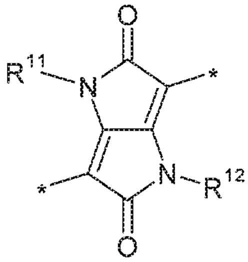 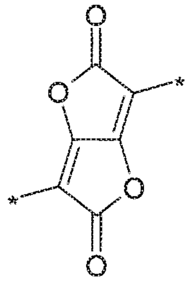 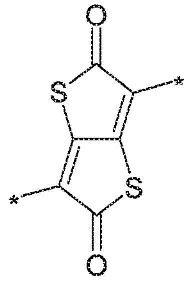

(A48) (A49) (A50) (A51)

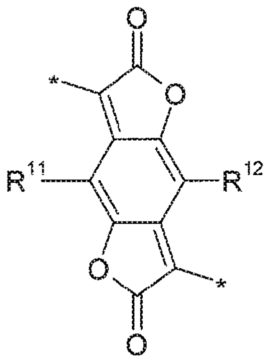 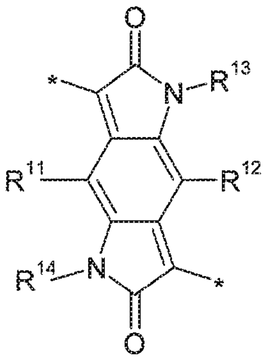 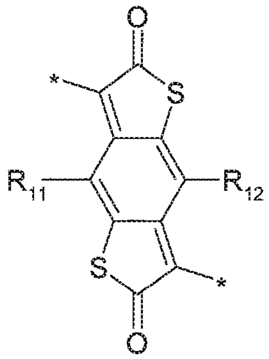

(A52) (A53) (A54)

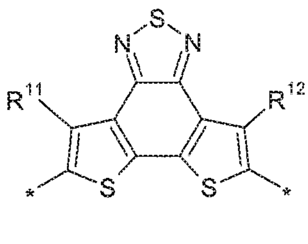 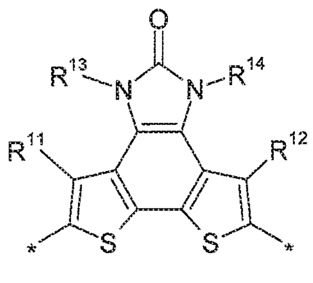 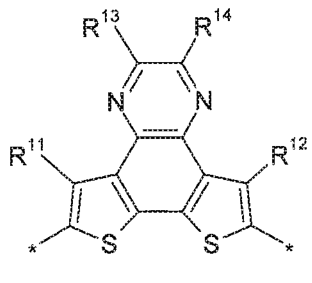

(A55) (A56) (A57)

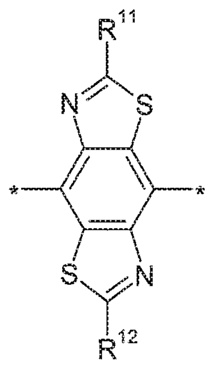
(A58)

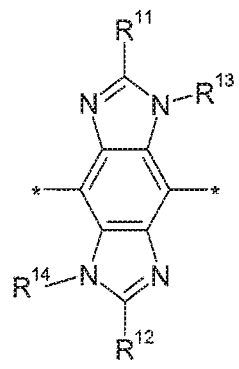
(A59)

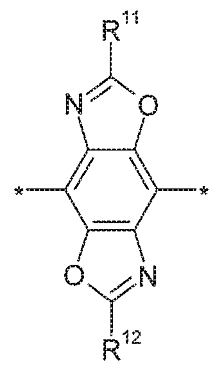
(A60)

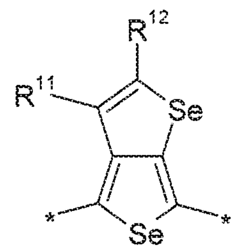
(A61)

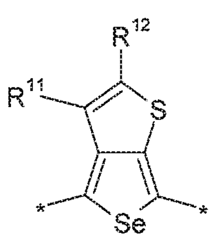
(A62)

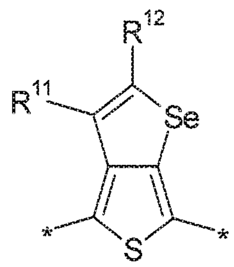
(A63)

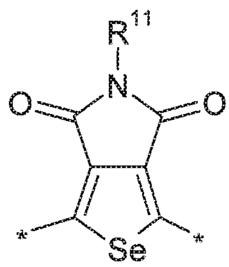
(A64)

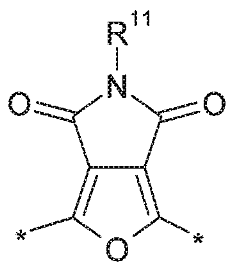
(A65)

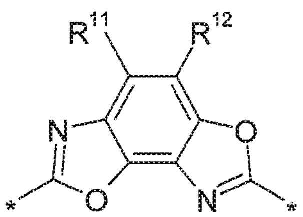
(A66)

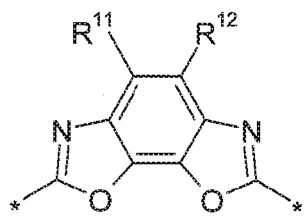
(A67)

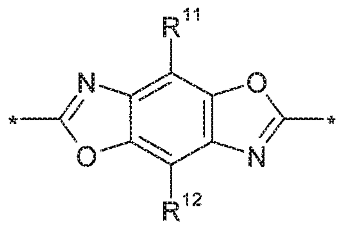
(A68)

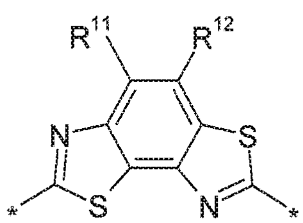
(A69)

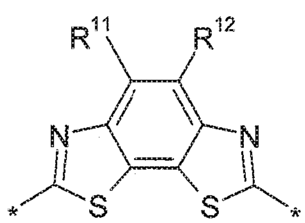
(A70)

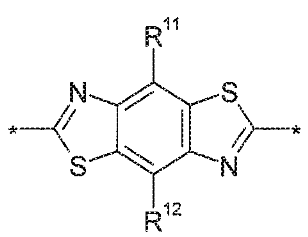
(A71)

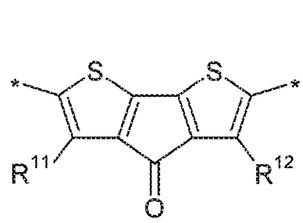

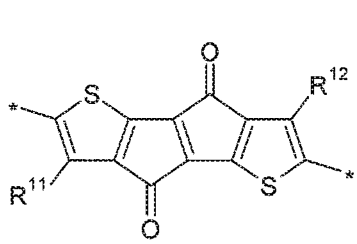

(A72) (A73)

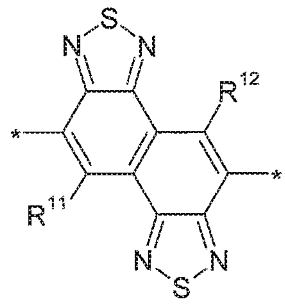
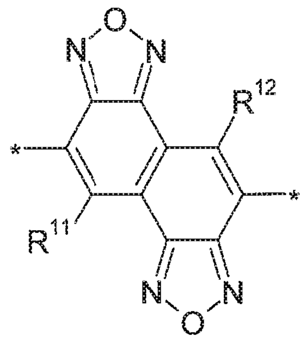
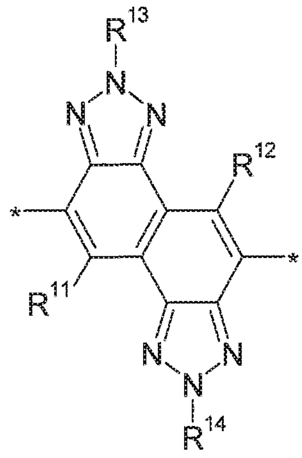

(A74) (A75) (A76)

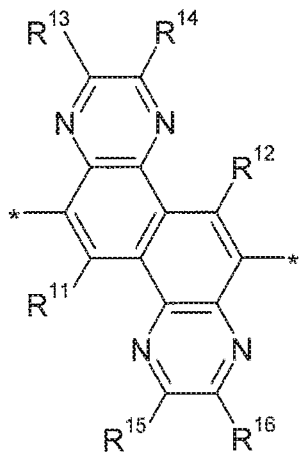
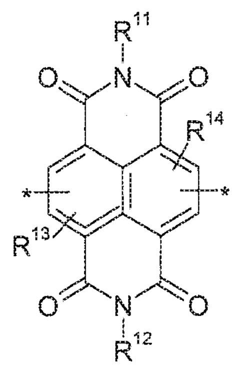
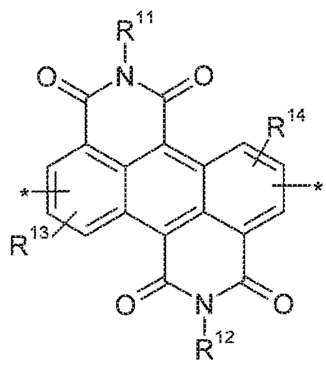

(A77) (A78) (A79)

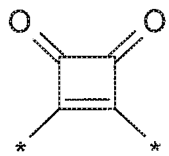
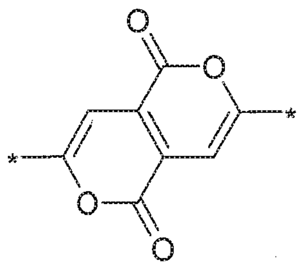
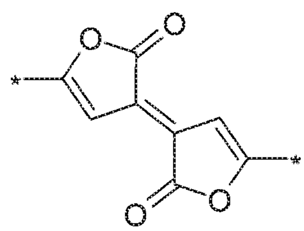

(A80) (A81) (A82)

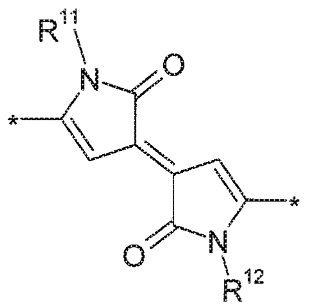

(A83)

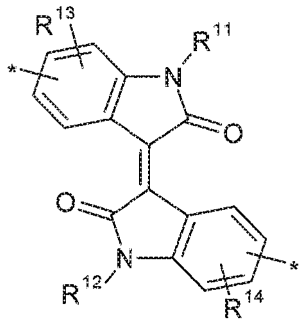

(A84)

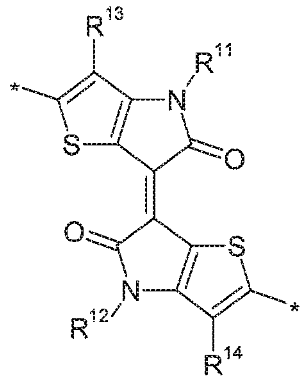

(A85)

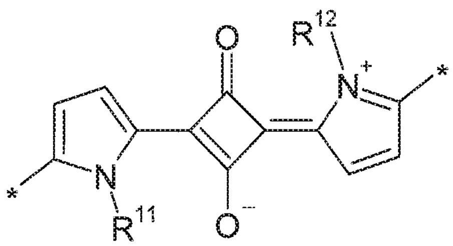

(A86)

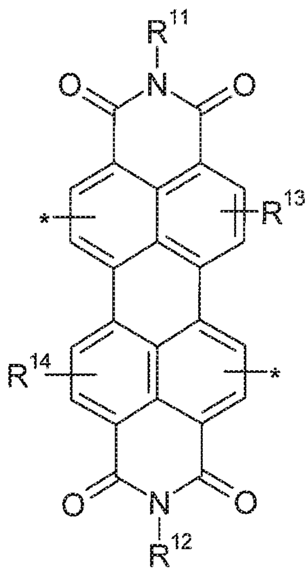

(A87)

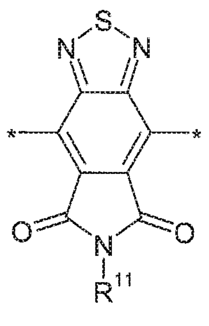

(A88)

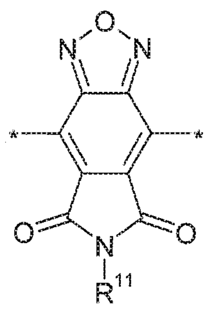

(A89)

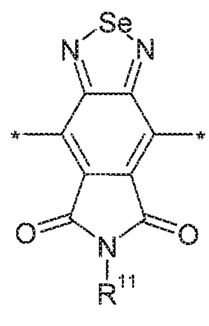

(A90)

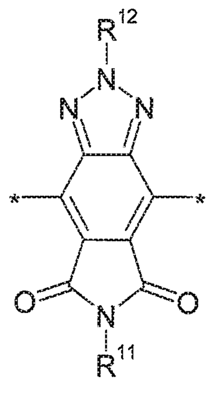

(A91)

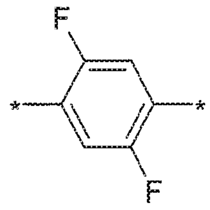

(A92)

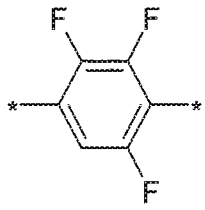

(A93)

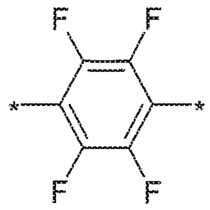

(A94)

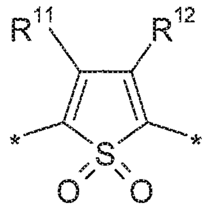

(A95)

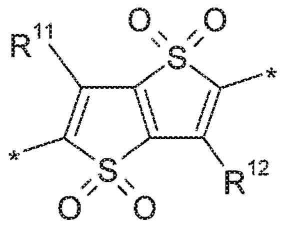

(A96)

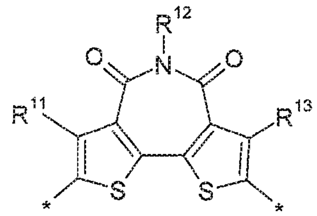

(A97)

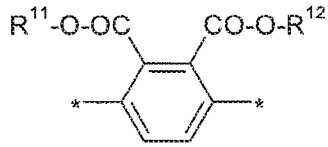

(A98)

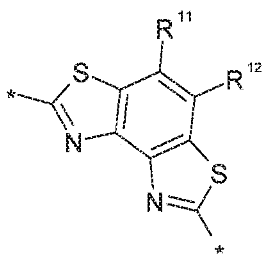

(A99)

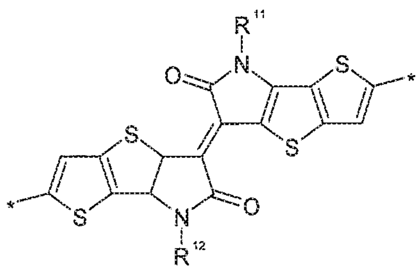

(A100)

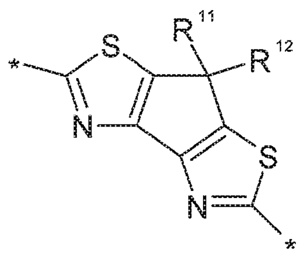

(A101)

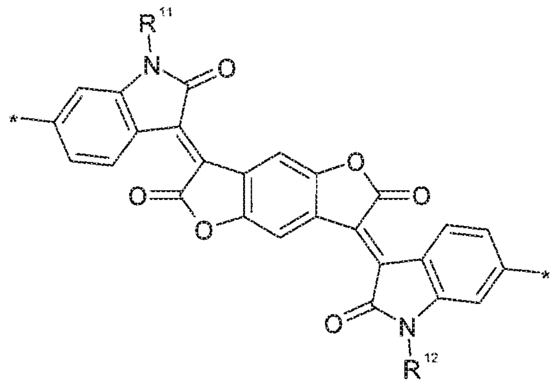

(A102)

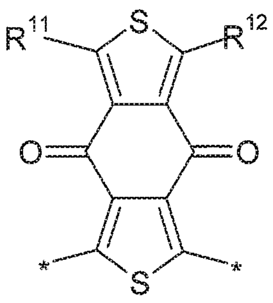

(A104)

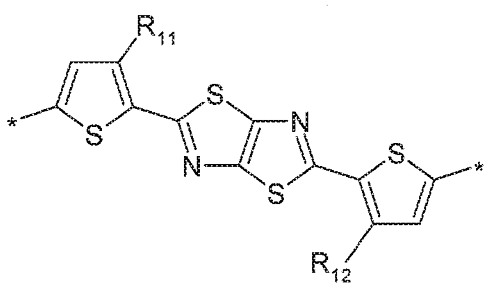

(A103)

wherein $R^{11}$, $R^{12}$, $R^{13}$, $R^{14}$, $R^{15}$ and $R^{16}$ independently of each other have one of the meanings of $R^3$ as given in formula I or one of its preferred meanings as given above and below.

Preferred acceptor units are selected from formulae A1, A6, A7, A15, A16, A20, A36, A74, A84, A88, A92, A94, A98 or A103 wherein preferably at least one of $R^{11}$, $R^{12}$, $R^{13}$ and $R^{14}$ is different from H.

Further preferred are repeating units and polymers of formulae II1, II2, II3, III, III1-III8, U1-U7, Pi-Pviii and their subformulae wherein one or more of $Ar^1$, $Ar^2$, $Ar^3$ and $Ar^4$, or wherein Sp, respectively, denote arylene or heteroarylene selected from the group consisting of the following formulae

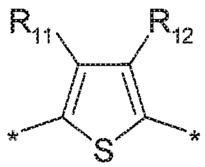

Sp1

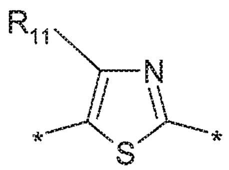

Sp2

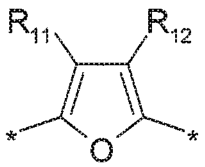

Sp3

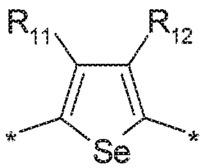

Sp4

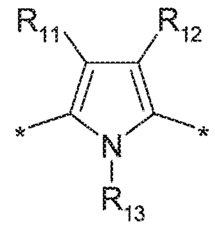

Sp5

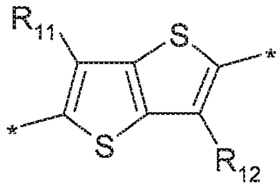

Sp6

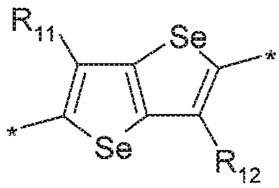

Sp7

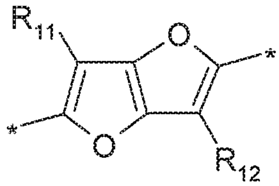

Sp8

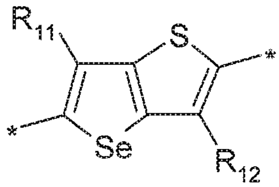

Sp9

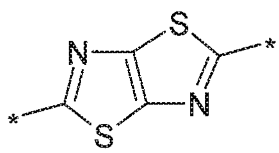

Sp10

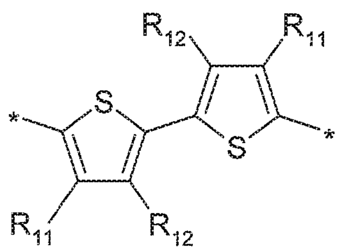

Sp11

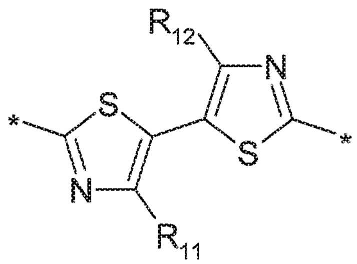

Sp12

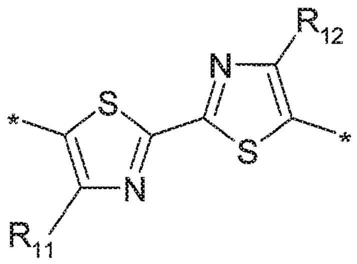

Sp13

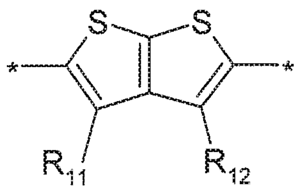

Sp14

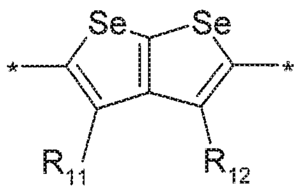

Sp15

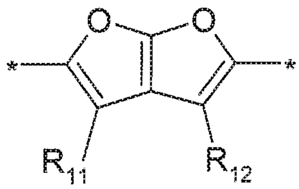

Sp16

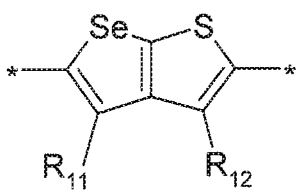

Sp17

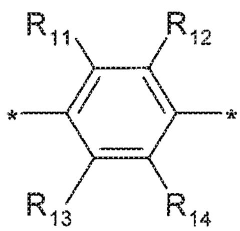

Sp18

wherein $R^{11}$, $R^{12}$, $R^{13}$, $R^{14}$ independently of each other have one of the meanings of $R^3$ as given in formula I or one of its preferred meanings as given above and below.

In the formulae Sp1 to Sp17 preferably $R^{11}$ and $R^{12}$ are H. In formula Sp18 preferably $R^{11-14}$ are H or F.

Very preferred are units selected from formulae Sp1, Sp2, Sp6, Sp10, Sp11, Sp12, Sp13 and Sp14, wherein preferably one of $R^{11}$ and $R^{12}$ is H or both $R^{11}$ and $R^{12}$ are H.

Further preferred are repeating units and polymers of formulae II1, II2, III, III1-III8 and their subformulae wherein

a) one or more of $Ar^1$, $Ar^2$, Ar3 and $Ar^4$ denote arylene or heteroarylene, preferably having electron donor properties, selected from the group consisting of the formulae D1-D151, very preferably of the formulae D1, D7, D10, D11, D19, D22, D29, D30, D35, D36, D37, D44, D55, D84, D87, D88, D89, D93, D94, D106, D111, D139, D140, D141, D146 and D150, and/or

b) one or more of $Ar^1$, $Ar^2$, $Ar^3$ and $Ar^4$ denote arylene or heteroarylene, preferably having electron accpetor properties, selected from the group consisting of the formulae A1-A103, very preferably of the formulae A1, A6, A7, A15, A16, A20, A36, A74, A84, A88, A92, A94, A98, A103 and A104,
and

c) one or more of $Ar^1$, $Ar^2$, $Ar^3$ and $Ar^4$ denote arylene or heteroarylene selected from the group consisting of the formulae Sp1-Sp18, very preferably of the formulae Sp1, Sp2, Sp6, Sp10, Sp11, Sp12, Sp13 and Sp14.

Further preferred are oligomers and polymers of subformulae III1-III8 wherein $Ar^1$ and $Ar^2$ have the same meaning and are selected from formulae D1, D7, D10, D11, D19, D22, D29, D30, D35, D36, D44, D55, D84, D87, D88, D89, D93, D106, D111, D140, D141, D146 and D150.

Further preferred are repeating units of formula U1-U7, oligomers and polymers of formula Pi-Pviii wherein

a) the donor units D are selected from the group consisting of the formulae D1, D7, D10, D11, D19, D22, D29, D30, D35, D36, D37, D44, D55, D84, D87, D88, D89, D93, D106, D111, D119, D140, D141, D146, and D147,
b) the acceptor units A selected from the group consisting of the formulae A1, A2, A5, A15, A16, A20, A74, A88, A92, A94 and A98, A99, A100, A104
and
c) the spacer units Sp selected from the group consisting of the formulae Sp1-Sp18, very preferably of the formulae Sp1, Sp6, Sp11 and Sp14,

wherein the spacer units, if present, are preferably located between the donor and acceptor units such that a donor unit and an acceptor unit are not directly connected to each other.

Further preferred oligomers and polymers of formula III and Pi-Pviii are selected from the following subformulae

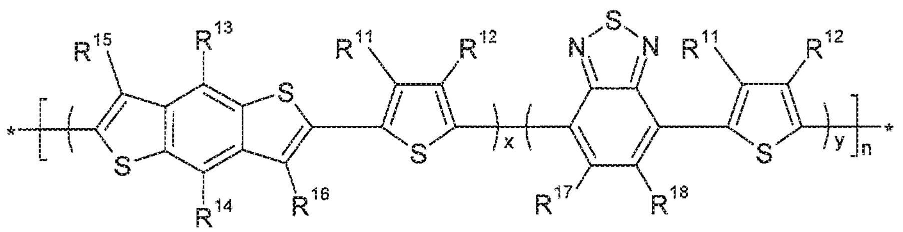

P1

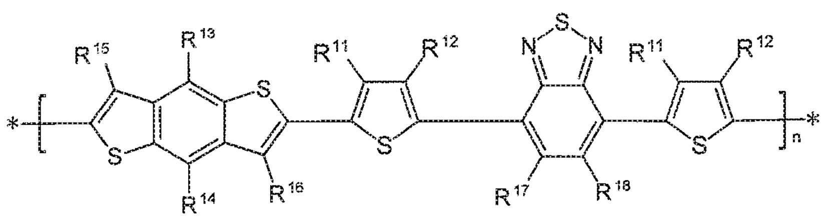

P2

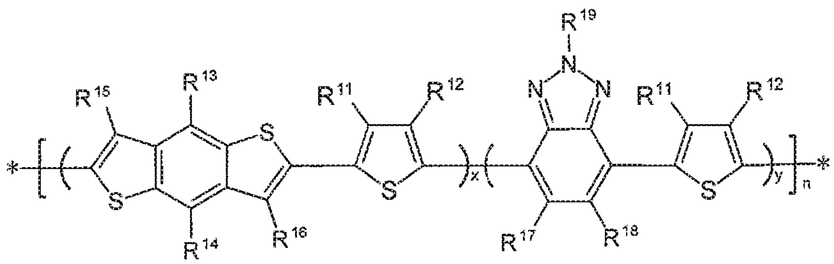
P3

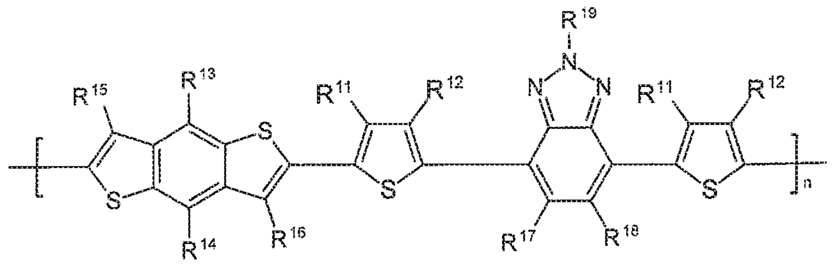
P4

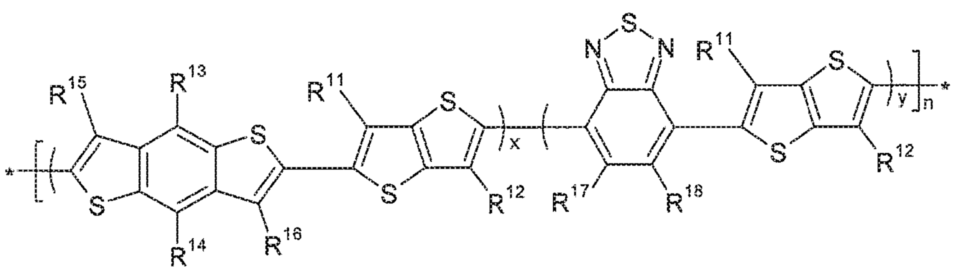
P5

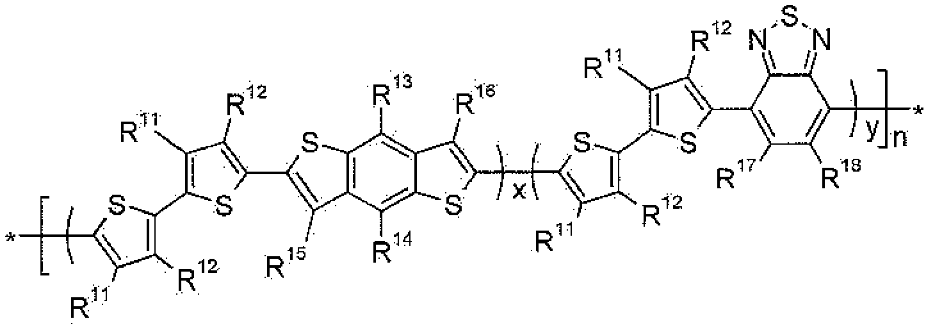
P6

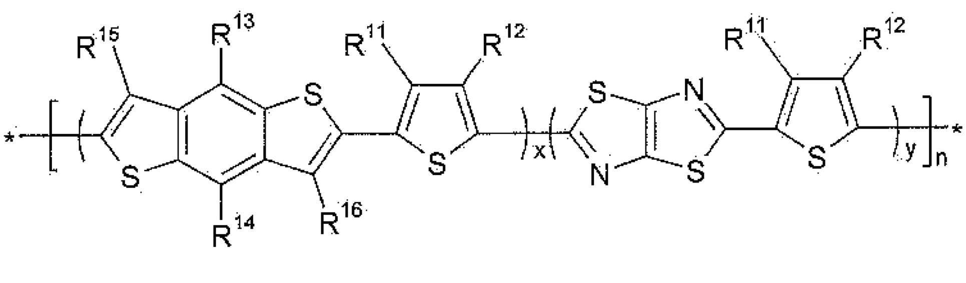
P7

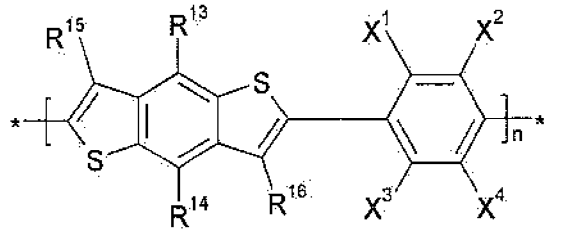

P5a

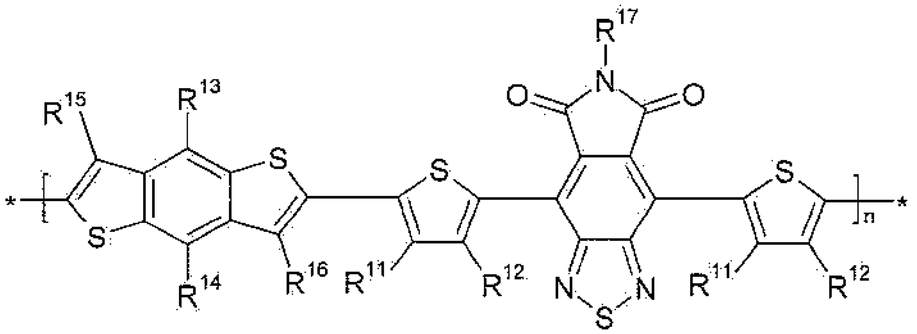

P6a

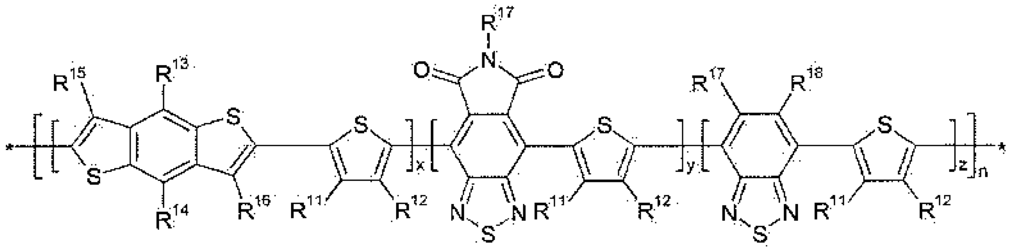

P7a

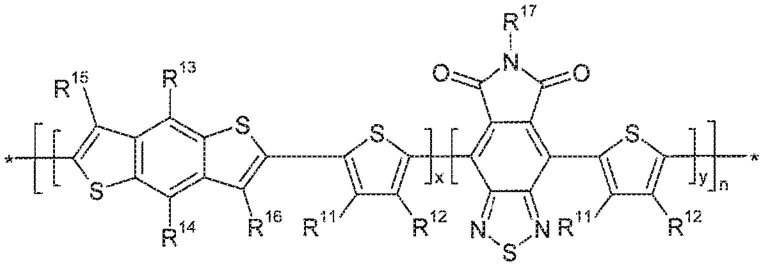

P8

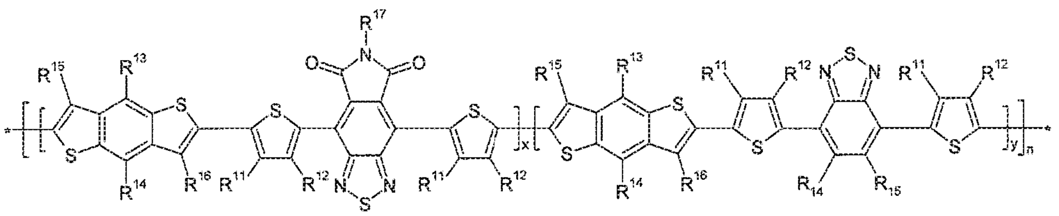

P9

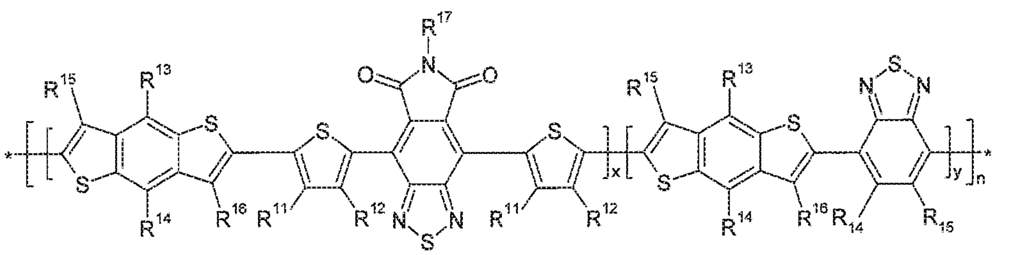

P10

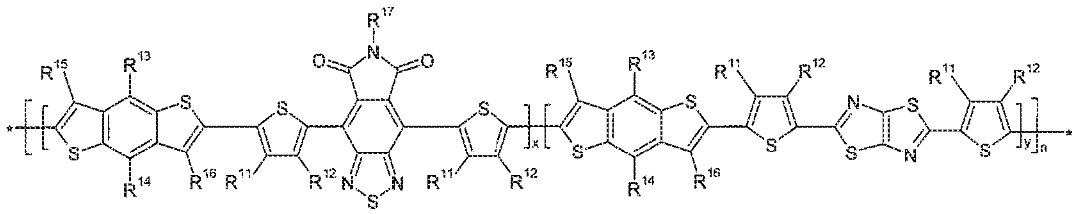

P11

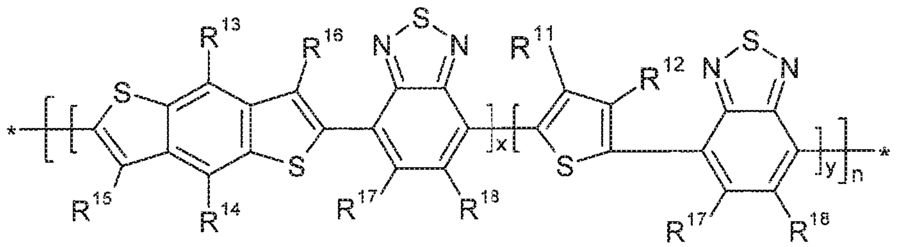

P12

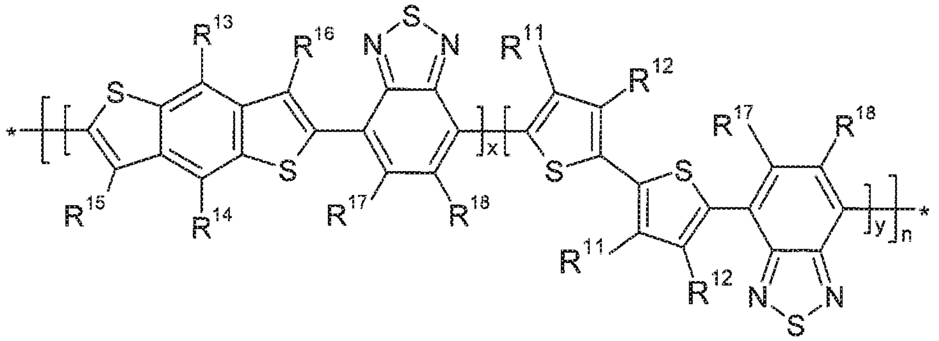

P13

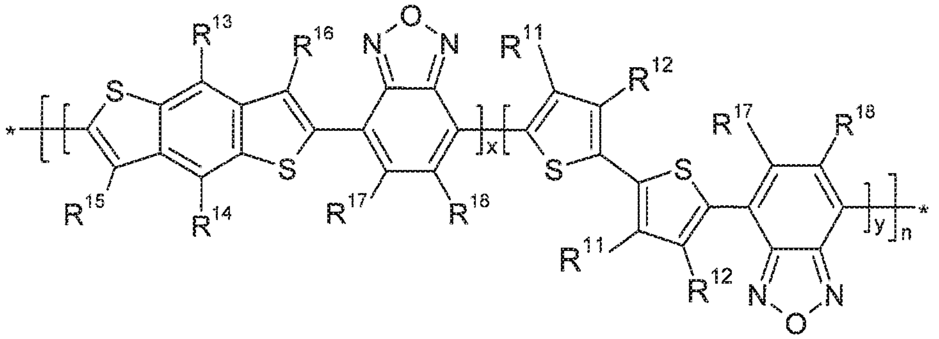

P14

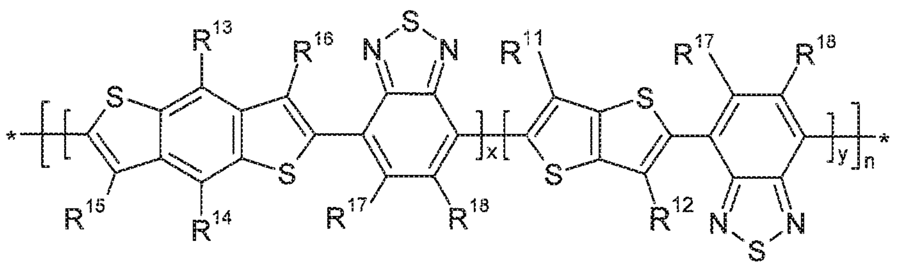

P15

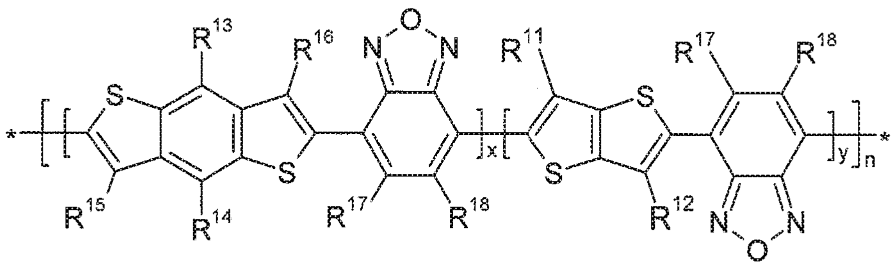

P16

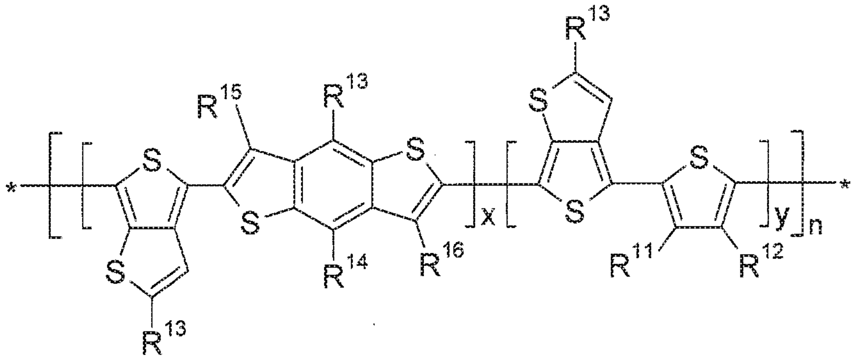

P17

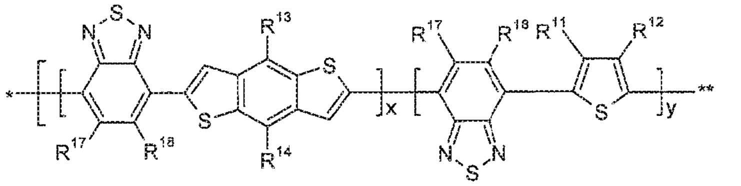

P18

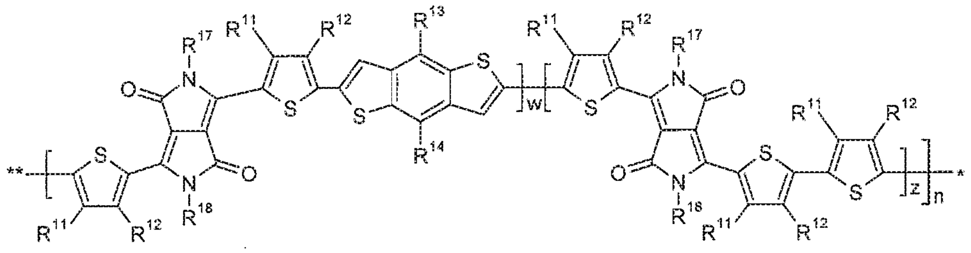

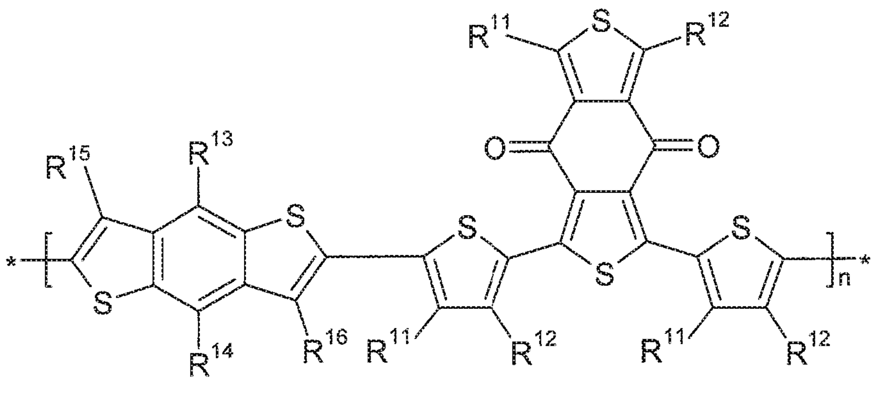

P19

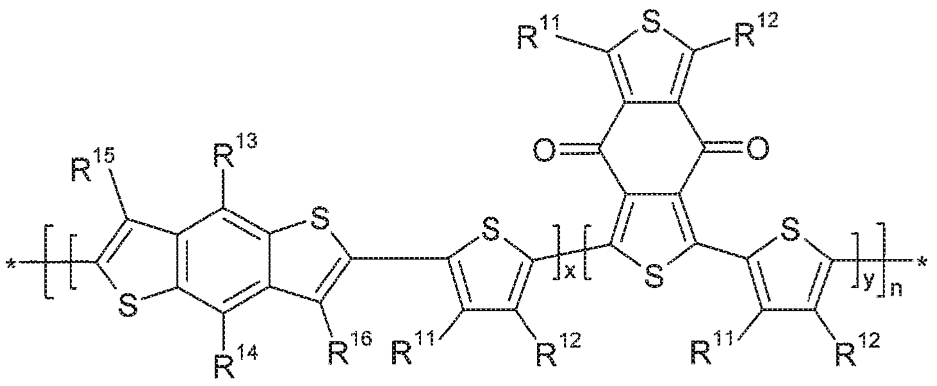

P20

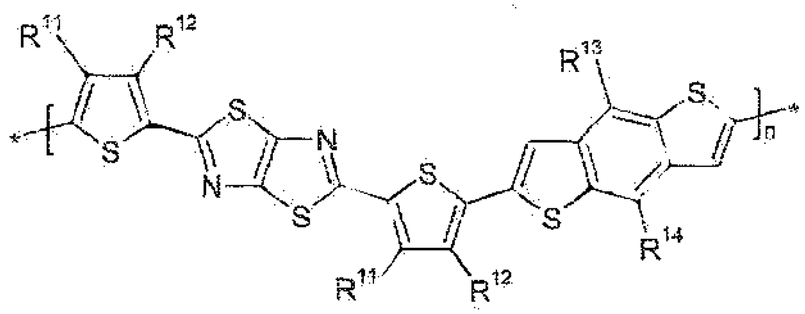

P21

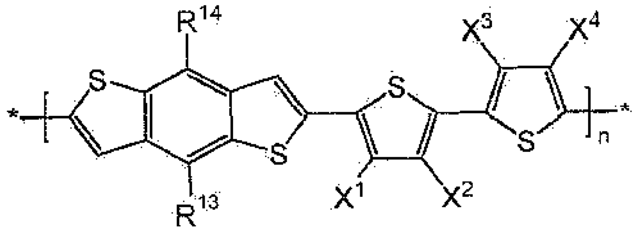

P22

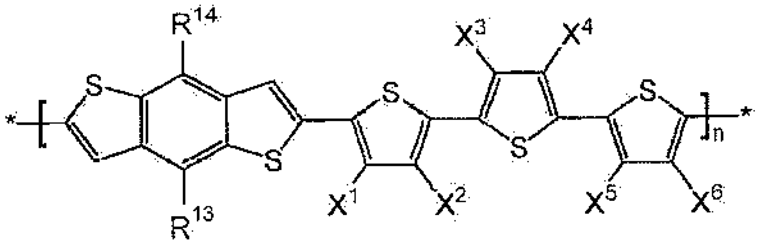

P23

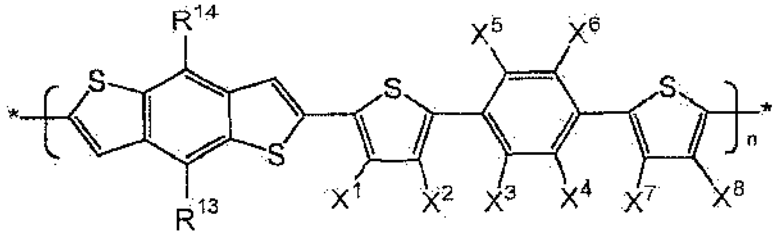

P24

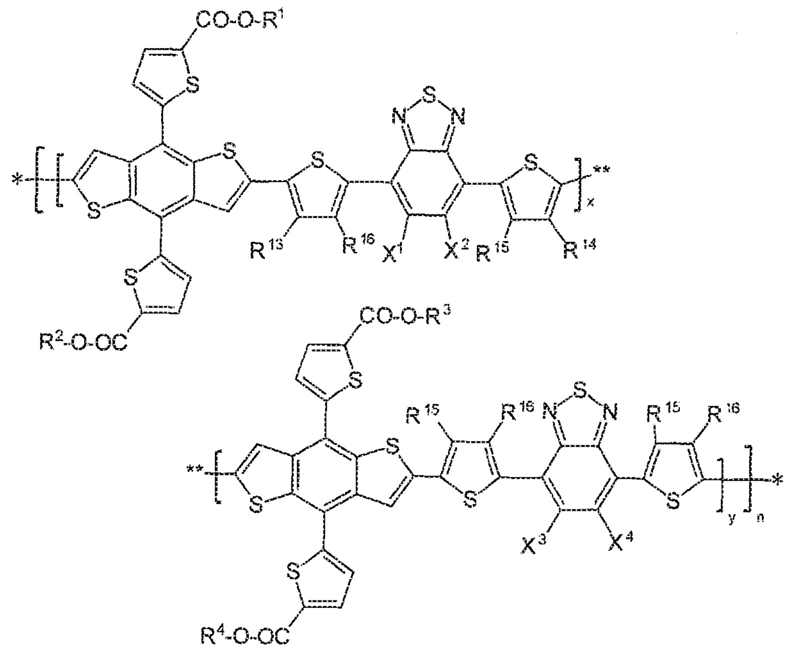

P25

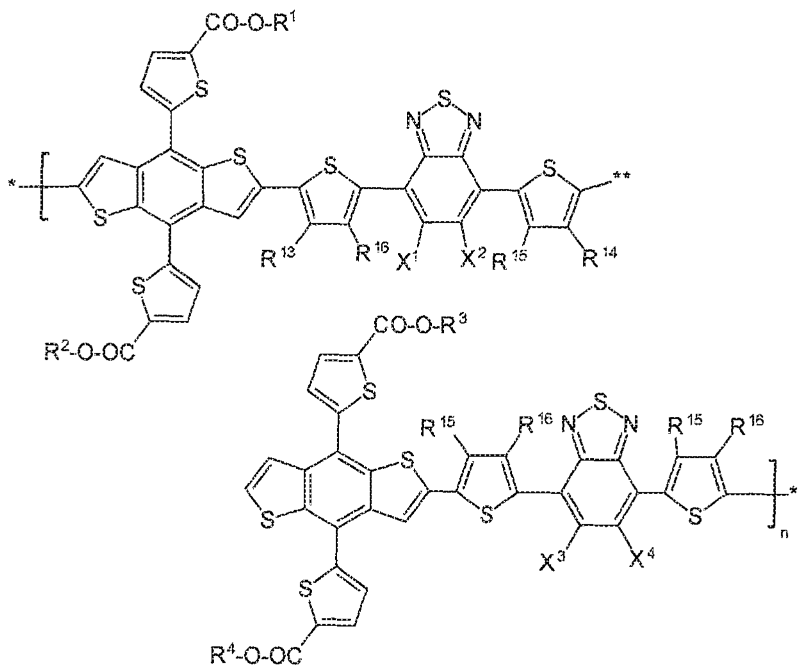

P26

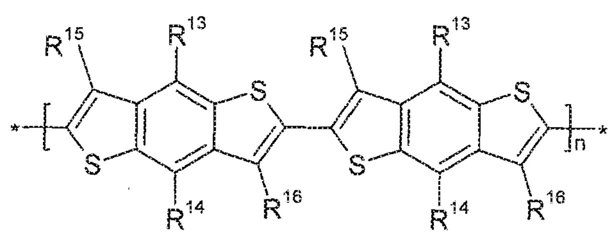

P27

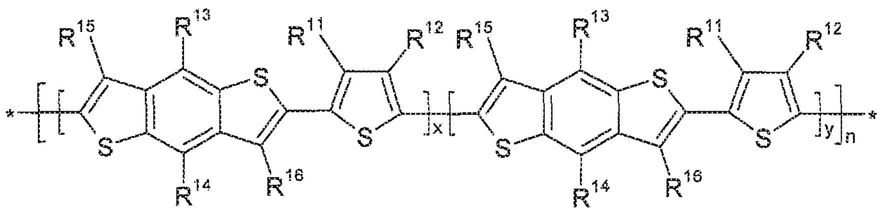

P28

wherein

$R^{13}$ denotes

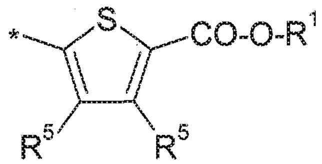

,

$R^{14}$ denotes

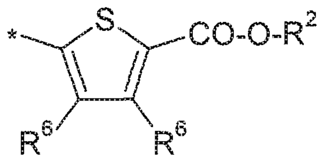

;

$R^1$, $R^2$, $R^5$ and $R^6$ have one of the meanings of formula I or one of the preferred meanings given above and below above and below, and $R^5$ and $R^6$ preferably denote H,

x, y and n have one of the meanings of formula III or one of the preferred meanings given above and below above and below,

$R^{11}$, $R^{12}$, $R^{15}$, $R^{16}$, $R^{17}$, $R^{18}$ and $R^{19}$ have one of the meanings of $R^3$ as given in formula I or one of its preferred meanings as given above and below,

$X^1$, $X^2$, $X^3$, $X^4$, $X^5$ and $X^6$ have one of the meanings of $R^3$ given in formula I or one of its preferred meanings given above and below, and preferably denote H, F, Cl, -CN, $R^0$, $OR^a$ or $C(=O)OR^0$, and $R^0$ is as defined above and below.

Further preferably the conjugated polymer is selected of formula IV

$R^{21}$-chain-$R^{22}$ IV

wherein "chain" denotes a polymer chain selected of formulae III, III1-III8, Pi-Pviii and P1-P28, and $R^{21}$ and $R^{22}$ have independently of each other one of the meanings of L as defined above, or denote, independently of each other, H, F, Br, Cl, I, $-CH_2Cl$, -CHO, -CR'=CR"$_2$, -SiR'R"R‴, -SiR'X'X", -SiR'R"X', -SnR'R"R‴, -BR'R", -B(OR')(OR"), $-B(OH)_2$, -O-$SO_2$-R', -C≡CH, - C≡C-SiR'$_3$, -ZnX' or an endcap group, X' and X" denote halogen, R', R" and R‴ have independently of each other one of the meanings of $R^0$ given in formula I, and preferably denote alkyl with 1 to 12 C atoms, and two of R', R" and R‴ may also form a cyclosilyl, cyclostannyl, cycloborane or cycloboronate group with 2 to 20 C atoms together with the respective hetero atom to which they are attached.

Preferred endcap groups $R^{21}$ and $R^{22}$ are H, $C_{1-20}$ alkyl, or optionally substituted $C_{6-12}$ aryl or $C_{2-10}$ heteroaryl, very preferably H or phenyl.

In the oligomers and polymers according to the present invention, including but not limited to those of formula III, IV, Pi-Pviii, P1-P28 and their subformulae, the indices v, w, x, y and z denote the mole fraction of the corresponding repeating units, such as A-E, and n denotes the degree of polymerisation or total number of repeating units. These formulae include block copolymers, random or statistical copolymers and alternating copolymers, as well as homopolymers for the case when x>0 and v=w=y=z=0.

In the oligomers and polymers according to the present invention, including but not limited to those of formula III, IV, Pi-Pviii, P1-P28 and their subformulae, wherein one of v, w, y and z is not 0 and the others of v, w, y and z are 0, x and the one of v, w, y and z which is not 0 are each preferably from 0.1 to 0.9, very preferably from 0.3 to 0.7.

In the polymers according to the present invention, including but not limited to those of formula III, IV, Pi-Pviii, P1-P28 and their subformulae, wherein two of v, w, y and z are not 0 and the others of v, w, y and z are 0, x and those of v, w, y and z which are not 0 are each preferably from 0.1 to 0.8, very preferably from 0.2 to 0.6.

In the oligomers and polymers according to the present invention, including but not limited to those of formula III, IV, Pi-Pviii, P1-P28 and their subformulae, wherein three of v, w, y and z are not 0 and the others of v, w, y and z are 0, x and those of v, w, y and z which are not 0 are each preferably from 0.1 to 0.7, very preferably from 0.2 to 0.5.

In the oligomers and polymers according to the present invention, including but not limited to those of formula III, IV, Pi-Pviii, P1-P28 and their subformulae, wherein all of v, w, y and z are not 0, x, v, w, y and z are each preferably from 0.1 to 0.6, very preferably from 0.2 to 0.4.

In the oligomers according to the present invention, the total number of repeating units n is preferably from 2 to 10, very preferably from 2 to 5.

In the polymers according to the present invention, the total number of repeating units n is preferably from 2 to 10,000, very preferably from 5 to 10,000. The total number of repeating units n is preferably $\geq 5$, very preferably $\geq 10$, most preferably $\geq 50$, and preferably $\leq 500$, very preferably $\leq 1{,}000$, most preferably $\leq 2{,}000$, including any combination of the aforementioned lower and upper limits of n.

The polymers of the present invention include homopolymers and copolymers, like statistical or random copolymers, alternating copolymers and block copolymers, as well as combinations thereof.

The oligomers and polymers of the present invention can be prepared from the corresponding monomers, which are preferably selected from formula V1 and V2

$R^{23}\text{-}(Ar^1)_a\text{-}U\text{-}(Ar^2)_b\text{-}(Ar^3)_c\text{-}(Ar^4)_d\text{-}R^{24}$ V1

$R^{23}\text{-}(Ar^1)_a\text{-}(Ar)_b\text{-}U\text{-}(Ar^3)_c\text{-}(Ar^4)_d\text{-}R^{24}$ V2

wherein U, $Ar^{1-4}$ , a, b, c and d have the meanings of formula II1, or one of the preferred meanings as described above and below, and $R^{23}$ and $R^{24}$ are independently of each other selected from the group consisting of H, which is preferably an activated C-H bond, Cl, Br, I, O-tosylate, O-triflate, O-mesylate, O-nonaflate, $-SiMe_2F$, $-SiMeF_2$, $-O-SO_2Z^1$, $-B(OZ^2)_2$ , $-CZ^3=C(Z^3)_2$, -C=CH, $-C\equiv CSi(Z^1)_3$, $-ZnX^0$ and $-Sn(Z^4)_3$, wherein $X^0$ is halogen, $Z^{1-4}$ are selected from the group consisting of alkyl and aryl, preferably $C_{1-10}$ alkyl and $C_{6-12}$ aryl, each being optionally substituted, and two groups $Z^2$ may also form a cycloboronate group having 2 to 20 C atoms together with the B- and O-atoms, and wherein at least one of $R^{23}$ and $R^{24}$ is different from H, and preferably both of $R^{23}$ and $R^{24}$ are different from H.

Very preferred are monomers of formula V1 and V2 and their subformulae wherein a+b+c+d $\geq 1$.

Further preferred are monomers of formula V1 and its subformulae wherein a+b+c+d=0.

Further preferred are monomers of formula V1 and V2 and their subformulae wherein $R^{23}$ and $R^{24}$ are selected from Br, $-B(OZ^2)_2$ and $Sn(Z^4)_3$.

Further preferred are monomers selected from the following subformulae

$R^{23}\text{-}U\text{-}R^{24}$ V1a

$R^{23}\text{-}Ar^1\text{-}U\text{-}Ar2\text{-}R^{24}$ V1b

$R^{23}\text{-}Ar^1\text{-}U\text{-}R^{24}$ V1c

$R^{23}\text{-}U\text{-}Ar^2\text{-}R^{24}$ V1d

wherein U, $Ar^1$, $Ar^2$, $R^{23}$ and $R^{24}$ are as defined in formula V1.

Very preferred are monomers of formula V1 and V2 and their subformulae wherein $R^{23}$ and $R^{24}$ are selected from Br, $B(OZ^2)_2$ and $Sn(Z^4)_3$.

Further preferred are monomers of of formulae V1, V2, V1a-V1d and their subformulae wherein $Ar^1$ and/or $Ar^2$ are selected from the following groups

a) the group consisting of the formulae D1-D145, very preferably of the formulae D1, D7, D10, D11, D19, D22, D29, D30, D35, D36, D37, D44, D55, D84, D87, D88, D89, D93, D94, D106, D111, D139, D140, D141 and D150,

b) the group consisting of the formulae A1-A98, very preferably of the formulae A1, A6, A7, A15, A16, A20, A36,

A74, A84, A88, A92, A98 and A103,

c) the group consisting of the formulae Sp1-Sp18, very preferably of the formulae Sp1, Sp2, Sp6, Sp10, Sp11, Sp12, Sp13 and Sp14.

Further preferred are monomers of formula V3

$$R^{23}\text{-}U^{*}\text{-}R^{24} \qquad V3$$

wherein $R^{23}$ and $R^{24}$ have the meanings given above and below, and preferably denote Br, $B(OZ^2)_2$ or $Sn(Z^4)_3$, and U* is a unit selected from the subformulae P1-P28 above wherein n is 1.

Novel monomers selected from the formulae V1, V2, V3 and their subformulae as described above and below are another object of the invention.

Another object of the invention are monomers selected form formula V1 or V2 wherein at least one of a, b, c and d is different from 0, preferably selected from formulae V1b, V1c and V1d or the preferred monomer embodiments as described above and below. Another object of the invention are monomers selected form formula V3

Further preferred units, monomers, oligomers and polymers of formulae I, I1, II1, II2, II3, III, III1-III8, U1-U7, Pi-Pviii, P1-P28, IV, V1, V2, V3 and their subformulae are selected from the following embodiments, including any combination thereof:

- $n \geq 5$,
- n is from 5 to 2,000, most preferably from 10 to 1,000,
- a1 is 1 or 2 and b1 is 0,
- a1=b1=1 and c1 and d1 are independently of each other 0, 1 or 2, preferably 0 or 1, very preferably 0,
- a1 is 2, b1 is 1 or 2, c1 is 0 or 1, preferably 0, and d1 is 0, 1 or 2, preferably 0 or 1, very preferably 0,
- $R^1$ and $R^2$ are selected from alkyl that is straight-chain or branched, has 1 to 25, preferably 1 to 18 C atoms, and is optionally fluorinated,
- $R^1$ and $R^2$ are selected from formulae SUB1-SUB6,
- $R^{3-6}$ denote H,
- one or more of $R^{3-6}$ is different from H and is selected from alkyl, alkoxy or thiaalkyl, all of which are straight-chain or branched, have 1 to 25, preferably 1 to 18 C atoms, and are optionally fluorinated,
- one or more of $R^{3-6}$ is different from H and is selected from F, Cl, CN, - C(=O)-$R^n$, -C(=O)-O$R^n$, -C(=O)-NH$R^n$ and -C(=O)-N$R^nR^m$, wherein $R^m$ and $R^n$ are independently of each other straight-chain or branched alkyl with 1 to 25, preferably 1 to 18 C atoms that is optionally fluorinated,
- one or more of $R^{3-6}$ is different from H and is selected from the group consisting of aryl, heteroaryl, aryloxy, heteroaryloxy, arylalkyl and heteroarylalkyl, each of which has 4 to 20 ring atoms and optionally contains fused rings and is unsubstituted or substituted by one or more groups L as defined in formula I,
- one or more of $R^{11-18}$ is different from H and is selected from alkyl, alkoxy or thiaalkyl, all of which are straight-chain or branched, have 1 to 25, preferably 1 to 18 C atoms, and are optionally fluorinated,
- one or more of $R^{11-18}$ is different from H and is selected from F, Cl, CN, - C(=O)-$R^n$, -C(=O)-O$R^n$, -C(=O)-NH$R^n$ and -C(=O)-N$R^nR^m$, wherein $R^m$ and $R^n$ are independently of each other straight-chain or branched alkyl with 1 to 25, preferably 1 to 18 C atoms that is optionally fluorinated,
- one or more of $R^{11-18}$ is different from H and is selected from the group consisting of aryl, heteroaryl, aryloxy, heteroaryloxy, arylalkyl and heteroarylalkyl, each of which has 4 to 20 ring atoms and optionally contains fused rings and is unsubstituted or substituted by one or more groups L as defined in formula I,

- R is straight-chain or branched alkyl with 1 to 25, preferably 1 to 18 C atoms which is optionally fluorinated,
- R is aryl, heteroaryl, arylalkyl or heteroarylalkyl, each of which has 4 to 20 ring atoms, optionally contains fused rings, and is unsubstituted or substituted by one or more groups L as defined in formula I,
- L is selected from alkyl, alkoxy or thiaalkyl, all of which are straight-chain or branched, have 1 to 25, preferably 1 to 18 C atoms, and are optionally fluorinated,
- L is selected from F, Cl, CN, -C(=O)-$R^n$, -C(=O)-O$R^n$, -C(=O)-NH$R^n$ and -C(=O)-N$R^nR^m$, wherein $R^m$ and $R^n$ are independently of each other straight-chain or branched alkyl with 1 to 25, preferably 1 to 18 C atoms that is optionally fluorinated,
- L is halogen, preferably F or Cl,
- L is CN, F or Cl,
- $R^{21}$ and $R^{22}$ are selected from H, $C_{1-20}$ alkyl, or optionally substituted $C_{6-12}$ aryl or $C_{2-10}$ heteroaryl, very preferably H or phenyl,
- $R^{23}$ and $R^{24}$ denote Br, $B(OZ^2)_2$ or $Sn(Z^4)_3$, wherein $Z^2$ and $Z^4$ are as defined in formula V1.

The oligomers and polymers according to the present invention can be synthesized according to or in analogy to methods that are known to the skilled person and are described in the literature. Other methods of preparation can be taken from the examples.

The oligomers and polymers according to the present invention can be prepared for example by copolymerising one or more monomers of formula V1, V2 or V1a-V1d with each other or with one or monomers of the following formulae in an aryl-aryl coupling reaction

$R^{23}$-$Ar^1$-$R^{24}$ MI

$R^{23}$-Af-$R^{24}$ MiI

$R^{23}$-$Ar^3$-$R^{24}$ MiII

$R^{23}$-$Ar^4$-$R^{24}$ MIV

wherein $Ar^{1-4}$, $R^{23}$ and $R^{24}$ have the meanings given in formula II2 and V1 or one of the preferred meanings given above and below.

For example, the oligomers and polymers can be suitably prepared by aryl-aryl coupling reactions, such as Yamamoto coupling, C-H activation coupling, Suzuki coupling, Stille coupling, Sonogashira coupling, Heck coupling or Buchwald coupling. Suzuki coupling, Stille coupling and Yamamoto coupling are especially preferred. The monomers which are polymerised to form the repeat units of the polymers can be prepared according to methods which are known to the person skilled in the art.

Preferably the oligomers and polymers are prepared from monomers selected from formulae V1, V2, V3, V1a-d and MI-MIV as described above.

Another aspect of the invention is a process for preparing an oligomer or polymer by coupling one or more identical or different monomers selected from formulae V1, V2, V1a-d with each other and/or with one or more comonomers, preferably selected from formulae MI-MIV, in a polymerisation reaction, preferably in an aryl-aryl coupling reaction.

Preferred aryl-aryl coupling and polymerisation methods used in the processes described above and below are Yamamoto coupling, Kumada coupling, Negishi coupling, Suzuki coupling, Stille coupling, Sonogashira coupling, Heck coupling, C-H activation coupling, Ullmann coupling or Buchwald coupling. Especially preferred are Suzuki coupling, Negishi coupling, Stille coupling and Yamamoto coupling. Suzuki coupling is described for example in WO 00/53656 A1. Negishi coupling is described for example in J. Chem. Soc., Chem. Common., 1977, 683-684. Yamamoto coupling is described in for example in T. Yamamoto et al., Prog. Polym. Sci., 1993, 17, 1153-1205, or WO 2004/022626 A1 .Stille coupling is described for example in Z. Bao et al., J. Am. Chem. Soc., 1995, 117, 12426-12435. C-H activation is described for example for example in M. Leclerc et al, Angew. Chem. Int. Ed. 2012, 51, 2068 - 2071.For example, when using Yamamoto coupling, monomers having two reactive halide groups are preferably used. When using Suzuki coupling, monomers having two reactive boronic acid or boronic acid ester groups or two reactive halide groups are preferably

used. When using Stille coupling, monomers having two reactive stannane groups or two reactive halide groups are preferably used. When using Negishi coupling, monomers having two reactive organozinc groups or two reactive halide groups are preferably used. When synthesizing a linear polymer by C-H activation polymerisation, preferably a monomer as described above is used wherein at least one reactive group is an activated hydrogen bond.

Preferred catalysts, especially for Suzuki, Negishi or Stille coupling, are selected from Pd(0) complexes or PD(II) salts. Preferred Pd(0) complexes are those bearing at least one phosphine ligand such as $Pd(Ph_3P)_4$. Another preferred phosphine ligand is tris(*ortho*-tolyl)phosphine, i.e. $Pd(o\text{-}Tol_3P)_4$. Preferred PD(II) salts include palladium acetate, i.e. $Pd(Oac)_2$ or trans-di(μ-acetato)-bis[o-(di-o-tolylphosphino)benzyl]dipalladium(II). Alternatively the Pd(0) complex can be prepared by mixing a Pd(0) dibenzylideneacetone complex, for example tris(dibenzyl-ideneacetone)dipalladium(0), bis(dibenzylideneacetone)palladium(0), or PD(II) salts *e.g.* palladium acetate, with a phosphine ligand, for example triphenylphosphine, tris(*ortho*-tolyl)phosphine, tris(o-methoxyphenyl)phosphine or tri(tert-butyl)phosphine. Suzuki polymerisation is performed in the presence of a base, for example sodium carbonate, potassium carbonate, cesium carbonated, lithium hydroxide, potassium phosphate or an organic base such as tetraethylammonium carbonate or tetraethylammonium hydroxide. Yamamoto polymerisation employs a Ni(0) complex, for example bis(1,5-cyclooctadienyl) nickel(0).

Suzuki, Stille or C-H activation coupling polymerisation may be used to prepare homopolymers as well as statistical, alternating and block random copolymers. Statistical, random block copolymers or block copolymers can be prepared for example from the above monomers, wherein one of the reactive groups is halogen and the other reactive group is a C-H activated bond, boronic acid, boronic acid derivative group or and alkylstannane. The synthesis of statistical, alternating and block copolymers is described in detail for example in WO 03/048225 A2 or WO 2005/014688 A2.

As alternatives to halogen as described above, leaving groups of formula $-O-SO_2Z^1$ can be used wherein $Z^1$ is as defined above. Particular examples of such leaving groups are tosylate, mesylate and triflate.

Preferred polymerisation conditions lead to alternating polymers which are particularly preferred for OTFT application, whereas statistical block copolymers are prepared preferably for OPV and OPD application. Preferred polycondensation are Suzuki coupling, Stille coupling, Sonogashira coupling, Heck coupling or Buchwald coupling, Negishi coupling or C-H activation coupling where the first set of reactive groups is composed of - Cl, -Br, -I, O-tosylate, O-triflate, O-mesylate and O-nonaflate and the second set of reactive groups is composed of -H, $-SiR_2F$, $-SiRF_2$, $-B(OR)_2$ , -CR=CHR', -C≡CH, -ZnX, -MgX and $-Sn(R_3)$. If a Yamamoto coupling reaction is used to prepare the polymer, the reactive monomer ends are both composed independently of -Cl, -Br, -I, O-tosylate, O-triflate, O-mesylate and O-nonaflate.

Suitable and preferred methods for preparing compounds according to the present invention are illustrated in the reaction schemes below, wherein the individual radicals are as defined above.

A synthesis method for a monomer comprising a unit of formula I or I1 is exemplarily illustrated in Scheme 1, wherein R has one of the meanings given for $R^1$ in formula I.

Scheme 1

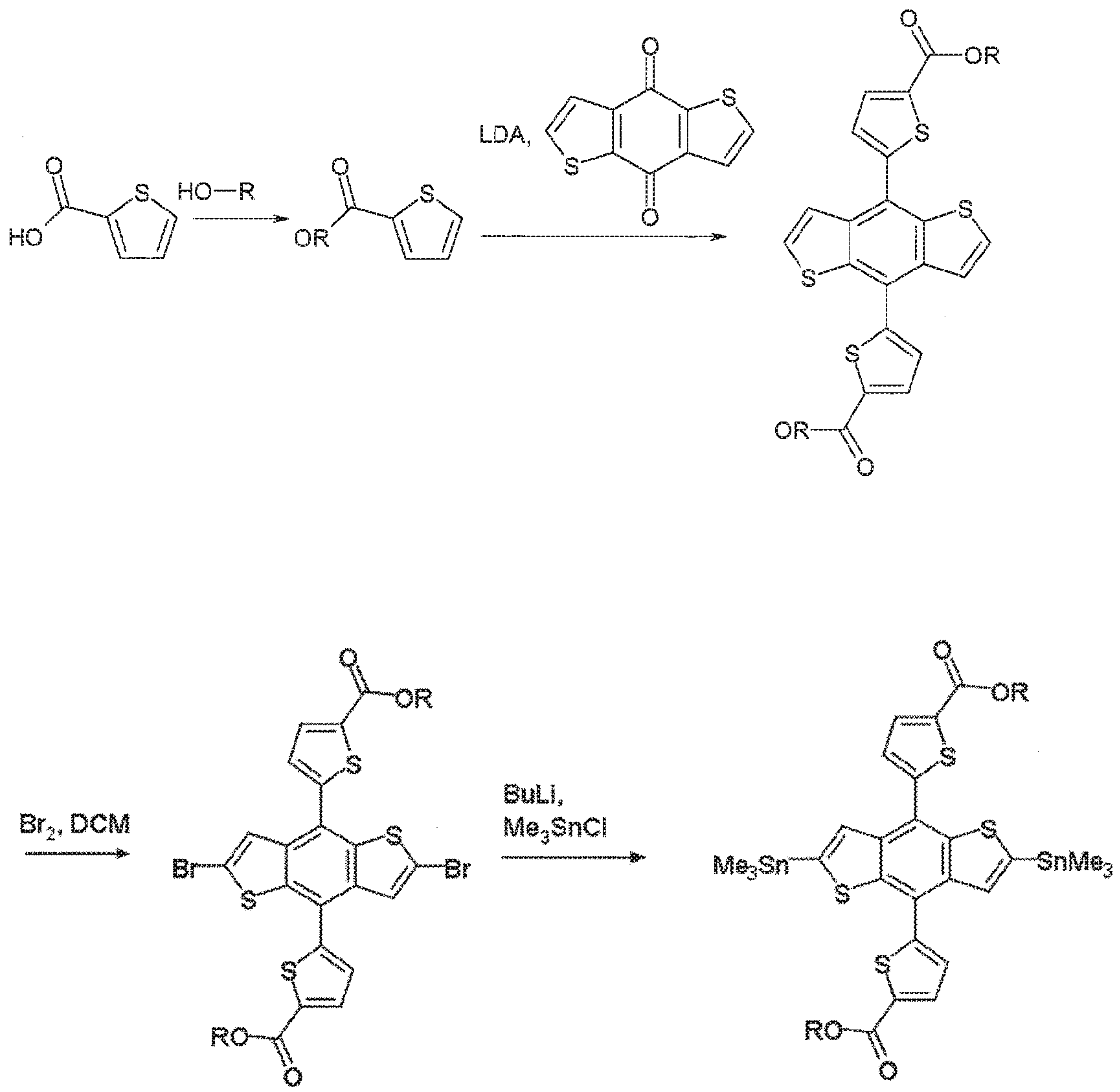


Further monomers can be prepared in analogy to Scheme 1.

The oligomers and polymers can be synthesized from these monomers by, or in analogy to, the aryl-aryl coupling reactions as described above. Particularly, conjugated polymers can be made by Pd catalysed direct arylation polymerisation with a dibromo counterpart (M. Wakioka, et al., Macromol., 2015, 48, 8382) or Pd catalysed polycondensations methods such as Yamamoto reaction (Yamamoto et al., Bull., Chem. Soc. Jpn., 1978, 51(7), 2091; Yamamo to et al., Macromolecules, 1992, 25(4), 1214), Suzuki-Miyaura reaction (Miyaura et al., Chem. Rev., 1995, 95, 2457) and Stille reaction (Bao et al., J. Am., Chem., Soc., 1995, 117(50), 12426) using the terminally brominated derivatives.

The novel methods of preparing a monomer, oligomer or polymer as described above and below, and the novel monomers and intermediates used therein, are further aspects of the invention.

The compounds according to the present invention can also be used in compositions or polymer blends, for example together with small molecules or other polymers having charge-transport, semiconducting, electrically conducting, photoconducting and/or light-emitting semiconducting properties, or for example with polymers having hole blocking, electron blocking properties for use as interlayers, charge blocking layers, charge transporting layer in OLED devices, OPV devices or perovskite based solar cells.

Small molecules according to the present invention which contain one or more electron withdrawing gropups can also be used as n-type semiconductors. For example they can be used as replacement of, or in addition to, fullerenes, especially in mixtures or blends of p-type and n-type semiconductors for use in OPV or OPD devices. Preferred compounds for use as n-type semiconductors are those of formula VI or their subformulae, wherein $R^{T1}$ and/or $R^{T2}$ denote or contain an electron withdrawing group.

Another aspect of the invention relates to a composition, which may also be a polymer blend, comprising one

or more compounds according to the present invention and one or more small molecule compounds and/or polymers having one or more of a charge-transport, semiconducting, electrically conducting, photoconducting, hole blocking and electron blocking property.

These compositions can be prepared by conventional methods that are described in prior art and known to the skilled person. Typically the compounds are mixed with each other or dissolved in suitable solvents and the solutions combined.

Another aspect of the invention relates to a formulation comprising one or more polymers, polymer blends or compositions as described above and below and one or more organic solvents.

Preferred solvents are aliphatic hydrocarbons, chlorinated hydrocarbons, aromatic hydrocarbons, ketones, ethers and mixtures thereof. Additional solvents which can be used include 1,2,4-trimethylbenzene, 1,2,3,4-tetramethyl benzene, pentylbenzene, mesitylene, cumene, cymene, cyclohexylbenzene, diethylbenzene, tetralin, decalin, 2,6-lutidine, 2-fluoro-m-xylene, 3-fluoro-o-xylene, 2-chlorobenzotrifluoride, N,N-dimethylformamide, 2-chloro-6-fluorotoluene, 2-fluoroanisole, anisole, 2,3-dimethylpyrazine, 4-fluoroanisole, 3-fluoroanisole, 3-trifluoro-methylanisole, 2-methylanisole, phenetol, 4-methylanisole, 3-methylanisole, 4-fluoro-3-methylanisole, 2-fluorobenzonitrile, 4-fluoroveratrol, 2,6-dimethylanisole, 3-fluorobenzo-nitrile, 2,5-dimethylanisole, 2,4-dimethylanisole, benzonitrile, 3,5-dimethyl-anisole, N,N-dimethylaniline, ethyl benzoate, 1-fluoro-3,5-dimethoxy-benzene, 1-methylnaphthalene, N-methylpyrrolidinone, 3-fluorobenzo-trifluoride, benzotrifluoride, dioxane, trifluoromethoxy-benzene, 4-fluorobenzotrifluoride, 3-fluoropyridine, toluene, 2-fluoro-toluene, 2-fluorobenzotrifluoride, 3-fluorotoluene, 4-isopropylbiphenyl, phenyl ether, pyridine, 4-fluorotoluene, 2,5-difluorotoluene, 1-chloro-2,4-difluorobenzene, 2-fluoropyridine, 3-chlorofluoro-benzene, 1-chloro-2,5-difluorobenzene, 4-chlorofluorobenzene, chloro-benzene, o-dichlorobenzene, 2-chlorofluorobenzene, p-xylene, m-xylene, o-xylene or mixture of o-, m-, and p-isomers. Solvents with relatively low polarity are generally preferred. For inkjet printing solvents and solvent mixtures with high boiling temperatures are preferred. For spin coating alkylated benzenes like xylene and toluene are preferred.

Examples of especially preferred solvents include, without limitation, dichloromethane, trichloromethane, chlorobenzene, o-dichlorobenzene, tetrahydrofuran, anisole, 2,4-dimethylanisole, 1-methylnaphthalene, morpholine, toluene, o-xylene, m-xylene, p-xylene, 1,4-dioxane, acetone, methylethylketone, 1,2-dichloroethane, 1,1,1-trichloroethane, 1,1,2,2-tetrachloroethane, ethyl acetate, n-butyl acetate, N,N-dimethylformamide, dimethylacetamide, dimethylsulfoxide, 1,5-dimethyltetraline, propiophenone, acetophenone, tetraline, 2-methylthiophene, 3-methylthiophene, decaline, indane, methyl benzoate, ethyl benzoate, mesitylene and/or mixtures thereof.

The concentration of the polymers in the solution is preferably 0.1 to 10% by weight, more preferably 0.5 to 5% by weight. Optionally, the solution also comprises one or more binders to adjust the rheological properties, as described for example in WO 2005/055248 A1 .

After the appropriate mixing and ageing, solutions are evaluated as one of the following categories: complete solution, borderline solution or insoluble. The contour line is drawn to outline the solubility parameter-hydrogen bonding limits dividing solubility and insolubility. 'Complete' solvents falling within the solubility area can be chosen from literature values such as published in "Crowley, J.D., Teague, G.S. Jr and Lowe, J.W. Jr., Journal of Paint Technology, 1966, 38 (496), 296 ". Solvent blends may also be used and can be identified as described in "Solvents, W.H.Ellis, Federation of Societies for Coatings Technology, p9-10, 1986". Such a procedure may lead to a blend of 'non' solvents that will dissolve both the polymers of the present invention, although it is desirable to have at least one true solvent in a blend.

The compounds according to the present invention can also be used in patterned OSC layers in the devices as described above and below. For applications in modern microelectronics it is generally desirable to generate small structures or patterns to reduce cost (more devices/unit area), and power consumption. Patterning of thin layers comprising a polymer according to the present invention can be carried out for example by photolithography, electron beam lithography or laser patterning.

For use as thin layers in electronic or electrooptical devices the compounds, compositions or formulations according to the present invention may be deposited by any suitable method. Liquid coating of devices is more desirable than vacuum deposition techniques. Solution deposition methods are especially preferred. The formulations of the present invention enable the use of a number of liquid coating techniques. Preferred deposition techniques include, without limitation, dip coating, spin coating, ink jet printing, nozzle printing, letter-press printing, screen printing, gravure printing, doctor blade coating, roller printing, reverse-roller printing, offset lithography printing, dry offset lithography printing, flexographic printing, web printing, spray coating, curtain coating, brush coating, slot dye coating or pad printing.

Ink jet printing is particularly preferred when high resolution layers and devices needs to be prepared. Selected formulations of the present invention may be applied to prefabricated device substrates by ink jet printing or microdispensing. Preferably industrial piezoelectric print heads such as but not limited to those supplied by Aprion, Hitachi-Koki, InkJet Technology, On Target Technology, Picojet, Spectra, Trident, Xaar may be used to apply the organic semiconductor layer to a substrate. Additionally semi-industrial heads such as those manufactured by Brother, Epson, Konica, Seiko Instruments Toshiba TEC or single nozzle microdispensers such as those produced by Microdrop and Microfab may be used.

In order to be applied by ink jet printing or microdispensing, the polymers should be first dissolved in a suitable solvent. Solvents must fulfil the requirements stated above and must not have any detrimental effect on the chosen print head. Additionally, solvents should have boiling points >100°C, preferably >140°C and more preferably >150°C in order to prevent operability problems caused by the solution drying out inside the print head. Apart from the solvents mentioned above, suitable solvents include substituted and non-substituted xylene derivatives, di-$C_{1-2}$-alkyl formamide, substituted and non-substituted anisoles and other phenol-ether derivatives, substituted heterocycles such as substituted pyridines, pyrazines, pyrimidines, pyrrolidinones, substituted and non-substituted *N*,*N*-di-$C_{1-2}$-alkylanilines and other fluorinated or chlorinated aromatics.

A preferred solvent for depositing a compound according to the present invention by ink jet printing comprises a benzene derivative which has a benzene ring substituted by one or more substituents wherein the total number of carbon atoms among the one or more substituents is at least three. For example, the benzene derivative may be substituted with a propyl group or three methyl groups, in either case there being at least three carbon atoms in total. Such a solvent enables an ink jet fluid to be formed comprising the solvent with the compound or polymer, which reduces or prevents clogging of the jets and separation of the components during spraying. The solvent(s) may include those selected from the following list of examples: dodecylbenzene, 1-methyl-4-tert-butylbenzene, terpineol, limonene, isodurene, terpinolene, cymene, diethylbenzene. The solvent may be a solvent mixture, that is a combination of two or more solvents, each solvent preferably having a boiling point >100°C, more preferably >140°C. Such solvent(s) also enhance film formation in the layer deposited and reduce defects in the layer.

The ink jet fluid (that is mixture of solvent, binder and semiconducting compound) preferably has a viscosity at 20°C of 1-100 mPws, more preferably 1-50 mPas and most preferably 1-30 mPas.

The compounds, compositions and formulations according to the present invention can additionally comprise one or more further components or additives selected for example from surface-active compounds, lubricating agents, wetting agents, dispersing agents, hydrophobing agents, adhesive agents, flow improvers, defoaming agents, deaerators, diluents which may be reactive or non-reactive, auxiliaries, colourants, dyes or pigments, sensitizers, stabilizers, nanoparticles or inhibitors.

The compounds and compositions according to the present invention are useful as charge transport, semiconducting, electrically conducting, photoconducting or light emitting material in optical, electrooptical, electronic, electroluminescent or photoluminescent components or devices. In these devices, a compound or composition of the present invention is typically applied as a thin layer or film.

Thus, the present invention also provides the use of the compound, composition or layer in an electronic device. The formulation may be used as a high mobility semiconducting material in various devices and apparatus. The formulation may be used, for example, in the form of a semiconducting layer or film. Accordingly, in another aspect, the present invention provides a semiconducting layer for use in an electronic device, the layer comprising a polymer, composition or polymer blend according to the invention. The layer or film may be less than about 30 microns. For various electronic device applications, the thickness may be less than about 1 micron thick. The layer may be deposited, for example on a part of an electronic device, by any of the aforementioned solution coating or printing techniques.

The invention additionally provides an electronic device comprising a polymer, polymer blend, composition or organic semiconducting layer according to the present invention. Especially preferred devices are OFETs, TFTs, ICs, logic circuits, capacitors, RFID tags, OLEDs, OLETs, OPEDs, OPVs, OPDs, solar cells, dye-sensitized solar cells (DSSC), perovskite-based solar cells, laser diodes, photoconductors, photodetectors, electrophotographic devices, electrophotographic recording devices, organic memory devices, sensor devices, charge injection layers, Schottky diodes, planarising layers, antistatic films, conducting substrates and conducting patterns.

Especially preferred electronic device are OFETs, OLEDs, OPV and OPD devices, in particular OPD and bulk heterojunction (BHJ) OPV devices. In an OFET, for example, the active semiconductor channel between the drain and source may comprise the layer of the invention. As another example, in an OLED device, the charge (hole or electron) injection or transport layer may comprise the layer of the invention.

For use in OPV or OPD devices the polymer according to the present invention is preferably used in a composition that comprises or contains, preferably consists of, one or more p-type semiconductors and one or more n-type semiconductors.

In a preferred embodiment at least one of the p-type semiconductors in the composition is a compound according to the present invention which is preferably a conjugated polymer. In this preferred embodiment the n-type semiconductor is preferably a fullerene or substituted fullerene.

In another preferred embodiment at least one of the n-type semiconductors in the composition is a compound according to the present invention which is preferably a small molecule, very preferably a compound of formula VI. In this preferred embodiment the p-type semiconductor is preferably a conjugated polymer.

In another preferred embodiment the OPV or OPD device comprises a composition comprising a compound according to the present invention as first n-type semiconductor, and further comprising an p-type semiconductor like a conjugated polymer, and a second n-type semiconductor, which is preferably a fullerene or substituted fullerene.

The n-type semiconductor or second n-type semiconductor in the composition of the aforementioned embodiments is for example an inorganic material such as zinc oxide ($ZnO_x$), zinc tin oxide (ZTO), titanium oxide ($TiO_x$), molybdenum oxide ($MoO_x$), nickel oxide ($NiO_x$), or cadmium selenide (CdSe), or an organic material such as graphene or a fullerene, a conjugated polymer or a fullerene or substituted fullerene.

The fullerene is for example an indene-$C_{60}$-fullerene bisaduct like ICBA, or a (6,6)-phenyl-butyric acid methyl ester derivatized methane $C_{60}$ fullerene, also known as "PCBM-$C_{60}$" or "$C_{60}$PCBM", as disclosed for example in G. Yu, J. Gao, J.C. Hummelen, F. Wudl, A.J. Heeger, Science 1995, Vol. 270, p. 1789 ff and having the structure shown below, or structural analogous compounds with e.g. a $C_{61}$ fullerene group, a $C_{70}$ fullerene group, or a $C_{71}$ fullerene group, or an organic polymer (see for example Coakley, K. M. and McGehee, M. D. Chem. Mater. 2004, 16, 4533).

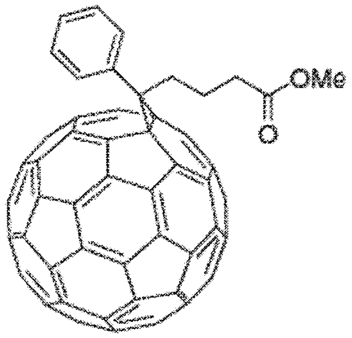

PCBM-$C_{60}$

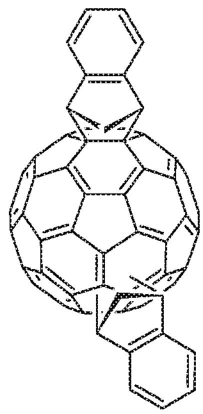

ICBA-$C_{60}$

Preferably the fullerene is PCBM-C60, PCBM-C70, bis-PCBM-C60, bis-PCBM-C70, ICMA-c60 (1',4'-dihydro-naphtho[2',3':1,2][5,6]fullerene-C60), ICBA, oQDM-C60 (1',4'-dihydro-naphtho[2',3':1,9][5,6]fullerene-C60-lh), or bis-oQDM-C60.

Further preferably the n-type semiconductor or second n-type semiconductor in the composition of the aforementioned embodiments is a fullerene or substituted fullerene of formula XII,

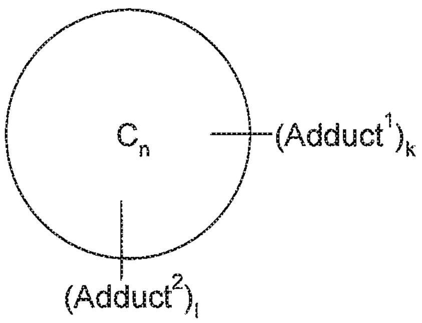

XII

| | |
|---|---|
| $C_n$ | denotes a fullerene composed of n carbon atoms, optionally with one or more atoms trapped inside, |
| $Adduct^1$ | is a primary adduct appended to the fullerene $C_n$ with any connectivity, |
| $Adduct^2$ | is a secondary adduct, or a combination of secondary adducts, appended to the fullerene $C_n$ with any connectivity, |
| k | is an integer $\geq 1$, and |
| l | is 0, an integer $\geq 1$, or a non-integer $> 0$. |

In the formula XII and its subformulae, k preferably denotes 1, 2, 3 or, 4, very preferably 1 or 2.

The fullerene $C_n$ in formula XII and its subformulae may be composed of any number n of carbon atoms Preferably, in the compounds of formula XII and its subformulae the number of carbon atoms n of which the fullerene $C_n$ is composed is 60, 70, 76, 78, 82, 84, 90, 94 or 96, very preferably 60 or 70.

The fullerene $C_n$ in formula XII and its subformulae is preferably selected from carbon based fullerenes, endohedral fullerenes, or mixtures thereof, very preferably from carbon based fullerenes.

Suitable and preferred carbon based fullerenes include, without limitation, ($C_{60\text{-}Ih}$)[5,6]fullerene, ($C_{70\text{-}D5h}$)[5,6]fullerene, ($C_{76\text{-}D2*}$)[5,6]fullerene, ($C_{84\text{-}D2*}$)[5,6]fullerene, ($C_{84\text{-}D2d}$)[5,6]fullerene, or a mixture of two or more of the aforementioned carbon based fullerenes.

The endohedral fullerenes are preferably metallofullerenes. Suitable and preferred metallofullerenes include, without limitation, $La@C_{60}$, $La@C_{82}$, $Y@C_{82}$, $Sc_3N@C_{80}$, $Y_3N@C_{80}$, $Sc_3C_2@C_{80}$ or a mixture of two or more of the aforementioned metallofullerenes.

Preferably the fullerene $C_n$ is substituted at a [6,6] and/or [5,6] bond, preferably substituted on at least one [6,6] bond.

Primary and secondary adduct, named "Adduct" in formula XII and its subformulae, is preferably selected from the following formulae

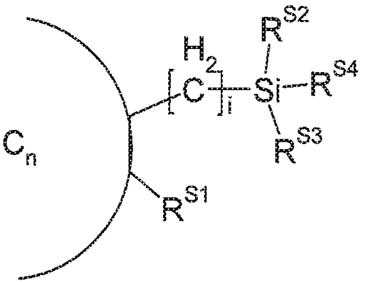

S-1

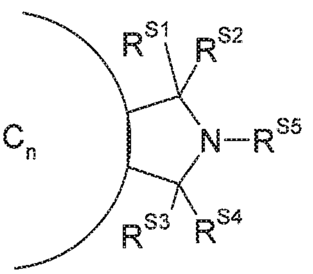

S-2

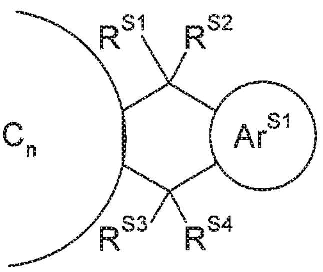

S-3

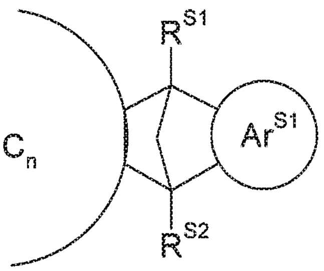

S-4

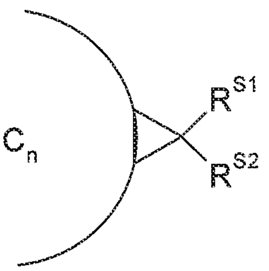

S-5

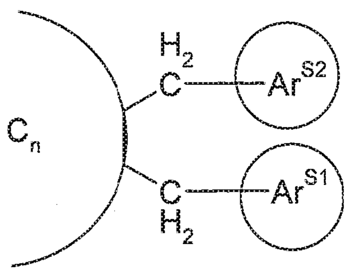

S-6

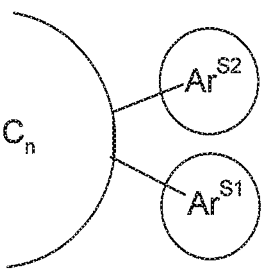

S-7

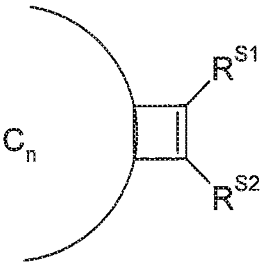 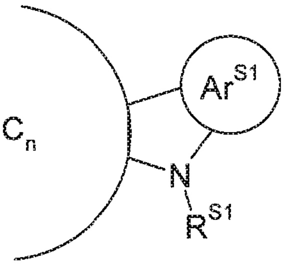 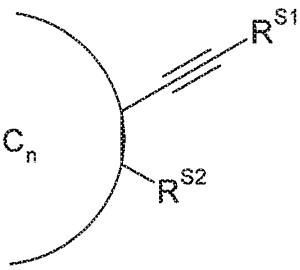

S-8 S-9 S-10

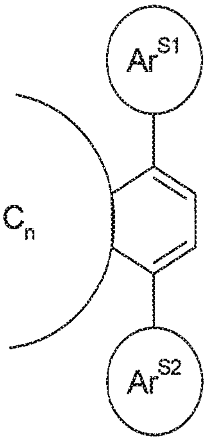 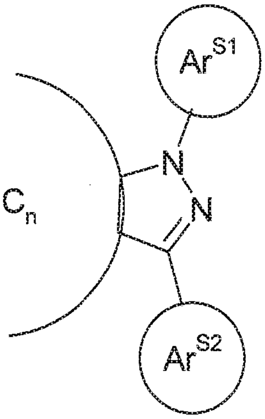 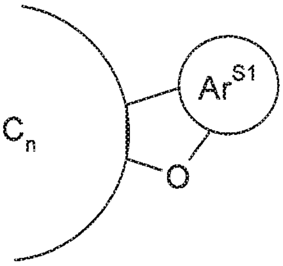

S-11 S-12 S-13

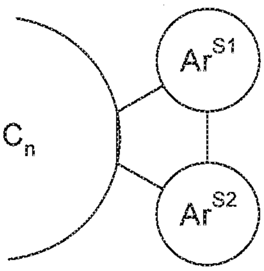 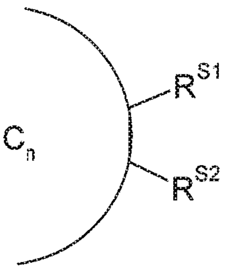 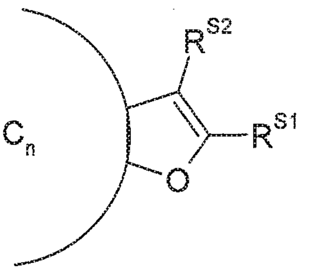

S-14 S-15 S-16

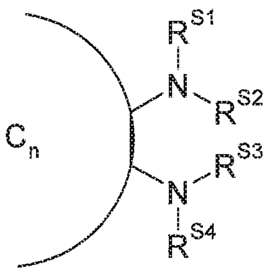 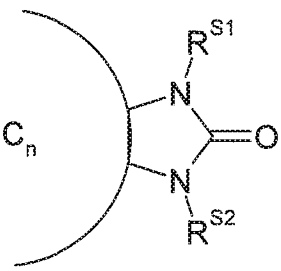 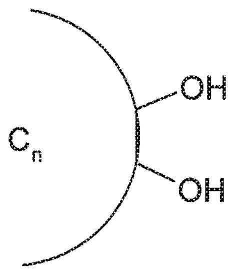

S-17 S-18 S-19

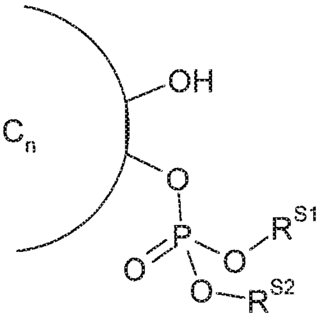

S-20

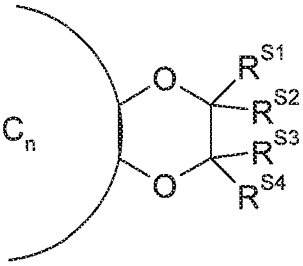

S-21

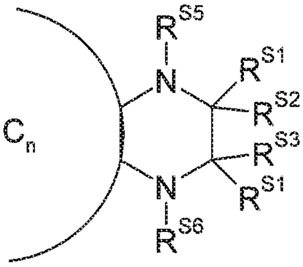

S-22

wherein $C_n$ is as defined in formula XII,

$Ar^{S1}$, $Ar^{S2}$ denote, independently of each other, an arylene or heteroarylene group with 5 to 20, preferably 5 to 15, ring atoms, which is mono- or polycyclic, and which is optionally substituted by one or more identical or different substituents having one of the meanings of L as defined above and below, and
$R^{S1}$, $R^{S2}$, $R^{S3}$, $R^{S4}$, $R^{S5}$ and $R^{S6}$ independently of each other denote H, CN or have one of the meanings of L as defined above and below, and i is an integer from 1 to 20, preferably from 1 to 12.

Preferred compounds of formula XII are selected from the following subformulae:

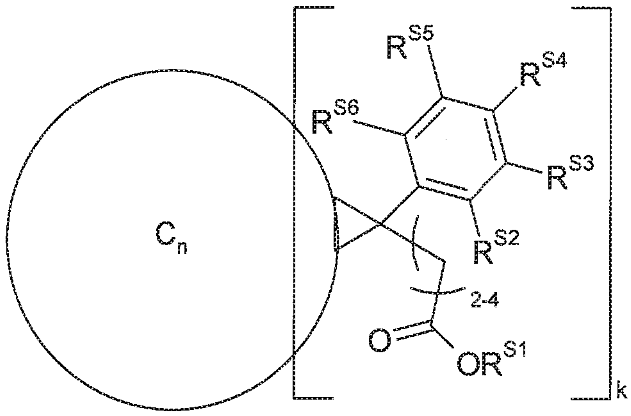

XIIa

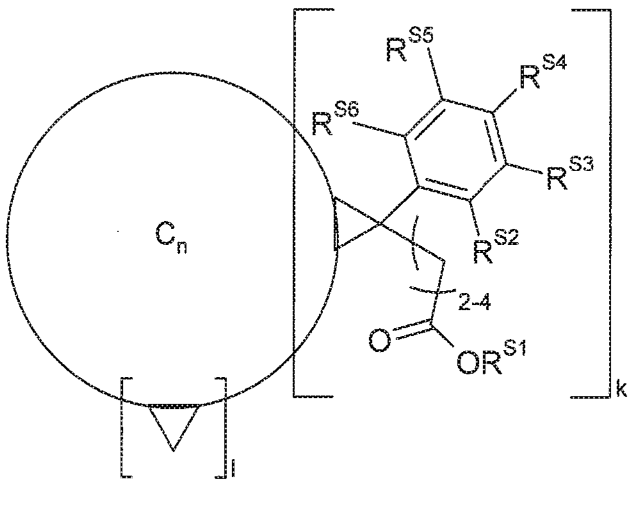

XIIb

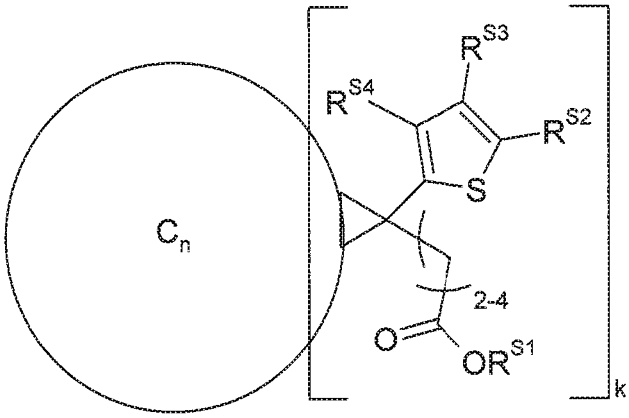

XIIc

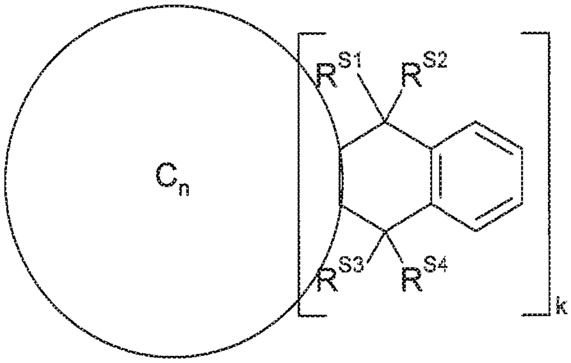

XIId

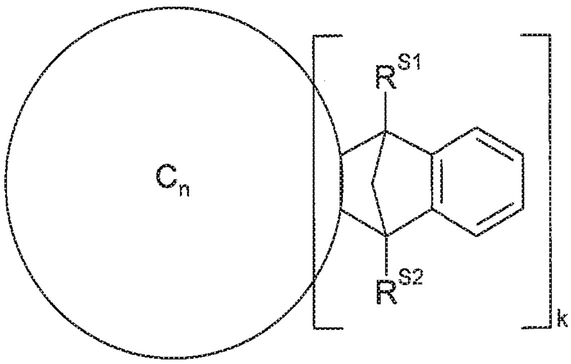

XIIe

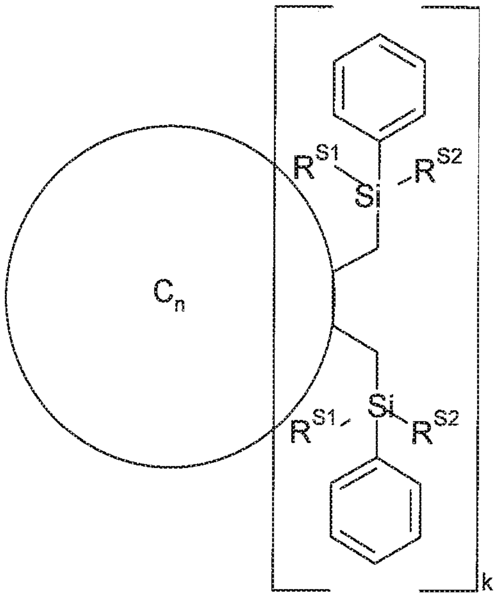

XIIf

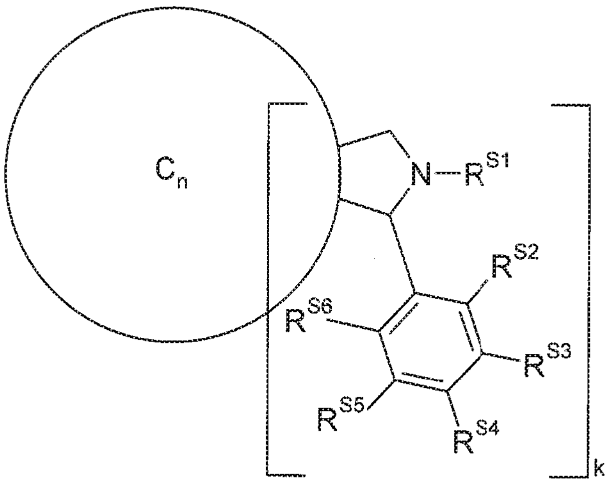

XIIg

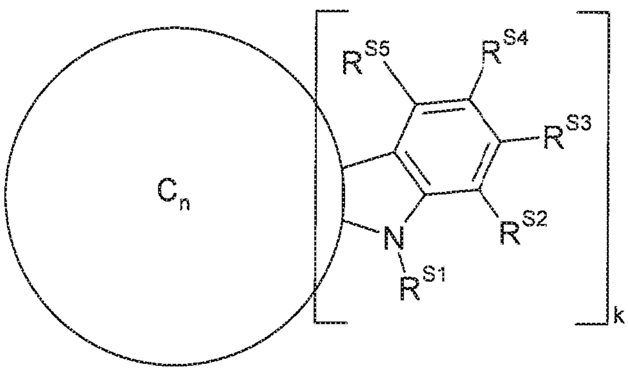

XIIh

wherein $C_n$, k and l are as defined in formula XII, and

$R^{S1}$, $R^{S2}$, $R^{S3}$, $R^{S4}$ $R^{S5}$ and $R^{S6}$ independently of each other denote H or have one of the meanings of L as defined above and below.

Further preferably the n-type semiconductor or second n-type semiconductor in the composition of the aforementioned embodiments is selected from graphene, metal oxides, like for example, ZnOx, TiOx, ZTO, MoOx, NiOx, quantum dots, like for example, CdSe or CdS, or conjugated polymers, like for example a polynaphthalenediimide or polyperylenediimide as described, for example, in WO2013142841 A1.

In another preferred embodiment the n-type semiconductor is an organic small molecule which does not contain a fullerene moiety (hereinafter also referred to as "non-fullerene acceptors" or NFA), and which is selected from naphthalene or perylene carboximide derivatives. Preferred naphthalene or perylene carboximide derivatives are described for example in Adv. Sci. 2016, 3, 1600117, Adv. Mater. 2016, 28, 8546-8551, J. Am. Chem. Soc., 2016, 138, 7248-7251 and J. Mater. Chem. A, 2016, 4, 17604.

In another preferred embodiment, the n-type semiconductor is an NFA which is selected from compounds comprising a polycyclic core and attached thereto two terminal groups which are electron withdrawing relative to the polycyclic core, and optionally further comprising one or more aromatic or heteroaromatic spacer groups, which are located between the polycyclic core and the terminal groups and which can be electron withdrawing or electron donating relative to the polycyclic core. As a result these preferred NFAs have an acceptor-donor-acceptor (A-D-A) structure, wherein the polycyclic core acts as donor and the terminal groups, optionally together with the spacer groups, act as acceptor.

Preferred A-D-A type NFAs are selected from formula N

$$R^{T1}\text{-}(Ar^{11})_{n11}\text{-core-}(Ar^{12})_{n12}\text{-}R^{T2} \qquad N$$

wherein, the individual radicals, independently of each other and on each occurrence identically or differently, have the following meanings $Ar^{11}$ and $Ar^{12}$ are selected from the following formulae

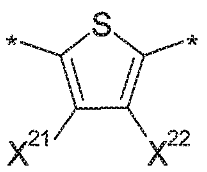

AR1

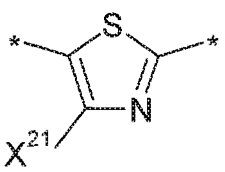

AR2

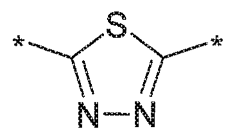

AR3

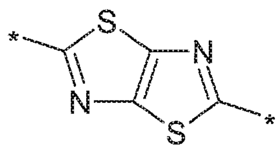

AR4

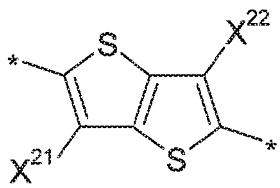

AR5

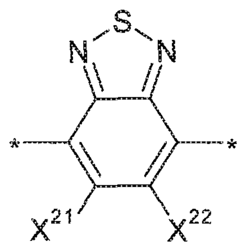

AR6

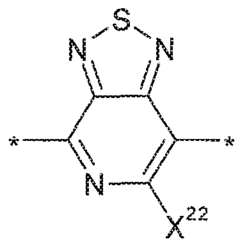

AR7

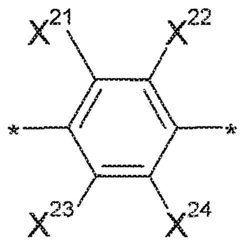

AR8

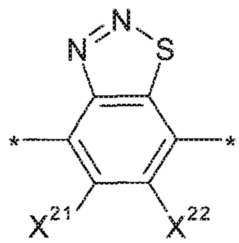

AR9

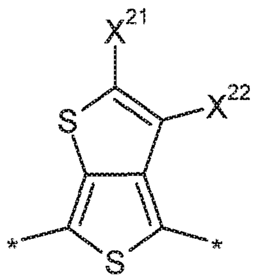
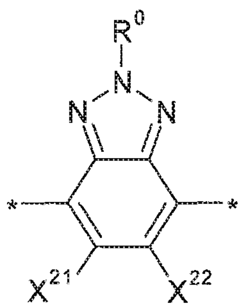

AR10 AR11

wherein $X^{21}$, $X^{22}$, $X^{23}$ and $X^{24}$ denote H, F, Cl, -CN, $R^0$, $OR^0$ or $C(=O)OR^0$, and $R^0$ is as defined above and below,

"core" is selected from the following formulae

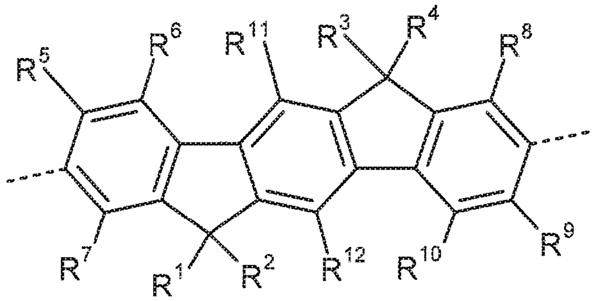

C1

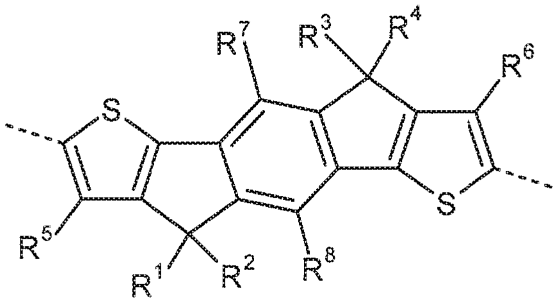

C2

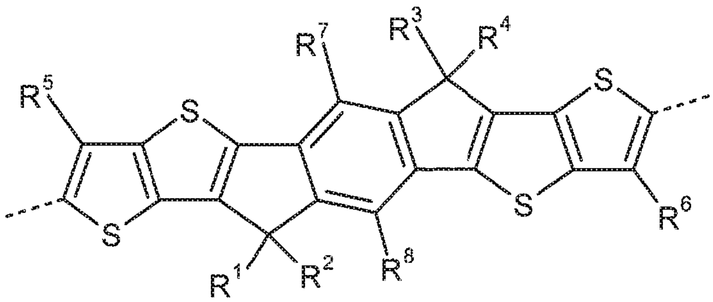

C3

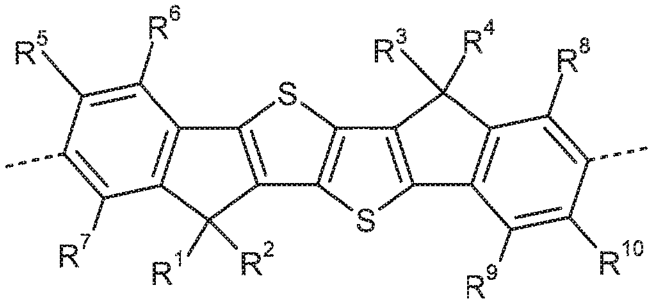

C4

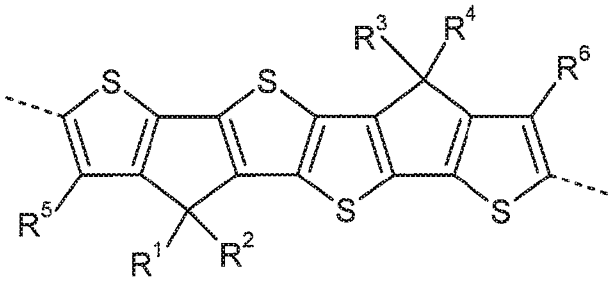

C5

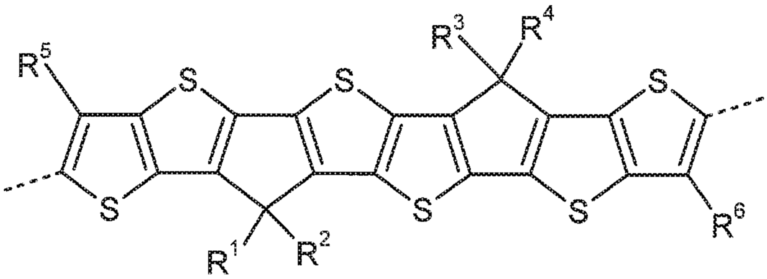

C6

wherein $R^{1-6}$ have the meanings given in formula I or one of the preferred meanings given above and below, and the pair of $R^1$ and $R^2$, and/or the pair of $R^3$ and $R^4$, together with the C atom to which they are attached, may also form a spiro group with 5 to 20 ring atoms which is mono- or polycyclic, optionally contains fused rings, and is unsubstituted or substituted by one or more identical or different groups L, and $R^7$, $R^8$ in formula C2 and C3 and $R^{11}$ and $R^{12}$ in formula C1 preferably denote H or F,

$R^{T1}$ and $R^{T2}$ are electron withdrawing groups selected from the following formulae

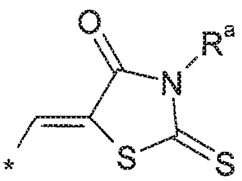

T1

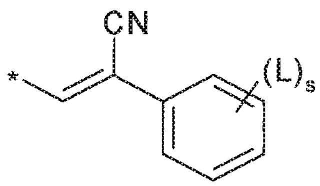

T2

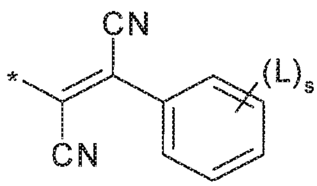

T3

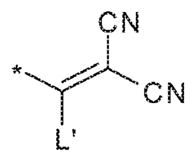

T4

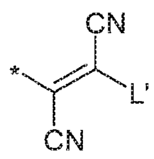

T5

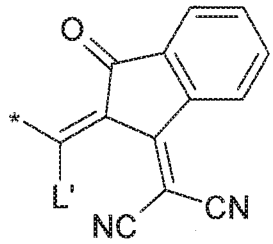

T6

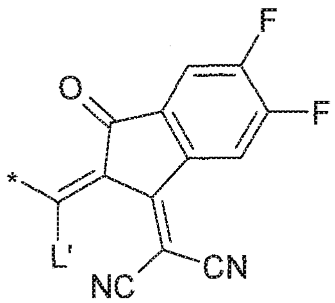

T7

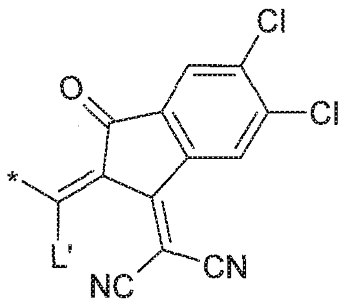

T8

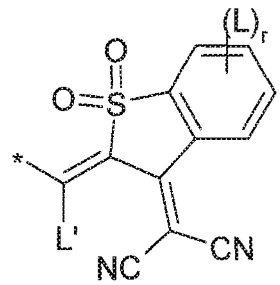

T9

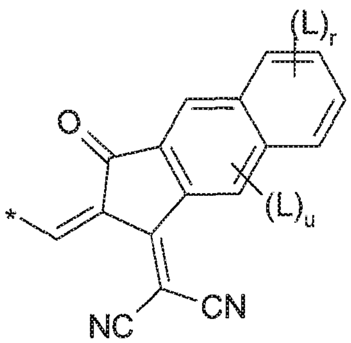

T10

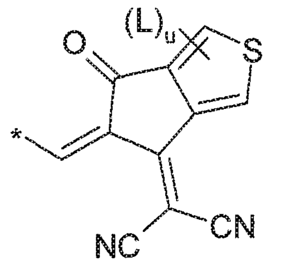

T11

L has one of the meanings given above,

L' has one of the meanings given for L,

r is 0, 1, 2, 3 or 4,

s is 0, 1, 2, 3, 4 or 5,

u is 0, 1 or 2,

and n11, n12 denote 0, 1, 2 or 3.

Preferred compounds of formula N are selected from the following embodiments or any combination thereof:

- $R^{T1}$ and $R^{T2}$ are selected from formulae T6, T7, T8 and T11,
- "core" is selected from formula C2, formula C3 wherein $R^7$ and $R^8$ denote H, formula C3 wherein $R^7$ and $R^8$ denote F, formula C5 or formula C6,
- n11 and n12 are 0 or 1,

- $Ar^{11}$ and $Ar^{12}$ are selected of formula AR1, AR4, AR5 or AR6,

- $R^{1-4}$ are selected from 4-alkylphenyl, 4-alkoxyphenyl, 3,5-dialkylphenyl or 3,5-dialkoxyphenyl, wherein alkyl is C1-16 alkyl, and alkoxy is C1-16 alkoxy.

Examples for suitable and preferred A-D-A type NFAs are the compound ITIC shown below, as disclosed by Y. Lin, J. Wang, Z.-G. Zhang, H. Bai, Y. Li, D. Zhu and X. Zhan, Adv. Mater. 2015, 27, 1170-1174, and the compound IEIC shown below, as disclosed by H. Lin, S. Chen, Z. Li, J. Y. L. Lai, G. Yang, T. McAfee, K. Jiang, Y. Li, Y. Liu, H. Hu, J. Zhao, W. Ma, H. Ade and H. Yan, Zhan, Adv. Mater., 2015, 27, 7299.

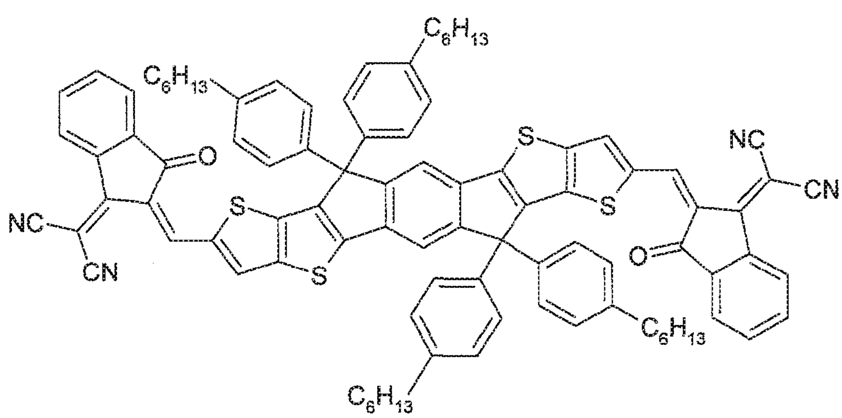

ITIC

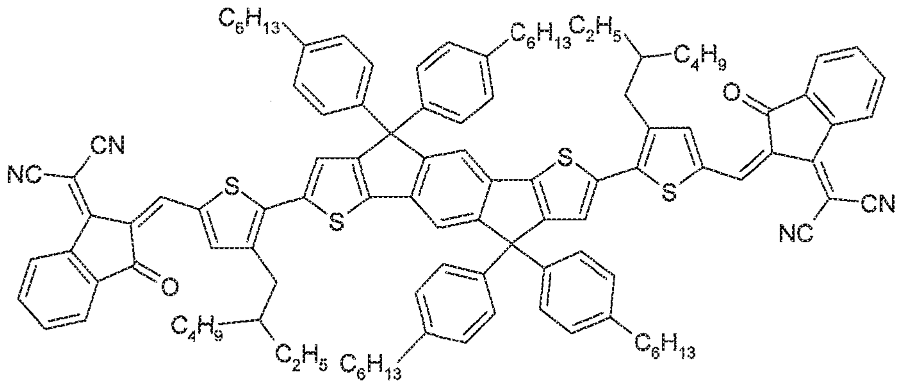

IEIC

Further examples for suitable and preferred A-D-A type NFAs are disclosed in WO 2018/007479 A1, WO 2018/036914 A1, WO 2018/065350 A1, WO 2018/065352 A1, WO 2018/065356 A1 and EP 3306690 A1.

The OPV or OPD device according to the present invention preferably comprises a first transparent or semi-transparent electrode on a transparent or semi-transparent substrate on one side of the active layer, and a second metallic or semi-transparent electrode on the other side of the active layer.

Preferably, the photoactive layer in an OPV or OPD device according to the present invention is further blended with additional organic and inorganic compounds to enhance the device properties. For example, metal particles such as Au or Ag nanoparticules or Au or Ag nanoprism for enhancements in light harvesting due to near-field effects (i.e. plasmonic effect) as described, for example in Adv. Mater. 2013, 25 (17), 2385-2396 and Adv. Ener. Mater. 10.1002/aenm.201400206, a molecular dopant such as 2,3,5,6-tetrafluoro-7,7,8,8-tetracyanoquinodimethane for enhancement in photoconductivity as described, for example in Adv. Mater. 2013, 25(48), 7038-7044, or a stabilising agent consisting of a UV absorption agent and/or anti-radical agent and/or antioxidant agent such as 2-hydroxybenzophenone, 2-hydroxyphenylbenzotriazole, oxalic acid anilides, hydroxyphenyl triazines, merocyanines, hindered phenol, N-aryl-thiomorpholine, N-aryl-thiomorpholine-1-oxide, N-aryl-thiomorpholine-1,1-dioxide, N-aryl-thiazolidine, N-aryl-thiazolidine-1 -oxide, N-aryl-thiazolidine-1,1-dioxide and 1,4-diazabicyclo[2.2.2]octane as described, for example, in WO2012095796 A1 and in WO2013021971 A1.

The device preferably may further comprise a UV to visible photo-conversion layer such as described, for example, in J. Mater. Chem. 2011, 21, 12331 or a NIR to visible or IR to NIR photo-conversion layer such as described, for example, in J. Appl. Phys. 2013, 113, 124509.

Further preferably the OPV or OPD device comprises, between the active layer and the first or second electrode,

one or more additional buffer layers acting as hole transporting layer and/or electron blocking layer, which comprise a material such as metal oxides, like for example, ZTO, $MoO_x$, $NiO_x$, a doped conjugated polymer, like for example PEDOT:PSS and polypyrrole-polystyrene sulfonate (PPy:PSS), a conjugated polymer, like for example polytriarylamine (PTAA), an organic compound, like for example substituted triaryl amine derivatives such as N,N'-diphenyl-N,N'-bis(1-naphthyl)(1,1'-biphenyl)-4,4'diamine (NPB), N,N'-diphenyl-N,N'-(3-methylphenyl)-1,1'-biphenyl-4,4'-diamine (TPD), graphene based materials, like for example, graphene oxide and graphene quantum dots or alternatively as hole blocking layer and/or electron transporting layer, which comprise a material such as metal oxide, like for example, $ZnO_x$, $TiO_x$, AZO (aluminium doped zinc oxide), a salt, like for example LiF, NaF, CsF, a conjugated polymer electrolyte, like for example poly[3-(6-trimethylammoniumhexyl)thiophene], poly(9,9-bis(2-ethylhexyl)-fluorene]-*b*-poly[3-(6-trimethylammoniumhexyl)thiophene], or poly[(9,9-bis(3'-(N,N-dimethylamino)propyl)-2,7-fluorene)-alt-2,7-(9,9-dioctylfluorene)], a polymer, like for example poly(ethyleneimine) or crosslinked N-containing compound derivatives or an organic compound, like for example tris(8-quinolinolato)-aluminium(III) ($Alq_3$), phenanthroline derivative or $C_{60}$ or $C_{70}$ based fullerenes, like for example, as described in Adv. Energy Mater. 2012, 2, 82-86.

In a composition comprising a small molecule compound according to the present invention and further comprising a polymer, the ratio polymer:small molecule compound is preferably from 5:1 to 1:5 by weight, more preferably from 1:1 to 1:3 by weight, most preferably 1:1 to 1:2 by weight.

In a composition comprising a polymer compound according to the present invention and further comprising a fullerene or modified fullerene, the ratio polymer:fullerene is preferably from 5:1 to 1:5 by weight, more preferably from 2:1 to 1:3 by weight, most preferably 1:1 to 1:2 by weight.

The composition according to the present invention may also comprise polymeric binder, preferably from 5 to 95% by weight. Examples of binder include polystyrene (PS), polypropylene (PP), polydimethylsilane (PDMS), and polymethylmethacrylate (PMMA).

To produce thin layers in BHJ OPV devices the compounds, compositions and formulations of the present invention may be deposited by any suitable method. Liquid coating of devices is more desirable than vacuum deposition techniques. Solution deposition methods are especially preferred. The formulations of the present invention enable the use of a number of liquid coating techniques. Preferred deposition techniques include, without limitation, dip coating, spin coating, ink jet printing, nozzle printing, letter-press printing, screen printing, gravure printing, doctor blade coating, roller printing, reverse-roller printing, offset lithography printing, dry offset lithography printing, flexographic printing, web printing, spray coating, curtain coating, brush coating, slot dye coating or pad printing. For the fabrication of OPV devices and modules area printing method compatible with flexible substrates are preferred, for example slot dye coating, spray coating and the like.

In the preparation of a formulation according to the present invention, suitable solvents are preferably selected to ensure full dissolution of both the p-type and n-type component, and take into account the boundary conditions (for example rheological properties) introduced by the chosen printing method.

Organic solvent are generally used for this purpose. Typical solvents can be aromatic solvents, halogenated solvents or chlorinated solvents, including chlorinated aromatic solvents. Examples include, but are not limited to chlorobenzene, 1,2-dichlorobenzene, chloroform, 1,2-dichloroethane, dichloromethane, carbon tetrachloride, toluene, cyclohexanone, ethylacetate, tetrahydrofuran, anisole, 2,4-dimethylanisole, 1-methylnaphthalene, morpholine, toluene, o-xylene, m-xylene, p-xylene, 1,4-dioxane, acetone, methylethylketone, 1,2-dichloroethane, 1,1,1-trichloroethane, 1,1,2,2-tetrachloroethane, ethyl acetate, n-butyl acetate, N,N-dimethylformamide, dimethylacetamide, dimethylsulfoxide, 1,5-dimethyltetraline, propiophenone, acetophenone, tetraline, 2-methylthiophene, 3-methylthiophene, decaline, indane, methyl benzoate, ethyl benzoate, mesitylene and combinations thereof.

The OPV device can for example be of any type known from the literature (see e.g. Waldauf et al., Appl. Phys. Lett., 2006, 89, 233517).

A first preferred OPV device according to the invention comprises the following layers (in the sequence from bottom to top):

- optionally a substrate,
- a high work function electrode, preferably comprising a metal oxide, like for example ITO and FTO, serving as anode,
- an optional conducting polymer layer or hole transport layer, preferably comprising an organic polymer or polymer blend, for example PEDOT:PSS (poly(3,4-ethylenedioxythiophene): poly(styrene-sulfonate), substituted triaryl amine derivatives, for example,TBD (N,N'-dyphenyl-N-N'-bis(3-methylphenyl)-1,1'biphenyl-4,4'-diamine) or NBD (N,N'-dyphenyl-N-N'-bis(1-napthylphenyl)-1,1,biphenyl-4,4'-diamine),
- a layer, also referred to as "photoactive layer", comprising a p-type and an n-type organic semiconductor, which can exist for example as a p-type/n-type bilayer or as distinct p-type and n-type layers, or as blend or p-type and n-type semiconductor, forming a BHJ,
- optionally a layer having electron transport properties, for example comprising LiF, $TiO_x$, $ZnO_x$, PFN, a poly(ethyleneimine) or crosslinked nitrogen containing compound derivatives or a phenanthroline derivatives

- a low work function electrode, preferably comprising a metal like for example aluminum, serving as cathode,

wherein at least one of the electrodes, preferably the anode, is transparent to visible and/or NIR light, and

wherein the p-type or n-type semiconductor is a compound according to the present invention.

A second preferred OPV device according to the invention is an inverted OPV device and comprises the following layers (in the sequence from bottom to top):

- optionally a substrate,
- a high work function metal or metal oxide electrode, comprising for example ITO and FTO, serving as cathode, a layer having hole blocking properties, preferably comprising a metal oxide like $TiO_x$ or $ZnO_x$, or comprising an organic compound such as polymer like poly(ethyleneimine) or crosslinked nitrogen containing compound derivatives or phenanthroline derivatives,
- a photoactive layer comprising a p-type and an n-type organic semiconductor, situated between the electrodes, which can exist for example as a p-type/n-type bilayer or as distinct p-type and n-type layers, or as blend or p-type and n-type semiconductor, forming a BHJ,
- an optional conducting polymer layer or hole transport layer, preferably comprising an organic polymer or polymer blend, for example of PEDOT:PSS, nafion or substituted triaryl amine derivatives, for example TBD or NBD,
- an electrode comprising a high work function metal like for example silver, serving as anode,

wherein at least one of the electrodes, preferably the cathode, is transparent to visible and/or NIR light, and

wherein the p-type or n-type semiconductor is a compound according to the present invention.

In the OPV devices of the present invention the p-type and n-type semiconductor materials are preferably selected from the materials, like the compound/polymer or compound/polymer/fullerene systems as described above.

When the active layer is deposited on the substrate, it forms a BHJ that phase separates at nanoscale level. For discussion on nanoscale phase separation see Dennler et al, Proceedings of the IEEE, 2005, 93 (8), 1429 or Hoppe et al, Adv. Func. Mater, 2004, 14(10), 1005. An optional annealing step may be then necessary to optimize blend morpohology and consequently OPV device performance.

Another method to optimize device performance is to prepare formulations for the fabrication of OPV(BHJ) devices that may include high boiling point additives to promote phase separation in the right way. 1,8-Octanedithiol, 1,8-diiodooctane, nitrobenzene, 1-chloronaphthalene, N,N-dimethylformamide, dimethylacetamide, dimethylsulfoxide and other additives have been used to obtain high-efficiency solar cells. Examples are disclosed in J. Peet, et al, Nat. Mater., 2007, 6, 497 or Fréchet et al. J. Am. Chem. Soc., 2010, 132, 7595-7597.

Another preferred embodiment of the present invention relates to the use of a compound or composition according to the present invention as dye, hole transport layer, hole blocking layer, electron transport layer and/or electron blocking layer in a DSSC or a perovskite-based solar cells, and to a DSSC or perovskite-based solar cells comprising a compound composition or polymer blend according to the present invention.

DSSCs and perovskite-based DSSCs can be manufactured as described in the literature, for example in Chem. Rev. 2010, 110, 6595-6663, Angew. Chem. Int. Ed. 2014, 53, 2-15 or in WO2013171520A1

The compounds and compositions of the present invention are also suitable for use in the semiconducting channel of an OFET. Accordingly, the invention also provides an OFET comprising a gate electrode, an insulating (or gate insulator) layer, a source electrode, a drain electrode and an organic semiconducting channel connecting the source and drain electrodes, wherein the organic semiconducting channel comprises a compound or composition according to the present invention. Other features of the OFET are well known to those skilled in the art.

OFETs where an OSC material is arranged as a thin film between a gate dielectric and a drain and a source electrode, are generally known, and are described for example in US 5,892,244, US 5,998,804, US 6,723,394 and in the references cited in the background section. Due to the advantages, like low cost production using the solubility properties of the compounds according to the invention and thus the processibility of large surfaces, preferred applications of these FETs are such as integrated circuitry, TFT displays and security applications.

The gate, source and drain electrodes and the insulating and semiconducting layer in the OFET device may be arranged in any sequence, provided that the source and drain electrode are separated from the gate electrode by the insulating layer, the gate electrode and the semiconductor layer both contact the insulating layer, and the source electrode and the drain electrode both contact the semiconducting layer.

An OFET device according to the present invention preferably comprises:

- a source electrode,
- a drain electrode,
- a gate electrode,
- a semiconducting layer,
- one or more gate insulator layers,
- optionally a substrate.

wherein the semiconductor layer comprises a compound or composition according to the present invention.

The OFET device can be a top gate device or a bottom gate device. Suitable structures and manufacturing methods of an OFET device are known to the skilled in the art and are described in the literature, for example in US 2007/0102696 A1.

The gate insulator layer preferably comprises a fluoropolymer, like e.g. the commercially available Cytop 809M® or Cytop 107M® (from Asahi Glass). Preferably the gate insulator layer is deposited, e.g. by spin-coating, doctor blading, wire bar coating, spray or dip coating or other known methods, from a formulation comprising an insulator material and one or more solvents with one or more fluoro atoms (fluorosolvents), preferably a perfluorosolvent. A suitable perfluorosolvent is e.g. FC75® (available from Acros, catalogue number 12380). Other suitable fluoropolymers and fluorosolvents are known in prior art, like for example the perfluoropolymers Teflon AF® 1600 or 2400 (from DuPont) or Fluoropel® (from Cytonix) or the perfluorosolvent FC 43® (Acros, No. 12377). Especially preferred are organic dielectric materials having a low permittivity (or dielectric contant) from 1.0 to 5.0, very preferably from 1.8 to 4.0 ("low k materials"), as disclosed for example in US 2007/0102696 A1 or US 7,095,044.

In security applications, OFETs and other devices with semiconducting materials according to the present invention, like transistors or diodes, can be used for RFID tags or security markings to authenticate and prevent counterfeiting of documents of value like banknotes, credit cards or ID cards, national ID documents, licenses or any product with monetry value, like stamps, tickets, shares, cheques etc.

Alternatively, the compounds and compositions according to the invention can be used in OLEDs, e.g. as the active display material in a flat panel display applications, or as backlight of a flat panel display like e.g. a liquid crystal display. Common OLEDs are realized using multilayer structures. An emission layer is generally sandwiched between one or more electron-transport and/or hole-transport layers. By applying an electric voltage electrons and holes as charge carriers move towards the emissive layer where their recombination leads to the excitation and hence luminescence of the lumophor units contained in the emission layer.

The compounds and compositions according to the invention can be employed in one or more of a buffer layer, electron or hole transport layer, electron or hole blocking layer and emissive layer, corresponding to their electrical and/or optical properties. Furthermore their use within the emissive layer is especially advantageous, if the compounds according to the invention show electroluminescent properties themselves or comprise electroluminescent groups or compounds. The selection, characterization as well as the processing of suitable monomeric, oligomeric and polymeric compounds or materials for the use in OLEDs is generally known by a person skilled in the art, see, e.g., Müller et al, Synth. Metals, 2000, 111-112, 31-34, Alcala, J. Appl. Phys., 2000, 88, 7124-7128 and the literature cited therein.

According to another use, the compounds and compositions according to the present invention, especially those showing photoluminescent properties, may be employed as materials of light sources, e.g. in display devices, as described in EP 0 889 350 A1 or by C. Weder et al., Science, 1998, 279, 835-837.

A further aspect of the invention relates to both the oxidised and reduced form of a compound according to the present invention. Either loss or gain of electrons results in formation of a highly delocalised ionic form, which is of high conductivity. This can occur on exposure to common dopants. Suitable dopants and methods of doping are known to those skilled in the art, e.g. from EP 0 528 662, US 5,198,153 or WO 96/21659.

The doping process typically implies treatment of the semiconductor material with an oxidating or reducing agent in a redox reaction to form delocalised ionic centres in the material, with the corresponding counterions derived from the applied dopants. Suitable doping methods comprise for example exposure to a doping vapor in the atmospheric pressure or at a reduced pressure, electrochemical doping in a solution containing a dopant, bringing a dopant into contact with the semiconductor material to be thermally diffused, and ion-implantantion of the dopant into the semiconductor material.

When electrons are used as carriers, suitable dopants are for example halogens (e.g., $I_2$, $Cl_2$, $Br_2$, ICl, $ICl_3$, IBr and IF), Lewis acids (e.g., $PF_5$, $AsF_5$, $SbF_5$, $BF_3$, $BCl_3$, $SbCl_5$, $BBr_3$ and $SO_3$), protonic acids, organic acids, or amino acids (e.g., HF, HCl, $HNO_3$, $H_2SO_4$, $HClO_4$, $FSO_3H$ and $ClSO_3H$), transition metal compounds (e.g., $FeCl_3$, FeOCl, $Fe(ClO_4)_3$, $Fe(4\text{-}CH_3C_6H_4SO_3)_3$, $TiCl_4$, $ZrCl_4$, $HfCl_4$, $NbF_5$, $NbCl_5$, $TaCl_5$, $MoF_5$, $MoCl_5$, $WF_5$, $WCl_6$, $UF_6$ and $LnCl_3$ (wherein Ln is a lanthanoid), anions (e.g., $Cl^-$, $Br^-$, $I^-$, $I_3^-$, $HSO_4^-$, $SO_4^{2-}$, $NO_3^-$, $ClO_4^-$, $BF_4^-$, $PF_6^-$, $AsF_6^-$, $SbF_6^-$, $FeCl_4^-$, $Fe(CN)_6^{3-}$, and anions of various sulfonic acids, such as aryl-$SO_3^-$). When holes are used as carriers, examples of dopants are cations (e.g., $H^+$, $Li^+$, $Na^+$, $K^+$, $Rb^+$ and $Cs^+$), alkali metals (e.g., Li, Na, K, Rb, and Cs), alkaline-earth metals (e.g., Ca, Sr, and Ba), $O_2$, $XeOF_4$, $(NO_2^+)$ $(SbF_6^-)$, $(NO_2^+)$ $(SbCl_6^-)$, $(NO_2^+)$ $(BF_4^-)$, $AgClO_4$, $H_2IrCl_6$, $La(NO_3)_3$ $6H_2O$,

$FSO_2OOSO_2F$, Eu, acetylcholine, $R_4N^+$, (R is an alkyl group), $R_4P^+$ (R is an alkyl group), $R_6As^+$ (R is an alkyl group), and $R_3S^+$ (R is an alkyl group).

The conducting form of a compound according to the present invention can be used as an organic "metal" in applications including, but not limited to, charge injection layers and ITO planarising layers in OLED applications, films for flat panel displays and touch screens, antistatic films, printed conductive substrates, patterns or tracts in electronic applications such as printed circuit boards and condensers.

The compounds and compositions according to the present invention may also be suitable for use in organic plasmon-emitting diodes (OPEDs), as described for example in Koller et al., Nat. Photonics, 2008, 2, 684.

According to another use, the compounds according to the present invention can be used alone or together with other materials in or as alignment layers in LCD or OLED devices, as described for example in US 2003/0021913. The use of charge transport compounds according to the present invention can increase the electrical conductivity of the alignment layer. When used in an LCD, this increased electrical conductivity can reduce adverse residual dc effects in the switchable LCD cell and suppress image sticking or, for example in ferroelectric LCDs, reduce the residual charge produced by the switching of the spontaneous polarisation charge of the ferroelectric LCs. When used in an OLED device comprising a light emitting material provided onto the alignment layer, this increased electrical conductivity can enhance the electroluminescence of the light emitting material. The compounds according to the present invention having mesogenic or liquid crystalline properties can form oriented anisotropic films as described above, which are especially useful as alignment layers to induce or enhance alignment in a liquid crystal medium provided onto said anisotropic film. The polymers according to the present invention may also be combined with photoisomerisable compounds and/or chromophores for use in or as photoalignment layers, as described in US 2003/0021913 A1.

According to another use the compounds and compositions according to the present invention, especially their water-soluble derivatives (for example with polar or ionic side groups) or ionically doped forms, can be employed as chemical sensors or materials for detecting and discriminating DNA sequences. Such uses are described for example in L. Chen, D. W. McBranch, H. Wang, R. Helgeson, F. Wudl and D. G. Whitten, Proc. Natl. Acad. Sci. U.S.A., 1999, 96, 12287; D. Wang, X. Gong, P. S. Heeger, F. Rininsland, G. C. Bazan and A. J. Heeger, Proc. Natl. Acad. Sci. U.S.A., 2002, 99, 49; N. DiCesare, M. R. Pinot, K. S. Schanze and J. R. Lakowicz, Langmuir, 2002, 18, 7785; D. T. McQuade, A. E. Pullen, T. M. Swager, Chem. Rev., 2000, 100, 2537.

Unless the context clearly indicates otherwise, as used herein plural forms of the terms herein are to be construed as including the singular form and vice versa.

Throughout the description and claims of this specification, the words "comprise" and "contain" and variations of the words, for example "comprising" and "comprises", mean "including but not limited to", and are not intended to (and do not) exclude other components.

It will be appreciated that variations to the foregoing embodiments of the invention can be made while still falling within the scope of the invention. Each feature disclosed in this specification, unless stated otherwise, may be replaced by alternative features serving the same, equivalent or similar purpose. Thus, unless stated otherwise, each feature disclosed is one example only of a generic series of equivalent or similar features.

All of the features disclosed in this specification may be combined in any combination, except combinations where at least some of such features and/or steps are mutually exclusive. In particular, the preferred features of the invention are applicable to all aspects of the invention and may be used in any combination. Likewise, features described in non-essential combinations may be used separately (not in combination).

Above and below, unless stated otherwise percentages are percent by weight and temperatures are given in degrees Celsius. Values of the dielectric constant $\varepsilon$ ("permittivity") refer to values taken at 20°C and 1,000 Hz.

The invention will now be described in more detail by reference to the following examples, which are illustrative only and do not limit the scope of the invention.

Example 1

Synthesis of 2-ethylhexyl thiophene-2-carboxylate

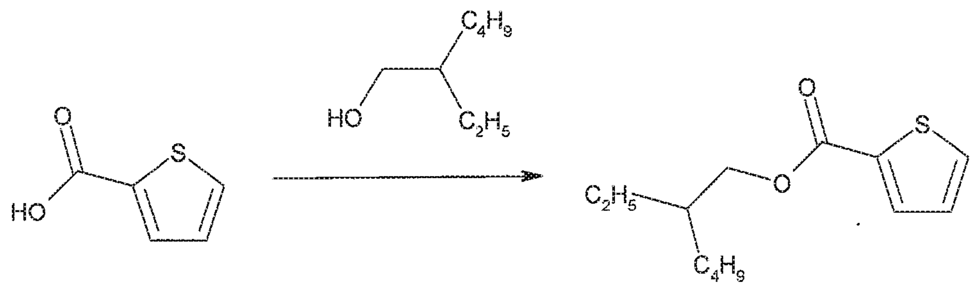

To solution of thiophene-2-carboxylic acid (5.00 g, 39.0 mmol), dicyclohexylcarbodiimide (9.65 g, 46.8mmol) and 4-dimethylaminopyridine (1.25 g, 13.7 mmol) in dry dichloromethane (100 $cm^3$) is added slowly 2-ethylhexyl alcohol (7.62 g, 58.8 mmol) and the mixture is stirred for 24 hour at 23 °C. The organic layer is washed with water (100 $cm^3$). An organic phase is separated and then dried over anhydrous magnesium sulphate. The organic layer is concentrated by vacuum evaporation, and the residue is purified by column chromatography on silica gel with 40-60 petrol:dichloromethane (1:1) as eluent to give 8.0 g of 2-ethylhexyl thiophene-2-carboxylate with a yield of 85%. $^1H$ NMR ($CDCl_3$, 400 MHz, ppm) δ 7.80 (dd, *J*= 1.2Hz, *J*=3.6 Hz, 1H), 7.54 (dd, *J* = 1.2 Hz, *J*=4.8 Hz, 1H), 7.10 (dd, *J*= 3.6Hz, *J*=4.8Hz, 1H),4.22 (dd, *J* = 2.0 Hz, *J* = 6.0 Hz, 2H),1.71 (m, 1H), 1.47-1.3 (m, 8 H), 0.96-0.89 (m, 6H). $^{13}C$ NMR ($CDCl_3$, 100 MHz, ppm) δ 162.53, 134.33, 133.27, 132.24, 124.81, 67.66, 39.05, 30.69, 29.11, 24.11, 23.10, 14.16, 11.22. HRMS (EI+): m/z calc. 240.1184, found 240.1185.

Synthesis of 5,5'-benzo[1,2-*b*:4,5-*b'*]dithiophene-4,8-diylbis-2-thiophenecarboxylic acid 2,2'-bis(2-ethylhexyl) ester

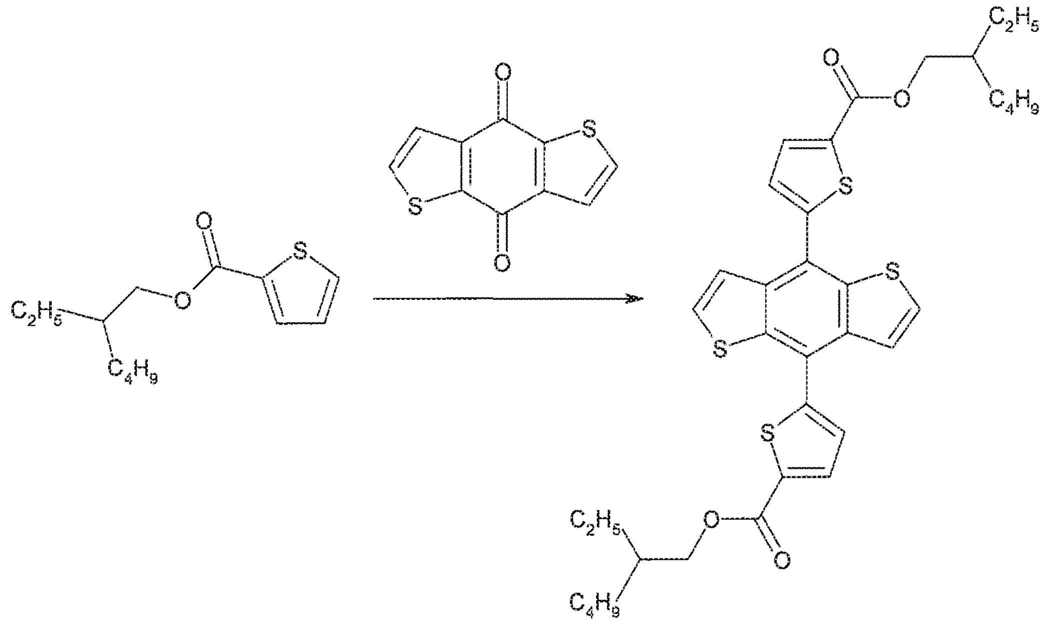

2-ethylhexyl thiophene-2-carboxylate (3.8 g, 15.8 mmol) is dissolved under inert atmosphere in 40 $cm^3$ of anhydrous tetrahydrofurn. A solution of fresh lithium diisopropylmime (2 M, 15.8 mmol) is added dropwise at -78 °C. After stirring for 1 hour, a solution of benzodithiophene-4,8-dione (1 g, 4.5 mmol, in 30 $cm^3$ of tetrahydrofuran) is added. The reaction mixture is stirred for 1 hour at 23 °C. A solution of tin(II)-chloride dihydrate (7.0 g, 31 mmol) in 10% hydrochloric acid (2.5 $cm^3$) is added, and the resulting mixture is stirred for 16 hours and poured into water and extracted with dichloromethane (3× 50 $cm^3$). The organic layer is washed with brine, and dried over magnesium sulphate. The crude product was purified by column chromatography on silica gel with 40-60 petrol:dichloromethane (1:1) as eluent to afford 0.6 g of 5,5'-benzo[1,2-*b*:4,5-*b*']dithiophene-4,8-diylbis-2-thiophenecarboxylic acid 2,2'-bis(2-ethylhexyl) ester with a yield of 20%. $^1H$ NMR ($CDCl_3$, 400 MHz, ppm) δ 7.94 (d, *J*=4.0 Hz, 2 H), 7.60 (d, *J*=5.6 Hz, 2 H), 7.53 (d, *J*=5.6 Hz, 2 H), 7.48 (d, *J*=4.0 Hz, 2 H), 4.29 (d, *J*=5.6 Hz, 4H), 1.76 (m, 2 H), 1.50-1.26 (m, 16 H), 0.99-0.92 (m, 12 H). $^{13}C$ NMR ($CDCl_3$, 100 MHz, ppm) δ 162.23, 146.09, 139.20, 136.64, 134.74, 133.49, 128.81, 128.52, 123.49, 122.83, 67.81,

38.95, 30.57, 28.99, 23.99, 22.97, 14.04, 11.10. HRMS (MALDI): m/z calc. 666.1960, found 666.1958.

Synthesis of 5,5-(2,6-dibromobenzo[1,2-*b*:-4,5-*b'*]dithiophene-4,8-diyl)bis-2-thiophenecarboxylic acid , 2.2'-bis(2-ethylhexyl) ester

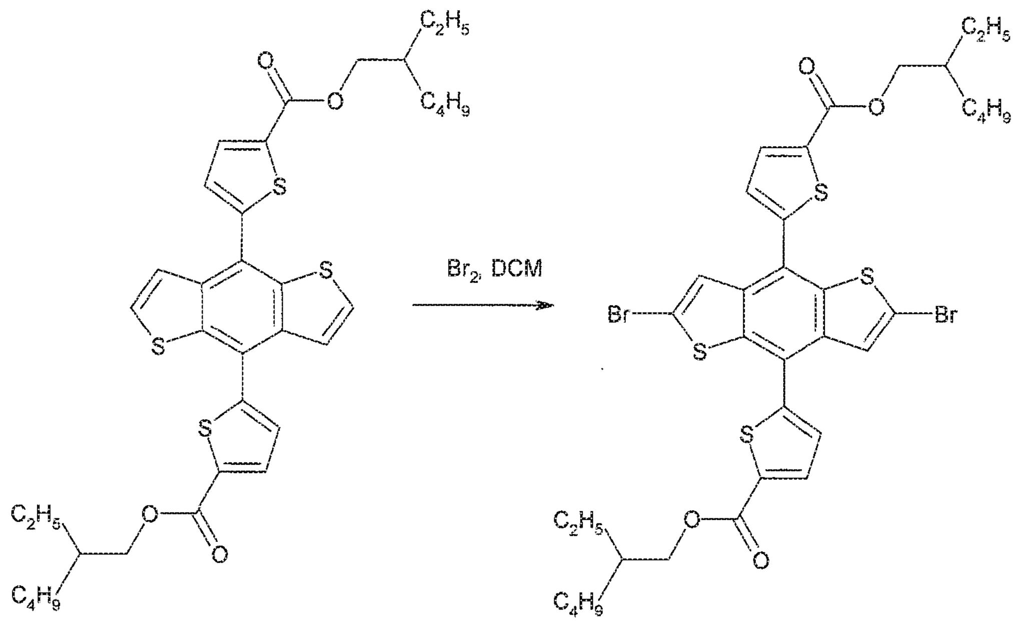


In a two-neck 100 mL flask under inert atmosphere, 5,5'-benzo[1,2-*b*:4,5-*b*'] dithiophene-4,8-diylbis-2-thiophenecarboxylic acid 2,2 '-b is(2 -ethyl hexyl) ester (3.0 g, 4.5 mmol) is dissolved in dichloromethane (50 $cm^3$). A solution of bromine (1.51g, 0.48 mL 9.45 mmol) in 10 $cm^3$ of dichloromethane is added dropwise at 0 °C. The mixture is stirred for 16 hours at 23 °C and poured into water. The excess bromine is quenched with sodium thiosulphate. The resulting solution is extracted with dichloromethane (3x 50 $cm^3$). The organic layer is washed with brine, and dried over magnesium sulphate. The crude product is purified by column chromatography on silica gel with 40-60 petrol:dichloromethane (1:1) as eluent to afford 3.2 g of 5,5'-(2,6-dibromobenzo[1,2-*b*:4,5-*b*']dithiophene-4, 8-diyl)bis-2-thiophenecarboxylic acid , 2,2'-bis(2-ethylhexyl) ester with a yield of 86%. $^1$H NMR ($CDCl_3$, 400 MHz, ppm) $\delta$ 7.91 (d, *J*=4.0Hz, 2 H), 7.53 (s, 2 H), 7.40 (d, *J*=4.0Hz, 2 H), 4.29 (dd, *J*=1.2Hz,J=5.6Hz, 4H), 1.76 (m, 2 H), 1.49-1.33 (m, 16 H), 0.98-0.91 (m, 12 H).$^{13}$C NMR ($CDCl_3$, 100 MHz, ppm) $\delta$ 162.11, 144.80, 140.54, 136.23, 135.50, 133.71, 129.03, 125.65, 121.92, 118.09, 68.11, 39.09, 30.72, 29.14, 24.13, 23.13, 14.22, 11.26. HRMS (MALDI): m/z calc. 822.0171, found 822.0170.

Synthesis of 5,5'-[2,6-bis(trimethylstannyl)benzo[1,2-*b*:4,5-*b'*]dithiophene-4, 8-diyl]bis-2-thiophenecarboxylic acid, 2,2'-bis(2-ethylhexyl) ester

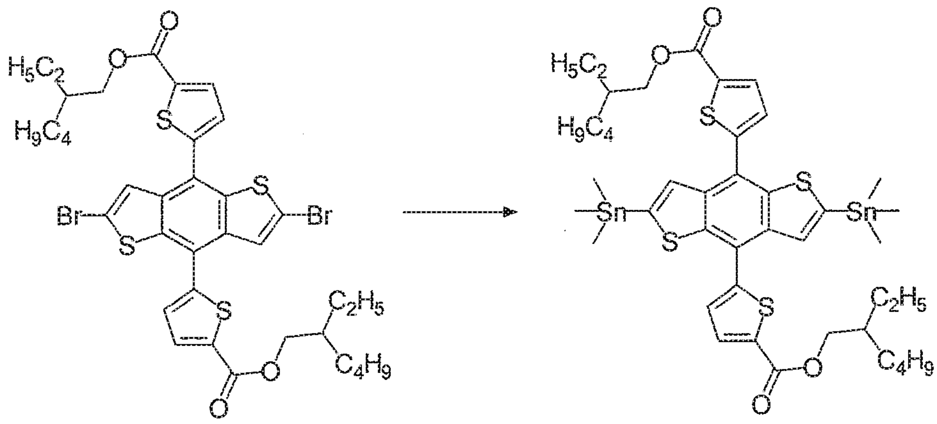

5,5'-(2,6-dibromobenzo[1,2-*b*:4,5-*b'*]dithiophene-4,8-diyl)bis-2-thiophenecarboxylic acid, 2,2'-bis(2-ethylhexyl) ester (2.0g, 2.42mmol) is dissolved in anhydrous tetrahydrofuran (20 $cm^3$). The n-butyllithium (2.2 $cm^3$, 5.32mmol, 2.4 M in hexane) is added slowly into this mixture within 15 minutes at -78 °C. The resulting solution is stirred for 1 hour at this temperature. The trimethyltin chloride (5.32 $cm^3$, 5.32mmol, 1 M in hexane) is added dropwise. The mixture is stirred for 16 hours, then poured into water and extracted with dichloromethane (3 $\times$ 30 $cm^3$). The combined organic phases are washed with brine, dried over magnesium sulphate and filtered. The filtrate is concentrated under reduced pressure to obtain crude product. This crude product is recrystallized using mixture of 40-60 petrol and propan-2-ol to give 1.5 g of product with a yield of 50%.$^1$H NMR (Acetone-$d_6$, 400 MHz, ppm) $\delta$ 8.00 (d, *J*=4.0Hz, 2 H), 7.75 (s, 2 H), 7.64 (d, *J*=4.0Hz, 2 H), 4.31 (d, *J*=5.6Hz, 4H), 1.76 (m, 2H), 1.50-1.35 (m, 16 H), 1.16-0.92 (m, 12 H), 0.50 (s, 18 H).$^{13}$C NMR ($CDCl_3$, 100 MHz, ppm) $\delta$ 162.37, 147.05, 144.00, 143.49, 137.41, 134.42, 133.46, 130.32, 128.71, 121.72, 67.75, 38.97, 30.61, 29.00, 24.03, 22.99, 14.06, 11.13,-8.30. HRMS (MALDI): m/z calc. 994.1264, found 994.1260.

Synthesis of polymer P1

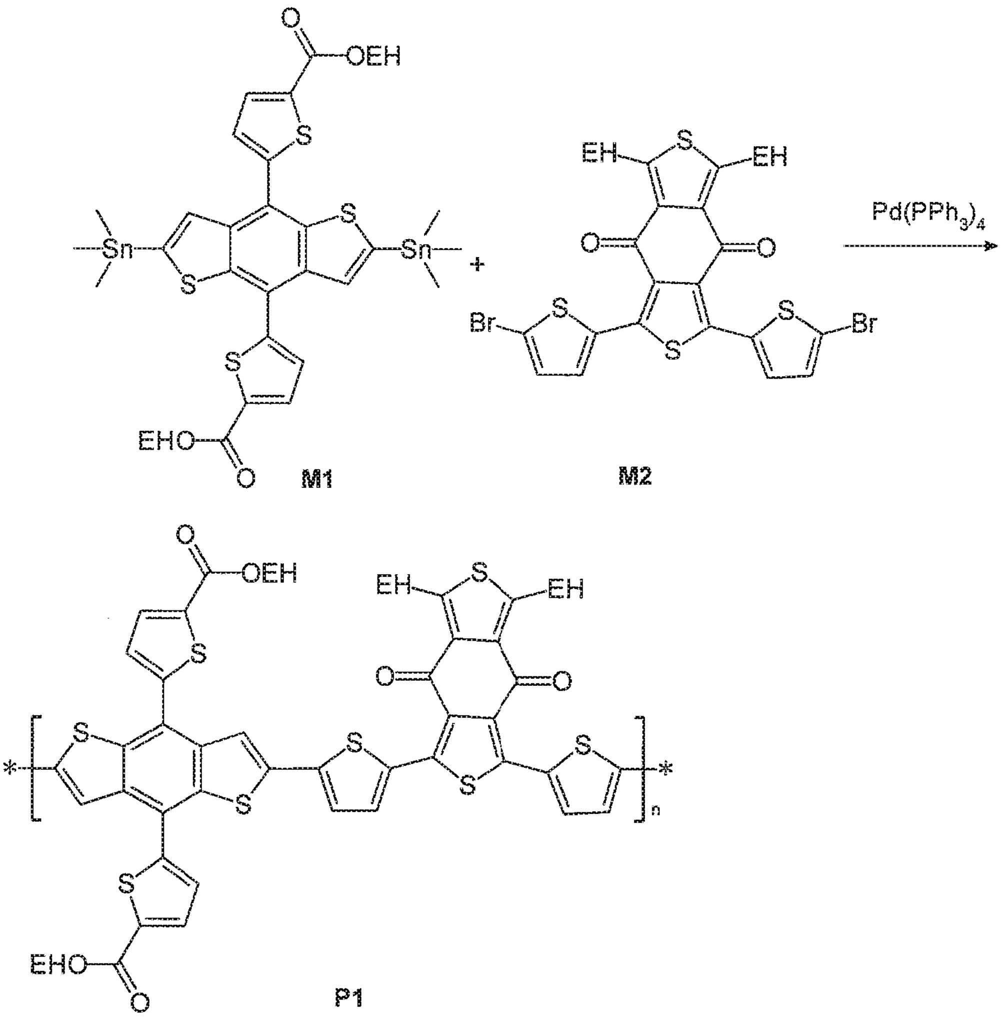


M1 M2

P1

wherein EH = 2-ethylhexyl

Compound M1 (0.3 mmol), compound M2 (0.3 mmol) and chlorobenzene (6 $cm^3$) are placed in a two-neck flask. The mixture is purged with argon for 5 minutes, and then 0.03 mmol of etrakis(triphenylphosphine)palladium are added. The mixture is purged with argon for another 5 minutes. Then the mixture is heated up to 115 °C under argon for 24 hours. After cooling to room temperature, the reaction mixture is poured into methanol. The polymer is filtered and subjected to Soxhlet extraction with acetone, hexane, dichloromethane and chloroform. The chloroform fraction is collected, concentrated and precipitated in methanol. The target polymer is collected by filtration and dried in vacuum to afford a black solid 290 mg (76%).

Molecular weight: 10.6 kg mol-1, PDI 2.2, measuring at 145 °C, in o-dichlorobenzene.

<u>Examples 2-6</u>

The following polymers were synthesized in analogy to the method described in Example 1.

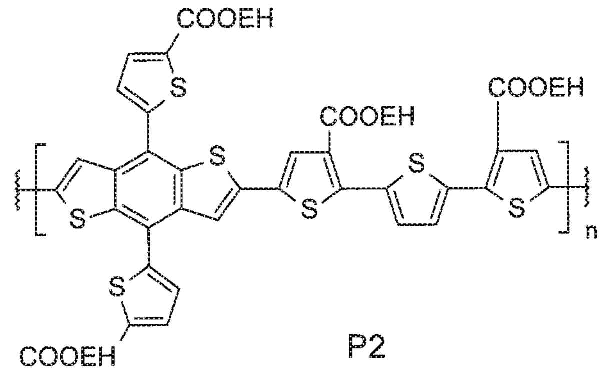

P2

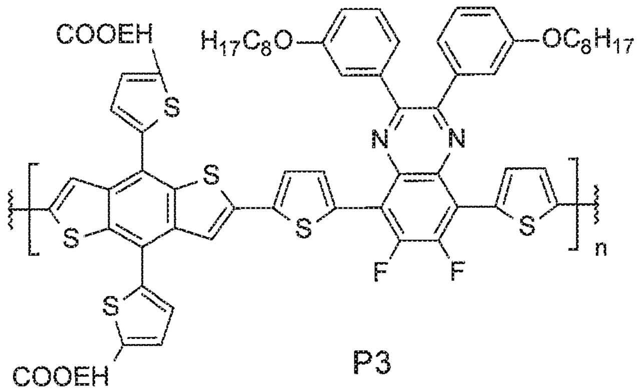

P3

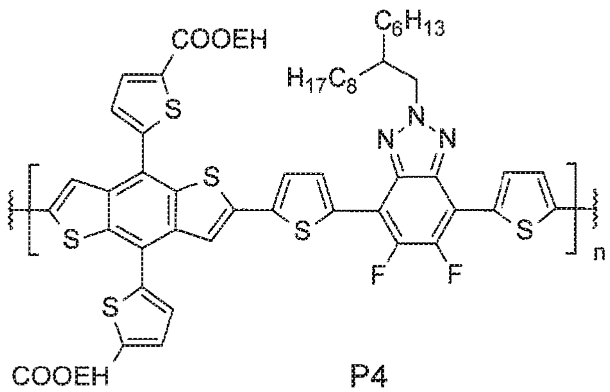

P4

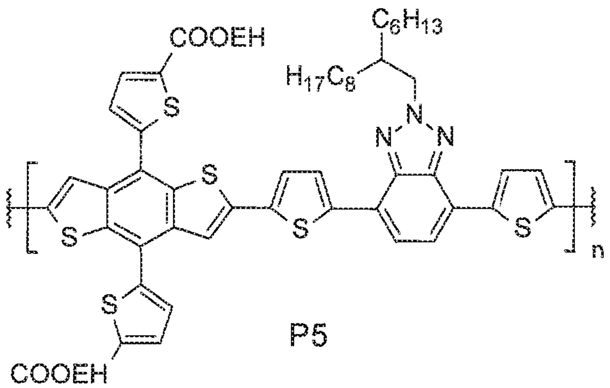

P5

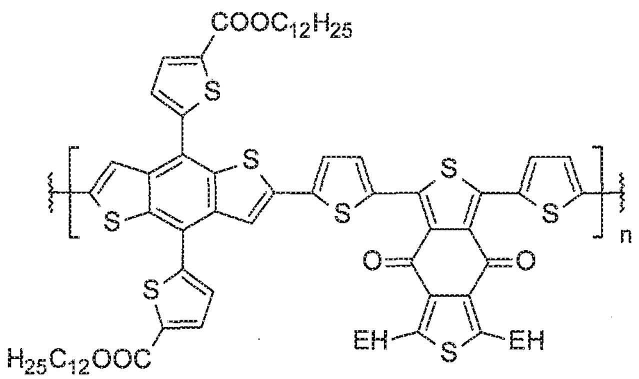

P6

wherein EH = 2-ethylhexyl and the COOEH group is connected via the C atom.

Table 1 shows the molecular weight of synthesized polymers P2-P6.

Table 1:

| Polymer | Mn (kg/mol) | Mw (kg/mol) | PDI |
|---|---|---|---|
| P2 | 29.6 | 67.6 | 2.3 |
| P3 | 9.4 | 19.4 | 2.1 |
| P4 | 12.8 | 40.0 | 3.0 |
| P5 | 15.7 | 27.4 | 1.7 |
| P6 | 15.8 | 56.0 | 3.5 |

Examples 7-12

Synthesis of 5,5'-benzo[1,2-*b*:4,5-*b*']dithiophene-4,8-diylbis-2-thiophenecarboxylic acid 2,2'-bis(dodecyl) ester

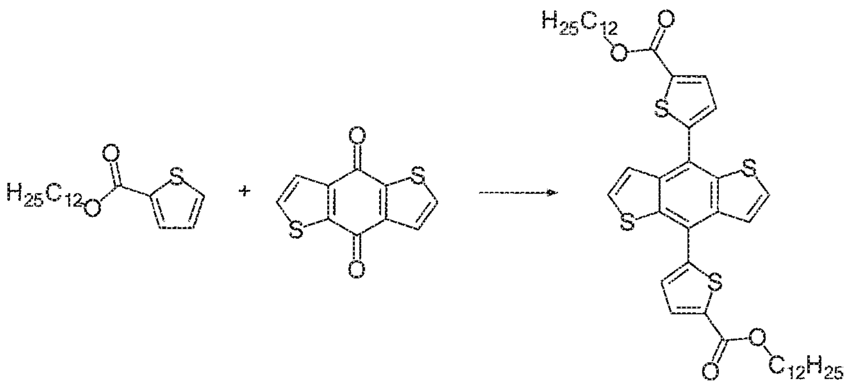

in a two-neck 250 mL flask under inert atmosphere, compound dodecyl thiophene-2-carboxylate (5 g, 16.9 mmol) is dissolved in anhydrous tetrahydrofuran (40 $cm^3$). A solution of fresh lithium diisopropylamine (8.45 $cm^3$, 2 M, 16.9 mmol) is added dropwise at -78 °C. After stirring for 1 hour, a solution of benzodithiophene-4,8-dione (1.06 g, 4.8 mmol, in tetrahydrofuran (30 $cm^3$)) is added. The reaction mixture is stirred for 1 hour at 23°C. A solution of tin(II)-chloride dihydrate (7.7 g, 34 mmol) in 10% hydrochloric acid (3 $cm^3$) is added, and the resulting mixture is stirred for 16 hours and poured into water and extracted with dichloromethane (3x 50 $cm^3$). The organic layer is washed with brine, and dried over magnesium sulphate. The crude product is purified by column chromatography on silica gel with 40-60

petrol:dichloromethane (1:1) as eluent to afford 0.82 g of product with a yield of 22%. $^1$H-NMR (CDCl3, 400MHz, ppm): δ 7.94 (s, 2H), 7.59 (d, 2H, J = 5.6 Hz), 7.53 (d, 2H, J = 5.6 Hz), 7.48 (s, 2H), 4.35 (t, 4H, J = 6.4 Hz), 1.79 (m, 4H), 1.47 (br, 4H), 1.35(br, 32H), 0.87 (m, 6H).

Synthesis of 5,5'-(2,6-dibromobenzo[1,2-*b*:4,5-*b*']dithiophene-4,8-diyl)bis-2-thiophenecarboxylic acid , 2,2'-bis(dodecyl) ester

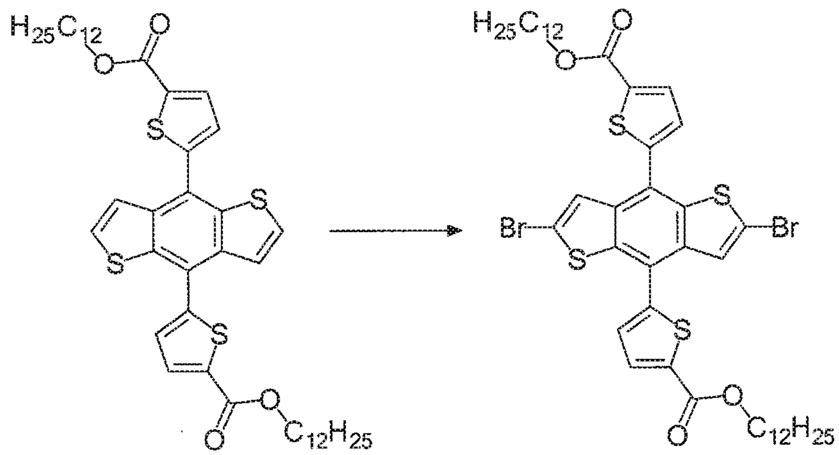

5,5'-benzo[1,2-*b*:4,5-*b*']dithiophene-4,8-diylbis-2-thiophenecarboxylic acid 2,2'-bis(dodecyl) ester (5.0 g, 6.4 mmol) is dissolved in dichloromethane (70 $cm^3$) under inert atmosphere. A solution of bromine (2.15g, 0.68 $cm^3$, 13.44 mmol) in dichloromethane (10 $cm^3$) is added dropwise at 0 °C. The mixture is stirred for 16 hours at 23 °C and poured into water. The excess of bromine is quenched with sodium thiosulphate. The resulting solution is extracted with dichloromethane (3x 50 $cm^3$). The organic layer is washed with brine, and dried over magnesium sulphate. The crude product is purified by column chromatography on silica gel with 40-60 petrol:dichloromethane (1:1) as eluent to afford 5.69 g of product with a yield of 85%. 1H-NMR ($CDCl_3$, 400 MHz, ppm): δ 7.91 (d, 2H, J = 3.6 Hz), 7.54 (s, 2H), 7.40 (d, 2H, J = 3.6 Hz), 4.35 (t, 4H, J = 6.8 Hz), 1.79 (m, 4H), 1.43 (br, 4H), 1.35(br, 32H), 0.87 (m, 6H).

Synthesis of 5,5'-benzo[1,2-*b*:4,5-*b*']dithiophene-4,8-diylbis-2-thiophenecarboxylic acid 2,2'-bis(octyl) ester

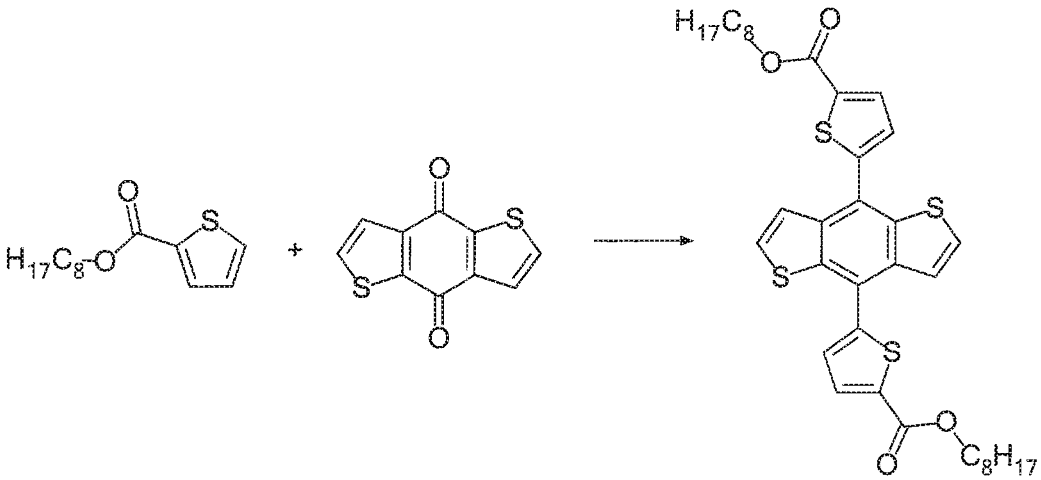

In a two-neck 250 mL flask under inert atmosphere, compound dodecyl thiophene-2-carboxylate (5.7 g, 23.7 mmol) is dissolved in anhydrous tetrahydrofuran (40 $cm^3$). A solution of fresh lithium diisopropylamine (11.85 $cm^3$, 2 M, 23.7 mmol) is added dropwise at -78 °C. After stirring for 1 hour, a solution of benzodithiophene-4,8-dione (1.5 g, 6.75

mmol, in tetrahydrofuran (50 $cm^3$)) is added. The reaction mixture is stirred for 1 hour at 23°C. A solution of tin(II)-chloride dihydrate (10.5 g, 46.5 mmol) in 10% hydrochloric acid (4.5 $cm^3$) is added, and the resulting mixture is stirred for 16 hours and poured into water and extracted with dichloromethane (3x 50 $cm^3$). The organic layer is washed with brine, and dried over magnesium sulphate. The crude product is purified by column chromatography on silica gel with 40-60 petrol:dichloromethane (1:1) as eluent to afford 1.12 g of product with a yield of 25%.

Synthesis of 5,5'-(2,6-dibromobenzo[1,2-*b*:4,5-*b*']dithiophene-4,8-diyl)bis-2-thiophenecarboxylic acid, 2,2'-bis(octyl) ester

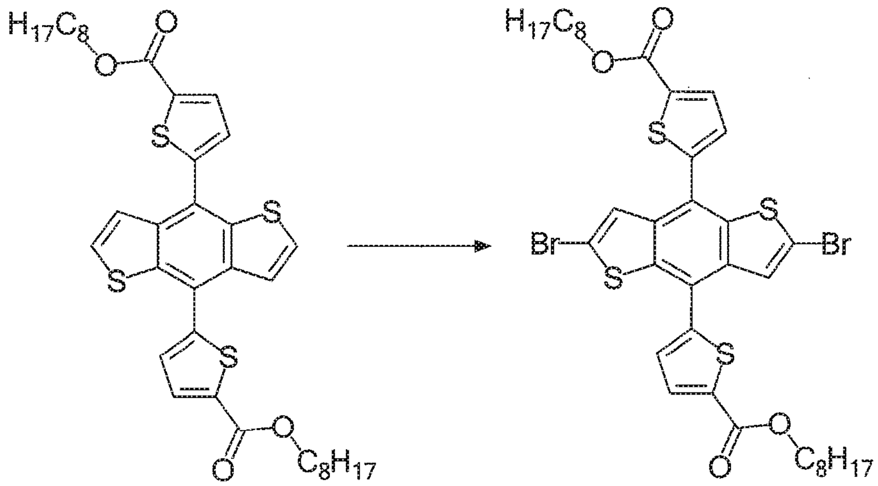

5,5'-benzo[1,2-*b*:4,5-*b*']dithiophene-4,8-diylbis-2-thiophenecarboxylic acid 2,2'-bis(octyl) ester (6.0 g, 9.0 mmol) is dissolved in dichloromethane (50 $cm^3$) under inert atmosphere. A solution of bromine (3.02 g, 1.0 $cm^3$, 18.9 mmol) in dichloromethane (20 $cm^3$) is added dropwise at 0 °C. The mixture is stirred for 16 hours at 23 °C and poured into water. The excess of bromine is quenched with sodium thiosulphate. The resulting solution is extracted with dichloromethane (3x 50 $cm^3$). The organic layer is washed with brine, and dried over magnesium sulphate. The crude product is purified by column chromatography on silica gel with 40-60 petrol:dichloromethane (1:1) as eluent to afford 5.94 g of product with a yield of 80%. $^1$H-NMR ($CDCl_3$, 400M, ppm): $\delta$ 7.91 (d, 2H, J = 3.6 Hz), 7.54 (s, 2H), 7.40 (d, 2H, J = 3.6 Hz), 4.35 (t, 4H, J = 6.8 Hz), 1.79 (m, 4H), 1.33 (br, 4H), 1.29(br, 16H), 0.87 (m, 6H).

General synthetic procedure for preparation of polymers P7-P12:

Dibromo-compound (0.3 mmol), distannyl compound (0.3 mmol) and chlorobenzene (6 $cm^3$) is placed in a 50 $cm^3$ of two-neck flask. The mixture is purged with argon for 5 minutes, and then tetrakis(triphenylphosphine)palladium (0.03 mmol) is added.The mixture is purged with argon for another 5 minutes. Then the mixture is heated up to 110°C under argon for corresponding time. After cooling to 23 °C, the reaction mixture is poured into methanol. The polymer is filtered and subjected to Soxhlet extraction with acetone, n-hexane and chloroform. The chloroform fraction is collected, concentrated and precipitated in methanol. The target polymer is collected by filtration and dried in vacuum to afford solid polymers.

Table 2 shows the reaction times required to achieve Polymers P7-P12.

Table 2:

| Polymer | Reaction time (hours) | Yield (%) |
|---|---|---|
| P7 | 8 | 66 |
| P8 | 6 | 74 |
| P9 | 18 | 69 |
| P10 | 25 | 65 |
| P11 | 24 | 74 |

(continued)

| Polymer | Reaction time (hours) | Yield (%) |
|---|---|---|
| P12 | 31 | 70 |

The synthesis of Polymer P7 is shown below:

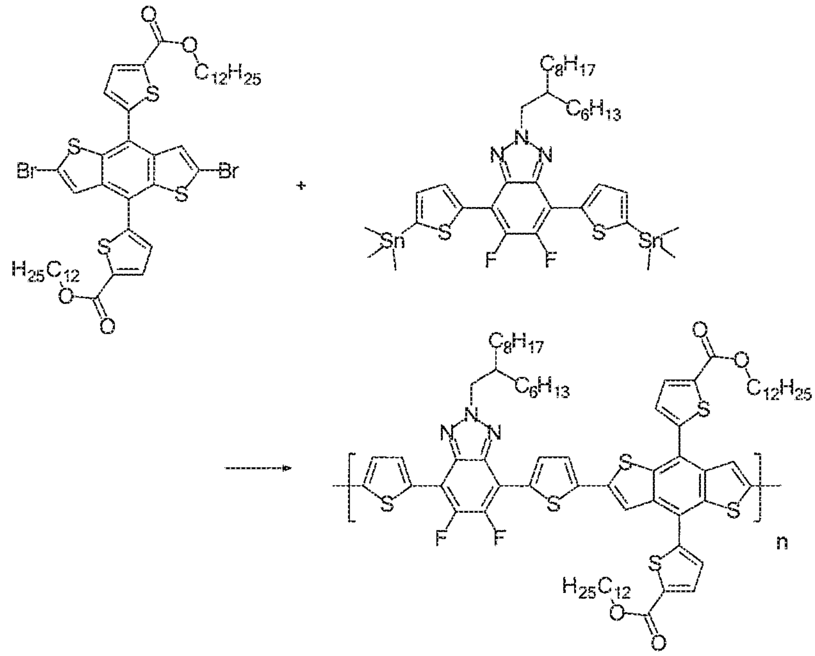

(P7)

The synthesis of Polymer P8 is shown below:

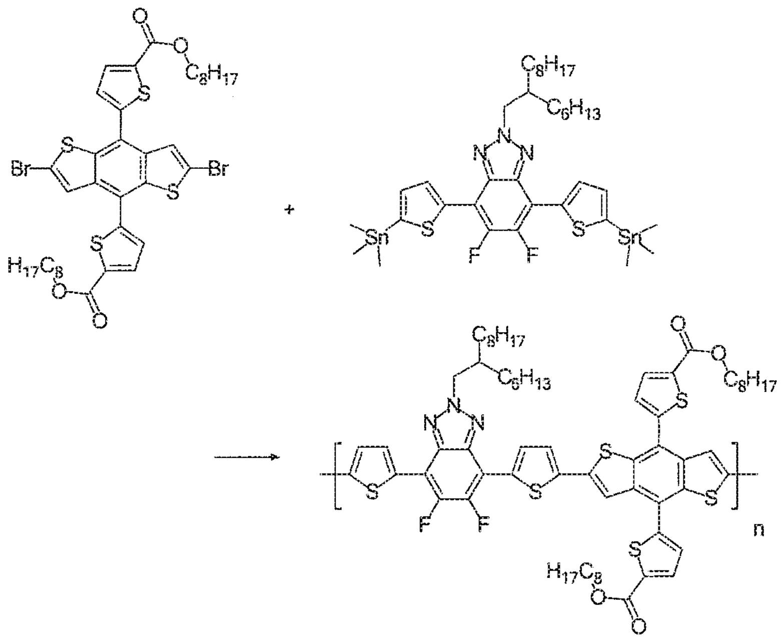

(P8)

The synthesis of Polymer P9 is shown below:

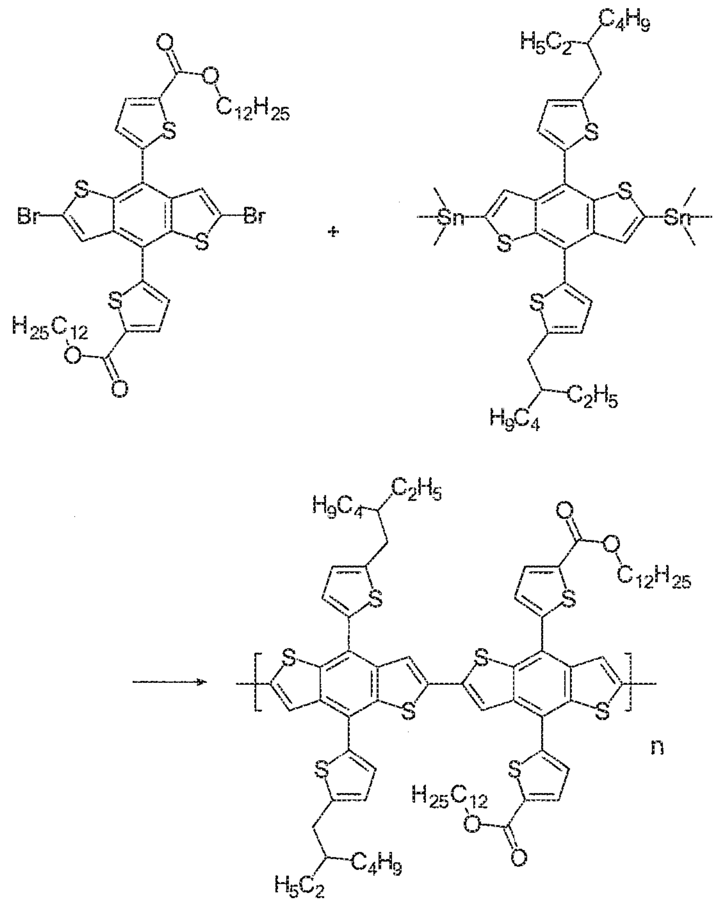

(P9)

The synthesis of Polymer P10 is shown below:

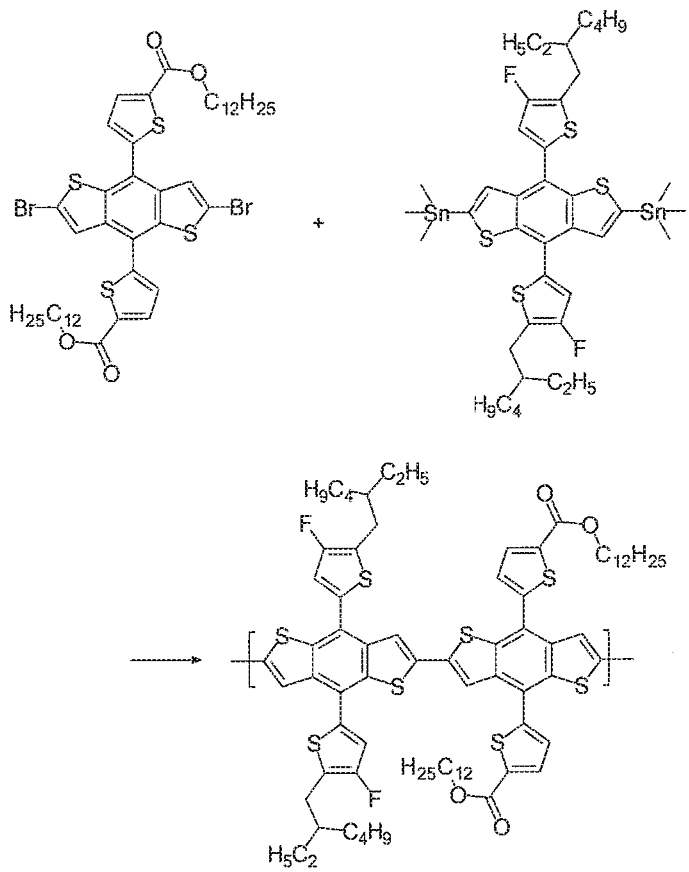

(P10)

The synthesis of Polymer P11 is shown below:

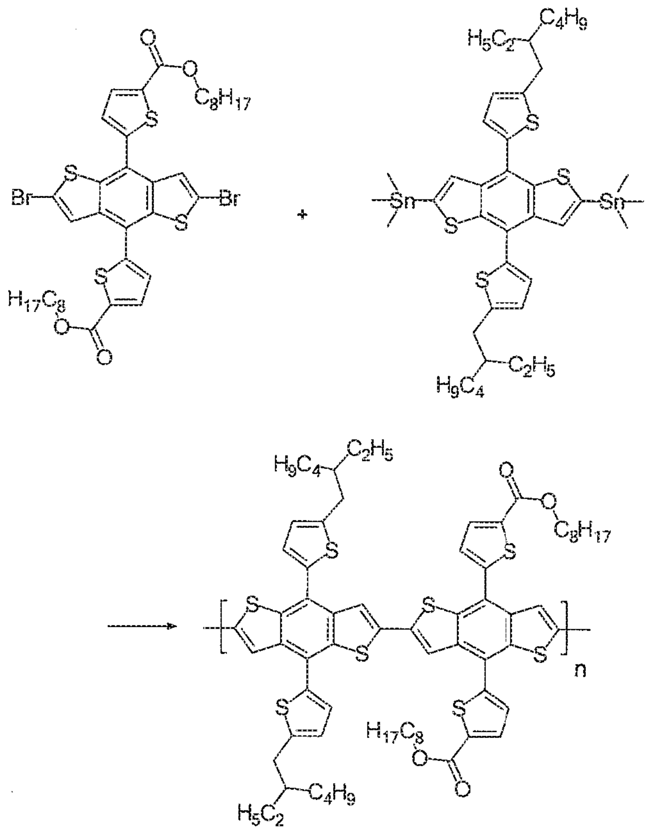

(P11)

The synthesis of Polymer P12 is shown below:

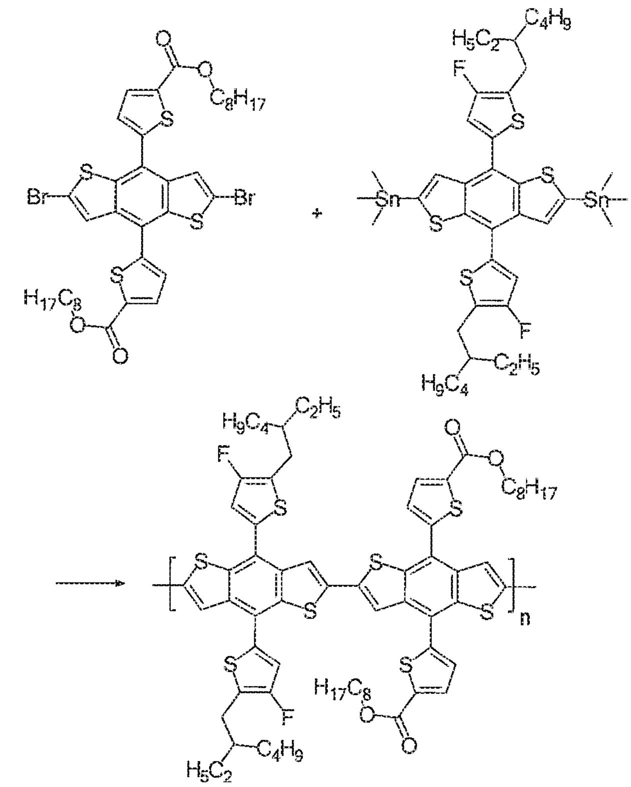

(P12)

Examples 13-16

The synthesis of Polymers P13-P16 is shown below:

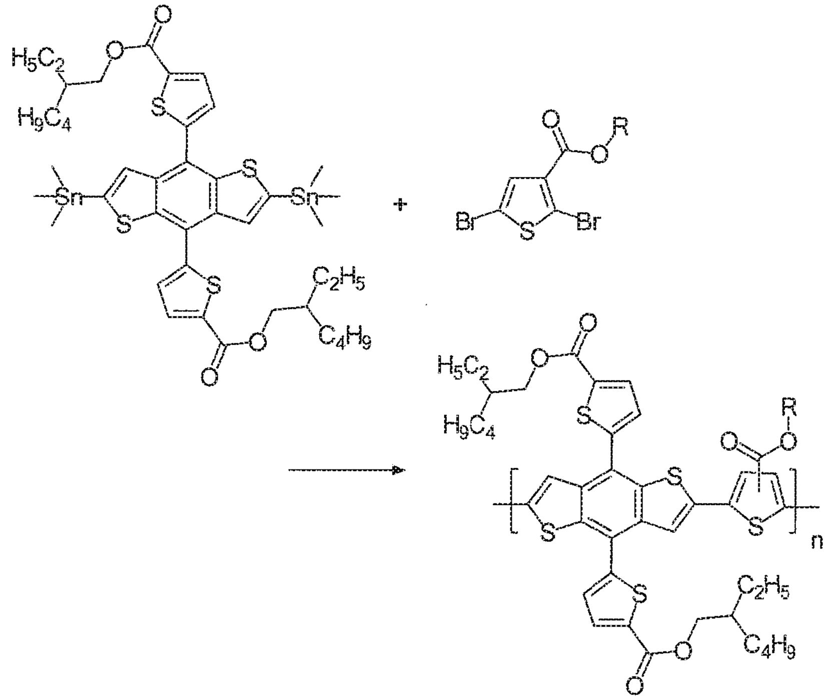

Polymerisation conditions for synthesis of P13-P16 are as follows: Stannyl compound (0.2 mmol), dibromo compound (0.2 mmol) and chlorobenzene (5 $cm^3$) are added into microwave vial, the mixture is purged with argon for 10 minutes. Next After, the 0.02 mmol of tetrakis(triphenylphosphine)palladium (0.02 mmol) is added, the mixture is prurged with argon for 5 minutes. The vial is put into microwave reactor for 5 hours at 135 °C. After cooling to room temperature, the reaction mixture is poured into vigorously stirred methanol (100 $cm^3$). The polymer is purified by column using chloroform as eluent.

Table 3 shows the molecular weight of synthesized polymers P13-P16.

Table 3:

| Polymer | R | Mn | PDI |
|---|---|---|---|
| P13 | Methyl | Insoluble | n/a |
| P14 | n-octvl | 12.0 | 1.8 |
| P15 | n-hexyl | 13.4 | 2.0 |
| P16 | n-butyl | 11.4 | 2.1 |

Use Example A

Current-voltage characteristics are measured using a Keithley 2400 SMU while the solar cells are illuminated by a Newport Solar Simulator at 100 mW·$cm^{-2}$ white light. The solar simulator is equipped with AM1.5G filters. The illumination intensity is calibrated using a Si photodiode. All the device preparation and characterization is done in a dry-nitrogen atmosphere.

Power conversion efficiency is calculated using the following expression

$$\eta = \frac{V_{oc} \times J_{sc} \times FF}{P_{in}}$$

where FF is defined as

$$FF = \frac{V_{max} \times J_{max}}{V_{oc} \times J_{sc}}$$

OPV device characteristics are obtained for a composition, which contains as donor a polymer of the above examples 1-6 or the polymer PBDB-T of prior art as shown below, and as acceptor the compound IT-4F (A2) or A3 as shown below, and is coated from an organic solution. Details of the solution composition are shown in Table 4 below.

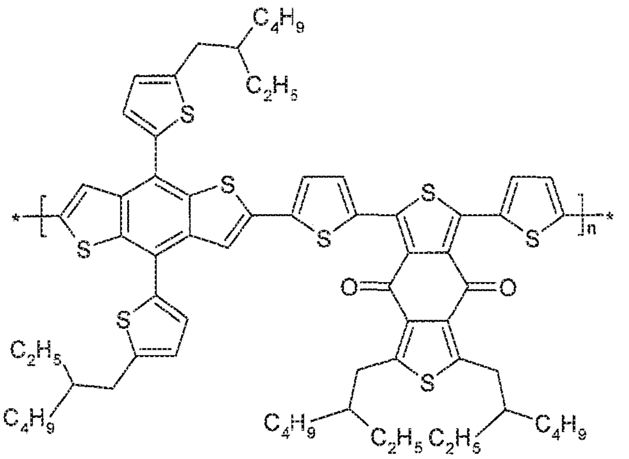

PBDB-T

Comparison polymer PBDB-T and its preparation are disclosed in *Adv. Mater.* **2016,** *28*, 4734-4739.

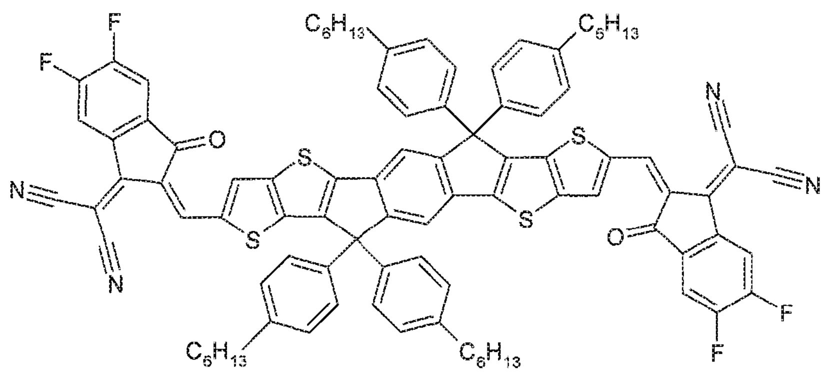

IT-4F (A2)

Acceptor A2 (IT-4F) and its preparation are disclosed in CN105315298 A.

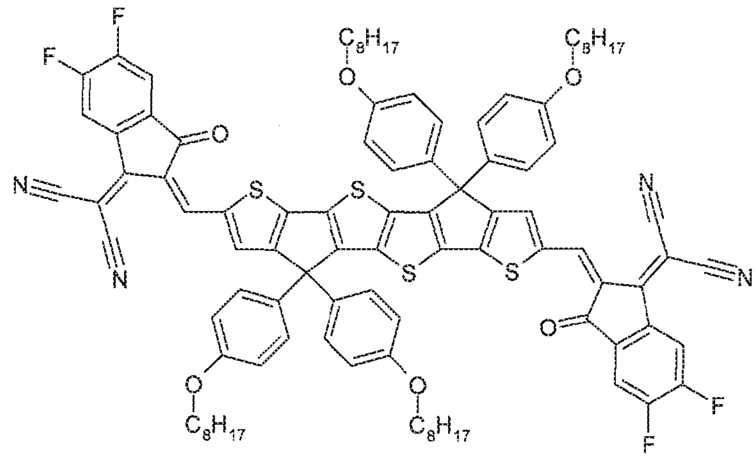

A3

Acceptor A3 and its preparation are disclosed in PCT/EP2017/074951.

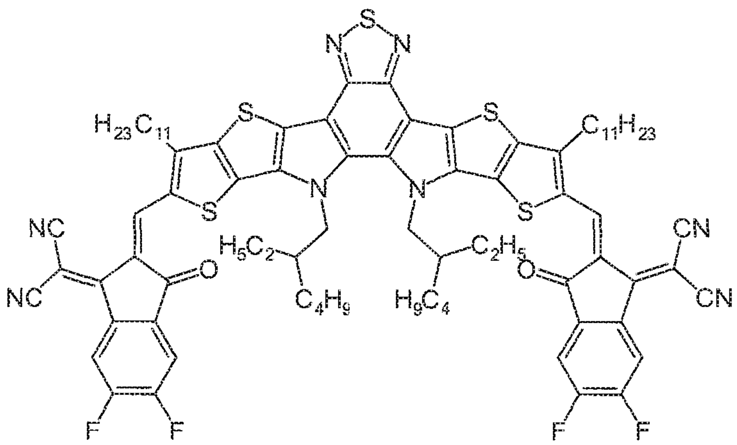

A4

Acceptor A4 and its preparation are disclosed in Joule 3, 1-12, 2019

A1: blade-coated bulk heterojunction organic photovoltaic devices

Organic photovoltaic (OPV) devices are fabricated on pre-patterned ITO-glass substrates (13Ω/sq.) purchased from LUMTEC Corporation. Substrates are cleaned using common solvents (acetone, iso-propanol, deionized-water) in an ultrasonic bath. A layer of commercially available aluminium zinc oxide (AlZnO, Nanograde) was applied as a uniform coating by doctor blade at 40 °C. The AlZnO Films are then annealed at 100 °C for 10 minutes in air. Active material solutions (i.e. polymer + acceptor) are prepared to fully dissolve the solutes at a 25 $mg.cm^{-3}$ solution concentration. Thin films are blade-coated in air atmosphere to achieve active layer thicknesses between 50 and 800 nm as measured using a profilometer. A short drying period follows to ensure removal of any residual solvent.

Typically, blade-coated films are dried at 70 °C for 2 minutes on a hotplate. Next the devices are transferred into an air atmosphere. On top of the active layer 0.1 mL of a conducting polymer poly(ethylene dioxythiophene) doped with poly(styrene sulfonic acid) [PEDOT:PSS Clevios HTL PV AI 4083 (Heraeus)] was spread and uniformly coated by doctor blade at 70 °C. Afterwards Ag (100 nm) cathodes are thermally evaporated through a shadow mask to define the cells. The devices were subsequently heated at 120°C for 5 minutes on a hotplate inside a $N_2$ atmosphere.

Table 4 shows the characteristics of the individual photoactive formulations. The solvent is either chlorobenzene:1 ,8-diiodooctane at a 99.5:0.5 volume ratio (CB:DIO), chlorobenzene:3-phenoxytoluene at a 97:3 volume ratio (CB:3PT), chloroform:chloronaphthalene at 99.5:0.5 volume ration (CF:CN), o-xylene (oXyl), chlorobenzene (CB) or mesitylene (mes).

Table 4: Formulation characteristics

| No. | Acceptor | Polymer | Ratio Polymer: Acceptor | Concentration g/L | Solvent |
|---|---|---|---|---|---|
| C1 | A2 | PBDB-T | 1.00:1.00 | 20 | CB:DIO |
| 1A | A2 | P1 | 1.00:1.00 | 20 | CB:DIO |
| C2 | A3 | PBDB-T | 1.00:1.00 | 20 | CB |
| 1B | A3 | P1 | 1.00: 1.00 | 20 | CB |
| 2 | A3 | P2 | 1.00:1.00 | 20 | CB |
| 3 | A3 | P3 | 1.00:1.00 | 20 | CB |
| 4 | A3 | P4 | 1.00:1.00 | 20 | CB |
| 5 | A3 | P5 | 1.00:1.00 | 20 | CB |
| 6 | A3 | P6 | 1.00:1.00 | 20 | CB |
| 7 | A4 | P1 | 1.00:1.00 | 8 | CF:CN |

A2: Inverted device properties

Table 5 shows the device characteristics for the individual OPV devices comprising a photoactive layer with a BHJ formed from the photoactive acceptor/polymer formulations of Table 4.

Table 5: Photovoltaic cell characteristics under simulated solar irradiation at 1 sun (AM1.5G).

| No. | Polymer | Average Performance | | | |
|---|---|---|---|---|---|
| | | Voc | Jsc | FF | PCE |
| | | mV | $mA \cdot cm^{-2}$ | % | % |
| C1 | PBDB-T | 594 | 14.7 | 53.0 | 4.62 |
| 1A | P1 | 724 | 15.3 | 56.8 | 6.27 |
| C2 | PBDB-T | 508 | 14.4 | 40.3 | 2.95 |
| 1B | P1 | 687 | 16.3 | 44.4 | 4.99 |
| 2 | P2 | 595 | 9.6 | 35.8 | 2.05 |
| 3 | P3 | 724 | 16.2 | 43.1 | 5.05 |
| 4 | P4 | 668 | 16.2 | 41.7 | 4.55 |
| 5 | P5 | 508 | 8.4 | 38.6 | 1.64 |
| 6 | P6 | 661 | 15.6 | 39.0 | 4.06 |

The devices 1A and 1B with donor polymer P1 according to the present invention show a significant improvement in open circuit voltage (Voc), compared to devices C1 and C2 with donor polymer PBDB-T from prior art, regardless if the acceptor is A2 or A3. This is an advantage for module production.

A3: spin-coated bulk heterojunction organic photovoltaic devices

Organic photovoltaic (OPV) devices are fabricated on pre-patterned ITO-glass substrates. Substrates are cleaned using common solvents (acetone, iso-propanol, deionized-water) in an ultrasonic bath and subsequently exposed to UV ozone. A layer of zinc oxide (ZnO) is applied as a uniform coating by spin coating as previously described in Adv. Mater. 2011, 23, 1679. Active material solutions (i.e. polymer + acceptor) are prepared to fully dissolve. Thin films are spin-coated in $N_2$ atmosphere to achieve active layer thicknesses between 50 and 800 nm as measured using a profilometer. A short drying period follows to ensure removal of any residual solvent. On top of the active layer 10 nm of molybdenum oxide is uniformly coated by thermal evaporation in a vacuum at $3\times10^{-4}$ Pa. Afterwards Al (100 nm)

cathodes are thermally evaporated through a shadow mask to define the cells.

Optionally, for the purpose of optimization, the ZnO layer and the molybdenum oxide layer is replaced with a layer of conducting polymer polyethylene dioxythiophene) doped with poly(styrene sulfonic acid) [PEDOT:PSS] and a layer of PFN-Br [Chem. Mater., 2004, 16, 708], respectively. Both these layers are applied by spin coating.

A4: spin-coated device properties

Table 6 shows the device characteristics for the individual OPV devices comprising a photoactive layer with a BHJ formed from the photoactive acceptor/polymer formulations of Table 4.

Table 6: Photovoltaic cell characteristics under simulated solar irradiation at 1 sun (AM1.5G).

| No. | Interlayer materials | Average Performance | | | |
|---|---|---|---|---|---|
| | | Voc | Jsc | FF | PCE |
| | | mV | $mA \cdot cm^{-2}$ | % | % |
| C1 | $ZnO/MoO_3$ | 777 | 19.2 | 61.3 | 9.14 |
| 1A | PEDOT:PSS/PNF-Br | 851 | 21.8 | 65.0 | 12.0 |
| 7 | PEDOT:PSS/PNF-Br | 835 | 24.9 | 68 | 14.17 |

Device 1A with donor polymer P1 according to the present invention and acceptor A2 shows a significant improvement in open circuit voltage (Voc) and PCE compared to device C1 with donor polymer PBDB-T of prior art and acceptor A2. This is an advantage for module production.

**Claims**

**1.** A compound comprising two or more repeating units, at least one of which is selected of formula I

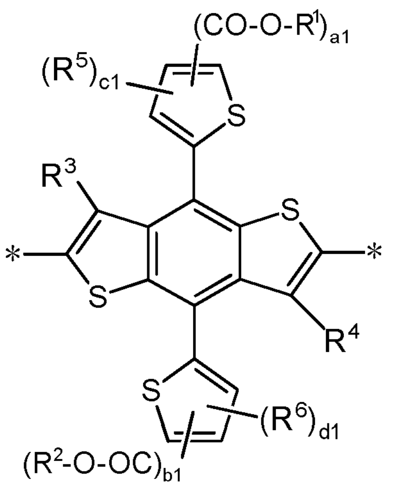

I

wherein the individual radicals, independently of each other and on each occurrence identically or differently, have the following meanings

$R^1$, $R^2$ straight-chain, branched or cyclic alkyl with 1 to 30, preferably 1 to 20, C atoms, in which one or more $CH_2$ groups are optionally replaced by -O-, -S-, -C(=O)-, -C(=S)-,-C(=O)-O-, -O-C(=O)-, $-NR^0-$, $-SiR^0R^{00}-$, $-CF_2-$, $-CR^0=CR^{00}-$,$-CY^1=CY^2-$ or -C≡C- in such a manner that O and/or S atoms are not linked directly to one another, and in which one or more H atoms are optionally replaced by F, C!, Br, I or CN, and in which one or more $CH_2$ or $CH_3$ groups are optionally replaced by a cationic or anionic group, or aryl, heteroaryl, arylalkyl or heteroarylalkyl, wherein each of the aforementioned cyclic groups has 5 to 20 ring atoms, is mono- or polycyclic, does optionally contain fused rings, and is unsubstituted or substituted by one or more identical or different groups L,

$R^{3-6}$ H, F, Cl, CN, or straight-chain, branched or cyclic alkyl with 1 to 30, preferably 1 to 20, C atoms, in which one or more $CH_2$ groups are optionally replaced by -O-, -S-, -C(=O)-, -C(=S)-,-C(=O)-O-, -O-C(=O)-, $-NR^0-$, $-SiR^0R^{00}-$, $-CF_2-$, $-CR^0=CR^{00}-$,$-CY^1=CY^2-$ or -C≡C- in such a manner that O and/or S atoms are not linked directly to one another, and in which one or more H atoms are optionally replaced by F, C!, Br, I or CN, and in which one or more $CH_2$ or $CH_3$ groups are optionally replaced by a cationic or anionic group, or aryl, heteroaryl, arylalkyl, heteroarylalkyl, aryloxy or heteroaryloxy, wherein each of the aforementioned cyclic groups has 5 to 20 ring atoms, is mono- or polycyclic, does optionally contain fused rings, and is unsubstituted or substituted by one or more identical or different groups L,

L F, C!, -CN, -NC, -NCO, -NCS, -OCN, -SCN, $R^0$, $OR^0$, $SR^0$,$-C(=O)X^0$, $-C(=O)R^0$, $-C(=O)-OR^0$, $-O-C(=O)-R^0$, $-NH_2$, $-NHR^0$, $-NR^0R^{00}$, $-C(=O)NHR^0$, $-C(=O)NR^0R^{00}$, $-SO_3R^0$, $-SO_2R^0$, -OH, $-NO_2$, $-CF_3$, $-SF_5$, or optionally substituted silyl, or carbyl or hydrocarbyl with with 1 to 30, preferably 1 to 20 C atoms that is optionally substituted and optionally comprises one or more hetero atoms, preferably F, -CN, $R^0$, $-OR^0$, $-SR^0$,-C(=O)-R°, $-C(=O)-OR^0$, $-O-C(=O)-R^0$, -O-C(=O)-OR°, $-C(=O)-NHR^0$, $-C(=O)-NR^0R^{00}$,

$Y^1$, $Y^2$ H, F, Cl or CN,

$X^0$ halogen, preferably F or Cl,

$R^0$, $R^{00}$ H or straight-chain or branched alkyl with 1 to 20, preferably 1 to 12, C atoms that is optionally fluorinated,

a1, b1 0, 1 or 2, wherein a1+b1>0,

c1, d1 0, 1 or 2, wherein a1+c1≤3 and b1+d1≤3.

2. The compound according to claim 1, **characterized in that** the unit of formula I is selected of formula 11

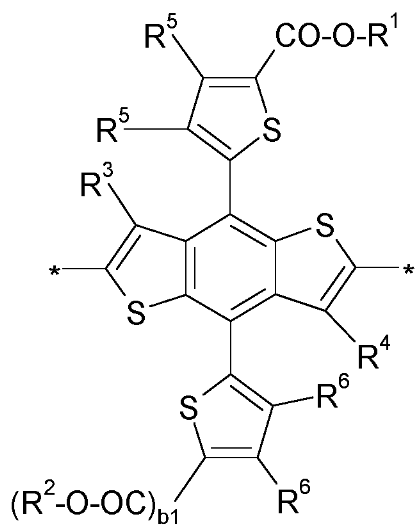

I1

wherein $R^{1-6}$ are as defined in claim 1, and b1 is 0, 1 or 2.

3. The compound according to claim 1 or 2, **characterized in that** $R^1$ and $R^2$ are selected from straight-chain or branched alkyl with 1 to 30 C atoms that is unsubstituted or substituted by one or more F atoms.

4. The compound according to one or more of claims 1 to 3, **characterized in that** $R^{3-6}$ are H.

5. The compound according to one or more of claims 1 to 4, **characterized in that** it is a conjugated oligomer or polymer comprising one or more units of formula I or 11, and additionally comprising one or more arylene or heteroarylene units that are different from formula I and 11, have from 5 to 20 ring atoms, are mono- or polycyclic, do optionally contain fused rings, are unsubstituted or substituted by one or more identical or different groups L, wherein one or more of these additional arylene or heteroarylene units have electron donor or electron acceptor property property.

6. The compound according to one or more of claims 1 to 5, **characterized in that** it is a conjugated oligomer or polymer comprising one or more repeating units of formula II1 and/or II2, and optionally one or more repeating units of formula II3:

$$-(Ar^1)_a-U-(Ar^2)_b-(Ar^3)_c-(Ar^4)_d- \qquad II1$$

$-(Ar^1)_a-(Ar^2)_b-U-(Ar^3)_c-(Ar^4)_d-$ II2

$-(Ar^1)_a-(Ar^2)_b-(Ar^3)_c-(Ar^4)_d-$ II3

wherein the individual radicals, independently of each other and on each occurrence identically or differently, have the following meanings

U a unit of formula I or 11 as defined in any of claims 1 to 4,
$Ar^{1-4}$ arylene or heteroarylene that has 5 to 20 ring atoms, is mono- or polycyclic, does optionally contain fused rings, is unsubstituted or substituted by one or more identical or different groups L, $R^1$ or $R^2$ as defined in claim 1, and is different from U,
a, b, c, d 0 or 1, wherein in formula II3 a+b+c+d≥1.

**7.** The compund according to one or more of claims claim 1 to 6, **characterized in that** it is selected of formula III:

$$*\!\left[(A)_x - (B)_y - (C)_z - (D)_v - (E)_w\right]_n\!* \qquad \text{III}$$

wherein the individual radicals, independently of each other and on each occurrence identically or differently, have the following meanings

A a unit of formula I or 11, II1 or II2 as defined in any of claims 1 to 6,
B, C, D, E a unit of formula I or 11, II1, II2 or II3 as defined in any of claims 1 to 6,
x > 0 and ≤ 1,
y, z, v, w ≥ 0 and < 1,
x+y+z+v+w 1,
n an integer ≥5.

**8.** The compound according to one or more of claims 1 to 7, **characterized in that** it is selected from the following formulae

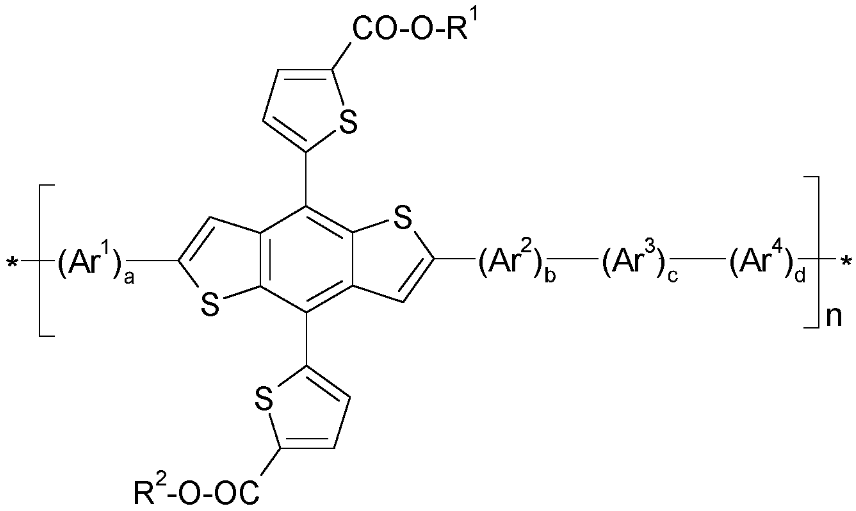

III1

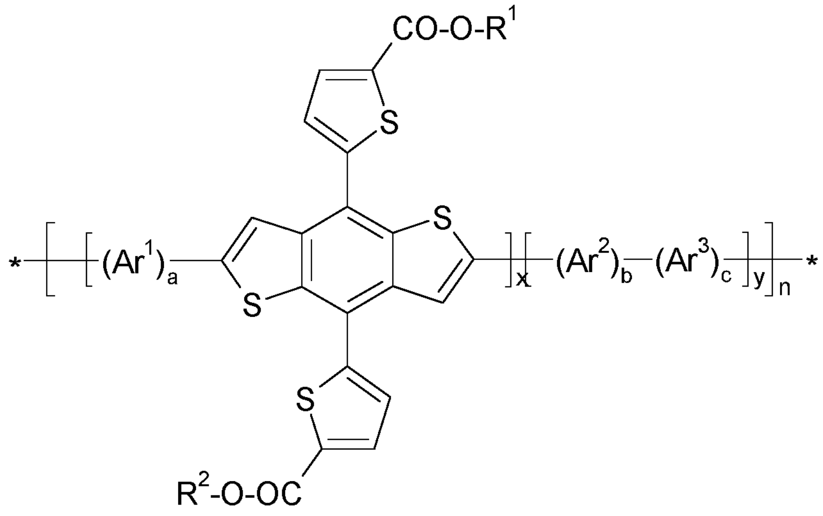

III2

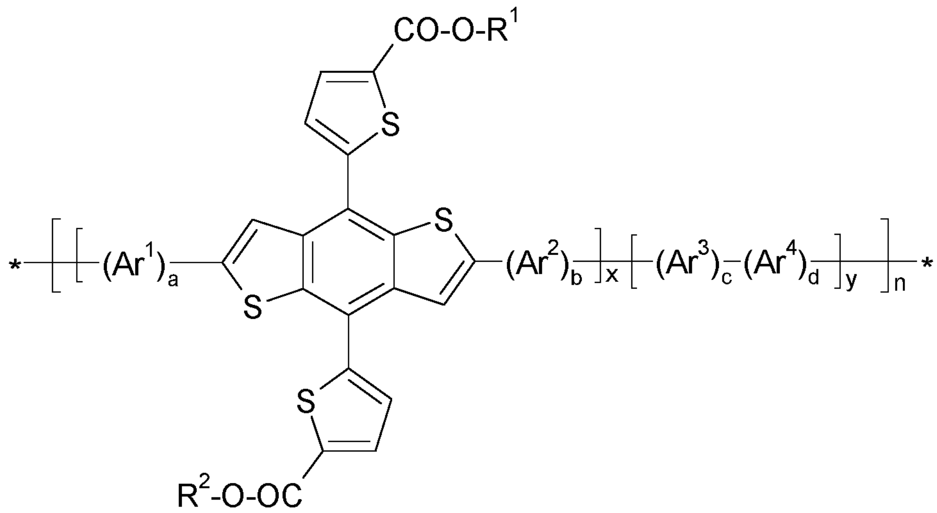

III3

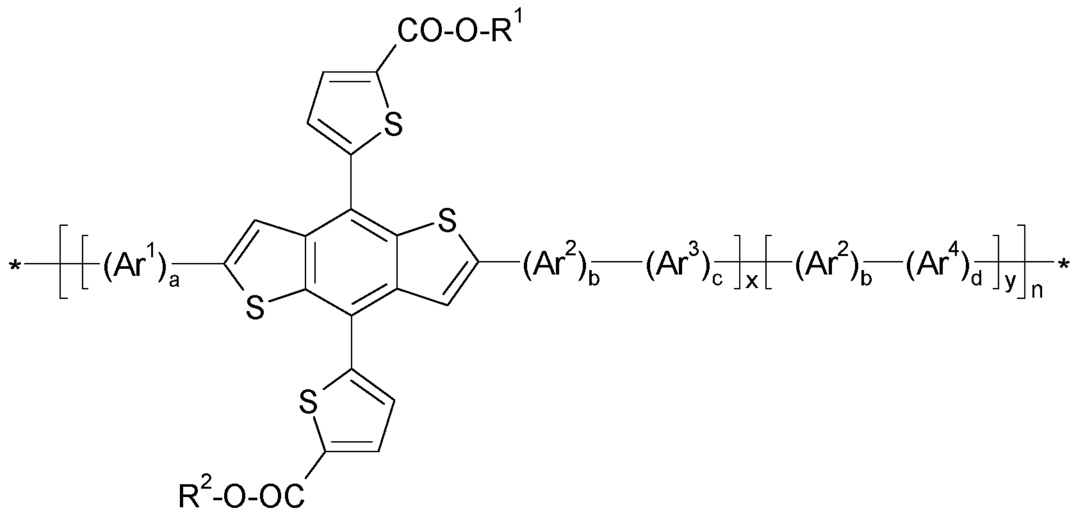

III4

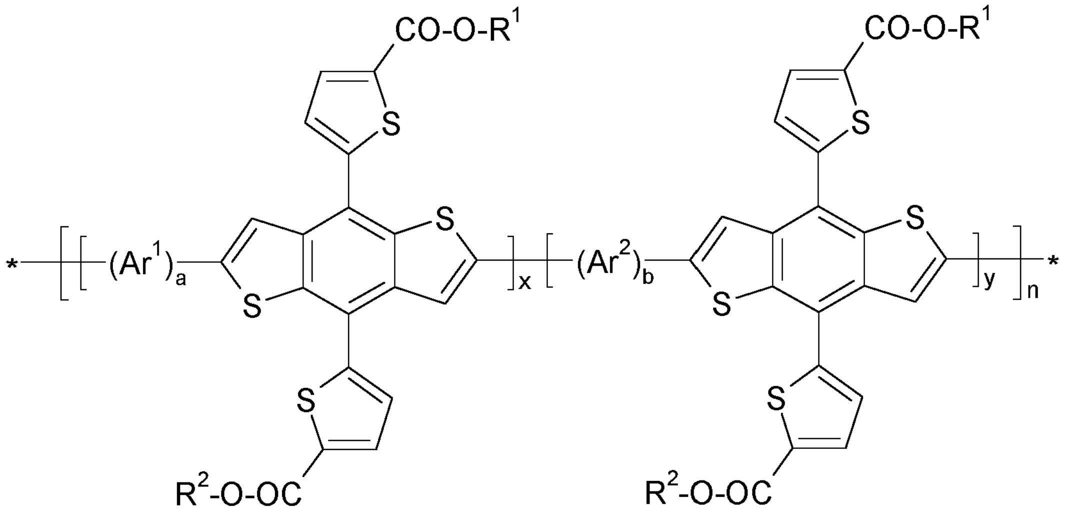

III5

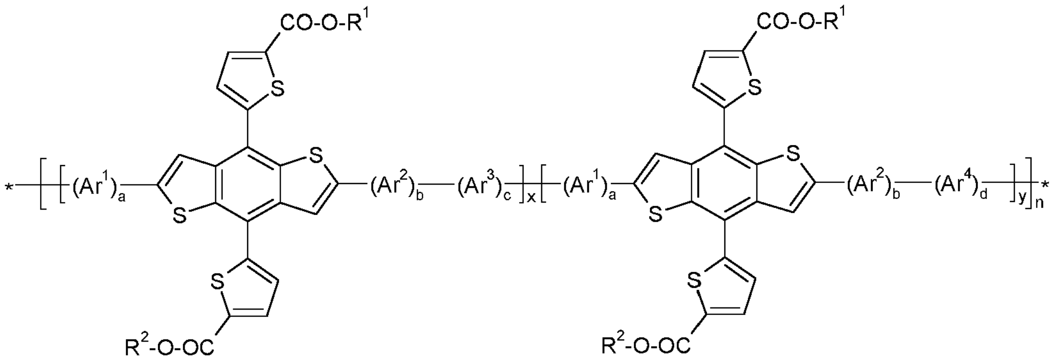

III6

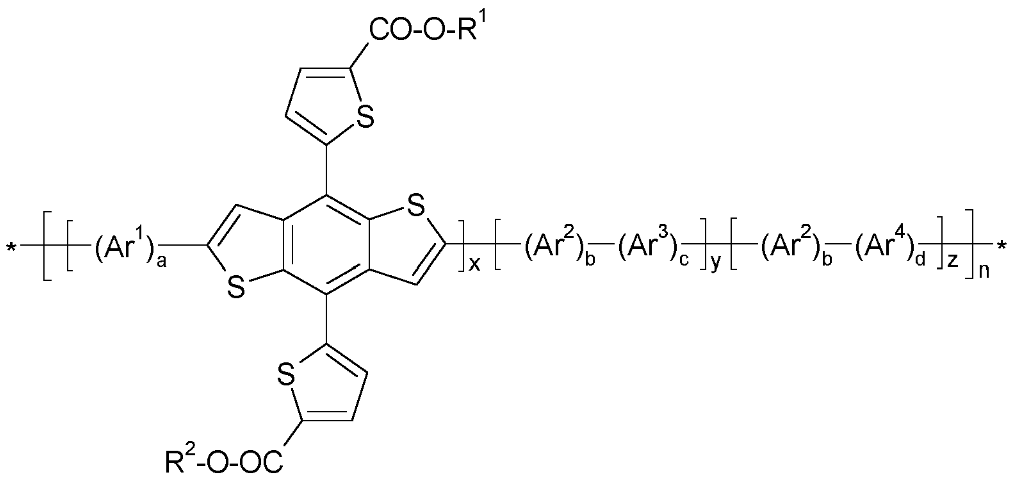

III7

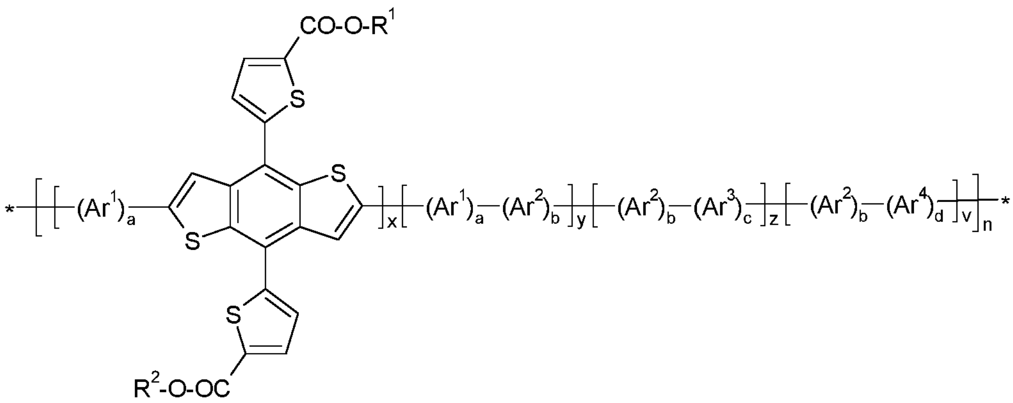

III8

wherein $R^1$, $R^2$, $Ar^1$, $Ar^2$, $Ar^3$, $Ar^4$, a, b, c, d, v, x, y, z and n have the meanings given in claims 1 to 7.

**9.** The compound according to any of claims 1 to 8, **characterized in that** it is a conjugated oligomer or polymer comprising one or more electron donor units, at least one of which is selected of formula I, further comprising one or more electron acceptor units, and optionally comprising one or more spacer units separating a donor unit from an acceptor unit, wherein each donor and acceptor unit is directly connected either to to another donor or acceptor unit or to a spacer unit, and wherein all of the donor, acceptor and spacer units that are different from formula I are each independently selected from arylene or heteroarylene that has from 5 to 20 ring atoms, is mono- or polycyclic, optionally contains fused rings, are is unsubstituted or substituted by one or more identical or different groups L as defined in claim 1.

**10.** The compound according to any of claims 1 to 9, **characterized in that** it comprises one or more units selected from the group consisting of the following formulae

-(D-Sp)- U1

-(A-Sp)- U2

-(A-D)- U3

-(D)- U4

-(Sp-D-Sp)- U5

-(A)- U6

-(Sp-A-Sp)- U7

wherein D denotes an electron donor unit, A denotes an electron acceptor unit and Sp denotes a spacer unit, all of which are selected, independently of each other and on each occurrence identically or differently, from arylene or heteroarylene that has from 5 to 20 ring atoms, is mono- or polycyclic, optionally contains fused rings, are is unsubstituted or substituted by one or more identical or different groups L as defined in claim 1, and wherein the polymer comprises at least one unit selected from formulae U1, U3, U4 and U5 as defined in claim 9 wherein D is a unit selected of formula I.

**11.** The compound according to any of claims 1 to 10, **characterized in that** it is selected from formulae Pi-Pviii

$-[(D-Sp)_x-(A-Sp)_y]_n-$ Pi

$-[(A-D)_x-(A-Sp)_y]_n-$ Pii

$-[(D)_x-(Sp-A-Sp)_y]_n-$ Piii

$-[D-Sp-A-Sp]_n-$ Piv

-[D-A]$_n$- Pv

-[D-Sp-A-Sp]$_n$ Pvi

-[D$^1$-A-D$^2$-A]$_n$ Pvii

-[D-A$^1$-D-A$^2$]$_n$ Pviii

wherein A, D and Sp are as defined in formula claim 10, A and D can each, in case of multiple occurrence, also have different meanings, D$^1$ and D$^2$ have one of the meanings given for D and are different from each other, A$^1$ and A$^2$ have one of the meanings given for A and are different from each other, x and y denote the molar fractions of the corresponding units, x and y are each, independently of one another, a non-integer >0 and <1, with x+y=1, and n is an integer >1.

**12.** The compound according to any of claims 1 to 11, **characterized in that** it is selected from the following formulae

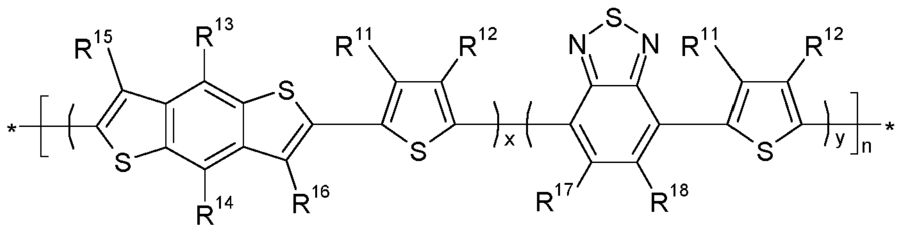

P1

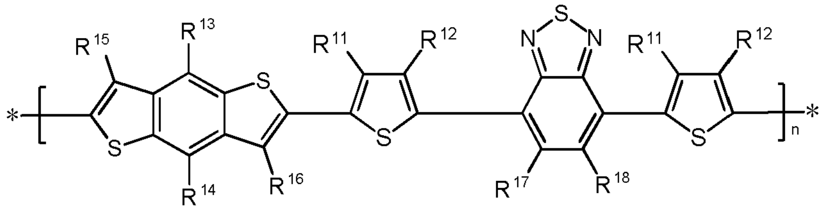

P2

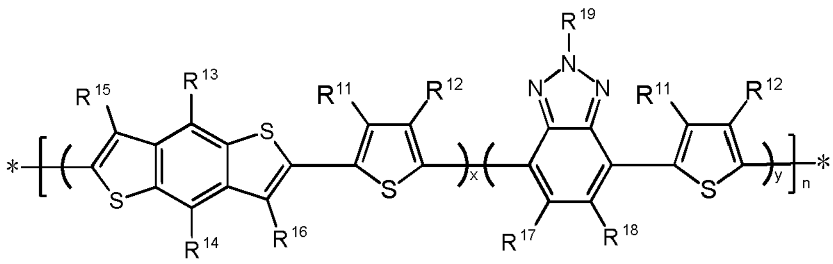

P3

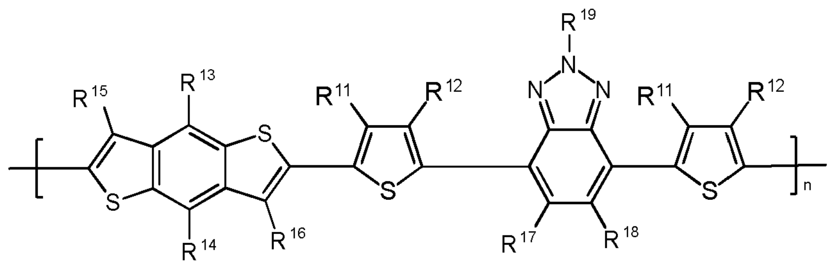

P4

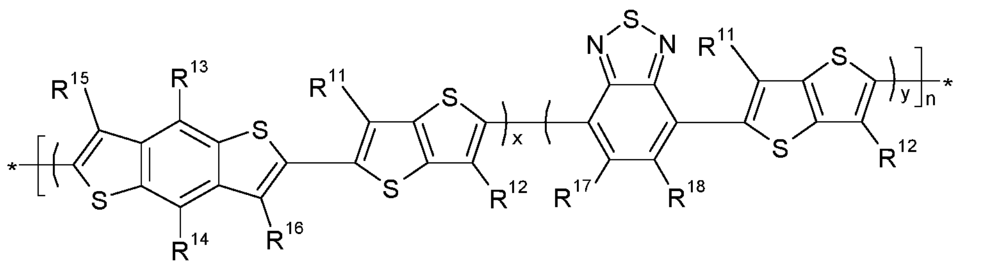

P5

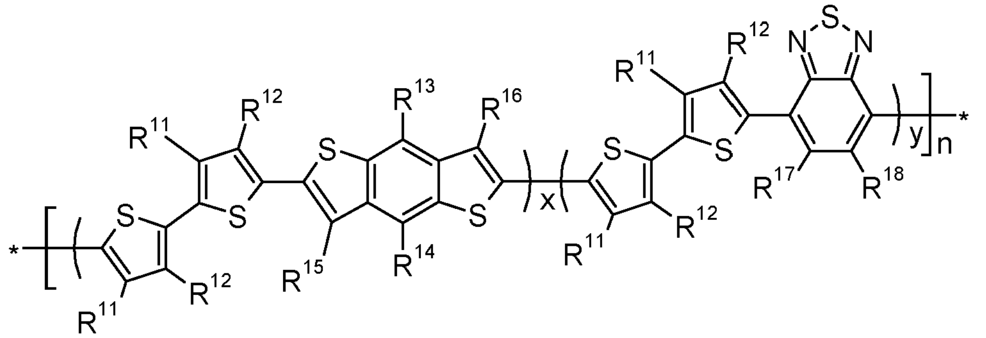

P6

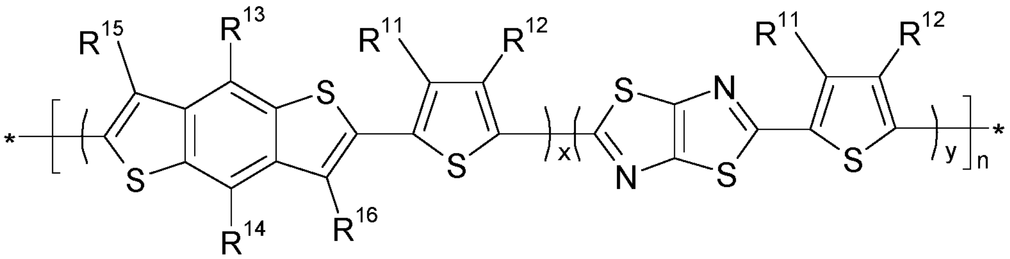

P7

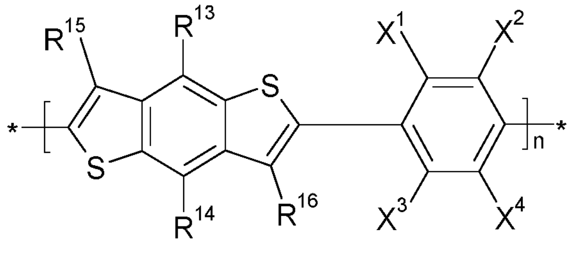

P5a

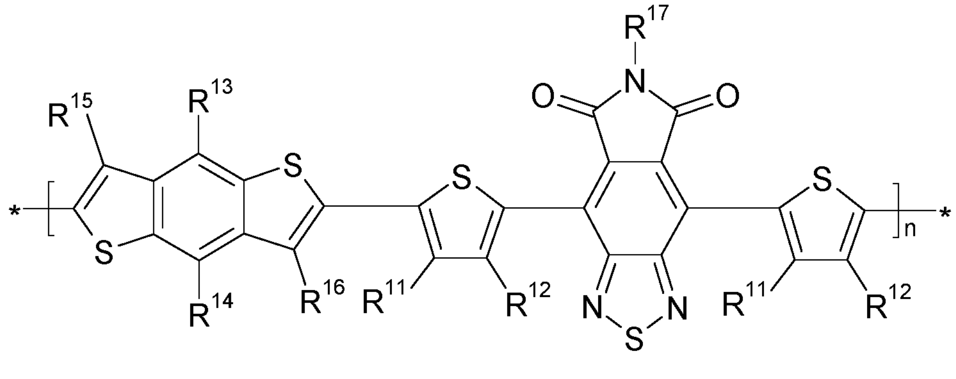

P6a

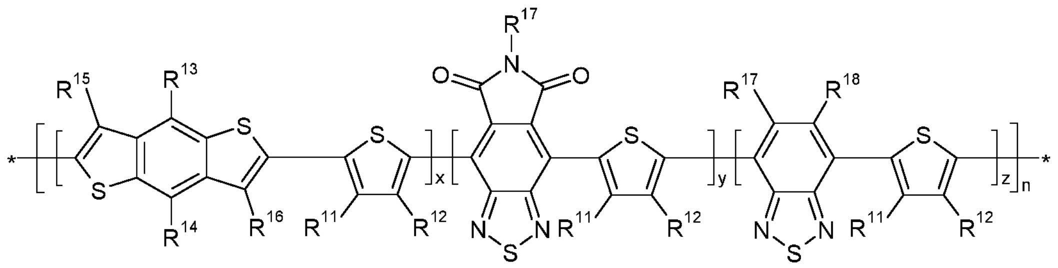

P7a

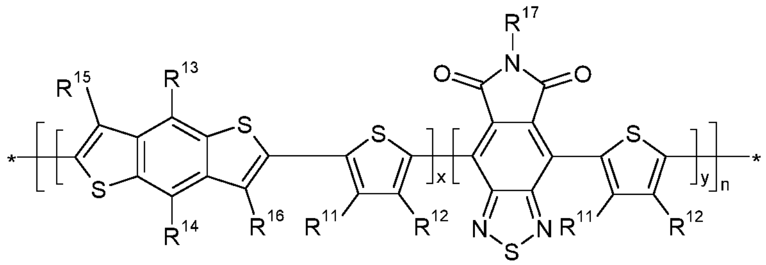

P8

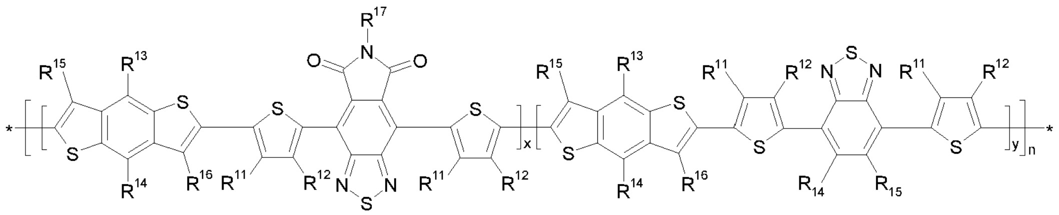

P9

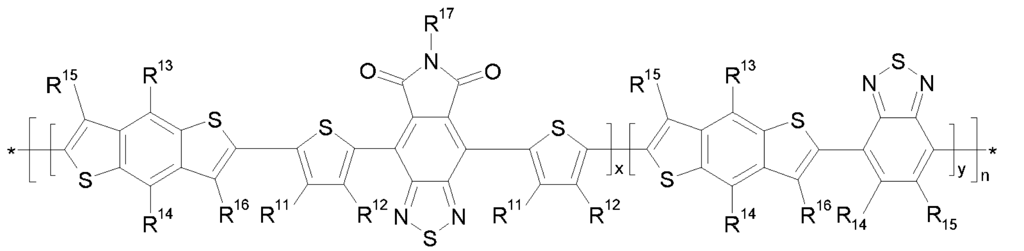

P10

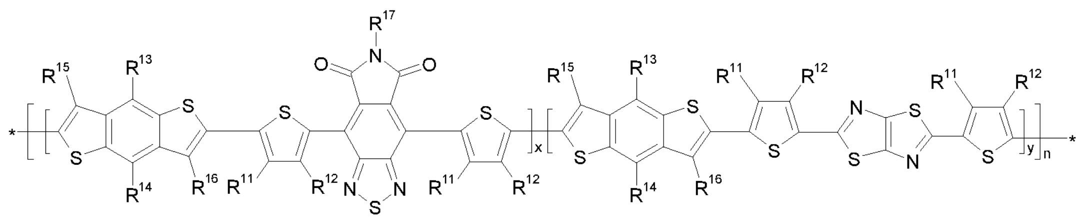

P11

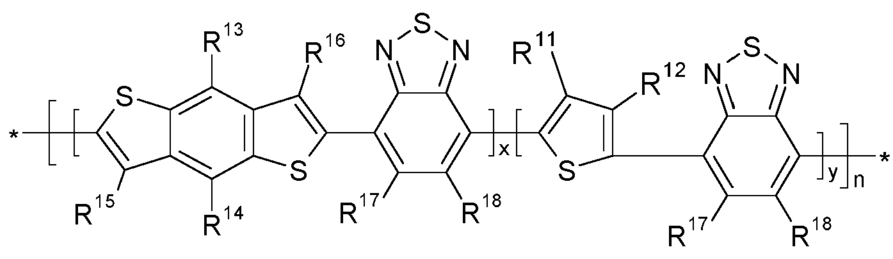

P12

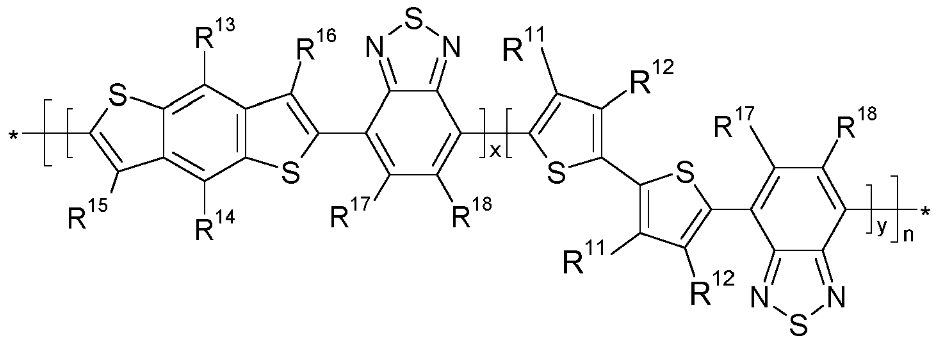

P13

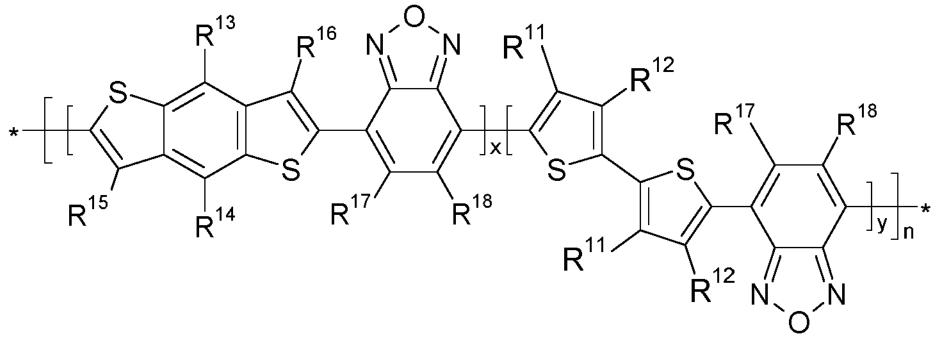

P14

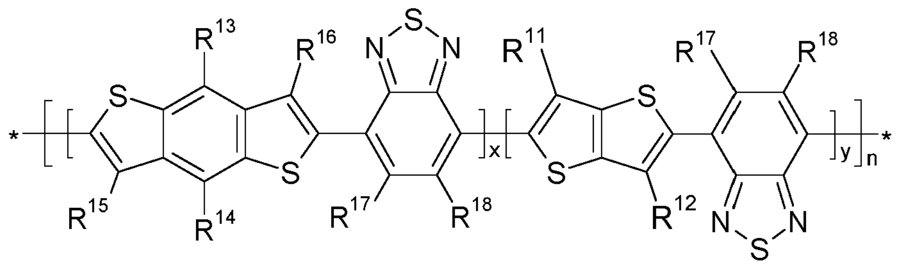

P15

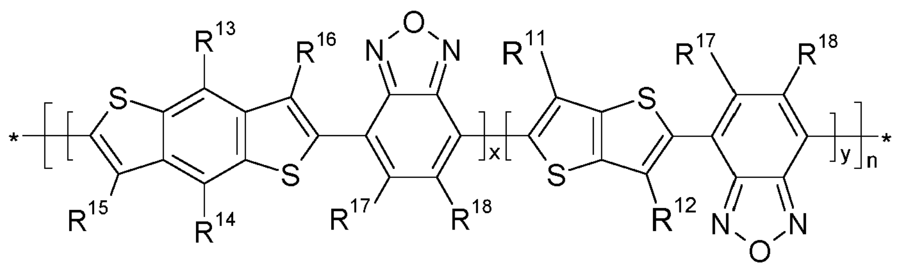

P16

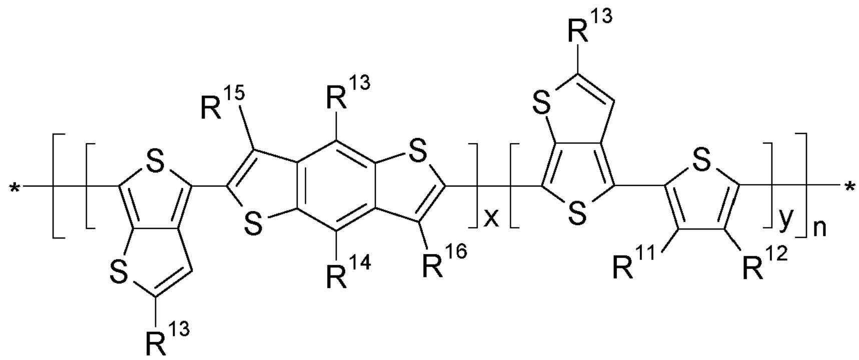

P17

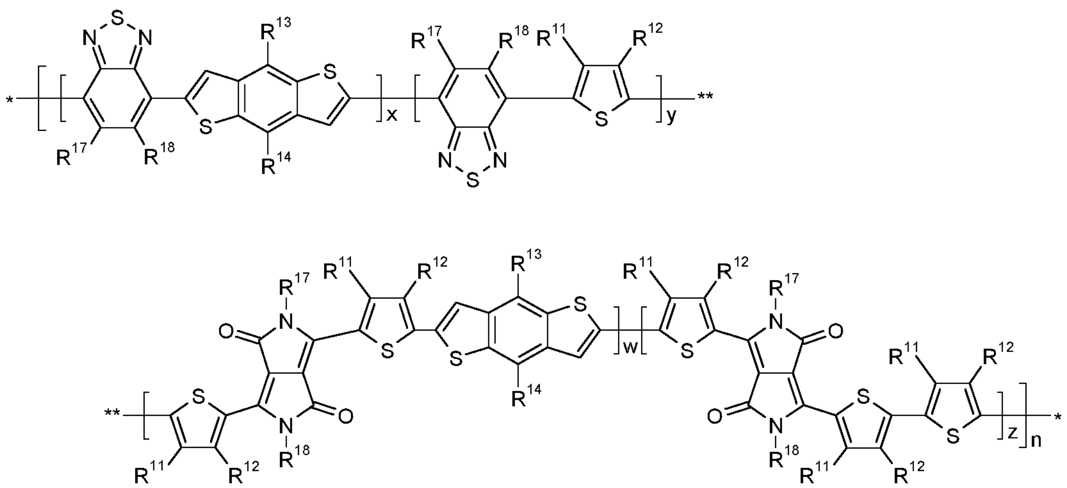

P18

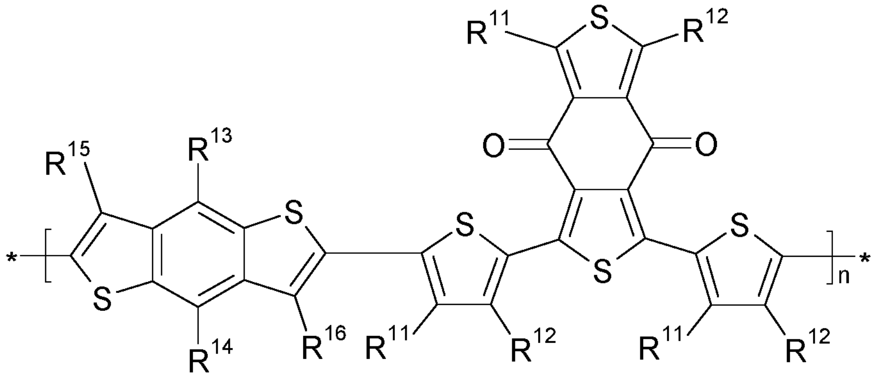

P19

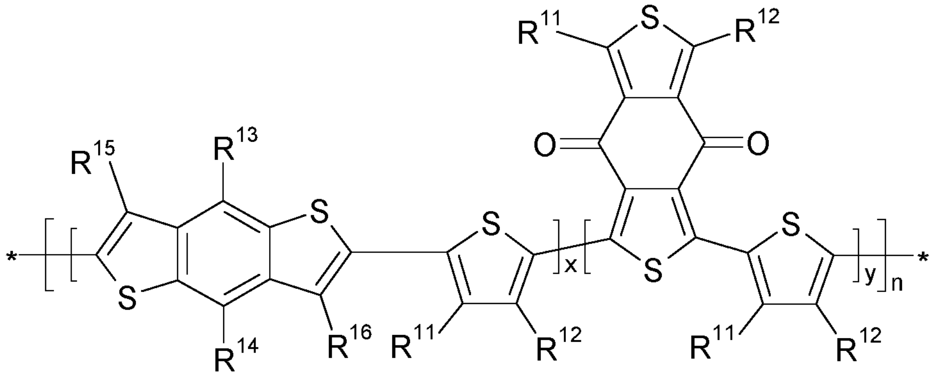

P20

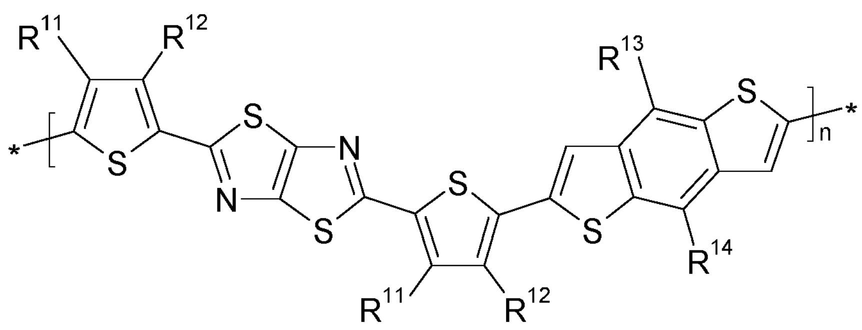

P21

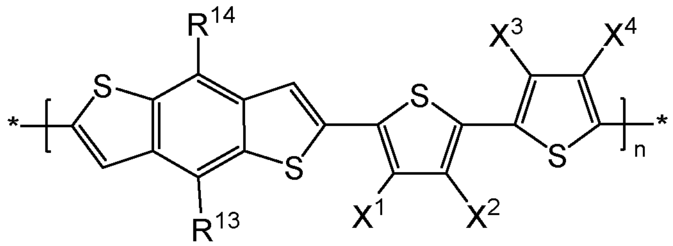

P22

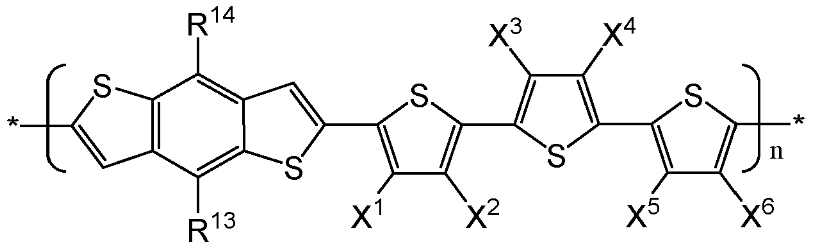

P23

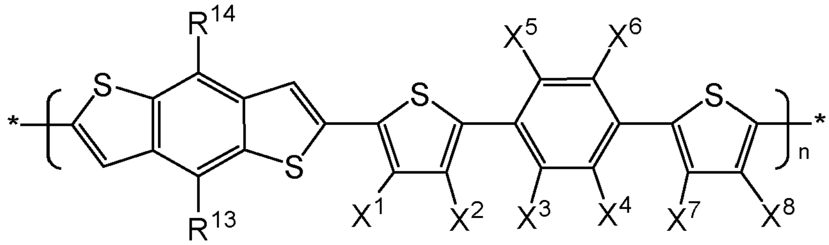

P24

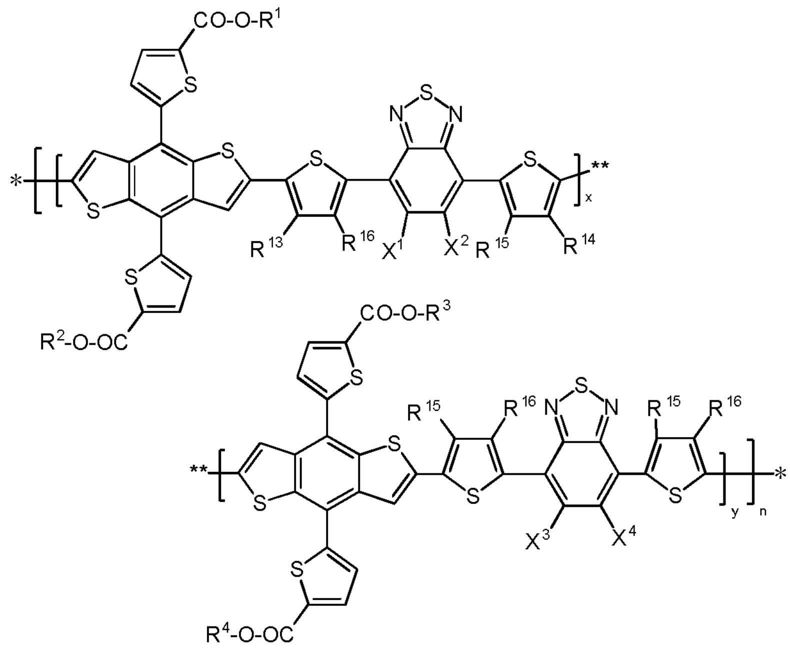

P25

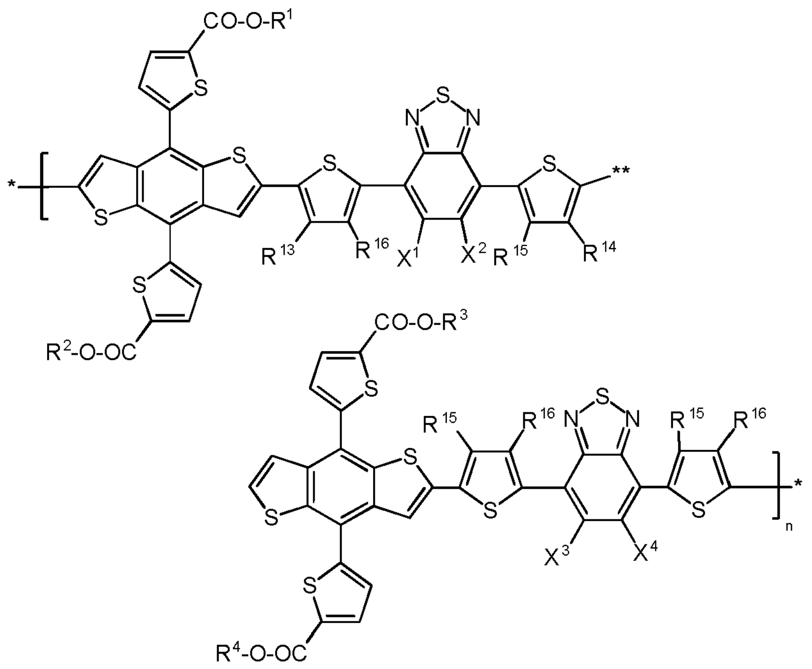

P26

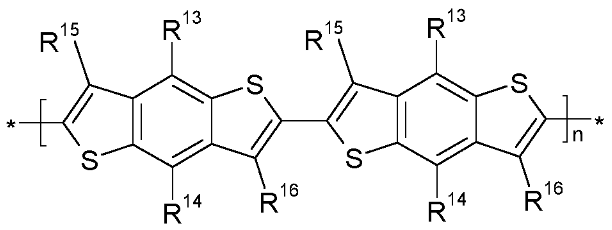

P27

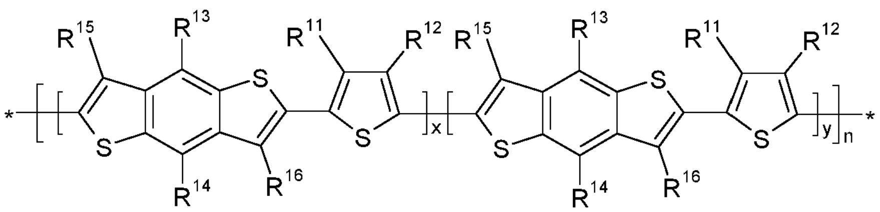

P28

wherein

$R^{13}$ denotes

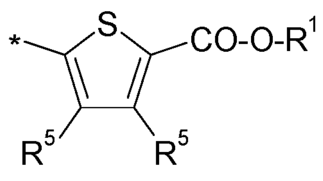

,

$R^{14}$ denotes

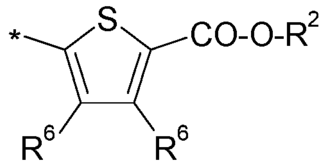

,

$R^1$, $R^2$, $R^5$ and $R^6$ have one of the meanings of claim 1,
x, y and n have one of the meanings of claim 6,
$R^{11}$, $R^{12}$, $R^{15}$, $R^{16}$, $R^{17}$, $R^{18}$ and $R^{19}$ have one of the meanings given for $R^3$ in claim 1,
$X^1$, $X^2$, $X^3$, $X^4$, $X^5$ and $X^6$ have one of the meanings given for $R^3$ in claim 1.

**13.** The compound according to one or more of claims 1 to 12, **characterized in that** it is selected of formula IV

$R^{21}$-chain-$R^{22}$ IV

wherein "chain" denotes an oligomer or polymer chain selected from formulae III, III1-III8, Pi-Pviii and P1-P18 as defined in claims 7, 8, 11 and 12, and $R^{21}$ and $R^{22}$ have independently of each other one of the meanings of L as defined in claim 1, or denote, independently of each other, H, F, Br, Cl, I, $-CH_2Cl$, -CHO, -CR'=CR"$_2$, -SiR'R"R‴, -SiR'X'X", -SiR'R"X', -SnR'R"R‴, -BR'R", -B(OR')(OR"), $-B(OH)_2$, $-O-SO_2-R'$, -C≡CH, -C≡C-SiR'$_3$, -ZnX' or an endcap group, X' and X" denote halogen, R', R" and R‴ have independently of each other one of the meanings of $R^0$ given in claim 1, and two of R', R" and R‴ may also form a cyclosilyl, cyclostannyl, cycloborane or cycloboronate group with 2 to 20 C atoms together with the respective hetero atom to which they are attached.

**14.** A compound of formula V1 or V2

$R^{23}-(Ar^1)_a-U-(Ar^2)_b-(Ar^3)_c-(Ar^4)_d-R^{24}$ V1

$R^{23}-(Ar^1)_a-(Ar^2)_b-U-(Ar^3)_c-(Ar^4)_d-R^{24}$ V2

wherein U, $Ar^{1-4}$, a, b, c and d have the meanings given in claim 6, and $R^{23}$ and $R^{24}$ are independently of each other selected from the group consisting of H, Cl, Br, I, O-tosylate, O-triflate, O-mesylate, O-nonaflate, $-SiMe_2F$, $-SiMeF_2$, $-O-SO_2Z^1$, $-B(OZ^2)_2$ , $-CZ^3=C(Z^3)_2$, - C≡CH, -C≡CSi$(Z^1)_3$, $-ZnX^0$ and $-Sn(Z^4)_3$, wherein $X^0$ is halogen, $Z^{1-4}$ are selected from the group consisting of $C_{1-10}$ alkyl and $C_{6-12}$ aryl, each being optionally substituted, and two groups $Z^2$ may also form a cycloboronate group having 2 to 20 C atoms together with the B- and O-atoms, wherein at least one of $R^{23}$ and $R^{24}$ is different from H,
and wherein at least one of a, b, c and d is different from 0.

**15.** A compound of formula V3

$R^{23}$-U*-$R^{24}$ V3

wherein $R^{23}$ and $R^{24}$ have the meanings given in claim 14, and U* is a unit selected from subformulae P1-P28 as defined in claim 12 wherein n is 1.

**16.** A composition comprising one or more compounds according to one or more of claims 1 to 13 and one or more additional compounds having one or more of semiconducting, charge transport, hole or electron transport, hole or electron blocking, electrically conducting, photoconducting or light emitting properties.

**17.** The composition of claim 16, comprising one or more p-type semiconductors, at least one of which is a compound according to one or more of claims 1 to 13, and further comprising one or more n-type semiconductors, preferably selected from fullerenes or fullerene derivatives.

**18.** The composition of claim 17, comprising one or more n-type semiconductors, at least one of which is a compound according to one or more of claims 1 to 13, and further comprising one or more p-type semiconductors, preferably selected from conjugated polymers.

**19.** A bulk heterojunction (BHJ) formed from a composition according to one or more of claims 16 to 18.

**20.** A formulation comprising one or more compounds according to one or more of claims 1 to 13 or a composition according to one or more of claims 16 to 18, and further comprising one or more solvents selected from organic solvents.

**21.** Use of a compound according to one or more of claims 1 to 13 or a composition according to one or more of claims 16 to 18, in an electronic or optoelectronic device, or in a component of such a device or in an assembly comprising such a device.

**22.** An electronic or optoelectronic device, or a component thereof, or an assembly comprising it, which comprises a compound according to one or more of claims 1 to 13 or a composition according to one or more of claims 16 to 18.

**23.** The electronic or optoelectronic device according to claim 22, which is selected from organic field effect transistors (OFET), organic thin film transistors (OTFT), organic light emitting diodes (OLED), organic light emitting transistors (OLET), organic photovoltaic devices (OPV), organic photodetectors (OPD), organic solar cells, dye-sensitized solar cells (DSSC), perovskite-based solar cells (PSC), laser diodes, Schottky diodes, photoconductors, photodetectors and thermoelectric devices.

**24.** The component according to claim 22, which is selected from charge injection layers, charge transport layers, interlayers, planarising layers, antistatic films, polymer electrolyte membranes (PEM), conducting substrates and conducting patterns.

**25.** The assembly according to claim 22, which is selected from integrated circuits (IC), radio frequency identification (RFID) tags, security markings, security devices, flat panel displays, backlights of flat panel displays, electrophotographic devices, electrophotographic recording devices, organic memory devices, sensor devices, biosensors and biochips.

**26.** A process of preparing a compound according to one or more of claims 1 to 13, by coupling one or more compounds of claim 14 or 15 with each other and/or with one or more monomers of formulae MI-MIV in an aryl-aryl coupling reaction

$R^{23}$-$Ar^1$-$R^{24}$ MI

$R^{23}$-$Ar^2$-$R^{24}$ MII

$R^{23}$-$Ar^3$-$R^{24}$ MIII

$R^{23}$-$Ar^4$-$R^{24}$ MIV

wherein $Ar^{1-4}$, $R^{23}$ and $R^{24}$ have the meanings given in claim 14.

## Patentansprüche

**1.** Verbindung, die zwei oder mehr Wiederholungseinheiten umfasst, von denen mindestens eine ausgewählt ist aus Formel I

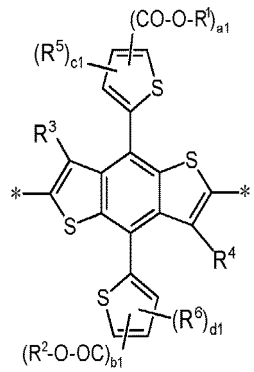

I

wobei die einzelnen Radikale unabhängig voneinander und bei jedem Auftreten identisch oder unterschiedlich die folgenden Bedeutungen aufweisen

$R^1$, $R^2$ geradkettiges, verzweigtes oder zyklisches Alkyl mit 1 bis 30, bevorzugt 1 bis 20 C-Atomen, in denen eine oder mehrere $CH_2$-Gruppen wahlweise durch -O-, -S-, - C(=O)-, -C(=S)-, -C(=O)-O-, -O-C(=O)-, $-NR^0-$, $-SiR^0R^{00}-$, $-CF_2-$, $-CR^0=CR^{00}-$, $-CY^1=CY^2-$ oder - C=C- derart ersetzt sind, dass O- und/oder S-Atome nicht direkt miteinander verknüpft sind, und in denen ein oder mehrere H-Atome wahlweise durch F, Cl, Br, I oder CN ersetzt sind, und in denen eine oder mehrere $CH_2$- oder $CH_3$-Gruppen wahlweise durch eine kationische oder anionische Gruppe oder Aryl, Heteroaryl, Arylalkyl oder Heteroarylalkyl ersetzt sind, wobei jede der vorgenannten zyklischen Gruppen 5 bis 20 Ringatome aufweist, mono- oder polyzyklisch ist, wahlweise kondensierte Ringe enthält und unsubstituiert oder durch eine oder mehrere identische oder unterschiedliche Gruppen L substituiert ist,

$R^{3-6}$ H, F, Cl, CN oder geradkettiges, verzweigtes oder zyklisches Alkyl mit 1 bis 30, bevorzugt 1 bis 20 C-Atomen, in denen eine oder mehrere $CH_2$-Gruppen wahlweise durch -O-, -S-, -C(=O)-, -C(=S)-, -C(=O)-O-, -O-C(=O)-, -NR°-, $-SiR^0R^{00}-$, $-CF_2-$, $-CR^0=CR^{00}-$, $-CY^1=CY^2-$ oder $-C\equiv C-$ derart ersetzt sind, dass O- und/oder S-Atome nicht direkt miteinander verknüpft sind, und in denen ein oder mehrere H-Atome wahlweise durch F, Cl, Br, I oder CN ersetzt sind, und in denen eine oder mehrere $CH_2$- oder $CH_3$-Gruppen wahlweise durch eine kationische oder anionische Gruppe oder Aryl, Heteroaryl, Arylalkyl, Heteroarylalkyl, Aryloxy oder Heteroaryloxy ersetzt sind, wobei jede der vorgenannten zyklischen Gruppen 5 bis 20 Ringatome aufweist, mono- oder polyzyklisch ist, wahlweise kondensierte Ringe enthält und unsubstituiert oder durch eine oder mehrere identische oder unterschiedliche Gruppen L substituiert ist,

L F, Cl, -CN, -NC, -NCO, -NCS, -OCN, -SCN, $R^0$, $OR^0$, $SR^0$, $-C(=O)X^0$, $-C(=O)R^0$, - $C(=O)-OR^0$, $-O-C(=O)-R^0$, $-NH_2$, $-NHR^0$, $-NR^0R^{00}$, $-C(=O)NHR^0$, $-C(=O)NR^0R^{00}$, $-SO_3R^0$, $-SO_2R^0$, - OH, $-NO_2$, $-CF_3$, $-SF_5$, oder wahlweise substituiertes Silyl oder Carbyl oder Hydrocarbyl mit 1 bis 30, bevorzugt 1 bis 20 C-Atomen, das wahlweise substituiert ist und wahlweise ein oder mehrere Heteroatome umfasst, bevorzugt F, -CN, $R^0$, $-OR^0$, $-SR^0$, $-C(=O)-R^0$, $-C(=O)-OR^0$, $-O-C(=O)-R^0$, -O-C(=O)-OR°, $-C(=O)-NHR^0$, $-C(=O)-NR^0R^{00}$,

$Y^1$,$Y^2$ H, F, Cl oder CN,

$X^0$ Halogen, bevorzugt F oder Cl,

$R^0$, $R^{00}$ H oder geradkettiges oder verzweigtes Alkyl mit 1 bis 20, bevorzugt 1 bis 12 C-Atomen, das wahlweise fluoriert ist,

a1, b1 0, 1 oder 2, wobei a1+b1>0,

c1, d1 0, 1 oder 2, wobei a1+c1≤3 und b1+d1≤3.

2. Verbindung nach Anspruch 1, **dadurch gekennzeichnet, dass** die Einheit aus Formel I aus Formel I1 ausgewählt ist

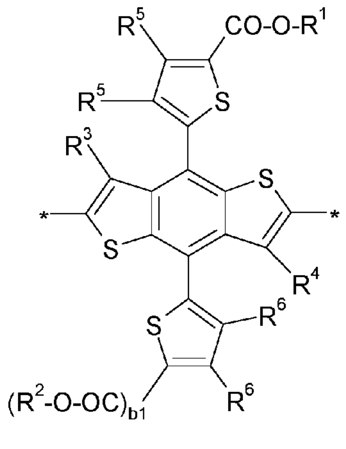

I1

wobei $R^{1-6}$ nach Anspruch 1 sind und b1 0, 1 oder 2 ist.

3. Verbindung nach Anspruch 1 oder 2, **dadurch gekennzeichnet, dass** $R^1$ und $R^2$ ausgewählt sind aus geradkettigem oder verzweigtem Alkyl mit 1 bis 30 C-Atomen, das unsubstituiert oder durch ein oder mehrere F-Atome substituiert ist.

4. Verbindung nach einem oder mehreren der Ansprüche 1 bis 3, **dadurch gekennzeichnet, dass** $R^{3-6}$ H sind.

5. Verbindung nach einem oder mehreren der Ansprüche 1 bis 4, **dadurch gekennzeichnet, dass** sie ein konjugiertes Oligomer oder Polymer ist, das eine oder mehrere Einheiten der Formel I oder I1 umfasst und zusätzlich eine oder mehrere Arylen- oder Heteroaryleneinheiten umfasst, die sich von Formel I und I1 unterscheiden, 5 bis 20 Ringatome aufweisen, mono- oder polyzyklisch sind, wahlweise kondensierte Ringe enthalten, unsubstituiert oder durch eine oder mehrere identische oder unterschiedliche Gruppen L substituiert sind, wobei eine oder mehrere dieser zusätzlichen Arylen- oder Heteroaryleneinheiten Elektrondonor- oder Elektronenakzeptor-Eigenschaft aufweisen.

6. Verbindung nach einem oder mehreren der Ansprüche 1 bis 5,

   **dadurch gekennzeichnet, dass** sie ein konjugiertes Oligomer oder Polymer ist, das eine oder mehrere sich wiederholende Einheiten der Formel II1 und/oder II2 und wahlweise eine oder mehrere sich wiederholende Einheiten der Formel II3 umfasst:

   $-(Ar^1)_a-U-(Ar^2)_b-(Ar^3)_c-(Ar^4)_d-$ II1

   $-(Ar^1)_a-(Ar^2)_b-U-(Ar^3)_c-(Ar^4)_d-$ II2

   $-(Ar^1)_a-(Ar^2)_b-(Ar^3)_c-(Ar^4)_d-$ II3

   wobei die einzelnen Radikale unabhängig voneinander und bei jedem Auftreten identisch oder unterschiedlich die folgenden Bedeutungen aufweisen
   U eine Einheit der Formel I oder I1, nach einem der Ansprüche 1 bis 4,
   $Ar^{1-4}$ Arylen oder Heteroarylen, das 5 bis 20 Ringatome aufweist, mono- oder polyzyklisch ist, wahlweise kondensierte Ringe enthält, unsubstituiert oder durch eine oder mehrere identische oder unterschiedliche Gruppen L substituiert ist, $R^1$ oder $R^2$ nach Anspruch 1, und sich von U unterscheidet,
   a, b, c, d 0 oder 1, wobei in Formel II3 $a+b+c+d \geq 1$.

7. Verbindung nach einem oder mehreren der Ansprüche 1 bis 6, **dadurch gekennzeichnet, dass** sie ausgewählt ist aus Formel III:

   $$*\!-\!\left[(A)_x-(B)_y-(C)_z-(D)_v-(E)_w\right]_n\!-\!* \qquad \text{III}$$

   wobei die einzelnen Radikale unabhängig voneinander und bei jedem Auftreten identisch oder unterschiedlich die folgenden Bedeutungen aufweisen

   A eine Einheit der Formel I oder I1, II1 oder II2, nach einem der Ansprüche 1 bis 6,
   B, C, D, E eine Einheit der Formel I oder I1, II1, II2 oder II3, nach einem der Ansprüche 1 bis 6,
   $x > 0$ und $\leq 1$,
   y, z, v, w $\geq 0$ und $< 1$, x+y+z+v+w 1,
   n eine ganze Zahl $\geq 5$.

8. Verbindung nach einem oder mehreren der Ansprüche 1 bis 7, **dadurch gekennzeichnet, dass** sie ausgewählt ist aus den folgenden Formeln

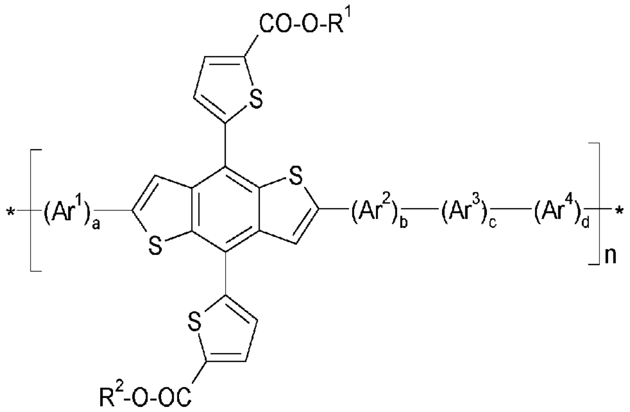

III1

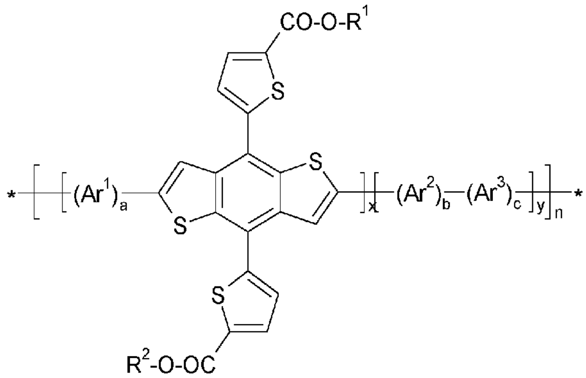

III2

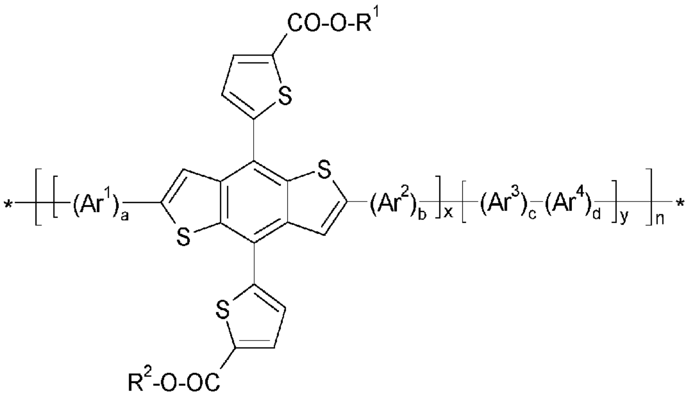

III3

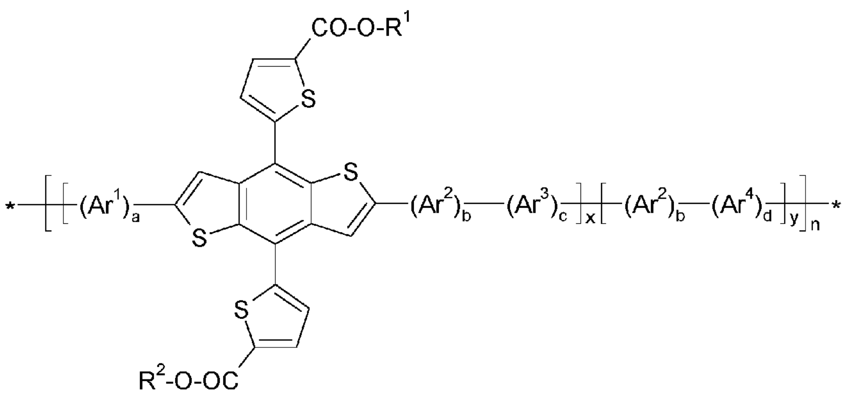

III4

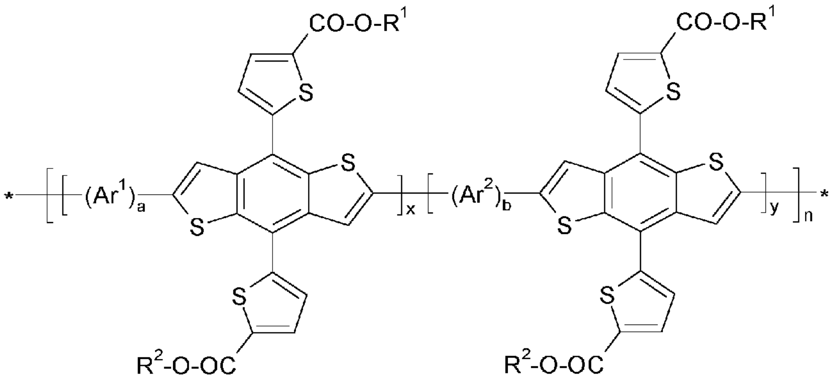

III5

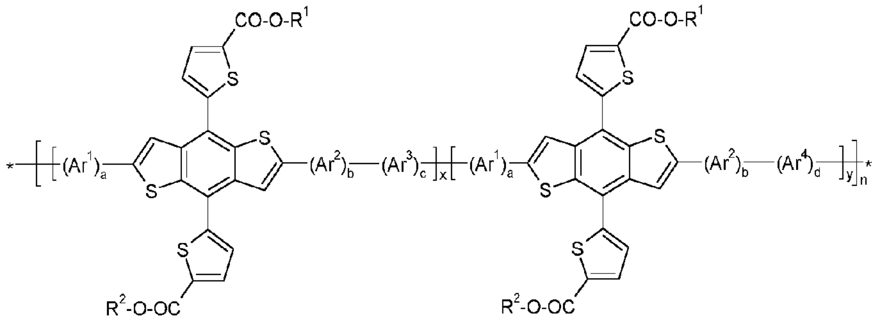

III6

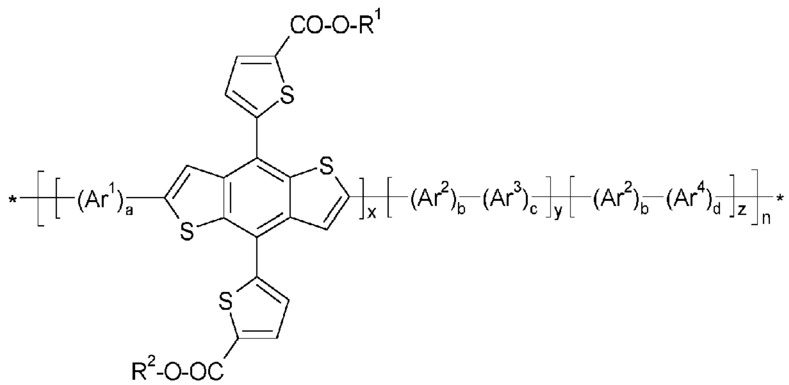

III7

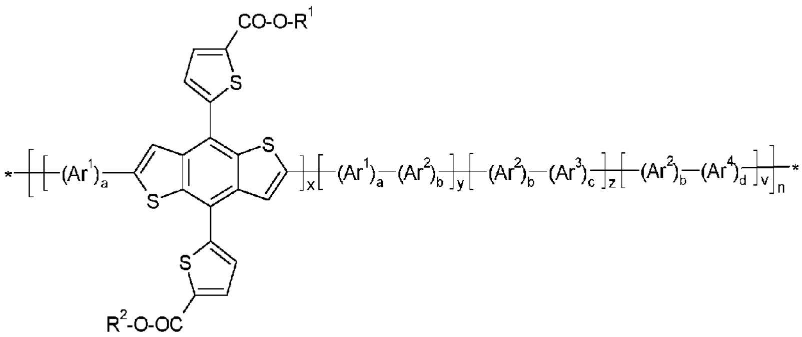

III8

wobei $R^1$, $R^2$, $Ar^1$, $Ar^2$, $Ar^3$, $Ar^4$, a, b, c, d, v, x, y, z und n die in den Ansprüchen 1 bis 7 angegebenen Bedeutungen aufweisen.

9. Verbindung nach einem der Ansprüche 1 bis 8, **dadurch gekennzeichnet, dass** sie ein konjugiertes Oligomer oder Polymer ist, das eine oder mehrere Elektronendonoreinheiten umfasst, von denen mindestens eine ausgewählt ist aus Formel I, weiter eine oder mehrere Elektronenakzeptoreinheiten umfassend, und wahlweise eine oder mehrere

Spacer-Einheiten umfassend, die eine Donoreinheit von einer Akzeptoreinheit trennen, wobei jede Donor- und Akzeptoreinheit direkt entweder mit einer anderen Donor- oder Akzeptoreinheit oder mit einer Spacer-Einheit verbunden ist, und wobei alle Donor-, Akzeptor- und Spacer-Einheiten, die sich von Formel I unterscheiden, jeweils unabhängig ausgewählt sind aus Arylen oder Heteroarylen, das 5 bis 20 Ringatome aufweist, mono- oder polyzyklisch ist, wahlweise kondensierte Ringe enthält, unsubstituiert oder durch eine oder mehrere identische oder unterschiedliche Gruppen L nach Anspruch 1 substituiert ist.

**10.** Verbindung nach einem der Ansprüche 1 bis 9, **dadurch gekennzeichnet, dass** sie eine oder mehrere Einheiten umfasst, ausgewählt aus der Gruppe bestehend aus den folgenden Formeln

-(D-Sp)- U1

-(A-Sp)- U2

-(A-D)- U3

-(D)- U4

-(Sp-D-Sp)- U5

-(A)- U6

-(Sp-A-Sp)- U7

wobei D eine Elektronendonoreinheit bezeichnet, A eine Elektronenakzeptoreinheit bezeichnet und Sp eine Spacer-Einheit bezeichnet, die alle unabhängig voneinander und bei jedem Auftreten identisch oder unterschiedlich ausgewählt sind aus Arylen oder Heteroarylen, das 5 bis 20 Ringatome aufweist, mono- oder polyzyklisch ist, wahlweise kondensierte Ringe enthält, unsubstituiert oder durch eine oder mehrere identische oder unterschiedliche Gruppen L nach Anspruch 1 definiert substituiert ist, und wobei das Polymer mindestens eine Einheit umfasst, ausgewählt aus den Formeln U1, U3, U4 und U5, nach Anspruch 9, wobei D eine aus Formel I ausgewählte Einheit ist.

**11.** Verbindung nach einem der Ansprüche 1 bis 10, **dadurch gekennzeichnet, dass** sie ausgewählt ist aus den Formeln Pi-Pviii

$-[(D\text{-}Sp)_x\text{-}(A\text{-}Sp)_y]_n-$ Pi

$-[(A\text{-}D)_x\text{-}(A\text{-}Sp)_y]_n-$ Pii

$-[(D)_x\text{-}(Sp\text{-}A\text{-}Sp)_y]_n-$ Piii

$-[D\text{-}Sp\text{-}A\text{-}Sp]_n-$ Piv

$-[D\text{-}A]_n-$ Pv

$-[D\text{-}Sp\text{-}A\text{-}Sp]_n$ Pvi

$-[D^1\text{-}A\text{-}D^2\text{-}A]_n$ Pvii

$-[D\text{-}A^1\text{-}D\text{-}A^2]_n$ Pviii

wobei A, D und Sp wie in der Formel nach Anspruch 10 sind, A und D im Falle mehrfachen Auftretens jeweils auch unterschiedliche Bedeutungen aufweisen können, $D^1$ und $D^2$ eine der für D angegebenen Bedeutungen aufweisen und sich voneinander unterscheiden, $A^1$ und $A^2$ eine der für A angegebenen Bedeutungen aufweisen und sich voneinander unterscheiden, x und y die Stoffmengenanteile der entsprechenden Einheiten bezeichnen, x und y jeweils unabhängig voneinander eine nicht ganze Zahl >0 und <1 sind, wobei x+y=1, und n eine ganze Zahl >1 ist.

**12.** Verbindung nach einem der Ansprüche 1 bis 11, **dadurch gekennzeichnet, dass** sie ausgewählt ist aus den folgenden Formeln

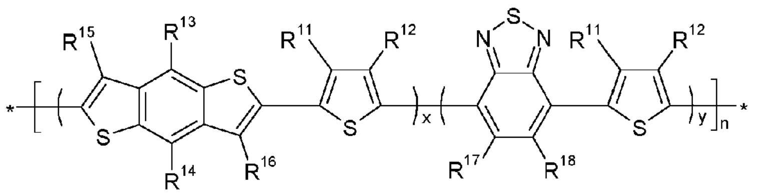

P1

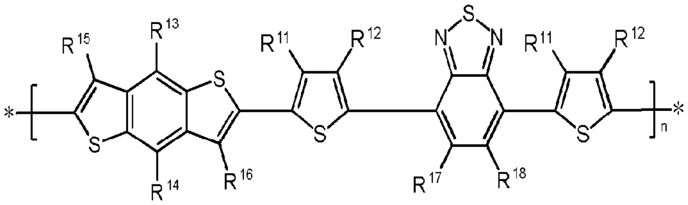

P2

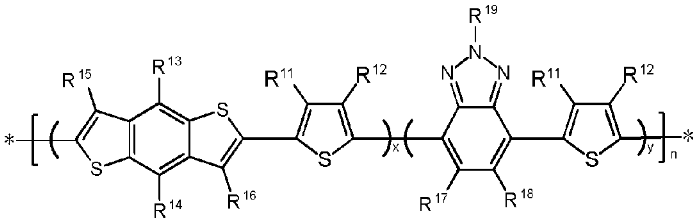

P3

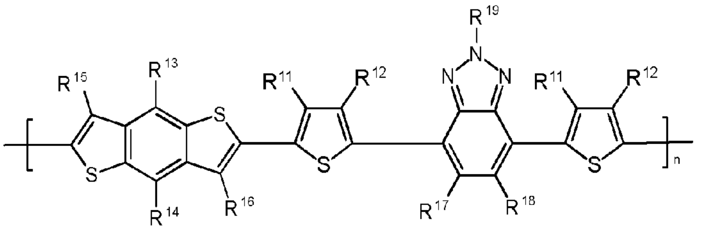

P4

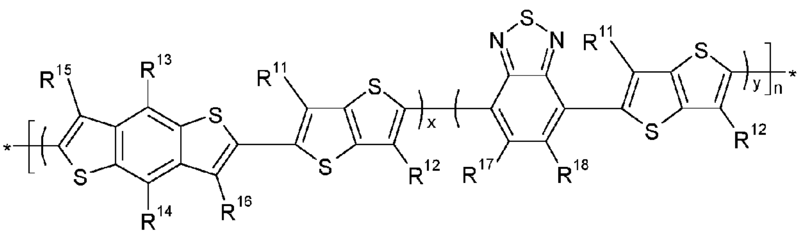

P5

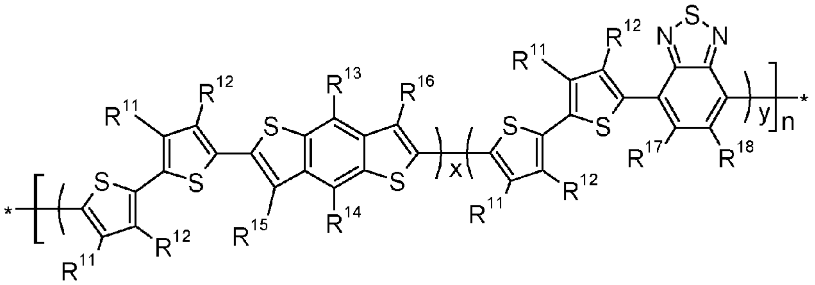

P6

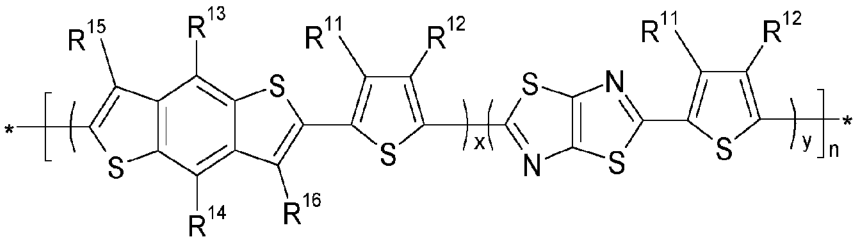

P7

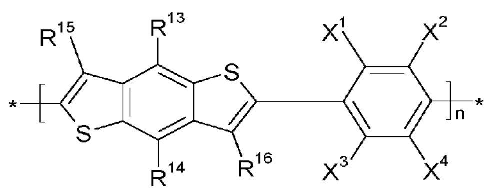

P5a

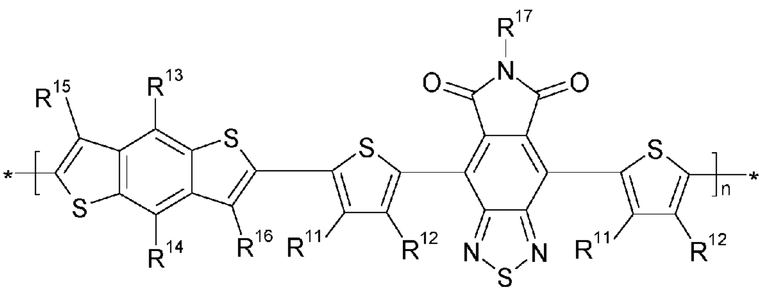

P6a

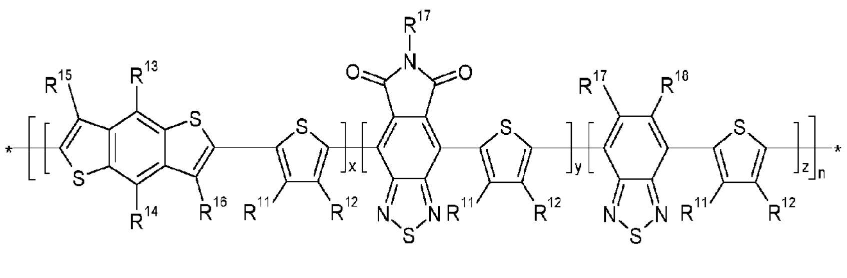

P7a

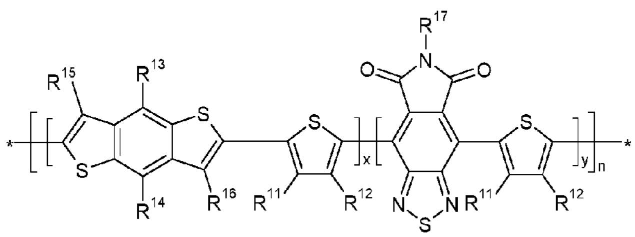

P8

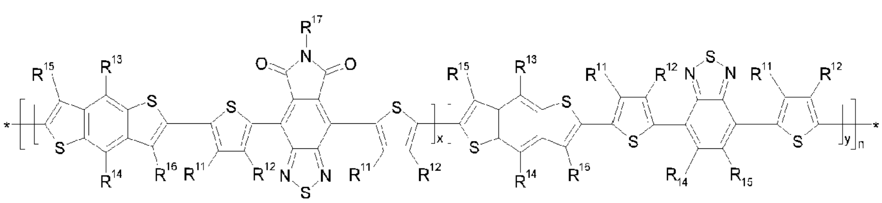

P9

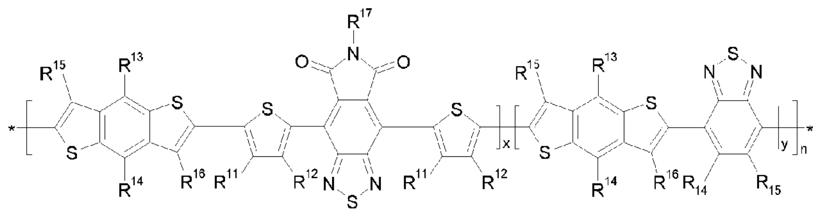

P10

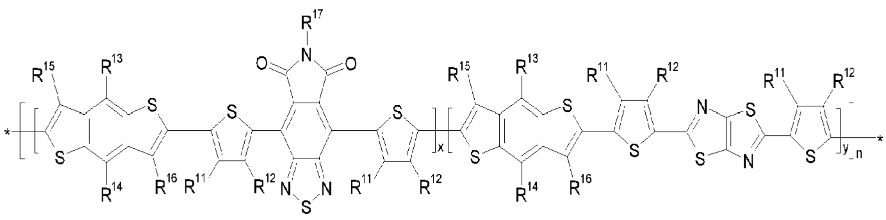

P11

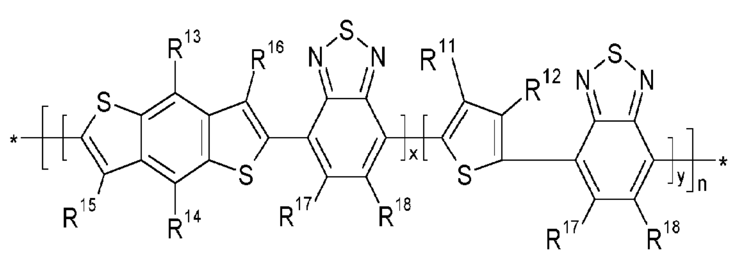

P12

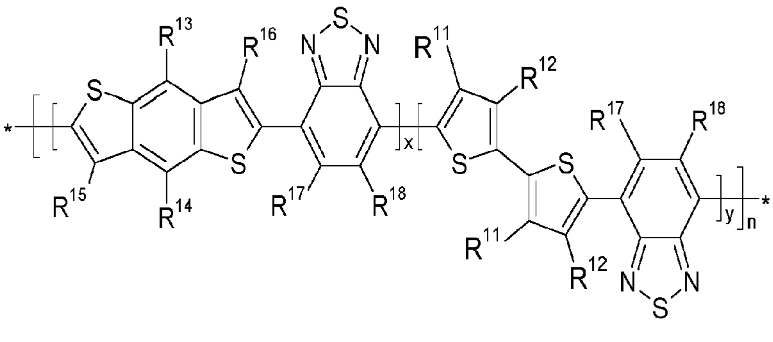

P13

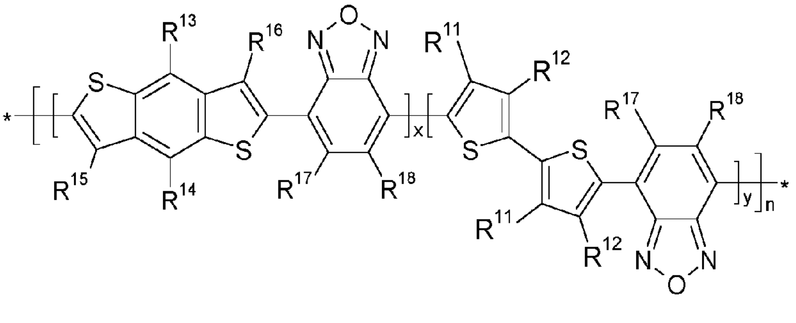

P14

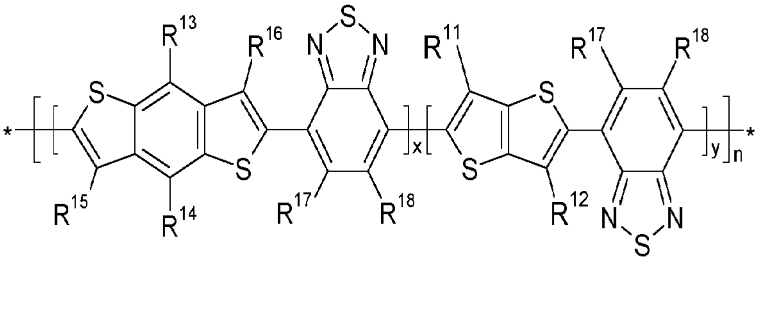

P15

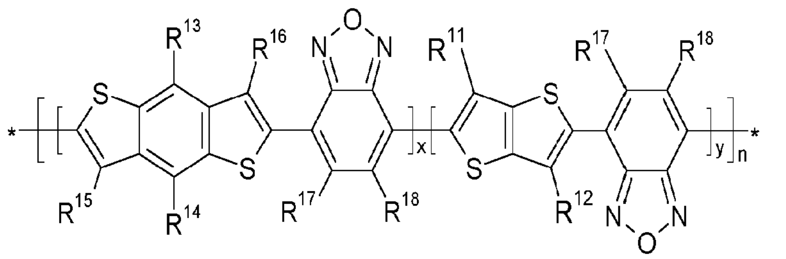

P16

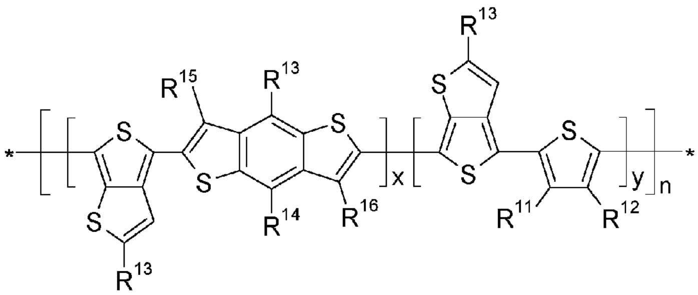

P17

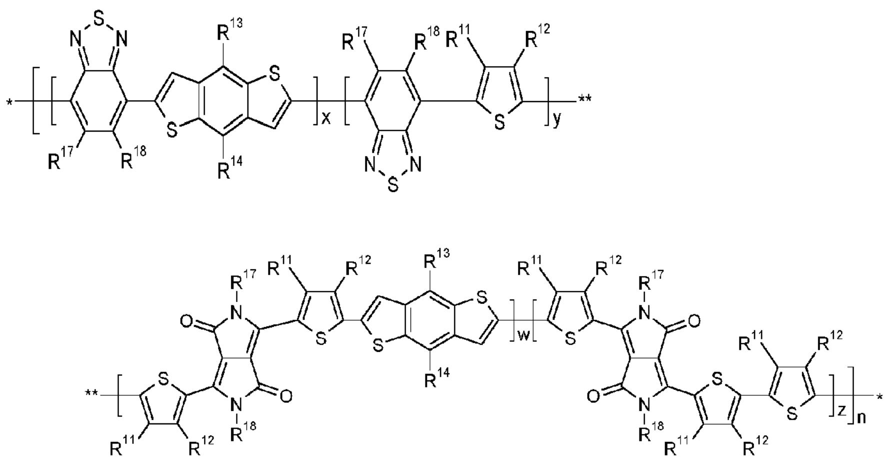

P18

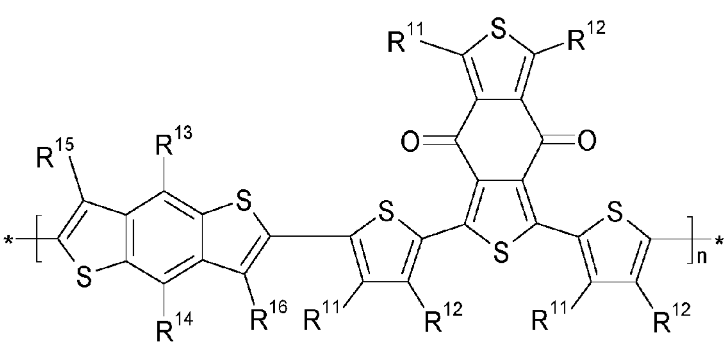

P19

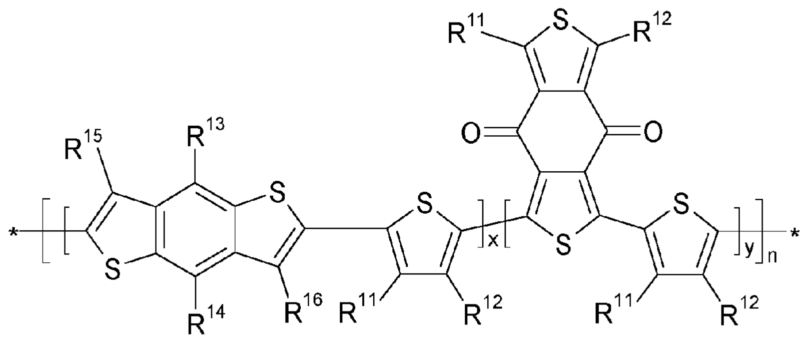

P20

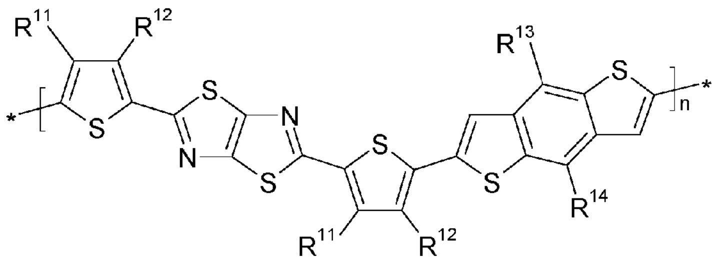

P21

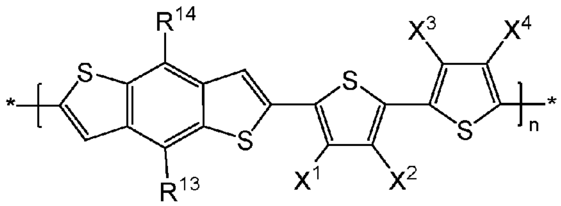

P22

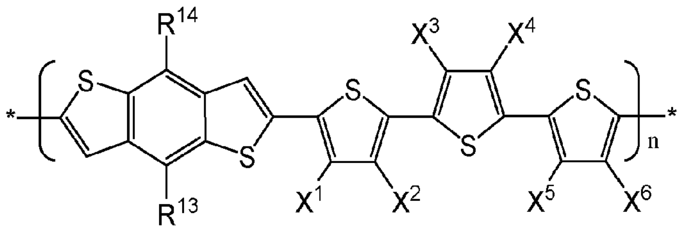

P23

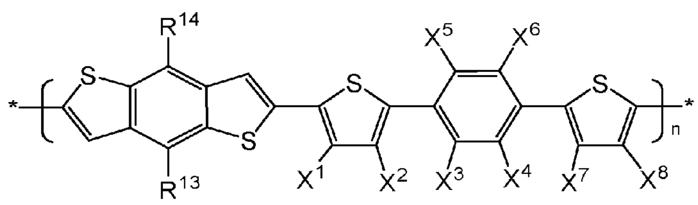

P24

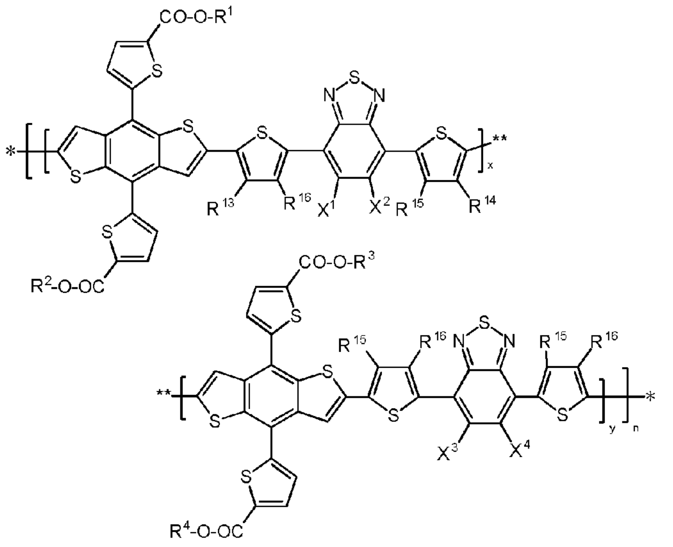

P25

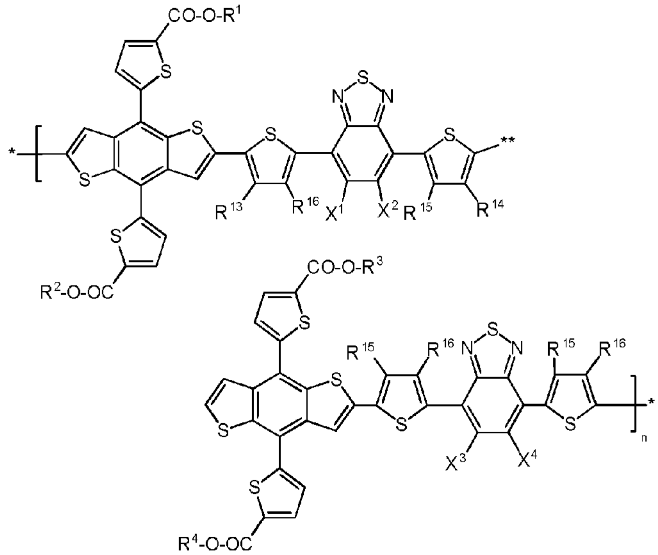

P26

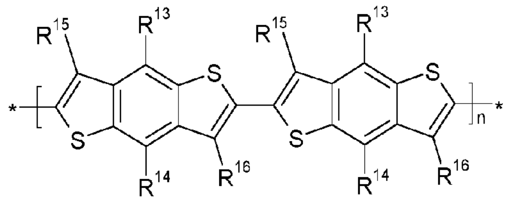

P27

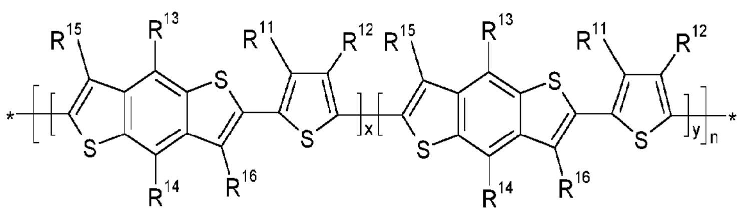

P28

wobei

$R^{13}$

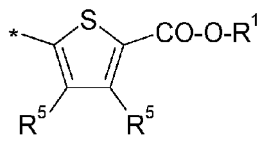

bezeichnet,
$R^{14}$

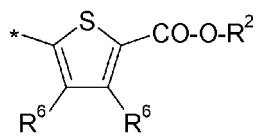

bezeichnet,
$R^1$, $R^2$, $R^5$ und $R^6$ eine der Bedeutungen nach Anspruch 1 aufweisen,
x, y und n eine der Bedeutungen nach Anspruch 6 aufweisen,
$R^{11}$, $R^{12}$, $R^{15}$, $R^{16}$, $R^{17}$, $R^{18}$ und $R^{19}$ eine der für $R^3$ in Anspruch 1 angegebenen Bedeutungen aufweisen,
$X^1$, $X^2$, $X^3$, $X^4$, $X^5$ und $X^6$ eine der für $R^3$ in Anspruch 1 angegebenen Bedeutungen aufweisen.

**13.** Verbindung nach einem oder mehreren der Ansprüche 1 bis 12, **dadurch gekennzeichnet, dass** sie ausgewählt ist aus Formel IV

$R^{21}$-Kette-$R^{22}$ IV

wobei "Kette" eine Oligomer- oder Polymerkette bezeichnet, ausgewählt aus den Formeln III, III1-III8, Pi-Pviii und P1-P18, nach den Ansprüchen 7, 8, 11 und 12, und $R^{21}$ und $R^{22}$ unabhängig voneinander eine der Bedeutungen von L nach Anspruch 1 aufweisen oder unabhängig voneinander H, F, Br, Cl, I, $-CH_2Cl$, -CHO, -CR'=CR"$_2$, -SiR'R"R'" , -SiR'X'X", - SiR'R"X', -SnR'R"R"', -BR'R", -B(OR')(OR"), $-B(OH)_2$, $-O-SO_2-R'$, -C=CH, -C≡C-SiR'$_3$, -ZnX' oder eine Endkappengruppe bezeichnen, X' und X" Halogen bezeichnen, R', R" und R'" unabhängig voneinander eine der in Anspruch 1 angegebenen Bedeutungen von $R^0$ aufweisen und zwei von R', R" und R'" zusammen mit dem jeweiligen Heteroatom, an das sie gebunden sind, auch eine Cyclosilyl-, Cyclostannyl-, Cycloboran- oder Cycloboronatgruppe mit 2 bis 20 C-Atomen bilden können.

**14.** Verbindung der Formel V1 oder V2

$R^{23}-(Ar^1)_a-U-(Ar^2)_b-(Ar^3)_c-(Ar^4)_d-R^{24}$ V1

$R^{23}-(Ar^1)_a-(Ar^2)_b-U-(Ar^3)_c-(Ar^4)_d-R^{24}$ V2

wobei u, $Ar^{1-4}$, a, b, c und d die in Anspruch 6 angegebenen Bedeutungen aufweisen und $R^{23}$ und $R^{24}$ unabhängig voneinander ausgewählt sind aus der Gruppe bestehend aus H, Cl, Br, I, O-Tosylat, O-Triflat, O-Mesylat, O-Nonaflat, $-SiMe_2F$, $-SiMeF_2$, $-O-SO_2Z^1$, - $B(OZ^2)_2$, $-CZ^3=C(Z^3)_2$, -C=CH, $-C\equiv CSi(Z^1)_3$, $-ZnX^0$ und $-Sn(Z^4)_3$, wobei $X^0$ Halogen ist, $Z^{1-4}$ ausgewählt sind aus der Gruppe bestehend aus $C_{1-10}$-Alkyl und $C_{6-12}$-Aryl, die jeweils wahlweise substituiert sind, und zwei Gruppen $Z^2$ zusammen mit den B- und O-Atomen auch eine Cycloboronatgruppe bilden können, die 2 bis 20 C-Atome aufweist, wobei sich mindestens eines von $R^{23}$ und $R^{24}$ von H unterscheidet,
und wobei sich mindestens eines von a, b, c und d von 0 unterscheidet.

**15.** Verbindung der Formel V3,

$R^{23}-U^*-R^{24}$ V3

wobei $R^{23}$ und $R^{24}$ die in Anspruch 14 angegebenen Bedeutungen aufweisen, und U* eine Einheit ist, die aus den Teilformeln P1-P28 nach Anspruch 12 ausgewählt ist, wobei n 1 ist.

**16.** Zusammensetzung, die eine oder mehrere Verbindungen nach einem oder mehreren der Ansprüche 1 bis 13, und eine oder mehrere zusätzliche Verbindungen umfasst, die eine oder mehrere aus Halbleiter-, Ladungstransport-,

Loch- oder Elektronentransport-, Loch- oder Elektronenblockier-, elektrisch leitenden, photoleitenden oder lichtemittierenden Eigenschaften aufweisen.

**17.** Zusammensetzung nach Anspruch 16, die einen oder mehrere Halbleiter vom p-Typ umfasst, von denen mindestens einer eine Verbindung nach einem oder mehreren der Ansprüche 1 bis 13 ist, und weiter einen oder mehrere Halbleiter vom n-Typ umfasst, die bevorzugt aus Fullerenen oder Fulleren-Derivaten ausgewählt sind.

**18.** Zusammensetzung nach Anspruch 11, die einen oder mehrere Halbleiter vom n-Typ umfasst, von denen mindestens einer eine Verbindung nach einem oder mehreren der Ansprüche 1 bis 13 ist, und weiter einen oder mehrere Halbleiter vom p-Typ umfasst, die bevorzugt aus konjugierten Polymeren ausgewählt sind.

**19.** Bulk-Heteroübergang (BHJ), der aus einer Zusammensetzung nach einem oder mehreren der Ansprüche 16 bis 18 gebildet ist.

**20.** Formulierung, die eine oder mehrere Verbindungen nach einem oder mehreren der Ansprüche 1 bis 13, oder eine Zusammensetzung nach einem oder mehreren der Ansprüche 16 bis 18 umfasst, und weiter ein oder mehrere Lösungsmittel, die aus organischen Lösungsmitteln ausgewählt sind, umfasst.

**21.** Verwendung einer Verbindung nach einem oder mehreren der Ansprüche 1 bis 13 oder einer Zusammensetzung nach einem oder mehreren der Ansprüche 16 bis 18 in einer elektronischen oder optoelektronischen Vorrichtung oder in einer Komponente einer solchen Vorrichtung oder in einer Anordnung, die eine solche Vorrichtung umfasst.

**22.** Elektronische oder optoelektronische Vorrichtung oder eine Komponente davon oder eine Anordnung, die diese umfasst, die eine Verbindung nach einem oder mehreren der Ansprüche 1 bis 13 oder eine Zusammensetzung nach einem oder mehreren der Ansprüche 16 bis 18 umfasst.

**23.** Elektronische oder optoelektronische Vorrichtung nach Anspruch 22, die aus organischen Feldeffekttransistoren (OFET), organischen Dünnschichttransistoren (OTFT), organischen Leuchtdioden (OLED), organischen Leuchttransistoren (OLET), organischen photovoltaischen Vorrichtungen (OPV), organischen Photodetektoren (OPD), organischen Solarzellen, farbstoffsensibilisierten Solarzellen (DSSC), Solarzellen auf Perowskitbasis (PSC), Laserdioden, Schottky-Dioden, Photoleitern, Photodetektoren und thermoelektrischen Vorrichtungen ausgewählt ist.

**24.** Komponente nach Anspruch 22, die aus Ladungsinjektionsschichten, Ladungstransportschichten, Zwischenschichten, Planarisierungsschichten, antistatischen Folien, Polymerelektrolytmembranen (PEM), leitenden Substraten und leitenden Strukturen ausgewählt ist.

**25.** Anordnung nach Anspruch 22, die aus integrierten Schaltungen (IC), Hochfrequenzidentifikations- (RFID-) Tags, Sicherheitsmarkierungen, Sicherheitsvorrichtungen, Flachbildschirmanzeigen, Hintergrundbeleuchtungen von Flachbildschirmanzeigen, elektrophotografischen Vorrichtungen, elektrophotografischen Aufzeichnungsvorrichtungen, organischen Speichervorrichtungen, Sensorvorrichtungen, Biosensoren und Biochips ausgewählt ist.

**26.** Prozess zum Herstellen einer Verbindung nach einem oder mehreren der Ansprüche 1 bis 13 durch Kuppeln einer oder mehrerer Verbindungen nach Anspruch 14 oder 15 miteinander und/oder mit einem oder mehreren Monomeren der Formeln MI-MIV in einer Aryl-Aryl-Kupplungsreaktion

$R^{23}$-$Ar^1$-$R^{24}$ MI

$R^{23}$-$Ar^2$-$R^{24}$ MII

$R^{23}$-$Ar^3$-$R^{24}$ MIII

$R^{23}$-$Ar^4$-$R^{24}$ MIV

wobei $Ar^{1-4}$, $R^{23}$ und $R^{24}$ die Bedeutungen nach Anspruch 14 aufweisen.

## Revendications

**1.** Composé comprenant deux motifs répétitifs ou plus, dont au moins un est sélectionné de la formule I

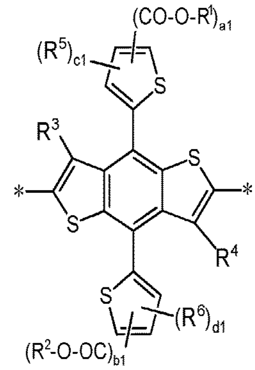

I

dans lequel les radicaux individuels, indépendamment les uns des autres et à chaque occurrence de manière identique ou différente, présentent les significations suivantes

$R^1$, $R^2$ alkyle linéaire, ramifié ou cyclique avec 1 à 30, de préférence 1 à 20, atomes de C, dans lequel un ou plusieurs groupes $CH_2$ sont facultativement remplacés par -O-, -S-, -C(=O)-, -C(=S)-, -C(=O)-O-, -O-C(=O)-, -NR°-, -Si$R^0R^{00}$-, -$CF_2$-, -$CR^0$=$CR^{00}$-, -$CY^1$=$CY^2$-ou -C=C- d'une manière telle que des atomes de O et/ou de S ne sont pas directement liés entre eux, et dans lequel un ou plusieurs atomes de H sont facultativement remplacés par F, Cl, Br, I ou CN, et dans lequel un ou plusieurs groupes $CH_2$ ou $CH_3$ sont facultativement remplacés par un groupe cationique ou anionique, ou aryle, hétéroaryle, arylalkyle ou hétéroarylalkyle, dans lequel chacun des groupes cycliques précités présente 5 à 20 atomes cycliques, est mono- ou polycyclique, contient facultativement des cycles fusionnés, et est non substitué ou substitué par un ou plusieurs groupes L identiques ou différents,

$R^{3-6}$ H, F, Cl, CN, ou alkyle linéaire, ramifié ou cyclique avec 1 à 30, de préférence 1 à 20, atomes de C, dans lequel un ou plusieurs groupes $CH_2$ sont facultativement remplacés par -O-, -S-, -C(=O)-, -C(=S)-, -C(=O)-O-, -O-C(=O)-, -$NR^0$-, -Si$R^0R^{00}$-, -$CF_2$-, - $CR^0$=$CR^{00}$-, -$CY^1$=$CY^2$- ou -C=C- d'une manière telle que des atomes de O et/ou de S ne sont pas directement liés entre eux, et dans lequel un ou plusieurs atomes de H sont facultativement remplacés par F, Cl, Br, I ou CN, et dans lequel un ou plusieurs groupes $CH_2$ ou $CH_3$ sont facultativement remplacés par un groupe cationique ou anionique, ou aryle, hétéroaryle, arylalkyle, hétéroarylalkyle, aryloxy ou hétéroaryloxy, dans lequel chacun des groupes cycliques précités présente 5 à 20 atomes cycliques, est mono- ou polycyclique, contient facultativement des cycles fusionnés, et est non substitué ou substitué par un ou plusieurs groupes L identiques ou différents,

L F, Cl, -CN, -NC, -NCO, -NCS, -OCN, -SCN, $R^0$, $OR^0$, $SR^0$, -C(=O)$X^0$, -C(=O)R°, - C(=O)-OR°, -O-C(=O)-$R^0$, -$NH_2$, -$NHR^0$, -$NR^0R^{00}$, -C(=O)NHR°, -C(=O)$NR^0R^{00}$, -$SO_3R^0$, -$SO_2R^0$, - OH, -$NO_2$, -$CF_3$, -$SF_5$, ou silyle, ou carbyle ou hydrocarbyle avec 1 à 30, de préférence 1 à 20 atomes de C qui est facultativement substitué et comprend facultativement un ou plusieurs hétéroatomes, de préférence F, -CN, $R^0$, -$OR^0$, -$SR^0$, -C(=O)-$R^0$, -C(=O)-OR°, -OC(=O)-$R^0$, -O-C(=O)-OR°, -C(=O)-$NHR^0$, -C(=O)-$NR^0R^{00}$,

$Y^1$,$Y^2$ H, F, Cl ou CN

$X^0$ halogène, de préférence F ou Cl,

$R^0$, $R^{00}$ H ou alkyle linéaire ou ramifié avec 1 à 20, de préférence 1 à 12 atomes de C qui est facultativement fluoré,

a1, b1 0, 1 ou 2, dans lequel a1+b1>0,

c1, d1 0, 1 ou 2, dans lequel a1+c1≤3 et b1+d1≤3.

**2.** Composé selon la revendication 1, **caractérisé en ce que** le motif de formule I est sélectionné de la formule I1

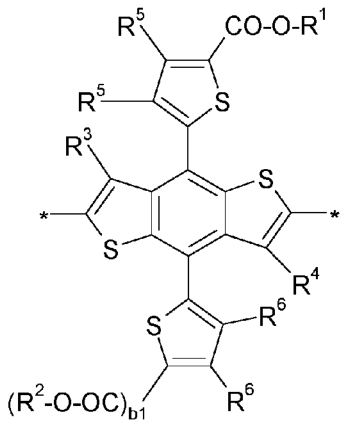

I1

dans lequel $R^{1-6}$ sont tels que définis dans la revendication 1, et b1 vaut 0, 1 ou 2.

**3.** Composé selon la revendication 1 ou 2, **caractérisé en ce que** $R^1$ et $R^2$ sont sélectionnés parmi un alkyle linéaire ou ramifié avec 1 à 30 atomes de C qui est non substitué ou substitué par un ou plusieurs atomes de F.

**4.** Composé selon une ou plusieurs des revendications 1 à 3, **caractérisé en ce que** $R^{3-6}$ sont H.

**5.** Composé selon une ou plusieurs des revendications 1 à 4, **caractérisé en ce qu'**il s'agit d'un oligomère ou polymère conjugué comprenant un ou plusieurs motifs de formule I ou I1, et comprenant en plus un ou plusieurs motifs arylène ou hétéroarylène qui sont différents de la formule I et I1, présentent de 5 à 20 atomes cycliques, sont mono- ou polycycliques, contiennent facultativement des cycles fusionnés, sont non substitués ou substitués par un ou plusieurs groupes L identiques ou différents, dans lequel un ou plusieurs de ces motifs arylène ou hétéroarylène supplémentaires présentent une propriété de donneur d'électrons ou une propriété d'accepteur d'électrons.

**6.** Composé selon une ou plusieurs des revendications 1 à 5,

**caractérisé en ce qu'**il s'agit d'un oligomère ou polymère conjugué comprenant un ou plusieurs motifs répétitifs de formule II1 et/ou II2, et facultativement un ou plusieurs motifs répétitifs de formule II3 :

$$-(Ar^1)_a-U-(Ar^2)_b-(Ar^3)_c-(Ar^4)_d- \qquad \text{II1}$$

$$-(Ar^1)_a-(Ar^2)_b-U-(Ar^3)_c-(Ar^4)_d- \qquad \text{II2}$$

$$-(Ar^1)_a-(Ar^2)_b-(Ar^3)_c-(Ar^4)_d- \qquad \text{II3}$$

dans lequel les radicaux individuels, indépendamment les uns des autres et à chaque occurrence de manière identique ou différente, présentent les significations suivantes
U un motif de formule I ou I1 tel que défini dans l'une quelconque des revendications 1 à 4,
$Ar^{1-4}$ arylène ou hétéroarylène qui présente de 5 à 20 atomes cycliques, est mono- ou polycyclique, contient facultativement des cycles fusionnés, et est non substitué ou substitué par un ou plusieurs groupes L identiques ou différents, $R^1$ ou $R^2$ tel que défini dans la revendication 1, et est différent de U,
a, b, c, d 0 ou 1, dans lequel dans la formule II3 $a+b+c+d \geq 1$.

**7.** Composé selon une ou plusieurs des revendications 1 à 6, **caractérisé en ce qu'**il est sélectionné de formule III :

$$*-\left[(A)_x-(B)_y-(C)_z-(D)_v-(E)_w\right]_n-* \qquad \text{III}$$

dans lequel les radicaux individuels, indépendamment les uns des autres et à chaque occurrence de manière identique ou différente, présentent les significations suivantes

A un motif de formule I ou I1, II1 ou II2 tel que défini dans l'une quelconque des revendications 1 à 6,

B, C, D, E un motif de formule I ou I1, II1, II2 ou II3 tel que défini dans l'une quelconque des revendications 1 à 6,
$X > 0$ et $\leq 1$,
y, z, v, w $\geq 0$ et $< 1$, x+y+z+v+w 1,
n un nombre entier $\geq 5$.

**8.** Composé selon une ou plusieurs des revendications 1 à 7, **caractérisé en ce qu'**il est sélectionné parmi les formules suivantes

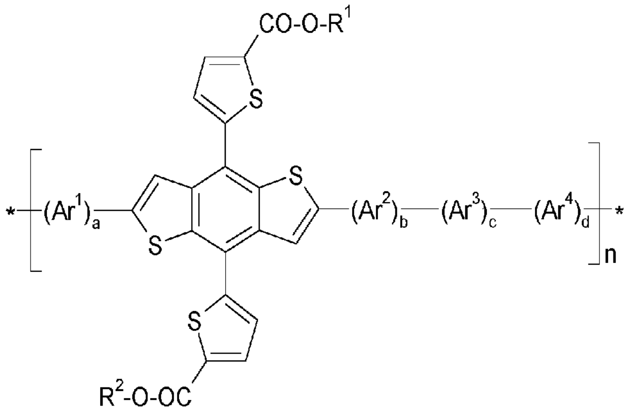

III1

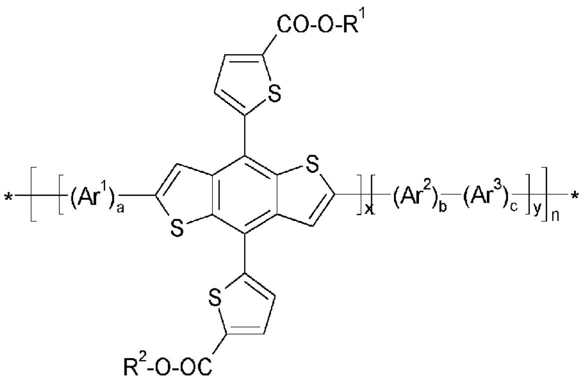

III2

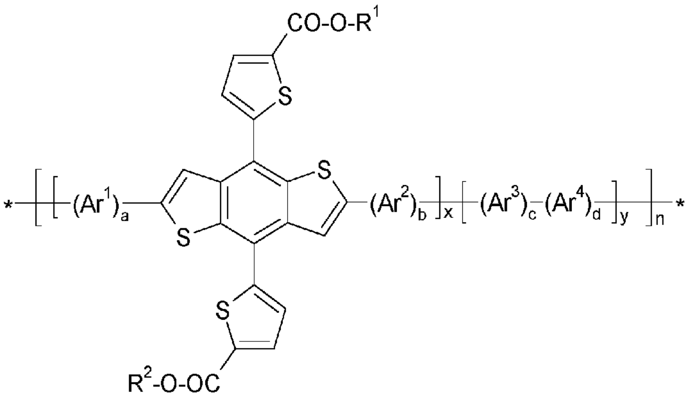

III3

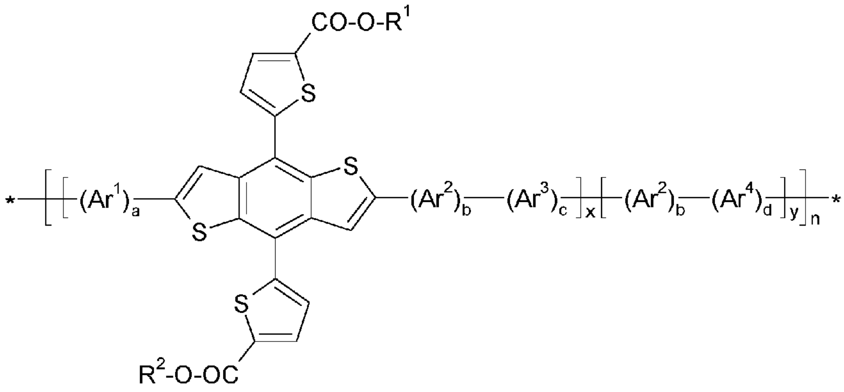

III4

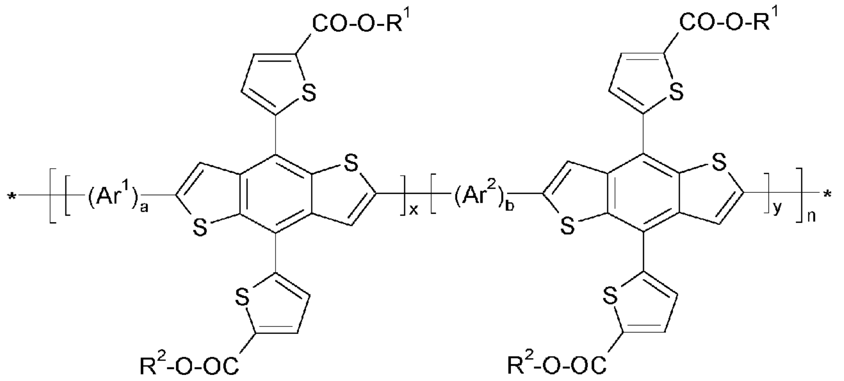

III5

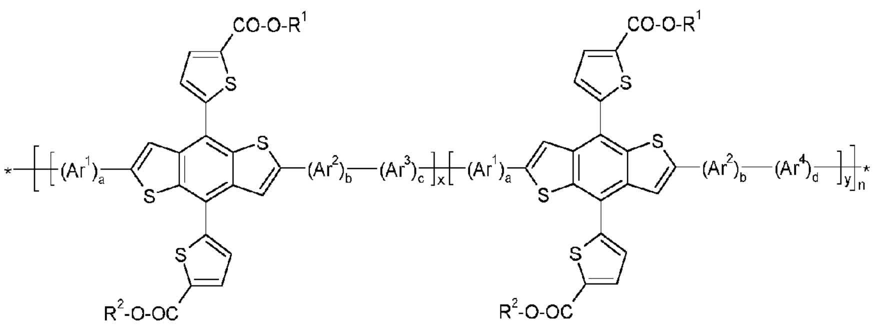

III6

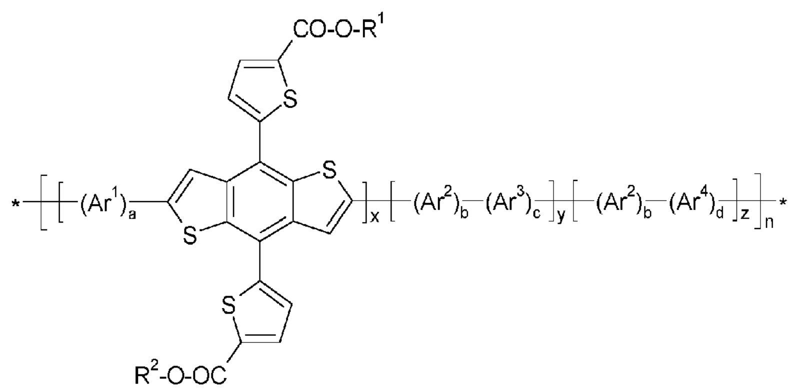

III7

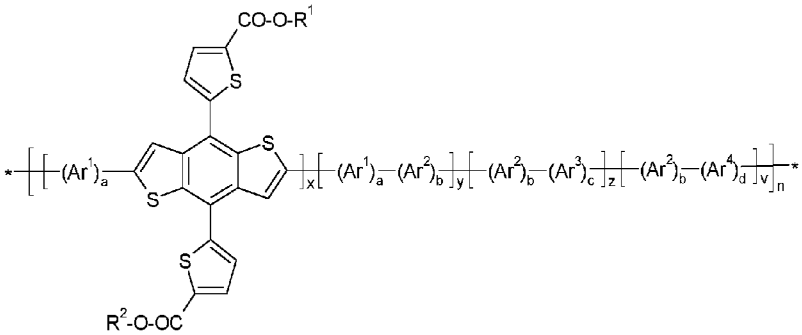 III8

dans lequel $R^1$, $R^2$, $Ar^1$, $Ar^2$, $Ar^3$, $Ar^4$, a, b, c, d, v, x, y, z et n présentent les significations données dans les revendications 1 à 7.

**9.** Composé selon l'une quelconque des revendications 1 à 8, **caractérisé en ce qu'**il s'agit d'un oligomère ou polymère conjugué comprenant un ou plusieurs motifs donneurs d'électrons, dont au moins un est sélectionné de formule I, comprenant en outre un ou plusieurs motifs accepteurs d'électrons, et comprenant facultativement un ou plusieurs motifs d'espacement séparant un motif donneur d'un motif accepteur, dans lequel chaque motif donneur et chaque motif accepteur est directement relié soit à un autre motif donneur ou accepteur, soit à un motif d'espacement, et dans lequel tous les motifs donneurs, accepteurs et d'espacement qui sont différents de la formule I sont chacun indépendamment sélectionnés parmi arylène ou hétéroarylène qui présente de 5 à 20 atomes cycliques, est mono- ou polycyclique, contient facultativement des cycles fusionnés, est non substitué ou substitué par un ou plusieurs groupes L identiques ou différents tels que définis dans la revendication 1.

**10.** Composé selon l'une quelconque des revendications 1 à 9, **caractérisé en ce qu'**il comprend un ou plusieurs motifs sélectionnés dans le groupe consistant en les formules suivantes

-(D-Sp)- U1

-(A-Sp)- U2

-(A-D)- U3

-(D)- U4

-(Sp-D-Sp)- U5

-(A)- U6

-(Sp-A-Sp)- U7

dans lequel D désigne un motif donneur d'électrons, A désigne un motif accepteur d'électrons et Sp désigne un motif d'espacement, qui sont tous sélectionnés, indépendamment les uns des autres et à chaque occurrence de manière identique ou différente, parmi arylène ou hétéroarylène qui présente de 5 à 20 atomes cycliques, est mono- ou polycyclique, contient facultativement des cycles fusionnés, est non substitué ou substitué par un ou plusieurs groupes L identiques ou différents tels que définis dans la revendication 1, et dans lequel le polymère comprend au moins un motif sélectionné parmi les formules U1, U3, U4 et U5 telles que définies dans la revendication 9, dans lequel D est un motif sélectionné de formule I.

**11.** Composé selon l'une quelconque des revendications 1 à 10, **caractérisé en ce qu'**il est sélectionné parmi les formules Pi-Pviii

$-[(D\text{-}Sp)_x\text{-}(A\text{-}Sp)_y]_n-$ Pi

$-[(A\text{-}D)_x\text{-}(A\text{-}Sp)_y]_n-$ Pii

$-[(D)_x\text{-}(Sp\text{-}A\text{-}Sp)_y]_n-$ Piii

$-[D\text{-}Sp\text{-}A\text{-}Sp]_n-$ Piv

$-[D\text{-}A]_n-$ Pv

$-[D\text{-}Sp\text{-}A\text{-}Sp]_n$ Pvi

$-[D^1\text{-}A\text{-}D^2\text{-}A]_n$ Pvii

$-[D\text{-}A^1\text{-}D\text{-}A^2]_n$ Pviii

dans lequel A, D et Sp sont tels que définis dans la formule de la revendication 10, A et D peuvent chacun, en cas d'occurrences multiples, présenter également des significations différentes, $D^1$ et $D^2$ présentent l'une des significations données pour D et sont différents l'un de l'autre, $A^1$ et $A^2$ présentent l'une des significations données pour A et sont différents l'un de l'autre, x et y désignent les fractions molaires des motifs correspondants, x et y sont chacun, indépendamment l'un de l'autre, un nombre non entier >0 et <1, avec x+y=1, et n est un nombre entier >1.

**12.** Composé selon l'une quelconque des revendications 1 à 11, **caractérisé en ce qu'**il est sélectionné parmi les formules suivantes

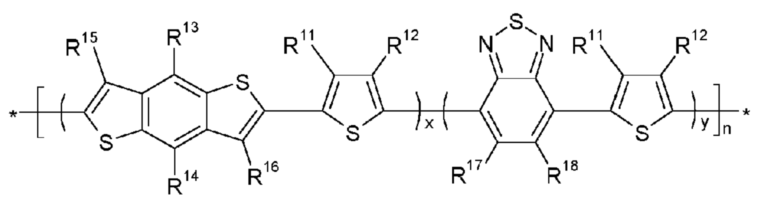

P1

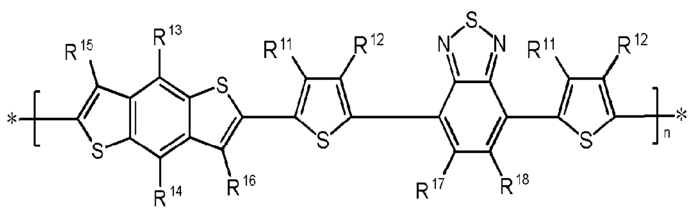

P2

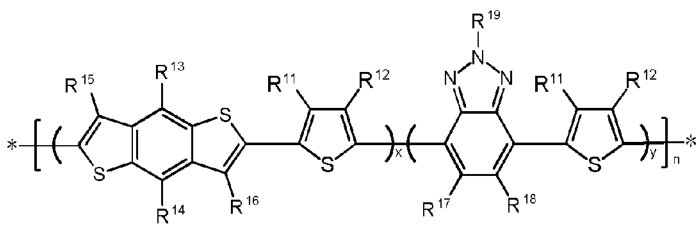

P3

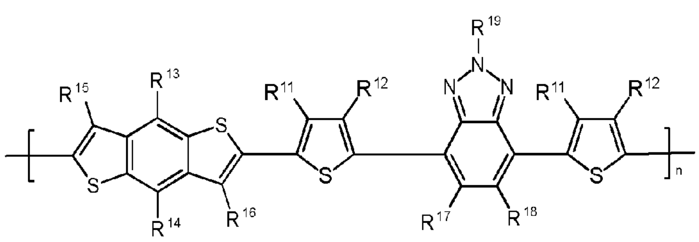

P4

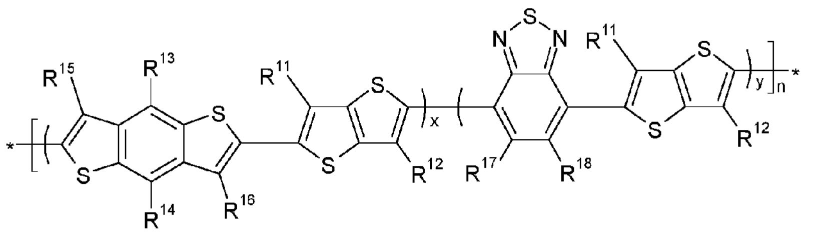
P5

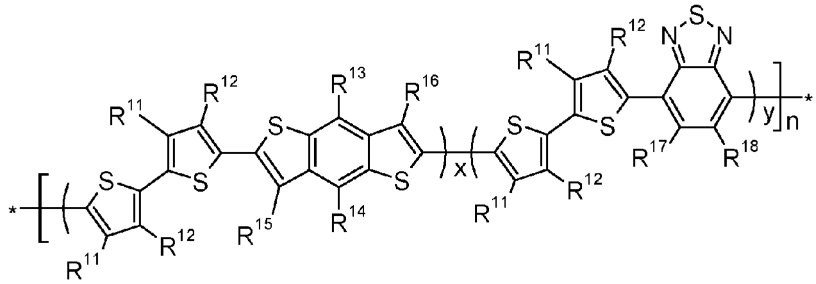
P6

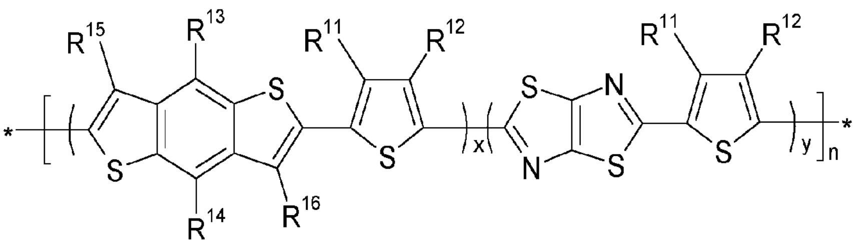
P7

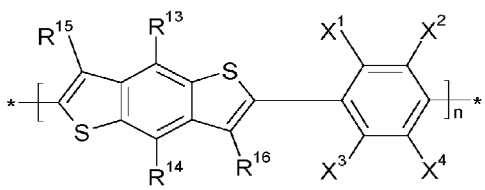
P5a

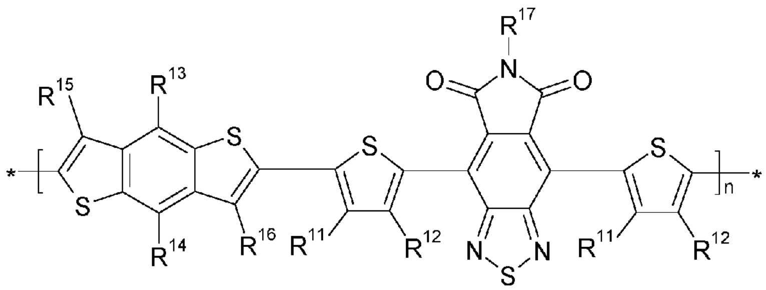
P6a

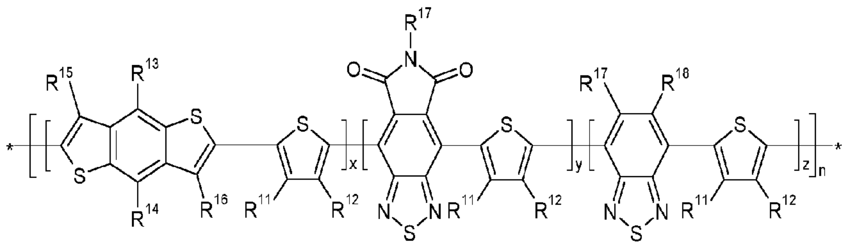
P7a

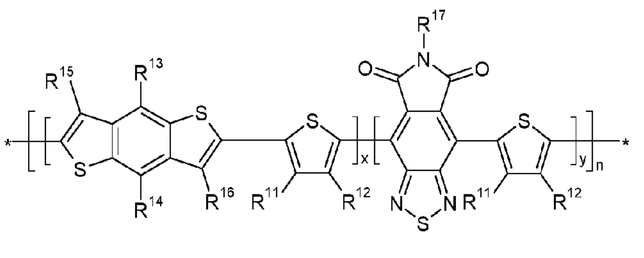

P8

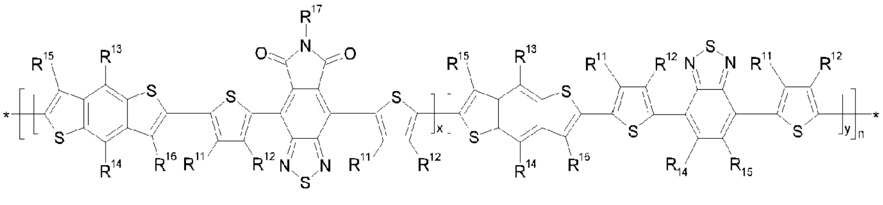

P9

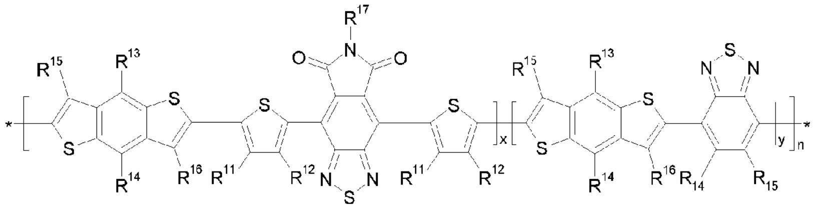

P10

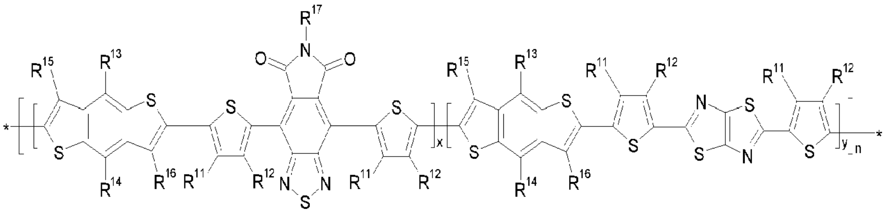

P11

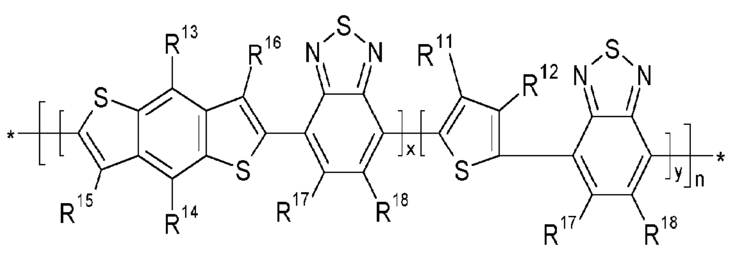

P12

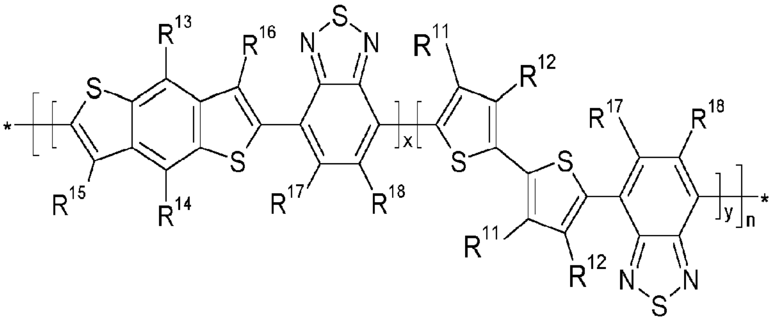

P13

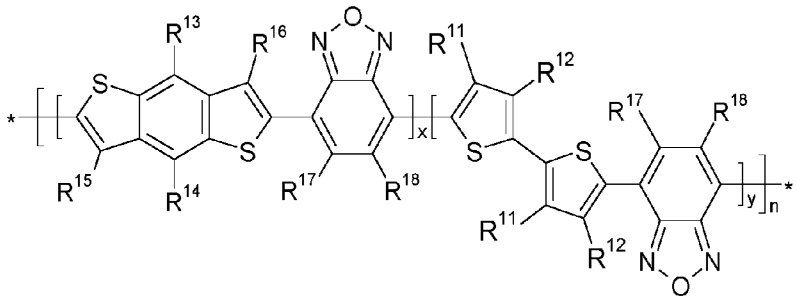

P14

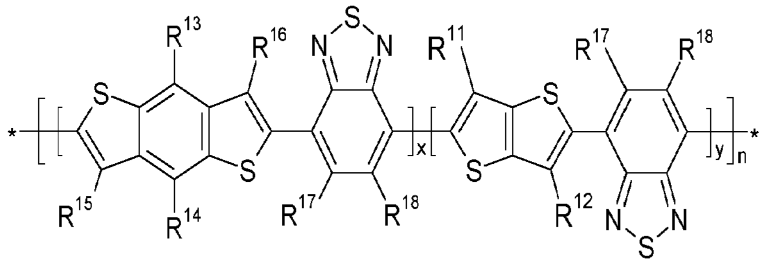

P15

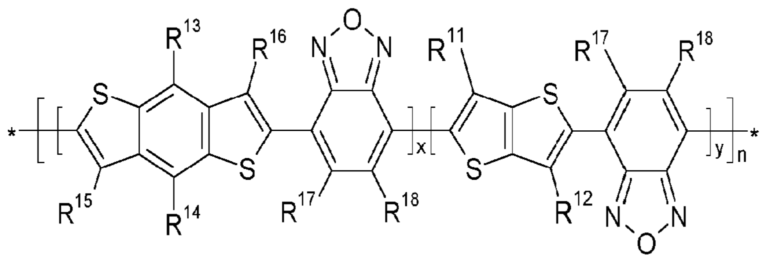

P16

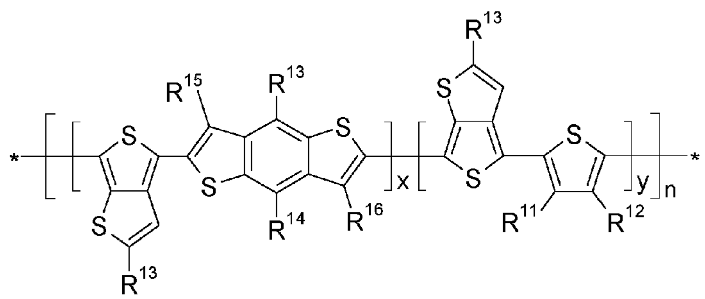

P17

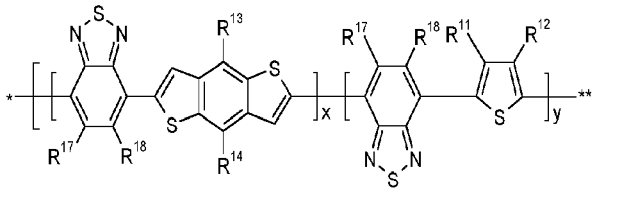

P18

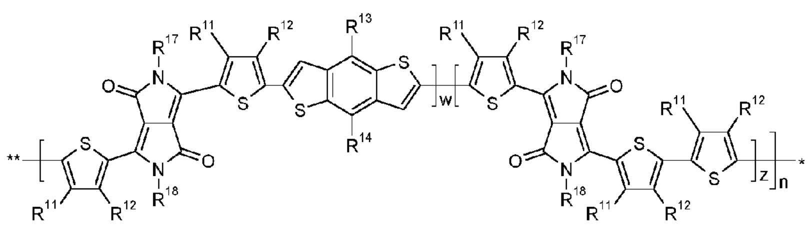

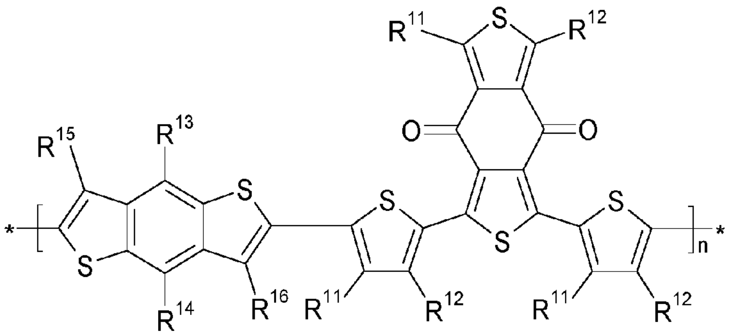

P19

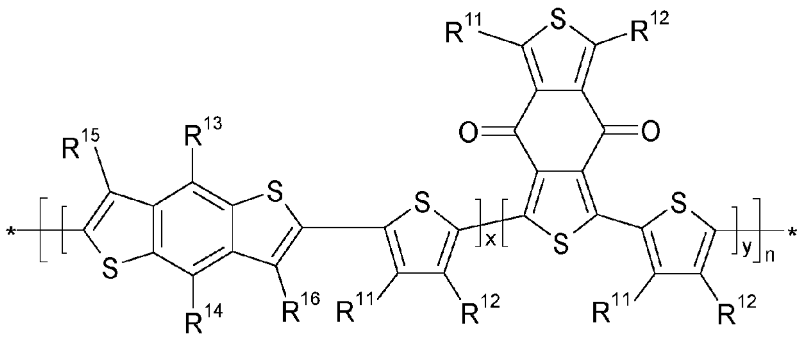

P20

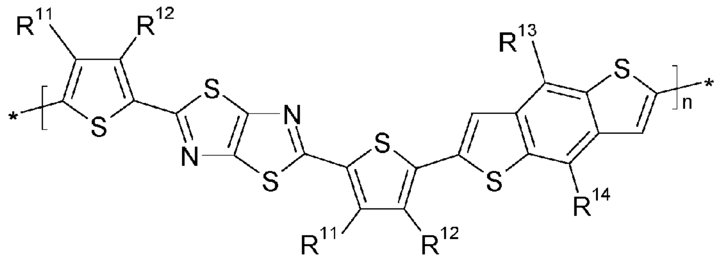

P21

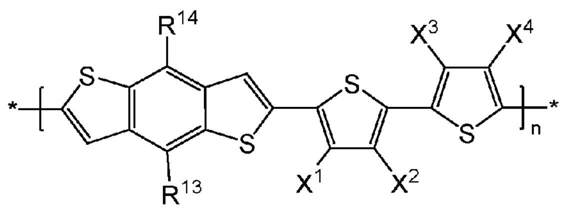

P22

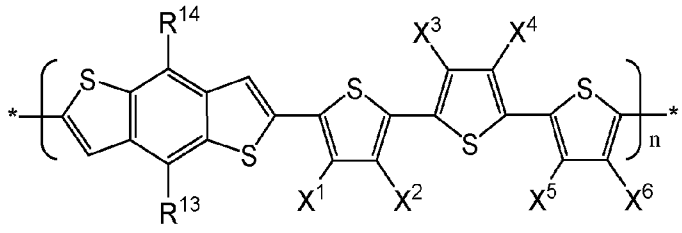

P23

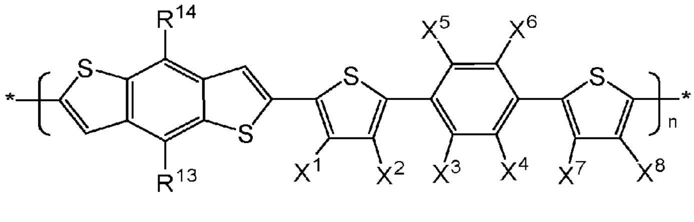

P24

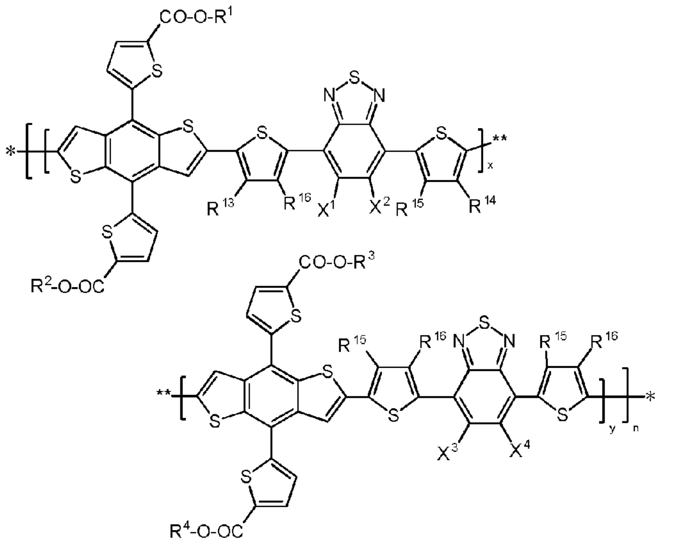

P25

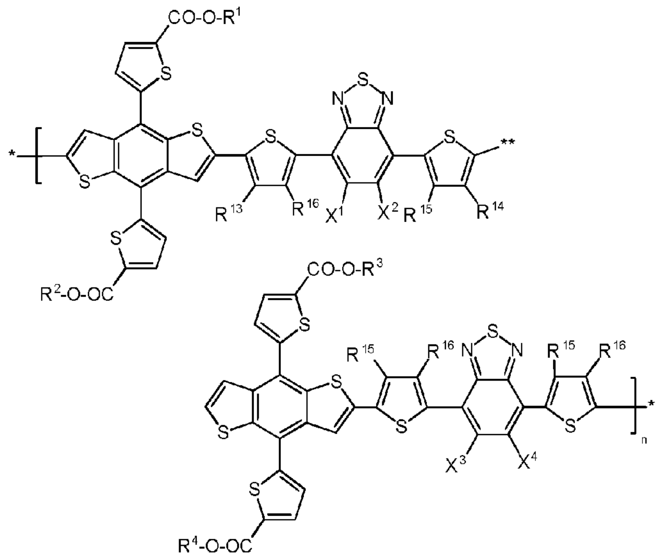

P26

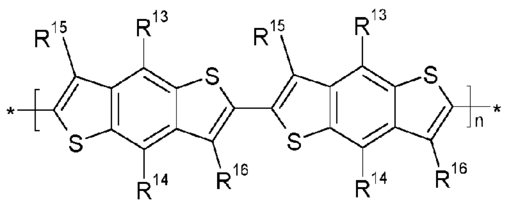

P27

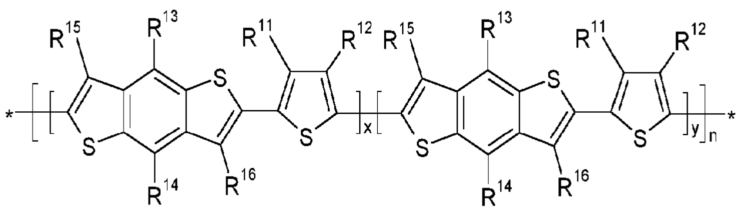

P28

dans lequel

$R^{13}$ désigne

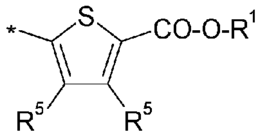

,

$R^{14}$ désigne

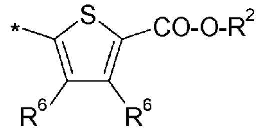

,

$R^1$, $R^2$, $R^5$ et $R^6$ présentent l'une des significations de la revendication 1,
x, y et n présentent l'une des significations de la revendication 6,
$R^{11}$, $R^{12}$, $R^{15}$, $R^{16}$, $R^{17}$, $R^{18}$ et $R^{19}$ présentent l'une des significations données pour $R^3$ dans la revendication 1,
$X^1$, $X^2$, $X^3$, $X^4$, $X^5$ et $X^6$ présentent l'une des significations données pour $R^3$ dans la revendication 1.

**13.** Composé selon une ou plusieurs des revendications 1 à 12, **caractérisé en ce qu'**il est sélectionné de la formule IV

$R^{21}$-chaîne-$R^{22}$ IV

dans lequel « chaîne » désigne une chaîne d'oligomères ou de polymères sélectionnée parmi les formules III, III1-III8, Pi-Pviii et P1-P18 telles que définies dans les revendications 7, 8, 11 et 12, et $R^{21}$ et $R^{22}$ présentent indépendamment l'un de l'autre l'une des significations de L tel que défini dans la revendication 1, ou désignent, indépendamment l'un de l'autre, H, F, Br, Cl, I, $-CH_2Cl$, -CHO, -CR'=CR"$_2$, -SiR'R"R''', - SiR'X'X", -SiR'R"X', -SnR'R"R''', -BR'R", -B(OR')(OR"), $-B(OH)_2$, $-O-SO_2-R'$, -C=CH, -C≡C-SiR'$_3$, -ZnX' ou un groupe de coiffe d'extrémité, X' et X" désignent halogène, R', R" et R''' présentent indépendamment les uns des autres l'une des significations de $R^0$ données dans la revendication 1, et deux de R', R" et R''' peuvent également former un groupe cyclosilyle, cyclostannyle, cycloborane ou cycloboronate avec 2 à 20 atomes de C avec l'hétéroatome respectif auquel ils sont attachés.

**14.** Composé de formule V1 ou V2

$R^{23}-(Ar^1)_a-U-(Ar^2)_b-(Ar^3)_c-(Ar^4)_d-R^{24}$ V1

$R^{23}-(Ar^1)_a-(Ar^2)_b-U-(Ar^3)_c-(Ar^4)_d-R^{24}$ V2

dans lequel U, $Ar^{1-4}$, a, b, c et d présentent les significations données dans la revendication 6, et $R^{23}$ et $R^{24}$ sont indépendamment l'un de l'autre sélectionnés dans le groupe consistant en H, Cl, Br, I, O-tosylate, O-triflate, O-mésylate, O-nonaflate, $-SiMe_2F$, $-SiMeF_2$, $-O-SO_2Z^1$, $-B(OZ^2)_2$, $-CZ^3=C(Z^3)_2$, -C=CH, $-C{\equiv}CSi(Z^1)_3$, $-ZnX^0$ et $-Sn(Z^4)_3$, dans lequel $X^0$ est halogène, $Z^{1-4}$ sont sélectionnés dans le groupe consistant en alkyle en $C_{1-10}$ et aryle en $C_{6-12}$, chacun étant facultativement substitué, et deux groupes $Z^2$ peuvent également former un groupe cycloboronate présentant 2 à 20 atomes de carbone avec les atomes de B et de O, dans lequel au moins un parmi $R^{23}$ et $R^{24}$ est différent de H,
et dans lequel au moins l'un parmi a, b, c et d est différent de 0.

**15.** Composé de formule V3

$R^{23}-U^*-R^{24}$ V3

dans lequel $R^{23}$ et $R^{24}$ présentent les significations données dans la revendication 14, et U* est un motif sélectionné parmi les sous-formules P1-P28 telles que définies dans la revendication 12, dans lequel n vaut 1.

**16.** Composition comprenant un ou plusieurs composés selon l'une quelconque des revendications 1 à 13 et un ou plusieurs composés supplémentaires présentant une ou plusieurs des propriétés semi-conductrices, de transport de charges, de transport de trous ou d'électrons, de blocage de trous ou d'électrons, électroconductrices, photoconductrices ou d'émission de lumière.

**17.** Composition selon la revendication 16, comprenant un ou plusieurs semi-conducteurs de type p, dont au moins un est un composé selon une ou plusieurs des revendications 1 à 13, et comprenant en outre un ou plusieurs semi-conducteurs de type n, de préférence sélectionnés parmi des fullerènes ou des dérivés de fullerène.

**18.** Composition selon la revendication 17, comprenant un ou plusieurs semi-conducteurs de type n, dont au moins un est un composé selon une ou plusieurs des revendications 1 à 13, et comprenant en outre un ou plusieurs semi-conducteurs de type p, de préférence sélectionnés parmi des polymères conjugués.

**19.** Hétérojonction en volume (BHJ) formée à partir d'une composition selon une ou plusieurs des revendications 16 à 18.

**20.** Formulation comprenant un ou plusieurs composés selon une ou plusieurs des revendications 1 à 13, ou composition selon une ou plusieurs des revendications 16 à 18, et comprenant en outre un ou plusieurs solvants sélectionnés parmi des solvants organiques.

**21.** Utilisation d'un composé selon une ou plusieurs des revendications 1 à 13 ou d'une composition selon une ou plusieurs des revendications 16 à 18, dans un dispositif électronique ou optoélectronique, ou dans un composant d'un tel dispositif ou dans un ensemble comprenant un tel dispositif.

**22.** Dispositif électronique ou optoélectronique, ou composant de celui-ci, ou ensemble le comprenant, qui comprend un composé selon une ou plusieurs des revendications 1 à 13 ou une composition selon une ou plusieurs des revendications 16 à 18.

**23.** Dispositif électronique ou optoélectronique selon la revendication 22, qui est sélectionné parmi des transistors à effet de champ organiques (OFET), des transistors à couches minces organiques (OTFT), des diodes électroluminescentes organiques (OLED), des transistors électroluminescents organiques (OLET), des dispositifs photovoltaïques organiques (OPV), des photodétecteurs organiques (OPD), des cellules solaires organiques, des cellules solaires à pigment photosensible (DSSC), des cellules solaires à base de pérovskite (PSC), des diodes laser, des diodes Schottky, des photoconducteurs, des photodétecteurs ou des dispositifs thermoélectriques.

**24.** Composant selon la revendication 22, qui est sélectionné parmi des couches d'injection de charge, des couches de transport de charge, des couches intermédiaires, des couches de planarisation, des films antistatiques, des membranes électrolytiques polymères (PEM), des substrats conducteurs et des motifs conducteurs.

**25.** Ensemble selon la revendication 22, qui est sélectionné parmi des circuits intégrés (CI), des étiquettes d'identification par radiofréquence (RFID), des marquages de sécurité, des dispositifs de sécurité, des écrans plats, des rétroéclairages d'écrans plats, des dispositifs électrophotographiques, des dispositifs d'enregistrement électrophotographique, des dispositifs mémoires organiques, des dispositifs capteurs, des biocapteurs et des biopuces.

**26.** Processus de préparation d'un composé selon une ou plusieurs des revendications 1 à 13, en couplant un ou plusieurs composés selon la revendication 14 ou 15 les uns aux autres et/ou à un ou plusieurs monomères de formules MI-MIV dans une réaction de couplage aryle-aryle.

$R^{23}$-$Ar^1$-$R^{24}$ MI

$R^{23}$-$Ar^2$-$R^{24}$ MII

$R^{23}$-$Ar^3$-$R^{24}$ MIII

$R^{23}$-$Ar^4$-$R^{24}$ MIV

dans lequel $Ar^{1-4}$, $R^{23}$ et $R^{24}$ présentent les significations données dans la revendication 14.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- CN 105218558 A
- WO 0053656 A1
- WO 2004022626 A1
- WO 03048225 A2
- WO 2005014688 A2
- WO 2005055248 A1
- WO 2013142841 A1
- WO 2018007479 A1
- WO 2018036914 A1
- WO 2018065350 A1
- WO 2018065352 A1
- WO 2018065356 A1
- EP 3306690 A1
- WO 2012095796 A1
- WO 2013021971 A1
- WO 2013171520 A1
- US 5892244 A
- US 5998804 A
- US 6723394 B
- US 20070102696 A1
- US 7095044 B
- EP 0889350 A1
- EP 0528662 A
- US 5198153 A
- WO 9621659 A
- US 20030021913 A
- US 20030021913 A1
- CN 105315298 A
- EP 2017074951 W


### Non-patent literature cited in the description


- **WANG ZHEN et al.** From Alloy-Like to Cascade Blended Structure: Designing High-Performance All-Small-Molecule Ternary Solar Cells. *J. Am. Chem.Soc.,* 31 January 2018, vol. 140 (4), 1549-1556
- *Pure Appl. Chem.,* 1996, vol. 68, 2291
- International Union of Pure and Applied Chemistry. *Compendium of Chemical Technology,* 19 August 2012, 477-480
- **J. THEWLIS.** Concise Dictionary of Physics. Pergamon Press, 1973
- *Pure Appl. Chem.,* 1994, vol. 66, 1134
- **J. M. G. COWIE.** Polymers: Chemistry & Physics of Modern Materials. Blackie, 1991
- *J. Chem. Soc., Chem. Common.,* 1977, 683-684
- **T. YAMAMOTO et al.** *Prog. Polym. Sci.,* 1993, vol. 17, 1153-1205
- **Z. BAO et al.** *J. Am. Chem. Soc.,* 1995, vol. 117, 12426-12435
- **M. LECLERC et al.** *Angew. Chem. Int. Ed.,* 2012, vol. 51, 2068-2071
- **M. WAKIOKA et al.** *Macromol.,* 2015, vol. 48, 8382
- **YAMAMOTO et al.** *Bull., Chem. Soc. Jpn.,* 1978, vol. 51 (7), 2091
- **YAMAMO TO et al.** *Macromolecules,* 1992, vol. 25 (4), 1214
- **MIYAURA et al.** *Chem. Rev.,* 1995, vol. 95, 2457
- **BAO et al.** *J. Am., Chem., Soc.,* 1995, vol. 117 (50), 12426
- **CROWLEY, J.D. ; TEAGUE, G.S. JR ; LOWE, J.W. JR.** *Journal of Paint Technology,* 1966, vol. 38 (496), 296
- **W.H.ELLIS.** Solvents. Federation of Societies for Coatings Technology, 1986, 9-10
- **G. YU ; J. GAO ; J.C. HUMMELEN ; F. WUDL ; A.J. HEEGER.** *Science,* 1995, vol. 270, 1789
- **COAKLEY, K. M. ; MCGEHEE, M. D.** *Chem. Mater.,* 2004, vol. 16, 4533
- *Adv. Sci.,* 2016, vol. 3, 1600117
- *Adv. Mater.,* 2016, vol. 28, 8546-8551
- *J. Am. Chem. Soc.,* 2016, vol. 138, 7248-7251
- *J. Mater. Chem. A,* 2016, vol. 4, 17604
- **Y. LIN ; J. WANG ; Z.-G. ZHANG ; H. BAI ; Y. LI ; D. ZHU ; X. ZHAN.** *Adv. Mater.,* 2015, vol. 27, 1170-1174
- **H. LIN ; S. CHEN ; Z. LI ; J. Y. L. LAI ; G. YANG ; T. MCAFEE ; K. JIANG ; Y. LI ; Y. LIU ; H. HU.** *Adv. Mater.,* 2015, vol. 27, 7299
- *Adv. Mater.,* 2013, vol. 25 (17), 2385-2396
- *Adv. Mater.,* 2013, vol. 25 (48), 7038-7044
- *J. Mater. Chem.,* 2011, vol. 21, 12331
- *J. Appl. Phys.,* 2013, vol. 113, 124509
- *Adv. Energy Mater.,* 2012, vol. 2, 82-86
- **WALDAUF et al.** *Appl. Phys. Lett.,* 2006, vol. 89, 233517
- **DENNLER et al.** *Proceedings of the IEEE,* 2005, vol. 93 (8), 1429

- **HOPPE et al.** *Adv. Func. Mater,* 2004, vol. 14 (10), 1005
- **J. PEET et al.** *Nat. Mater.,* 2007, vol. 6, 497
- **FRÉCHET et al.** *J. Am. Chem. Soc.,* 2010, vol. 132, 7595-7597
- *Chem. Rev.,* 2010, vol. 110, 6595-6663
- *Angew. Chem. Int. Ed.,* 2014, vol. 53, 2-15
- **MÜLLER et al.** *Synth. Metals,* 2000, 111-112, 31-34
- **ALCALA.** *J. Appl. Phys.,* 2000, vol. 88, 7124-7128
- **C. WEDER et al.** *Science,* 1998, vol. 279, 835-837
- **KOLLER et al.** *Nat. Photonics,* 2008, vol. 2, 684
- **L. CHEN ; D. W. MCBRANCH ; H. WANG ; R. HELGESON ; F. WUDL ; D. G. WHITTEN.** *Proc. Natl. Acad. Sci. U.S.A.,* 1999, vol. 96, 12287
- **D. WANG ; X. GONG ; P. S. HEEGER ; F. RININSLAND ; G. C. BAZAN ; A. J. HEEGER.** *Proc. Natl. Acad. Sci. U.S.A.,* 2002, vol. 99, 49
- **N. DICESARE ; M. R. PINOT ; K. S. SCHANZE ; J. R. LAKOWICZ.** *Langmuir,* 2002, vol. 18, 7785
- **D. T. MCQUADE ; A. E. PULLEN ; T. M. SWAGER.** *Chem. Rev.,* 2000, vol. 100, 2537
- *Chem. Mater.,* 2004, vol. 16, 708